# EUROPEAN PATENT APPLICATION

(11) **EP 4 343 433 A1**
(43) Date of publication of application: **27.03.2024**
(21) Application number: 23196838.9
(22) Date of filing: 12.09.2023
(51) Int. Cl.: G03F 7/004, G03F 7/039

(54) **POLYMER, CHEMICALLY AMPLIFIED POSITIVE RESIST COMPOSITION, RESIST PATTERNING PROCESS, AND MASK BLANK**

(30) Priority: 22.09.2022 JP 2022150817
(71) Applicant: SHIN-ETSU CHEMICAL CO., LTD., Tokyo 1000005 (JP)
(72) Inventor: FUKUSHIMA, Masahiro, Niigata (JP); WATANABE, Satoshi, Niigata (JP); FUNATSU, Kenji, Niigata (JP); MASUNAGA, Keiichi, Niigata (JP); KOTAKE, Masaaki, Niigata (JP); MATSUZAWA, Yuta, Niigata (JP)
(74) Representative: Sonnenhauser, Thomas Martin

(57) **Abstract**

A polymer containing a structural unit including an aromatic hydroxy group bonded to a main chain, where the aromatic hydroxy group is protected by an acid-labile group represented by the following formula (ALU-1) and is deprotected by action of an acid to become alkalisoluble. This provides: a polymer that makes it possible to form a resist film with which it is possible to form a pattern having extremely high isolated space resolution, small LER, and excellent rectangularity, effects of development loading and residue defects being suppressed, and the pattern having etching resistance and suppressed pattern collapse in the produced resist pattern; a chemically amplified positive resist composition containing the polymer; a resist patterning process using the chemically amplified positive resist composition; and a mask blank including the chemically amplified positive resist composition.

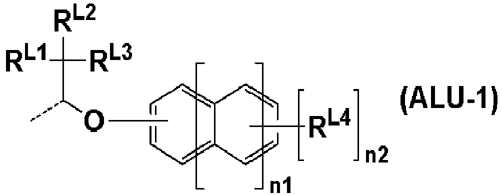

## Description

### TECHNICAL FIELD

The present invention relates to: a polymer having a particular structure; a chemically amplified positive resist composition containing the polymer; a resist patterning process; and a mask blank.

### BACKGROUND ART

A finer pattern rule has been recently required for integrated circuits with higher integration. To process a pattern with a size of 0.2 µm or less, a chemically amplified resist composition, which uses an acid as a catalyst, has been mainly used. In this process, high-energy beams such as ultraviolet ray, far ultraviolet ray, extreme ultraviolet ray (EUV), and electron beam (EB) are used as an exposure light source. In particular, the electron beam lithography, which is employed as an ultrafine processing technique, is also indispensable for processing a photomask blank in producing a photomask for semiconductor manufacture.

In general, EB lithography is performed without using a mask. In the case of a positive resist, the resist film is sequentially irradiated with an electron beam having a fine surface area except for a region to be left. In the case of a negative resist, the region of the resist film to be left is sequentially irradiated with an electron beam having a fine surface area. Consequently, this method needs to sweep across the finely divided region on the surface to be processed and thus takes more time than one-time exposure using a photomask. To keep the throughput high, this method requires a sensitive resist film. In the photomask blank processing, which is a particularly important use, some photomask substrates are coated with a surface material that easily affects pattern profile of the chemically amplified resist film, like a chromium compound film such as a chromium oxide film. To keep high resolution and profile after etching, it is important to keep the pattern profile of the resist film rectangular, regardless of the type of the substrate. Moreover, it is also important that line edge roughness (LER) is small. In recent years, a multi-beam mask writing (MBMW) process is employed for processing a mask blank in some cases in order to achieve miniaturization. In this process, a low-sensitivity resist (high-dose region), which is advantageous in terms of roughness, is used, and optimization of the resist composition in this high-dose region has also attracted attention.

Regulation of sensitivity and pattern profile has been improved by various methods, for example, by selecting or combining materials used for the resist composition and process conditions. One improvement method is to suppress acid diffusion, which significantly affects the resolution of a resist film. In photomask processing, the profile of the obtained resist pattern is required not to change depending on the time between exposure and heating. This time-dependent change in the resist pattern profile is mostly caused by the diffusion of an acid generated by exposure. The acid diffusion significantly affects not only photomask processing but also the sensitivity and resolution of resist compositions in general. Therefore, many studies have been made on this problem.

Patent Documents 1 and 2 disclose examples of suppressing acid diffusion by making the acid generated from the acid generator bulky to reduce LER. However, the suppression of acid diffusion by using such an acid generator is still insufficient. Accordingly, development of an acid generator with less acid diffusion has been desired.

Meanwhile, Patent Document 3 discloses an example of regulating acid diffusion by introducing, to a polymer to be used in a resist composition, a repeating unit that has a sulfonium structure and generates a sulfonic acid by exposure to light. Such a method of suppressing acid diffusion by incorporating a repeating unit that generates an acid by exposure into the base polymer is effective in obtaining a pattern with small LER. However, such a base polymer containing a repeating unit that generates an acid by exposure has, in some cases, a problem of solubility in an organic solvent, depending on the structure and the introducing ratio of the unit.

Polymers having many aromatic skeletons with acidic side chains, such as polyhydroxystyrene, have been favorably used as base polymers of a resist composition for KrF lithography, but have not been used as base polymers of a resist composition for ArF lithography, since such polymers exhibit great absorption of light having a wavelength of about 200 nm. However, these polymers are important materials as resist compositions for EB lithography and EUV lithography, which are effective in forming a pattern finer than a processing limit of the ArF excimer laser beam, in that the polymers have high etching resistance.

A base polymer mainly used in a positive resist composition for EB lithography or EUV lithography contains an acid-labile group that masks an acidic functional group of a phenolic side chain. This acid-labile group deprotects by an acid catalyst generated from a photo-acid generator by irradiation with a high-energy beam, thereby causing the base polymer to be solubilized in an alkaline developer. As the acid-labile group, a tertiary alkyl group and a tert-butoxycarbonyl group have been used. Besides these, an acetal group has been used as an acid-labile group that requires a relatively low activation energy (Patent Document 4, Patent Document 5, Patent Document 6, Patent Document 7, and Patent Document 8).

However, although the acetal group has an advantage of being able to provide a highly sensitive resist film, a deprotection reaction takes place even in an unexposed part of the resist film and a residue remains even in an exposed part if the acetal is reactive and has a bulky structure, particularly in a multi-beam mask writing (MBMW) process in EB lithography for producing an advanced mask of 10 nm or finer. This is because the writing is performed in a thin film region where the resist film thickness is 100 nm or less and a high-dose region where the irradiation energy is high. Thus, the acetal group has problems of causing the degradation of isolated space resolution, which is regarded as important especially in positive resists, the degradation of LER, and the generation of defects.

In a developing step in photomask production, a phenomenon called development loading is known to occur. Development loading is a phenomenon in which a difference occurs in the finished dimensions of a pattern between regions on the photomask where the pattern is dense and regions where the pattern is sparse. That is, due to development loading, an uneven distribution occurs in the finished dimensions of the pattern depending on the surrounding pattern distribution. Factors of the phenomenon include the fact that a difference occurs in deprotection reaction on generation of an acid due to a difference in the energy of the electron beam and the fact that a difference occurs in the dissolution rate of the sparsely and densely patterned portions to an alkaline developer. As an improvement means, Patent Document 9 discloses a method of correcting development loading by irradiation with an electron beam with the incident dose adjusted in an EB writing apparatus to draw a pattern on a photomask. However, conventional correction methods do not allow correction with sufficient consideration of the phenomenon of development loading. Therefore, the accuracy of the correction of development loading is poor in conventional correction methods. To solve this problem, there have been developed methods, disclosed in Patent Document 10 and Patent Document 11, of writing methods for writing on a resist film and improving techniques for development after patterning. However, such methods are insufficient for distributing fine dense and sparse patterns uniformly in advanced-generation patterning, and there has been desired an improved resist composition capable of achieving high resolution and the reduction of development loading and residue defects even in advanced-generation patterning.

### CITATION LIST

### PATENT LITERATURE

Patent Document 1: JP2009-053518A
Patent Document 2: JP2010-100604A
Patent Document 3: JP2011-022564A
Patent Document 4: JP3981830B2
Patent Document 5: JP5385017B2
Patent Document 6: WO2019/167419A1
Patent Document 7: JP6987873B2
Patent Document 8: JP5696254B2
Patent Document 9: JP2007-150243A
Patent Document 10: JP5443548B2
Patent Document 11: JP6281244B2

### SUMMARY OF INVENTION

### TECHNICAL PROBLEM

The present invention has been made to solve the above-described problems, and an object thereof is to provide: a polymer that makes it possible to form a resist film with which it is possible to form a pattern having extremely high isolated space resolution, small LER, and excellent rectangularity, effects of development loading and residue defects being suppressed, and the pattern having etching resistance and suppressed pattern collapse in the produced resist pattern; a chemically amplified positive resist composition containing the polymer; a resist patterning process using the chemically amplified positive resist composition; and a mask blank including the chemically amplified positive resist composition.

### SOLUTION TO PROBLEM

To achieve the object, the present invention provides a polymer comprising a structural unit comprising an aromatic hydroxy group bonded to a main chain, wherein the aromatic hydroxy group is protected by an acid-labile group represented by the following formula (ALU-1) and is deprotected by action of an acid to become alkali-soluble, 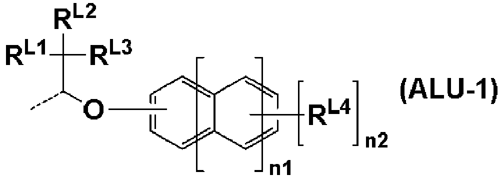 wherein R^{L1} to R^{L3} each independently represent a hydrogen atom or a hydrocarbyl group having 1 to 6 carbon atoms and do not have an aromatic ring structure, any two of R^{L1} to R^{L3} optionally being bonded to each other to form a cyclic structure together with a carbon atom to which R^{L1} to R^{L3} are bonded; R^{L4} represents a hydrogen atom, a halogen atom, a nitro group, or a hydrocarbyl group having 1 to 6 carbon atoms and optionally having a heteroatom; n1 represents an integer of 0 or 1; when n1 is 0, n2 represents an integer of 0 to 5 and when n1 is 1, n2 represents an integer of 0 to 7; and a broken line represents a bond with an oxygen atom of the aromatic hydroxy group of the unit comprising the aromatic hydroxy group bonded to the main chain of the polymer.

Such a polymer makes it possible to form a resist film with which it is possible to form a pattern having extremely high isolated space resolution, small LER, and excellent rectangularity, effects of development loading and residue defects being suppressed, and the pattern having etching resistance and suppressed pattern collapse in the produced resist pattern.

In the present invention, the unit comprising the aromatic hydroxy group bonded to the main chain of the polymer is preferably a repeating unit represented by the following formula (A1), 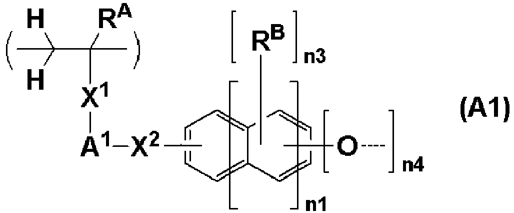 wherein each R^{A} independently represents a hydrogen atom, a fluorine atom, a methyl group, or a trifluoromethyl group; X¹ represents a single bond, *-C(=O)-O-, or *-C(=O)-NH-; "*" represents an attachment point to a carbon atom in the main chain; A¹ represents a single bond or a saturated hydrocarbylene group having 1 to 10 carbon atoms, a part of -CH₂- constituting the saturated hydrocarbylene group optionally being substituted with - O-; X² represents a single bond, an ether bond, an ester bond, a carbonyl group, a sulfonic acid ester bond, a carbonate bond, or a carbamate bond; R^{B} represents a halogen atom or a linear, branched, or cyclic hydrocarbyl group having 1 to 20 carbon atoms and optionally having a heteroatom; n1 is as defined above; n3 represents an integer of 0 to 4 when n1 is 0 and represents an integer of 0 to 6 when n1 is 1; n4 represents an integer of 1 to 3, provided that when n1 is 0, n3+n4 ≤ 5 and when n1 is 1, n3+n4 ≤ 7; and a broken line represents a bond with the formula (ALU-1).

Such a polymer can achieve the above-described advantageous effects with certainty.

The inventive polymer preferably further comprises a phenolic hydroxy group-containing repeating unit represented by the following formula (A2), 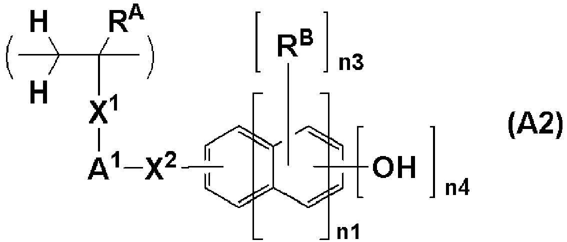 wherein each R^{A} independently represents a hydrogen atom, a fluorine atom, a methyl group, or a trifluoromethyl group; X¹ represents a single bond, *-C(=O)-O-, or *-C(=O)-NH-; "*" represents an attachment point to a carbon atom in the main chain; A¹ represents a single bond or a saturated hydrocarbylene group having 1 to 10 carbon atoms, a part of -CH₂- constituting the saturated hydrocarbylene group optionally being substituted with - O-; X² represents a single bond, an ether bond, an ester bond, a carbonyl group, a sulfonic acid ester bond, a carbonate bond, or a carbamate bond; R^{B} represents a halogen atom or a linear, branched, or cyclic hydrocarbyl group having 1 to 20 carbon atoms and optionally having a heteroatom; n1 is as defined above; n3 represents an integer of 0 to 4 when n1 is 0 and represents an integer of 0 to 6 when n1 is 1; n4 represents an integer of 1 to 3, provided that when n1 is 0, n3+n4 ≤ 5 and when n1 is 1, n3+n4 ≤ 7.

According to such a polymer, an appropriate rate of dissolution in an alkaline developer can be ensured.

In this event, the phenolic hydroxy group-containing repeating unit is preferably a repeating unit represented by the following formula (A2-1), 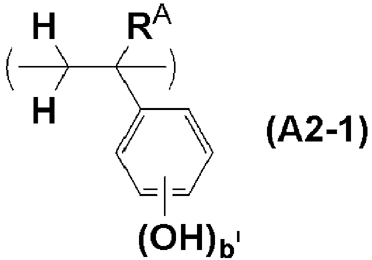 wherein R^{A} is as defined above; and "b'" represents an integer of 1 to 3.

Such a polymer can exhibit the above-described advantageous effects further.

The inventive polymer preferably further comprises one or more repeating units represented by any of the following formulae (B1) to (B3), 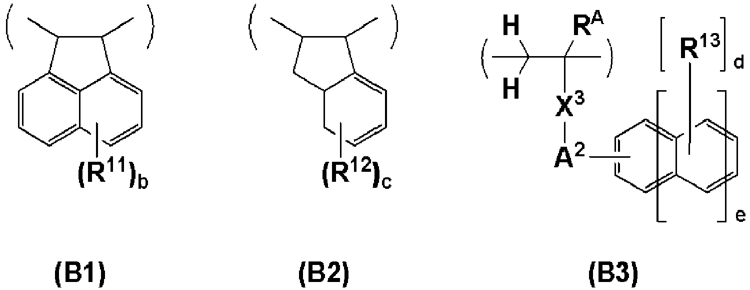 wherein each R^{A} independently represents a hydrogen atom, a fluorine atom, a methyl group, or a trifluoromethyl group; "b" and "c" each independently represent an integer of 0 to 4; "d" represents an integer of 0 to 5; "e" represents an integer of 0 to 2; X³ represents a single bond, *-C(=O)-O-, or *-C(=O)-NH-; "*" represents an attachment point to a carbon atom in the main chain; A² represents a single bond or a saturated hydrocarbylene group having 1 to 10 carbon atoms, a part of -CH₂-constituting the saturated hydrocarbylene group optionally being substituted with -O-; R¹¹ and R¹² each independently represent a hydroxy group, a halogen atom, a saturated hydrocarbylcarbonyloxy group having 2 to 8 carbon atoms optionally substituted with a halogen atom, a saturated hydrocarbyl group having 1 to 8 carbon atoms optionally substituted with a halogen atom, or a saturated hydrocarbyloxy group having 1 to 8 carbon atoms optionally substituted with a halogen atom; and R¹³ represents an acetyl group, a saturated hydrocarbyl group having 1 to 20 carbon atoms, a saturated hydrocarbyloxy group having 1 to 20 carbon atoms, a saturated hydrocarbylcarbonyloxy group having 2 to 20 carbon atoms, a saturated hydrocarbyloxyhydrocarbyl group having 2 to 20 carbon atoms, a saturated hydrocarbylthiohydrocarbyl group having 2 to 20 carbon atoms, a halogen atom, a nitro group, or a cyano group, and when "e" is 1 or 2, R¹³ optionally represents a hydroxy group.

Such a polymer has an additional ring structure in the main chain, and therefore, has enhanced resistance to EB irradiation at the time of etching or pattern inspection in addition to enhanced etching resistance provided by aromatic rings.

The inventive polymer preferably further comprises a repeating unit represented by the following formula (A3-1) and/or the following formula (A3-2), 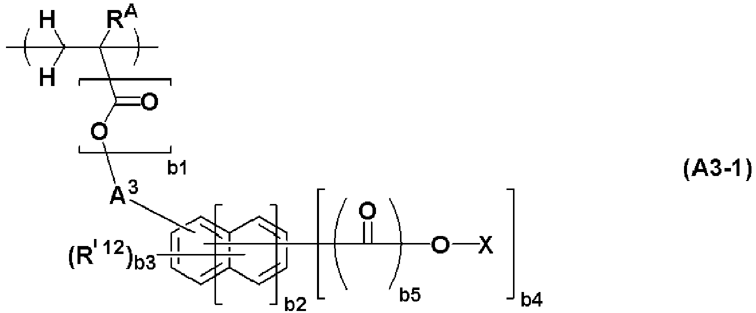 wherein each R^{A} independently represents a hydrogen atom, a fluorine atom, a methyl group, or a trifluoromethyl group; b1 represents 0 or 1; b2 represents an integer of 0 to 2; b3 represents an integer that satisfies 0 ≤ b3 ≤ 5+2b2-b4; b4 represents an integer of 1 to 3; b5 represents 0 or 1; R'¹² represents a halogen atom, a saturated hydrocarbyl group having 1 to 6 carbon atoms optionally substituted with a halogen atom, a saturated hydrocarbyloxy group having 1 to 6 carbon atoms optionally substituted with a halogen atom, or a saturated hydrocarbylcarbonyloxy group having 2 to 8 carbon atoms optionally substituted with a halogen atom; A³ represents a single bond or a saturated hydrocarbylene group having 1 to 10 carbon atoms, a part of -CH₂- of the saturated hydrocarbylene group optionally being substituted with -O-; and X represents an acid-labile group when b4 is 1 and represents a hydrogen atom or an acid-labile group when b4 is 2 or more, provided that at least one X is an acid-labile group, 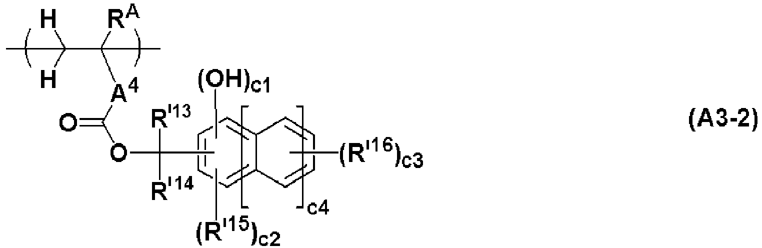 wherein c1 represents an integer of 0 to 2; c2 represents an integer of 0 to 2; c3 represents an integer of 0 to 5; c4 represents an integer of 0 to 2; each R^{A} independently represents a hydrogen atom, a fluorine atom, a methyl group, or a trifluoromethyl group; A⁴ represents a single bond, a phenylene group, a naphthylene group, or *-C(=O)-O-A⁴¹-; A⁴¹ represents an aliphatic hydrocarbylene group having 1 to 20 carbon atoms, a phenylene group, or a naphthylene group, the aliphatic hydrocarbylene group optionally having a hydroxy group, an ether bond, an ester bond, or a lactone ring; R'¹³ and R'¹⁴ each independently represent a hydrocarbyl group having 1 to 10 carbon atoms and optionally having a heteroatom, R'¹³ and R'¹⁴ optionally being bonded to each other to form a ring together with a carbon atom to which R'¹³ and R'¹⁴ are bonded; each R'¹⁵ independently represents a fluorine atom, a fluorinated alkyl group having 1 to 5 carbon atoms, or a fluorinated alkoxy group having 1 to 5 carbon atoms; and each R'¹⁶ independently represents a hydrocarbyl group having 1 to 10 carbon atoms and optionally having a heteroatom.

Such a polymer has a high dissolution rate in an exposed portion, so that favorable performance can be provided regarding fluctuation in line width in development loading.

The inventive polymer preferably further comprises one or more repeating units represented by any of the following formulae (C1) to (C8), 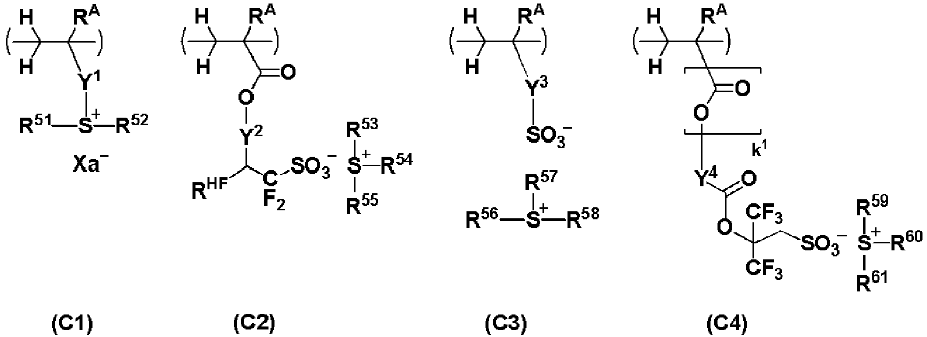 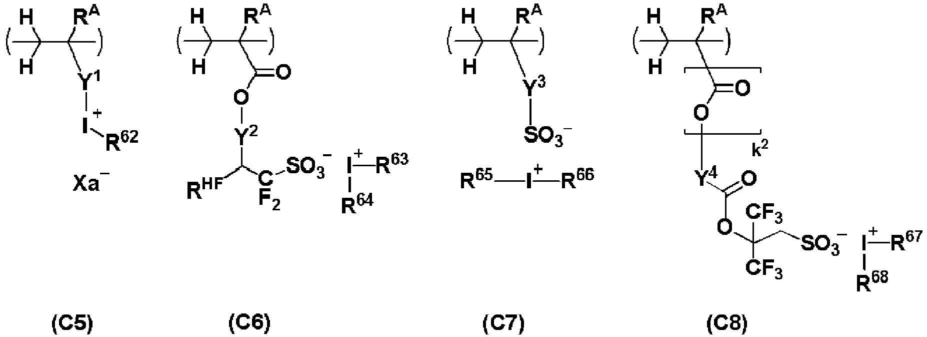 wherein each R^{A} independently represents a hydrogen atom, a fluorine atom, a methyl group, or a trifluoromethyl group; Y¹ represents a single bond, an aliphatic hydrocarbylene group having 1 to 6 carbon atoms, a phenylene group, a naphthylene group, a group having 7 to 18 carbon atoms obtained by combining these groups, *-O-Y¹¹-, *-C(=O)-O-Y¹¹-, or *-C(=O)-NH-Y¹¹-; Y¹¹ represents an aliphatic hydrocarbylene group having 1 to 6 carbon atoms, a phenylene group, a naphthylene group, or a group having 7 to 18 carbon atoms obtained by combining these groups, Y¹¹ optionally having a carbonyl group, an ester bond, an ether bond, or a hydroxy group; Y² represents a single bond or **-Y²¹-C(=O)-O-; Y²¹ represents a hydrocarbylene group having 1 to 20 carbon atoms and optionally having a heteroatom; Y³ represents a single bond, a methylene group, an ethylene group, a phenylene group, a fluorinated phenylene group, a phenylene group substituted with a trifluoromethyl group, *-O-Y³¹-, *-C(=O)-O-Y³¹-, or *-C(=O)-NH-Y³¹-; Y³¹ represents an aliphatic hydrocarbylene group having 1 to 6 carbon atoms, a phenylene group, a fluorinated phenylene group, a phenylene group substituted with a trifluoromethyl group, or a group having 7 to 20 carbon atoms obtained by combining these groups, Y³¹ optionally having a carbonyl group, an ester bond, an ether bond, or a hydroxy group; "*" represents an attachment point to a carbon atom in the main chain; "**" represents an attachment point to an oxygen atom in the formula; Y⁴ represents a single bond or a hydrocarbylene group having 1 to 30 carbon atoms and optionally having a heteroatom; k¹ and k² each independently represent 0 or 1, and when Y⁴ is a single bond, k¹ and k² are 0; R⁵¹ to R⁶⁸ each independently represent a halogen atom or a hydrocarbyl group having 1 to 25 carbon atoms and optionally having a heteroatom; R⁵¹ and R⁵² are optionally bonded to each other to form a ring together with a sulfur atom to which R⁵¹ and R⁵² are bonded; R⁵³ and R⁵⁴, R⁵⁶ and R⁵⁷, and R⁵⁹ and R⁶⁰ are optionally bonded to each other to form a ring together with a sulfur atom to which R⁵³ and R⁵⁴, R⁵⁶ and R⁵⁷, and R⁵⁹ and R⁶⁰ are respectively bonded; R^{HF} represents a hydrogen atom or a trifluoromethyl group; and Xa" represents a non-nucleophilic counter ion.

According to such a polymer, acid diffusion is suppressed to an appropriate degree, and a pattern having reduced LER can be obtained.

In addition, the present invention provides a chemically amplified positive resist composition comprising the above-described polymer.

Such a chemically amplified positive resist composition contains a polymer that makes it possible to form a resist film with which it is possible to form a pattern having extremely high isolated space resolution, small LER, and excellent rectangularity, effects of development loading and residue defects being suppressed, and the pattern having etching resistance and suppressed pattern collapse in the produced resist pattern.

The inventive chemically amplified positive resist composition preferably further comprises an organic solvent.

Such a chemically amplified positive resist composition has excellent workability.

The inventive chemically amplified positive resist composition preferably further comprises a photo-acid generator whose anion has a conjugate acid having acidity pKa of -2.0 or higher.

Such a chemically amplified positive resist composition catalyzes the deprotection reaction of the acid-labile groups of the polymer, so that favorable resolution can be achieved.

In this event, the photo-acid generator preferably contains an anion structure of a photo-acid generator represented by the following formula (M-1), 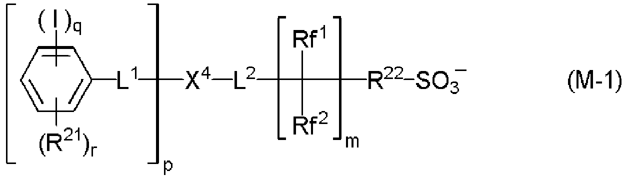 wherein "m" represents 0 or 1; "p" represents an integer of 1 to 3; "q" represents an integer of 1 to 5; "r" represents an integer of 0 to 3; L¹ represents a single bond, an ether bond, an ester bond, a sulfonic acid ester bond, a carbonate bond, or a carbamate bond; L² represents an ether bond, an ester bond, a sulfonic acid ester bond, a carbonate bond, or a carbamate bond; X⁴ represents a single bond or a hydrocarbylene group having 1 to 20 carbon atoms when "p" is 1, and represents a hydrocarbon group having a valency of p+1 and having 1 to 20 carbon atoms when "p" is 2 or 3, the hydrocarbylene group and the hydrocarbon group having a valency of p+1 optionally having at least one selected from an ether bond, a carbonyl group, an ester bond, an amide bond, a sultone ring, a lactam ring, a carbonate bond, a halogen atom, a hydroxy group, and a carboxy group; Rf¹ and Rf² each independently represent a hydrogen atom, a fluorine atom, or a trifluoromethyl group, provided that at least one is a fluorine atom or a trifluoromethyl group; R²¹ represents a hydroxy group, a carboxy group, a saturated hydrocarbyl group having 1 to 6 carbon atoms, a saturated hydrocarbyloxy group having 1 to 6 carbon atoms, a saturated hydrocarbylcarbonyloxy group having 2 to 6 carbon atoms, a fluorine atom, a chlorine atom, a bromine atom, an amino group, -N(R^{1A})-C(=O)-R^{1B}, or -N(R^{1A})-C(=O)-O-R^{1B}; R^{1A} represents a hydrogen atom or a saturated hydrocarbyl group having 1 to 6 carbon atoms; R^{1B} represents a saturated hydrocarbyl group having 1 to 6 carbon atoms or an unsaturated aliphatic hydrocarbyl group having 2 to 8 carbon atoms; and R²² represents a saturated hydrocarbylene group having 1 to 20 carbon atoms or an arylene group having 6 to 14 carbon atoms, a part or all of hydrogen atoms in the saturated hydrocarbylene group optionally being substituted with a halogen atom other than a fluorine atom, and a part or all of hydrogen atoms in the arylene group optionally being substituted with a substituent selected from a saturated hydrocarbyl group having 1 to 20 carbon atoms, a saturated hydrocarbyloxy group having 1 to 20 carbon atoms, an aryl group having 6 to 14 carbon atoms, a halogen atom, and a hydroxy group.

Such a chemically amplified positive resist composition can exhibit the above-described advantageous effects even more.

The inventive chemically amplified positive resist composition preferably further comprises a quencher.

According to such a chemically amplified positive resist composition, the diffusion rate of the acid in the resist film can be suppressed further, and the profile can be corrected.

The inventive chemically amplified positive resist composition preferably further comprises a fluorine-containing polymer having at least one selected from a repeating unit represented by the following formula (D1), a repeating unit represented by the following formula (D2), a repeating unit represented by the following formula (D3), and a repeating unit represented by the following formula (D4), 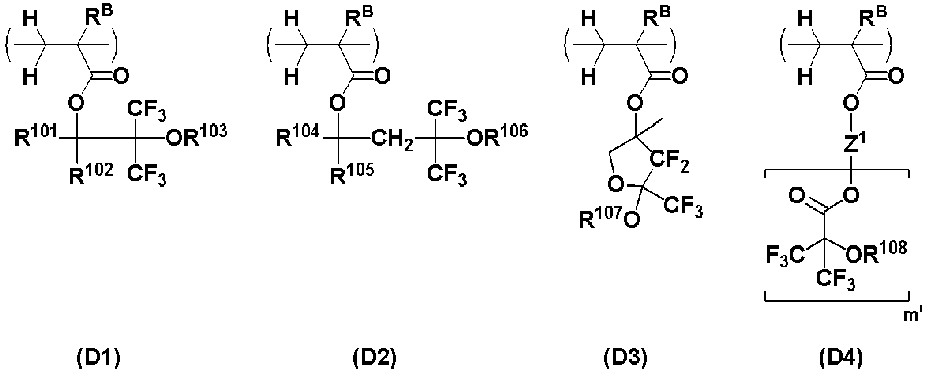 wherein each R^{B} independently represents a hydrogen atom, a fluorine atom, a methyl group, or a trifluoromethyl group; R¹⁰¹, R¹⁰², R¹⁰⁴, and R¹⁰⁵ each independently represents a hydrogen atom or a saturated hydrocarbyl group having 1 to 10 carbon atoms; R¹⁰³, R¹⁰⁶, R¹⁰⁷, and R¹⁰⁸ each independently represent a hydrogen atom, a hydrocarbyl group having 1 to 15 carbon atoms, a fluorinated hydrocarbyl group having 1 to 15 carbon atoms, or an acid-labile group, wherein R¹⁰³, R¹⁰⁶, R¹⁰⁷, and R¹⁰⁸ optionally have an intervening ether bond or carbonyl group in a carbon-carbon bond when each of R¹⁰³, R¹⁰⁶, R¹⁰⁷, and R¹⁰⁸ is a hydrocarbyl group or a fluorinated hydrocarbyl group; "m'" represents an integer of 1 to 3; and Z¹ represents a hydrocarbon group having a valency of m'+1 and having 1 to 20 carbon atoms or a fluorinated hydrocarbon group having a valency of m'+1 and having 1 to 20 carbon atoms.

Such a chemically amplified positive resist composition allows higher contrast, can prevent chemical flare of acid upon irradiation with a high-energy beam, can prevent mixing of acid from an antistatic film in the process of coating a resist film with an antistatic film material, and can suppress unexpected unnecessary pattern degradation.

In this event, the fluorine-containing polymer preferably further has at least one selected from a repeating unit represented by the following formula (D5) and a repeating unit represented by the following formula (D6), 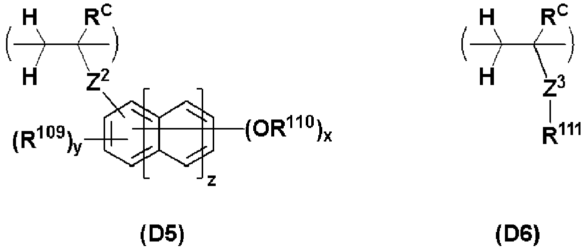 wherein each R^{C} independently represents a hydrogen atom or a methyl group; R¹⁰⁹ represents a hydrogen atom or a linear or branched hydrocarbyl group having 1 to 5 carbon atoms and optionally having, in a carbon-carbon bond, an intervening group containing a heteroatom; R¹¹⁰ represents a linear or branched hydrocarbyl group having 1 to 5 carbon atoms and optionally having, in a carbon-carbon bond, an intervening group containing a heteroatom; R¹¹¹ represents a saturated hydrocarbyl group having 1 to 20 carbon atoms, at least one hydrogen atom being substituted with a fluorine atom and a part of - CH₂- constituting the saturated hydrocarbyl group optionally being substituted with an ester bond or an ether bond; "x" represents an integer of 1 to 3; "y" represents an integer that satisfies 0 ≤ y ≤ 5+2z-x; "z" represents 0 or 1; Z² represents a single bond, *-C(=O)-O-, or *-C(=O)-NH-; Z³ represents a single bond, -O-, *-C(=O)-O-Z³¹-Z³²-, or *-C(=O)-NH-Z³²-Z³²-; Z³¹ represents a single bond or a saturated hydrocarbylene group having 1 to 10 carbon atoms; Z³² represents a single bond, an ester bond, an ether bond, or a sulfonamide bond; and "*" represents an attachment point to a carbon atom in the main chain.

Such a chemically amplified positive resist composition can exhibit the above-described advantageous effects further.

In the present invention, the polymer preferably has a dissolution rate of 10 nm/min or lower to an alkaline developer.

Such a chemically amplified positive resist composition makes it possible to form a fine pattern since the pattern does not collapse.

In the present invention, an unexposed portion of a resist film obtained from the chemically amplified positive resist composition preferably has a dissolution rate of 10 nm/min or lower to an alkaline developer.

Such a chemically amplified positive resist composition makes it possible to form a fine pattern since the pattern does not collapse.

In the present invention, an exposed portion of a resist film obtained from the chemically amplified positive resist composition preferably has a dissolution rate of 50 nm/sec or higher to an alkaline developer.

Such a chemically amplified positive resist composition can be dissolved in an alkaline developer uniformly even when there is variation in the pattern layout in a pattern of low and high densities, so that the fluctuation of line width can be reduced.

The present invention also provides a resist patterning process comprising the steps of:
forming a resist film on a substrate by using the above-described chemically amplified positive resist composition;
irradiating the resist film with a high-energy beam to form a pattern; and
developing, by using an alkaline developer, the resist film irradiated to form the pattern.

According to such a resist patterning process, it is possible to form a pattern having extremely high isolated space resolution, small LER, and excellent rectangularity, effects of development loading and residue defects can be suppressed, and the pattern has etching resistance and suppressed pattern collapse in the produced resist pattern.

In the present invention, the high-energy beam is preferably a KrF excimer laser beam, an ArF excimer laser beam, an electron beam, or an extreme ultraviolet ray having a wavelength of 3 to 15 nm.

Such a high-energy beam can be used in the inventive resist patterning process.

In the present invention, an uppermost surface of the substrate is preferably composed of a material containing at least one selected from chromium, silicon, tantalum, molybdenum, cobalt, nickel, tungsten, and tin.

The inventive resist patterning process is particularly useful for patterning a substrate having a surface of a material that is liable to cause pattern peel-off or pattern collapse.

In this event, a transmission type or reflective mask blank is preferably used as the substrate.

In the inventive resist patterning process, the above-described substrates can be used.

In addition, the present invention provides a transmission type or reflective mask blank, coated with the above-described chemically amplified positive resist composition.

Such a mask blank includes a chemically amplified positive resist composition containing a polymer that makes it possible to form a resist film with which it is possible to form a pattern having extremely high isolated space resolution, small LER, and excellent rectangularity, effects of development loading and residue defects being suppressed, and the pattern having etching resistance and suppressed pattern collapse in the produced resist pattern.

### ADVANTAGEOUS EFFECTS OF INVENTION

A chemically amplified positive resist composition containing the inventive polymer makes it possible to form a pattern having high resolution, small LER, and a profile having excellent rectangularity after exposure, and a pattern in which the influence of residue defects is suppressed. Such a chemically amplified positive resist composition is suitable for forming a resist film sensitive to an electron beam used for processing a semiconductor, a photomask blank, etc. Meanwhile, according to a patterning process using the inventive chemically amplified positive resist composition, it is possible to form a pattern having high resolution while having etching resistance and reduced LER and a pattern in which the influence of residue defects are suppressed. Therefore, the patterning process can be employed suitably in fine processing techniques, especially EUV lithography and EB lithography.

### DESCRIPTION OF EMBODIMENTS

As described above, there has been desired the development of: a polymer that makes it possible to form a resist film with which it is possible to form a pattern having extremely high isolated space resolution, small LER, and excellent rectangularity, effects of development loading and residue defects being suppressed, and the pattern having etching resistance and suppressed pattern collapse in the produced resist pattern; a chemically amplified positive resist composition containing the polymer; a resist patterning process using the chemically amplified positive resist composition; and a mask blank including the chemically amplified positive resist composition.

To achieve the object, the present inventors have studied earnestly and found out that it is possible to obtain a pattern that exhibits excellent isolated space resolution, pattern profile, and LER and has suppressed effects of development loading and residue defects even in a high-dose region by using a resist composition containing a polymer having an acetal type acid-labile group that has a particular structure. Thus, the present invention has been completed.

That is, the present invention is a polymer comprising a structural unit comprising an aromatic hydroxy group bonded to a main chain, wherein the aromatic hydroxy group is protected by an acid-labile group represented by the following formula (ALU-1) and is deprotected by action of an acid to become alkali-soluble, 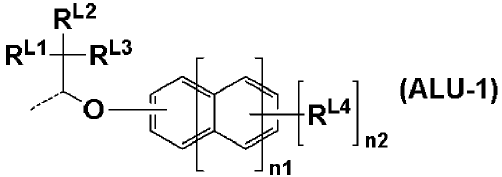 wherein R^{L1} to R^{L3} each independently represent a hydrogen atom or a hydrocarbyl group having 1 to 6 carbon atoms and do not have an aromatic ring structure, any two of R^{L1} to R^{L3} optionally being bonded to each other to form a cyclic structure together with a carbon atom to which R^{L1} to R^{L3} are bonded; R^{L4} represents a hydrogen atom, a halogen atom, a nitro group, or a hydrocarbyl group having 1 to 6 carbon atoms and optionally having a heteroatom; n1 represents an integer of 0 or 1; when n1 is 0, n2 represents an integer of 0 to 5 and when n1 is 1, n2 represents an integer of 0 to 7; and a broken line represents a bond with an oxygen atom of the aromatic hydroxy group of the unit comprising the aromatic hydroxy group bonded to the main chain of the polymer.

Hereinafter, the present invention will be described in detail. Note that in the following description, some structures shown by chemical formulae contain an asymmetric carbon, thus including an enantiomer and a diastereomer. In this case, these isomers are collectively shown by one formula. One kind of the isomers may be used or the isomers may be used in combination.

### [Polymer]

In the inventive polymer, a structural unit includes an aromatic hydroxy group bonded to a main chain, the aromatic hydroxy group being protected by an acid-labile group represented by the following formula (ALU-1) and being deprotected by action of an acid to become alkali-soluble.

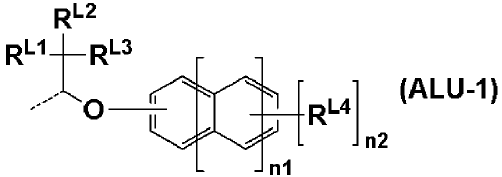

In the formula (ALU-1), R^{L1} to R^{L3} each independently represent a hydrogen atom or a hydrocarbyl group having 1 to 6 carbon atoms and do not have an aromatic ring structure. Any two of R^{L1} to R^{L3} are optionally bonded to each other to form a cyclic structure together with a carbon atom to which R^{L1} to R^{L3} are bonded. R^{L4} represents a hydrogen atom, a halogen atom, a nitro group, or a hydrocarbyl group having 1 to 6 carbon atoms and optionally having a heteroatom. n1 represents an integer of 0 or 1. When n1 is 0, n2 represents an integer of 0 to 5 and when n1 is 1, n2 represents an integer of 0 to 7. A broken line represents a bond with an oxygen atom of the aromatic hydroxy group of the unit comprising the aromatic hydroxy group bonded to the main chain of the polymer.

In the formula (ALU-1), R^{L1} to R^{L3} each independently represent a hydrogen atom or a hydrocarbyl group having 1 to 6 carbon atoms and do not contain an aromatic ring structure. The hydrocarbyl group may be saturated or unsaturated, and may be linear, branched, or cyclic. Specific examples thereof include: alkyl groups having 1 to 6 carbon atoms, such as a methyl group, an ethyl group, an n-propyl group, an isopropyl group, an n-butyl group, and a tert-butyl group; cyclic saturated hydrocarbyl groups having 3 to 6 carbon atoms, such as a cyclopropyl group, a cyclopentyl group, a cyclohexyl group, and a cyclopropylmethyl group; alkenyl groups having 2 to 6 carbon atoms, such as a vinyl group, an allyl group, a propenyl group, a butenyl group, and a hexenyl group; and cyclic unsaturated hydrocarbyl groups having 3 to 6 carbon atoms, such as a cyclohexenyl group. However, the hydrocarbyl group is not limited thereto.

Any two of R^{L1} to R^{L3} may be bonded to each other to form a ring structure together with the carbon atom bonded thereto. Specific examples of the ring structure include a cyclopropyl group, a cyclobutyl group, a cyclopentyl group, and a cyclohexyl group, but are not limited thereto.

R^{L1} to R^{L3} are selected appropriately in accordance with design of the group decomposable by an acid. For example, a hydrogen atom is selected in design including decomposition by a strong acid while securing relatively high stability, and a linear alkyl group is selected in design using relatively high reactivity for higher sensitivity to pH and suppression of residue defects. Examples include a methyl group, an ethyl group, a propyl group, and an isopropyl group. When R^{L1} to R^{L3} form a ring, examples include a cyclopentyl group and a cyclohexyl group. A methyl group, which has the optimum acid elimination ability, is more preferable.

In the acetal structure constituted by the formula (ALU-1), the carbon atom between R^{L1} to R^{L3} is preferably secondary in view of the stability of the polymer and reactivity with acid. When the carbon atom between R^{L1} to R^{L3} is secondary, reactivity is of appropriate level and stability is favorable compared to when the carbon atom between R^{L1} to R^{L3} is primary, and reactivity is good and reaction contrast is enhanced compared to when the carbon atom between R^{L1} to R^{L3} is tertiary.

R^{L4} represents a hydrogen atom, a halogen atom, a nitro group, or a hydrocarbyl group having 1 to 6 carbon atoms and optionally having a heteroatom. Examples of the halogen atom include a fluorine atom, a chlorine atom, a bromine atom, and an iodine atom.

Specific examples of the hydrocarbyl group include those given as examples of the above R^{L1} to R^{L3}, but are not limited thereto. In addition, some or all of the hydrogen atoms of the hydrocarbyl group may be substituted with a group containing a heteroatom, such as an oxygen atom, a sulfur atom, a nitrogen atom, or a halogen atom, while some -CH₂- contained in the hydrocarbyl group may be substituted with a group containing a heteroatom such as an oxygen atom, a sulfur atom, or a nitrogen atom. Thus, the resulting hydrocarbyl group may contain a hydroxy group, an alkoxy group, a thioalkoxy group, a fluorine-containing alkyl group, a fluorine-containing alkoxy group, a fluorine-containing thioalkoxy group, a cyano group, a fluorine atom, a chlorine atom, a bromine atom, an iodine atom, a carbonyl group, an ether bond, an ester bond, a sulfonic acid ester bond, a carbonate bond, a lactone ring, a sultone ring, a carboxylic anhydride, a haloalkyl group, etc.

In the formula (ALU-1), n1 represents an integer of 0 or 1. When n1=0, a benzene ring is indicated, and when n1=1, a naphthalene ring is indicated. From the viewpoints of the availability of raw materials and the solubility of the deprotected product to an alkaline developer, a benzene ring, where n1=0, is preferable.

In the formula (ALU-1), n2 represents an integer of 0 to 5 when n1 is 0, and represents an integer of 0 to 7 when n1 is 1.

Specific examples of the formula (ALU-1) include the following, but are not limited thereto. A broken line represents a bond with an oxygen atom of the aromatic hydroxy group of the unit having the aromatic hydroxy group bonded to the main chain of the polymer.

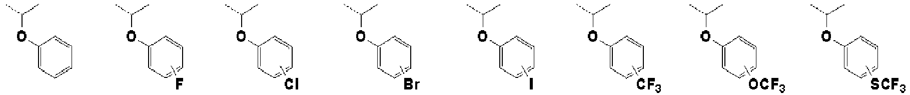

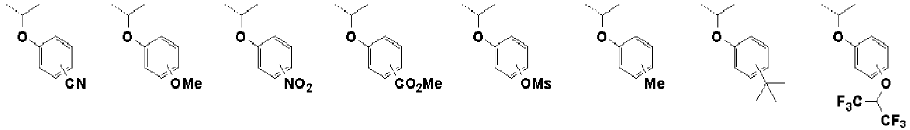

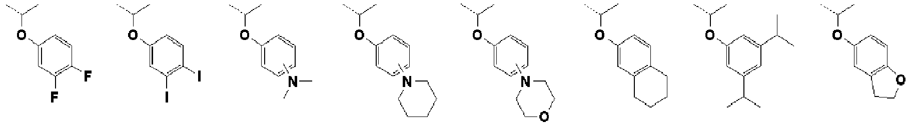

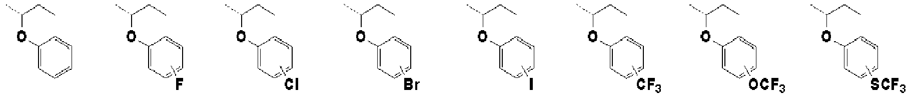

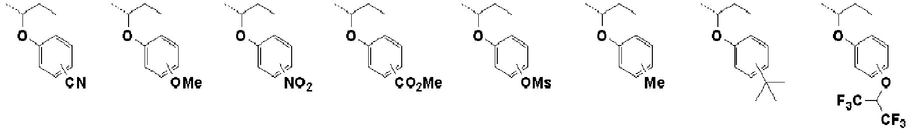

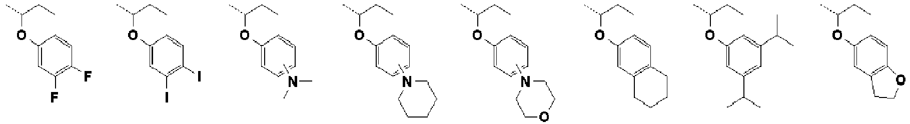

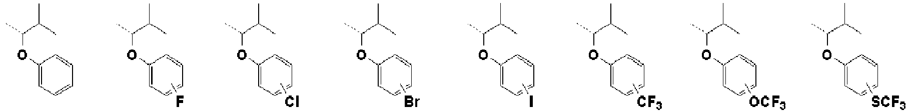

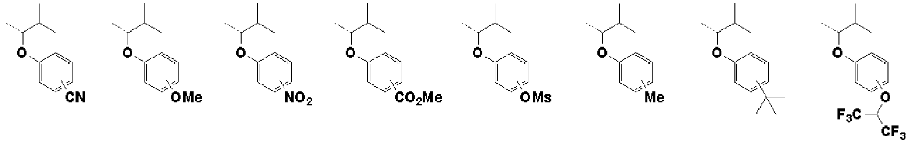

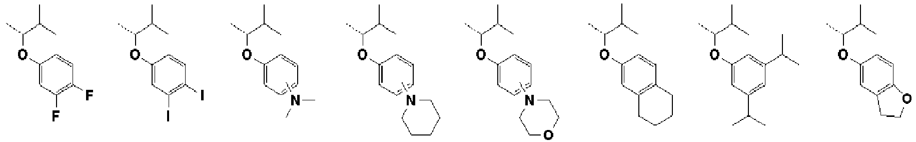

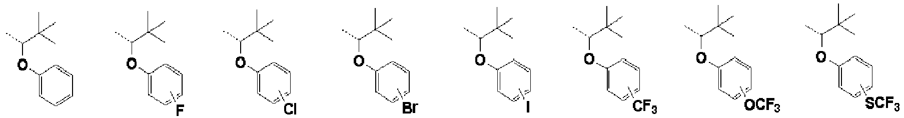

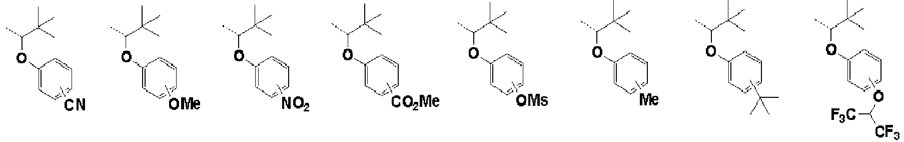

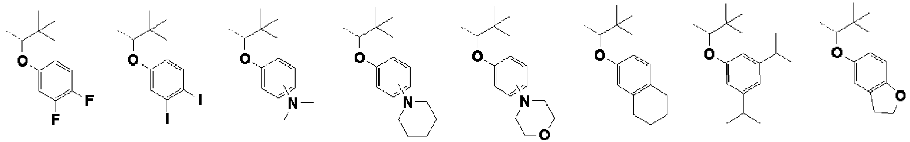

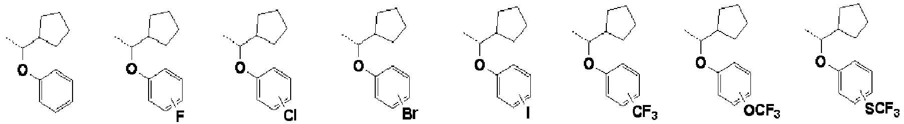

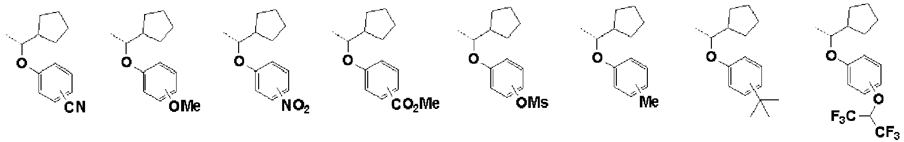

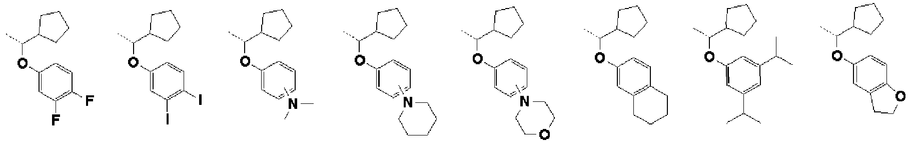

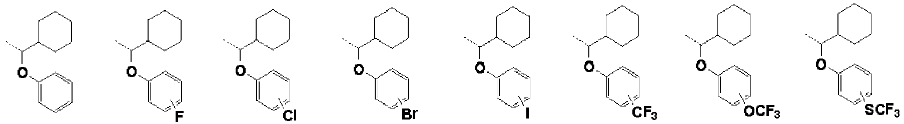

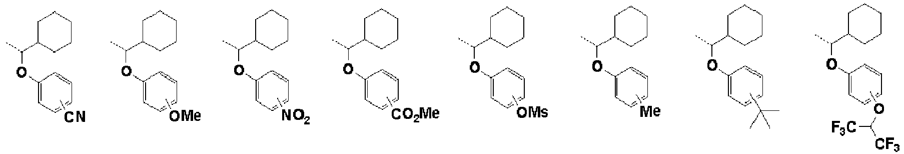

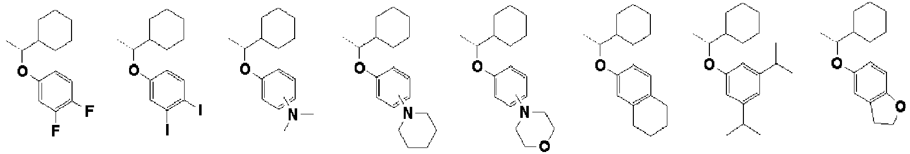

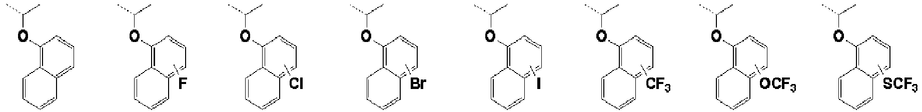

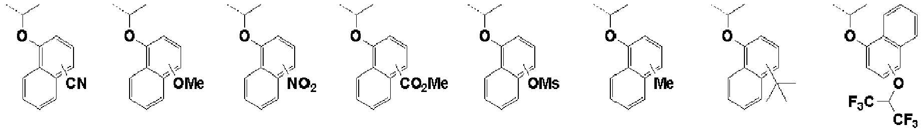

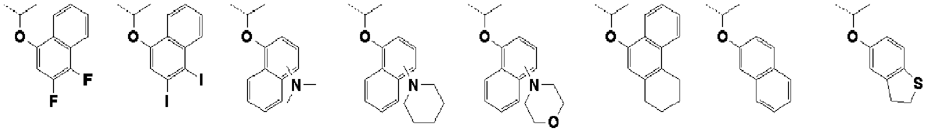

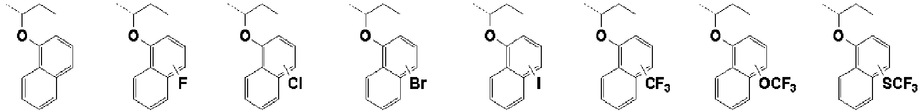

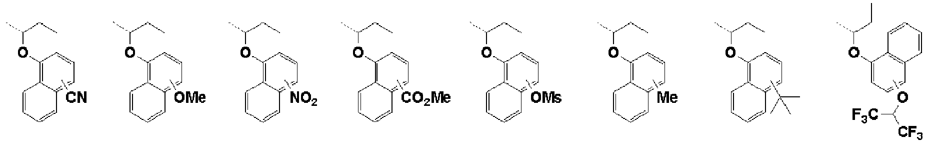

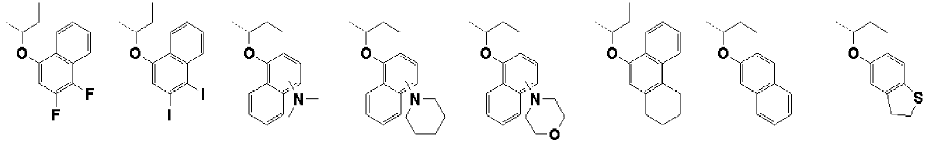

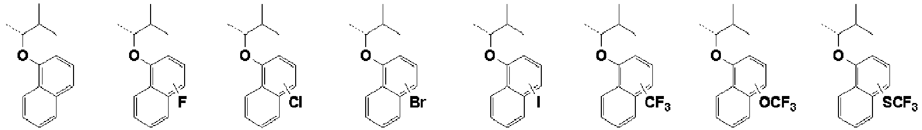

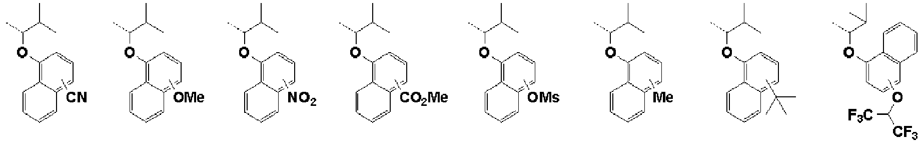

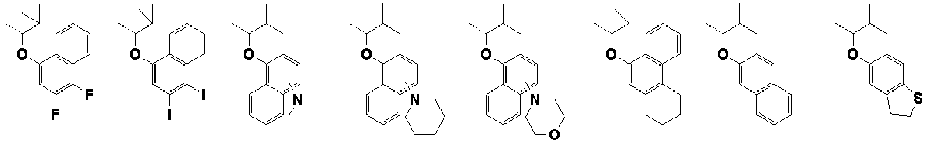

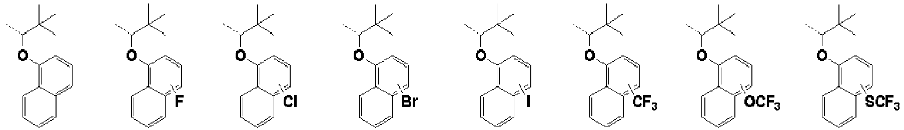

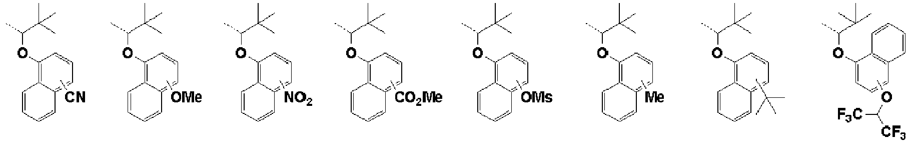

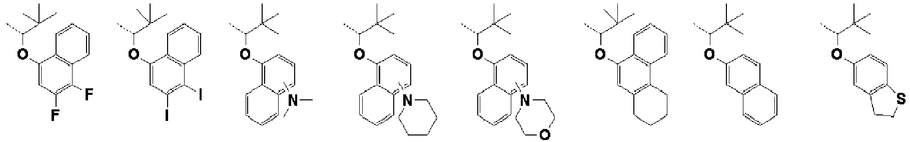

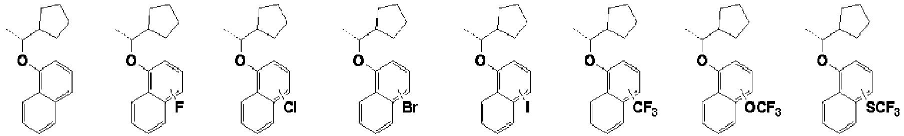

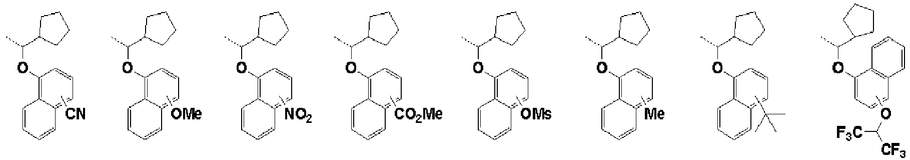

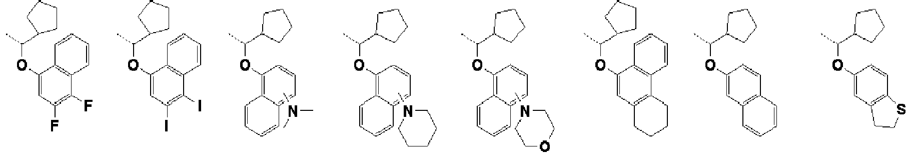

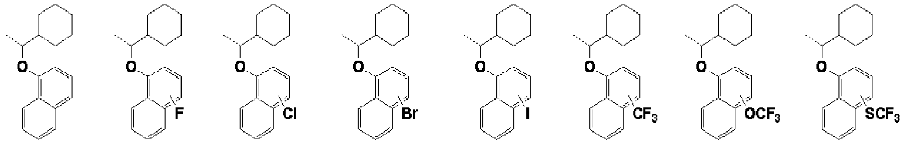

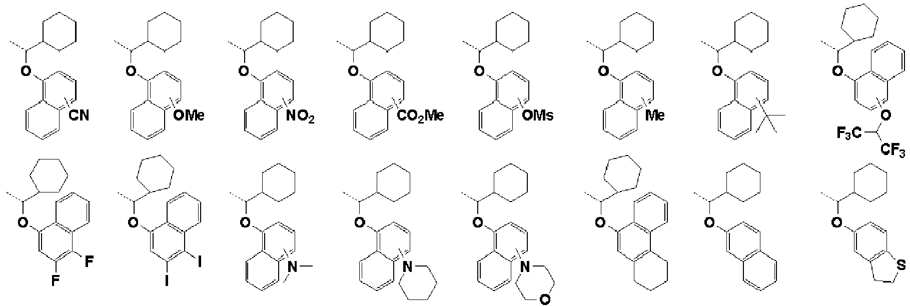

The main factor that makes it possible to achieve high resolution by an aromatic acetal type acid-labile group contained in the inventive polymer is as follows. In an exposed portion, the aromatic alcohol component generated after the deprotection reaction has high solubility in an alkaline developer, so that the residual component after the development is reduced. Meanwhile, in an unexposed portion, the aromatic rings in the polymer main chain and the aromatic rings in the aromatic acetal type acid-labile group are arranged regularly due to a stacking effect, so that rigidity is enhanced, and collapse resistance to developers is exhibited. Thus, the contrast between the exposed portion and the unexposed portion is enhanced. By the synergistic effect of the above, the inventive polymer works advantageously in mask processing in generations of 10 nm or finer.

The unit containing the aromatic hydroxy group bonded to the main chain of the polymer, the unit being modified by the formula (ALU-1), is preferably a repeating unit A1 represented by the following formula (A1) .

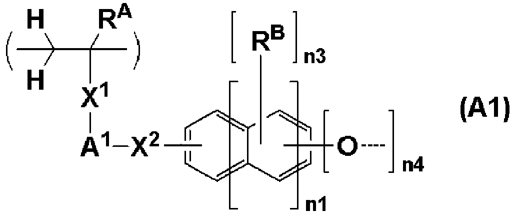

In the formula (A1), each R^{A} independently represents a hydrogen atom, a fluorine atom, a methyl group, or a trifluoromethyl group. X¹ represents a single bond, *-C(=O)-O-, or *-C(=O)-NH-. "*" represents an attachment point to a carbon atom in the main chain. A¹ represents a single bond or a saturated hydrocarbylene group having 1 to 10 carbon atoms, a part of -CH₂-constituting the saturated hydrocarbylene group optionally being substituted with -O-. X² represents a single bond, an ether bond, an ester bond, a carbonyl group, a sulfonic acid ester bond, a carbonate bond, or a carbamate bond. R^{B} represents a halogen atom or a linear, branched, or cyclic hydrocarbyl group having 1 to 20 carbon atoms and optionally having a heteroatom. n1 is as defined above. n3 represents an integer of 0 to 4 when n1 is 0 and represents an integer of 0 to 6 when n1 is 1. n4 represents an integer of 1 to 3, provided that when n1 is 0, n3+n4 ≤ 5 and when n1 is 1, n3+n4 ≤ 7. A broken line represents a bond with the formula (ALU-1).

In the formula (A1), each R^{A} independently represents a hydrogen atom, a fluorine atom, a methyl group, or a trifluoromethyl group.

In the formula (A1), X¹ represents a single bond, *-C(=O)-O-, or *-C(=O)-NH-. "*" represents an attachment point to a carbon atom in the main chain.

In the formula (A1), A¹ represents a single bond or a saturated hydrocarbylene group having 1 to 10 carbon atoms, a part of -CH₂- constituting the saturated hydrocarbylene group optionally being substituted with - O-. The saturated hydrocarbylene group may be linear, branched, or cyclic, and specific examples thereof include: alkanediyl groups having 1 to 10 carbon atoms, such as a methylene group, an ethane-1,2-diyl group, a propane-1,3-diyl group, a butane-1,4-diyl group, a pentane-1,5-diyl group, a hexane-1,6-diyl group, and structural isomers thereof; cyclic saturated hydrocarbylene groups having 3 to 10 carbon atoms, such as a cyclopropanediyl group, a cyclobutanediyl group, a cyclopentanediyl group, and a cyclohexanediyl group; and groups obtained by combining these groups.

In the formula (A1), X² represents a single bond, an ether bond, an ester bond, a carbonyl group, a sulfonic acid ester bond, a carbonate bond, or a carbamate bond. In particular, a single bond, an ether bond, and an ester bond are preferable, and a single bond and an ester bond are further preferable.

In the formula (A1), R^{B} represents a halogen atom or a linear, branched, or cyclic hydrocarbyl group having 1 to 20 carbon atoms and optionally having a heteroatom. Specific examples thereof include: alkyl groups having 1 to 20 carbon atoms, such as a methyl group, an ethyl group, an n-propyl group, an isopropyl group, an n-butyl group, and a tert-butyl group; cyclic saturated hydrocarbyl groups having 3 to 20 carbon atoms, such as a cyclopropyl group, a cyclopentyl group, a cyclohexyl group, a cyclopropylmethyl group, a 4-methylcyclohexyl group, a cyclohexylmethyl group, a norbornyl group, and an adamantyl group; alkenyl groups having 2 to 20 carbon atoms, such as a vinyl group, an allyl group, a propenyl group, a butenyl group, and a hexenyl group; cyclic unsaturated hydrocarbyl groups having 3 to 20 carbon atoms, such as a cyclohexenyl group; aryl groups having 6 to 20 carbon atoms, such as a phenyl group and a naphthyl group; aralkyl groups having 7 to 20 carbon atoms, such as a benzyl group, a 1-phenylethyl group, and a 2-phenylethyl group; and groups obtained by combining these groups. In particular, aryl groups are preferable. In addition, some or all of the hydrogen atoms of the hydrocarbyl group may be substituted with a group containing a heteroatom, such as an oxygen atom, a sulfur atom, a nitrogen atom, or a halogen atom, while some -CH₂-contained in the hydrocarbyl group may be substituted with a group containing a heteroatom such as an oxygen atom, a sulfur atom, or a nitrogen atom. Thus, the resulting hydrocarbyl group may contain a hydroxy group, a cyano group, a fluorine atom, a chlorine atom, a bromine atom, an iodine atom, a carbonyl group, an ether bond, an ester bond, a sulfonic acid ester bond, a carbonate bond, a lactone ring, a sultone ring, a carboxylic anhydride, a haloalkyl group, etc.

In the formula (A1), n1 represents an integer of 0 or 1.

In the formula (A1), n3 represents an integer of 0 to 4 when n1 is 0 and represents an integer of 0 to 6 when n1 is 1.

In the formula (A1), n4 represents an integer of 1 to 3, provided that when n1 is 0, n3+n4 ≤ 5 and when n1 is 1, n3+n4 ≤ 7.

Specific examples of the formula (A1) include the following, but are not limited thereto. A broken line represents a bond with the formula (ALU-1).

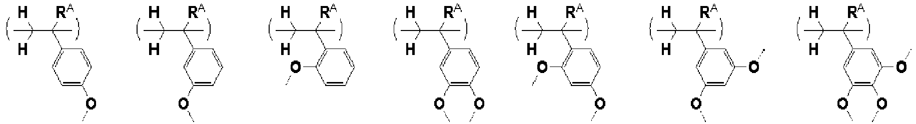

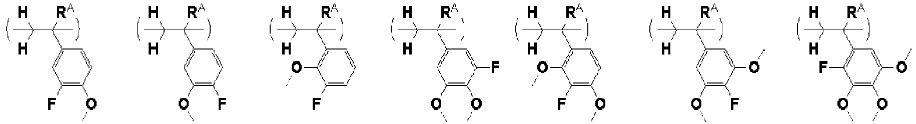

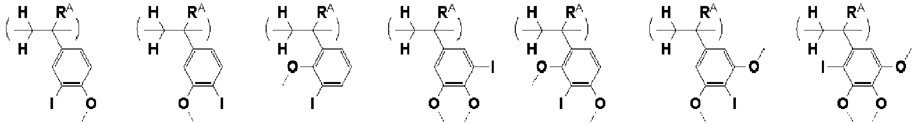

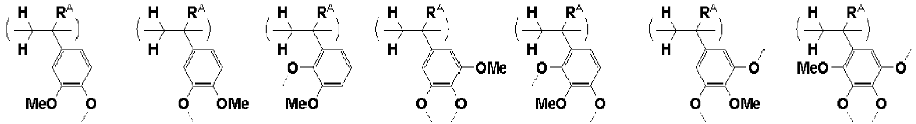

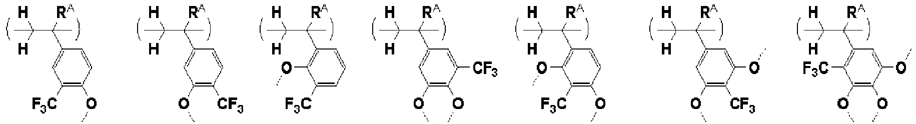

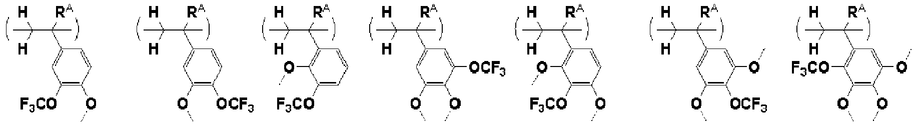

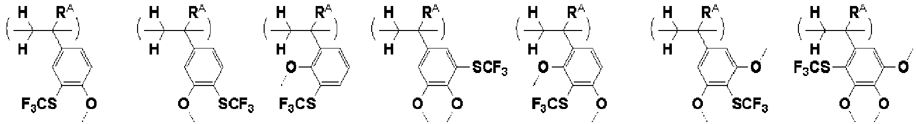

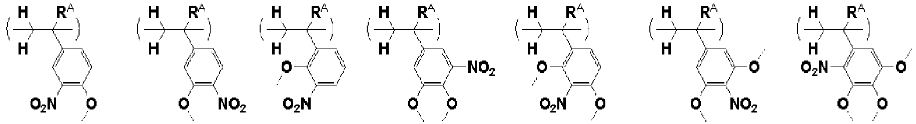

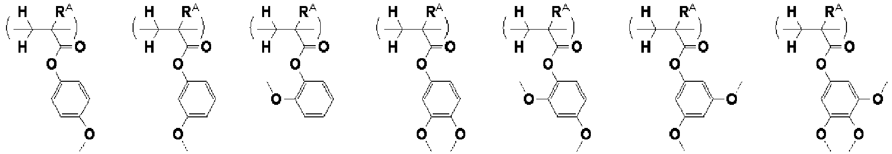

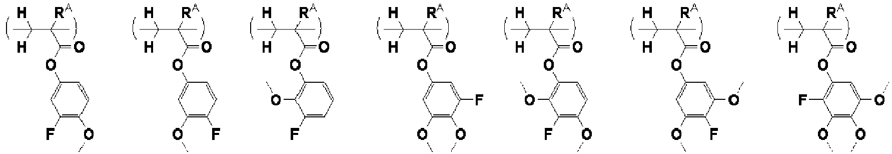

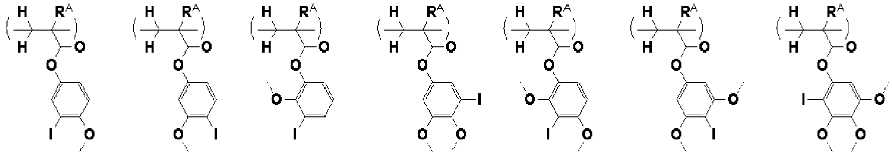

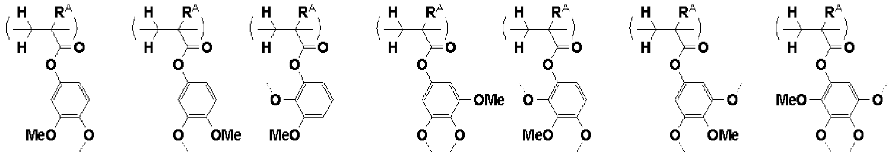

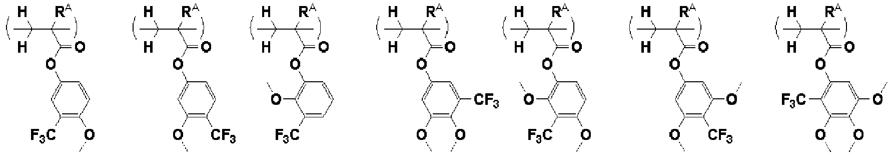

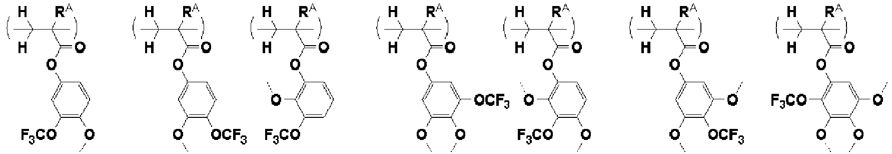

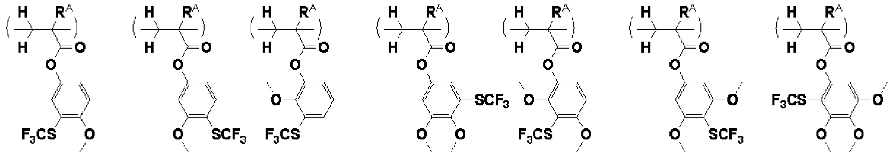

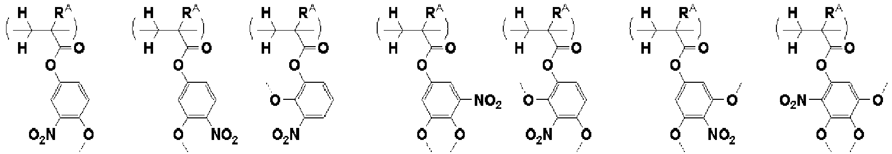

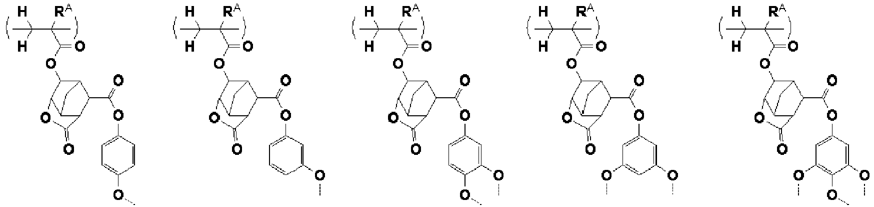

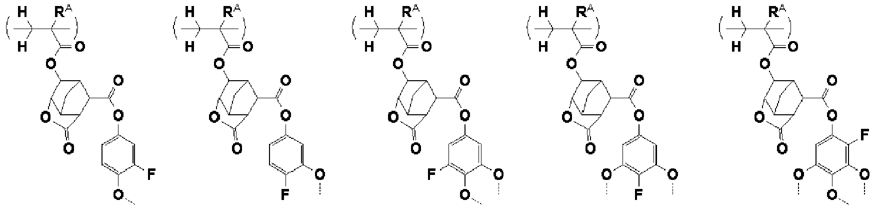

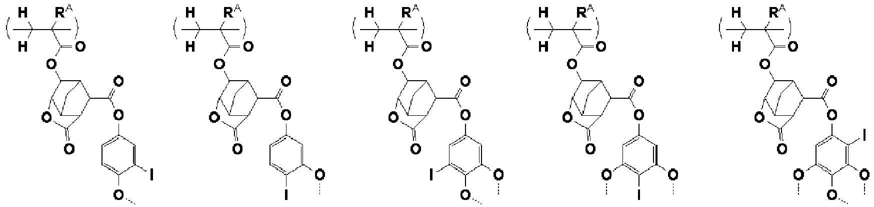

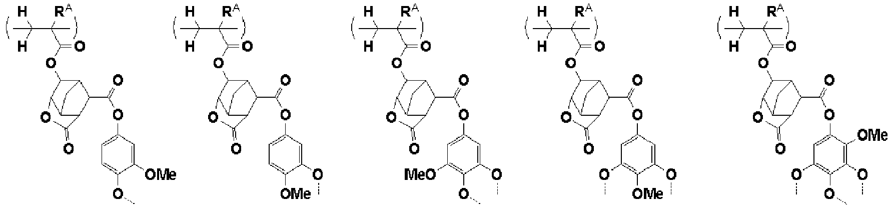

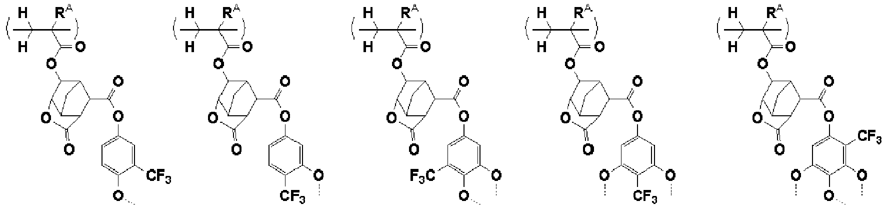

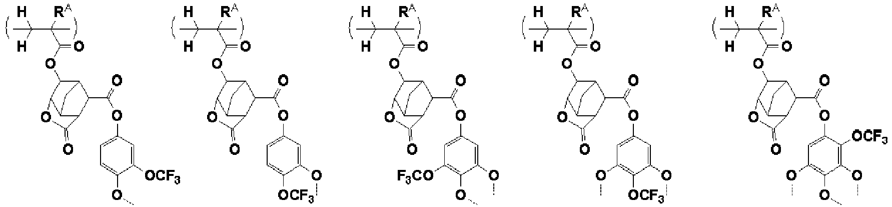

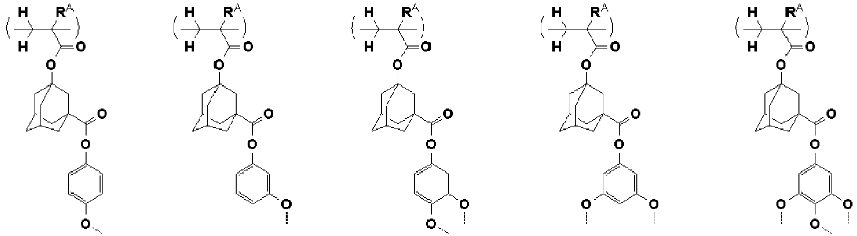

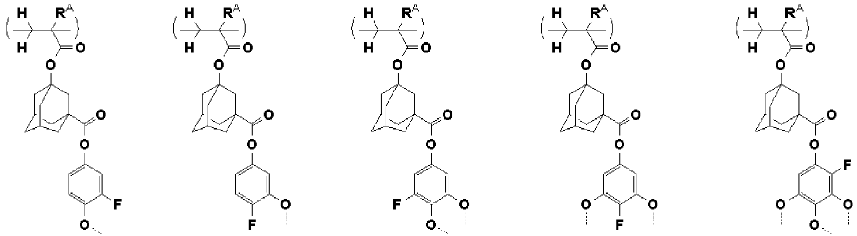

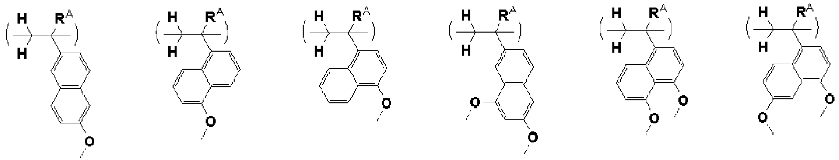

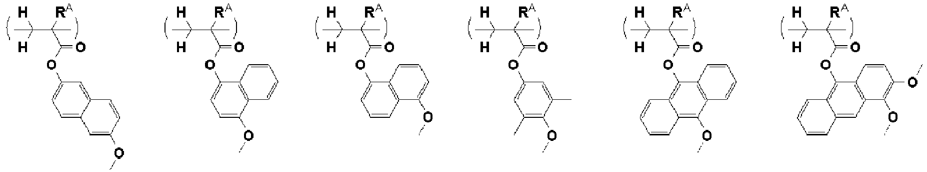

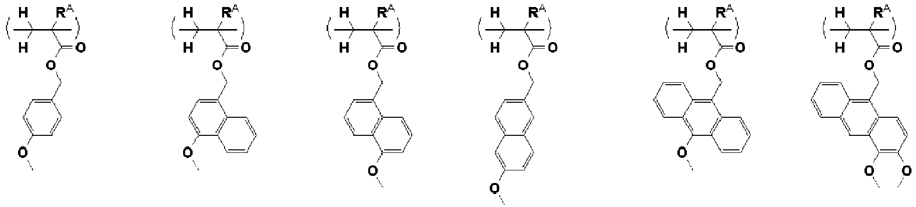

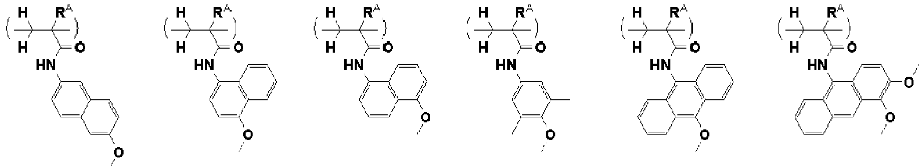

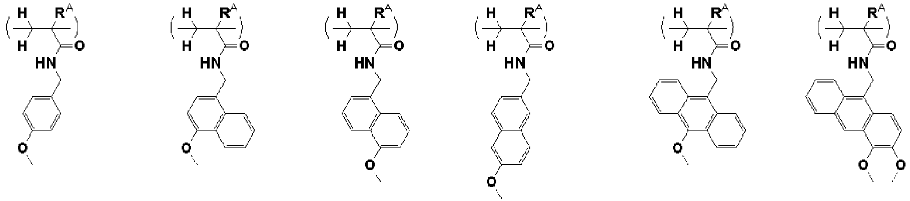

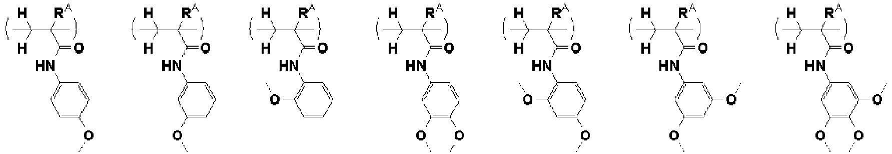

As methods for protecting the polymer with an acetal type acid-labile group after polymerization, known methods include: a method using vinyl ether and an acid catalyst; and a method of using an acetalizing agent having a haloalkoxy group together with a base. Here, either method can be employed.

For example, in the case of the method using vinyl ether and an acid catalyst, examples of the acid catalyst to be used in the reaction include methanesulfonic acid, trifluoroacetic acid, oxalic acid, pyridine methanesulfonate, etc. The reaction temperature is preferably 5°C to 30°C, and the reaction time can be 0.2 to 10 hours, preferably 0.5 to 6 hours.

As the method of using an acetalizing agent having a haloalkoxy group together with a base, there is a method of adding dropwise an acetalizing agent having a haloalkoxy group in the presence of a basic compound such as triethylamine. The reaction temperature at this time can be -20 to 50°C, and the reaction time can be 0.2 to 10 hours, preferably 0.5 to 6 hours.

However, in a method of using an acetalizing agent having a haloalkoxy group together with a base, a strong corrosive acid, such as hydrochloric acid, is generated. The acid corrodes metallic production vessel and piping, and there is a risk of a semiconductor product being contaminated with a metal component that causes defects. Therefore, particularly in advanced generations, the method using vinyl ether and an acid catalyst is preferable, since metal impurities in raw materials to be used in a resist composition are required to be 10 ppb or less.

The repeating unit protected by the acetal type acid-labile group is preferably introduced in the range of 10 to 40 mol% of all the repeating units of the polymer contained in the chemically amplified positive resist composition described below, more preferably 10 to 35 mol%, further preferably 20 to 30 mol%.

As the design of the chemically amplified positive resist composition, it is also possible to mix a known polymer having an acid-labile group protected by a tertiary alkyl group or a tert-butoxycarbonyl group besides the polymer having the acid-labile group protected by the acetal group shown in the present invention. However, for the advantageous effects of the present invention to be exhibited, the proportion of the polymer having the acid-labile group protected by the acetal group shown in the present invention is preferably 30% or more of all the polymers contained in the chemically amplified positive resist composition.

Since the acetal type acid-labile group contained in the inventive polymer also has an effect of suppressing the influence of back scattering at the time of electron-beam writing, the pattern profile exhibits rectangularity and does not become reverse-tapered in regions of sensitivity to 50 µC or more, preferably 80 µC or more, more preferably 100 µC or more.

The inventive polymer preferably contains a repeating unit represented by a phenolic hydroxy group-containing repeating unit A2 in addition to the repeating unit A1 in which an aromatic hydroxy group is protected by (ALU-1).

The repeating unit A2 is represented by the following formula (A2). A polymer having such a repeating unit can ensure an appropriate dissolution rate in an alkaline developer.

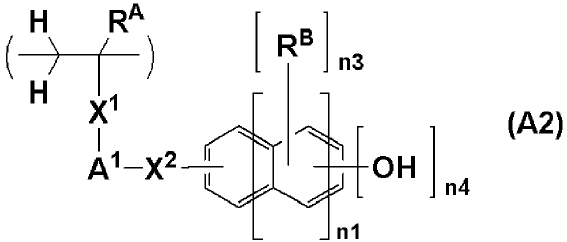

In the formula (A2), each R^{A} independently represents a hydrogen atom, a fluorine atom, a methyl group, or a trifluoromethyl group. X¹ represents a single bond, *-C(=O)-O-, or *-C(=O)-NH-. "*" represents an attachment point to a carbon atom in the main chain. A¹ represents a single bond or a saturated hydrocarbylene group having 1 to 10 carbon atoms, a part of -CH₂-constituting the saturated hydrocarbylene group optionally being substituted with -O-. X² represents a single bond, an ether bond, an ester bond, a carbonyl group, a sulfonic acid ester bond, a carbonate bond, or a carbamate bond. R^{B} represents a halogen atom or a linear, branched, or cyclic hydrocarbyl group having 1 to 20 carbon atoms and optionally having a heteroatom. n1 is as defined above. n3 represents an integer of 0 to 4 when n1 is 0 and represents an integer of 0 to 6 when n1 is 1. n4 represents an integer of 1 to 3, provided that when n1 is 0, n3+n4 ≤ 5 and when n1 is 1, n3+n4 ≤ 7.

In the formula (A2), R^{A}, X¹, X², A¹, R^{B}, n1, n3, and n4 are as defined above.

When X¹ and A¹ both represent a single bond, preferable examples of the repeating unit A2 include units derived from 3-hydroxystyrene, 4-hydroxystyrene, 5-hydroxy-2-vinylnaphthalene, 6-hydroxy-2-vinylnaphthalene, etc. In particular, repeating units represented by the following formula (A2-1) etc. are more preferable.

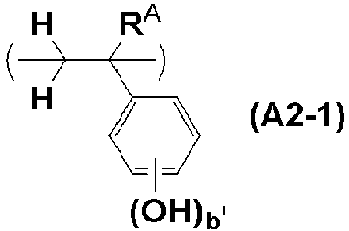

In the formula (A2-1), R^{A} is as defined above. "b'" represents an integer of 1 to 3.

When X¹ is not a single bond, preferable examples of the repeating unit A2 include the formula (A1) where the broken line is a hydrogen atom, but the repeating unit A2 is not limited thereto.

The repeating unit A2 is preferably contained in an amount of 30 to 90 mol%, preferably 40 to 85 mol% with respect to all the repeating units of the polymer. Here, when at least one out of a repeating unit B1 represented by the formula (B1) and a repeating unit B2 represented by the formula (B2) is contained for providing the polymer with higher etching resistance as described below, and when the unit has a phenolic hydroxy group as a substituent, repeating unit A2 is preferably contained in the above proportion with the amount of the repeating unit B1 and/or B2 taken into account. One kind of the repeating unit A2 may be used, or two or more kinds may be used in combination.

The polymer preferably further contains one or more selected from a repeating unit B1 represented by the following formula (B1), a repeating unit B2 represented by the following formula (B2), and a repeating unit B3 represented by the following formula (B3).

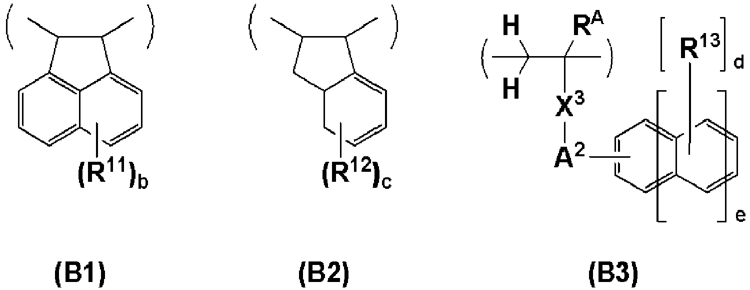

In the formulae, each R^{A} independently represents a hydrogen atom, a fluorine atom, a methyl group, or a trifluoromethyl group. "b" and "c" each independently represent an integer of 0 to 4. "d" represents an integer of 0 to 5. "e" represents an integer of 0 to 2. X³ represents a single bond, *-C(=O)-O-, or *-C(=O)-NH-. "*" represents an attachment point to a carbon atom in the main chain. A² represents a single bond or a saturated hydrocarbylene group having 1 to 10 carbon atoms, a part of -CH₂- constituting the saturated hydrocarbylene group optionally being substituted with - O-. R¹¹ and R¹² each independently represent a hydroxy group, a halogen atom, a saturated hydrocarbylcarbonyloxy group having 2 to 8 carbon atoms optionally substituted with a halogen atom, a saturated hydrocarbyl group having 1 to 8 carbon atoms optionally substituted with a halogen atom, or a saturated hydrocarbyloxy group having 1 to 8 carbon atoms optionally substituted with a halogen atom. R¹³ represents an acetyl group, a saturated hydrocarbyl group having 1 to 20 carbon atoms, a saturated hydrocarbyloxy group having 1 to 20 carbon atoms, a saturated hydrocarbylcarbonyloxy group having 2 to 20 carbon atoms, a saturated hydrocarbyloxyhydrocarbyl group having 2 to 20 carbon atoms, a saturated hydrocarbylthiohydrocarbyl group having 2 to 20 carbon atoms, a halogen atom, a nitro group, or a cyano group, and when "e" is 1 or 2, R¹³ optionally represents a hydroxy group.

In the formulae (B1) and (B2), "b" and "c" each independently represent an integer of 0 to 4.

In the formulae (B1) and (B2), R¹¹ and R¹² each independently represent a hydroxy group, a halogen atom, a saturated hydrocarbylcarbonyloxy group having 2 to 8 carbon atoms optionally substituted with a halogen atom, a saturated hydrocarbyl group having 1 to 8 carbon atoms optionally substituted with a halogen atom, or a saturated hydrocarbyloxy group having 1 to 8 carbon atoms optionally substituted with a halogen atom. The saturated hydrocarbyl group, the saturated hydrocarbyloxy group, and the saturated hydrocarbylcarbonyloxy group may be linear, branched, or cyclic. When "b" is 2 or more, the R¹¹s may be identical to or different from one another. When "c" is 2 or more, the R¹²s may be identical to or different from one another.

In the formula (B3), R^{A} is as defined above. "d" represents an integer of 0 to 5. "e" represents an integer of 0 to 2.

In the formula (B3), R¹³ represents an acetyl group, a saturated hydrocarbyl group having 1 to 20 carbon atoms, a saturated hydrocarbyloxy group having 1 to 20 carbon atoms, a saturated hydrocarbylcarbonyloxy group having 2 to 20 carbon atoms, a saturated hydrocarbyloxyhydrocarbyl group having 2 to 20 carbon atoms, a saturated hydrocarbylthiohydrocarbyl group having 2 to 20 carbon atoms, a halogen atom, a nitro group, or a cyano group, and when "e" is 1 or 2, R¹³ optionally represents a hydroxy group. The saturated hydrocarbyl group, the saturated hydrocarbyloxy group, the saturated hydrocarbylcarbonyloxy group, the saturated hydrocarbyloxyhydrocarbyl group, and the saturated hydrocarbylthiohydrocarbyl group may be linear, branched, or cyclic. When "d" is 2 or more, the R¹¹s may be identical to or different from one another.

In the formula (B3), X³ represents a single bond, *-C(=O)-O-, or *-C(=O)-NH-. "*" represents an attachment point to a carbon atom in the main chain.

In the formula (B3), A² represents a single bond or a saturated hydrocarbylene group having 1 to 10 carbon atoms, a part of -CH₂- constituting the saturated hydrocarbylene group optionally being substituted with - O-. The saturated hydrocarbylene group may be linear, branched, or cyclic, and specific examples thereof include the groups given as examples in the description of A¹ in the formula (A1).

When the repeating units B1 to B3 are used, it is possible to achieve, in addition to the etching resistance provided by aromatic rings, the advantageous effect of enhancing EB irradiation resistance at the time of etching and pattern inspection by a ring structure being added to the main chain.

To achieve the effect of improving etching durability, the repeating units B1 to B3 are preferably contained in an amount of 5 mol% or more with respect to all the repeating units of the polymer. Furthermore, the repeating units B1 to B3 are preferably contained in an amount of 25 mol% or less, more preferably 20 mol% or less with respect to all the repeating units constituting the polymer. The contained amount is preferably 25 mol% or less when no functional groups are contained or when the functional group is not a hydroxy group, since there is no risk of development defects being generated in this range. One kind of the repeating units B1 to B3 may be used, or two or more kinds thereof may be used in combination.

The contained amount of the repeating unit A2 and at least one selected from the repeating units B1 to B3 is preferably 50 mol% or more, further preferably 60 mol% or more of all the repeating units of the polymer.

The inventive polymer preferably further contains a repeating unit represented by the following formula (A3-1) and/or the following formula (A3-2). The polymer may contain the repeating unit A1, the repeating unit A2, a repeating unit A3-1 represented by the following formula (A3-1), and a repeating unit A3-2 represented by the following formula (A3-2). The polymer may also contain a polymer containing the repeating unit A1 and the repeating unit A2, a polymer containing the repeating unit A1 and the repeating unit A3-1, and/or a polymer containing the repeating unit A1 and the repeating unit A3-2.

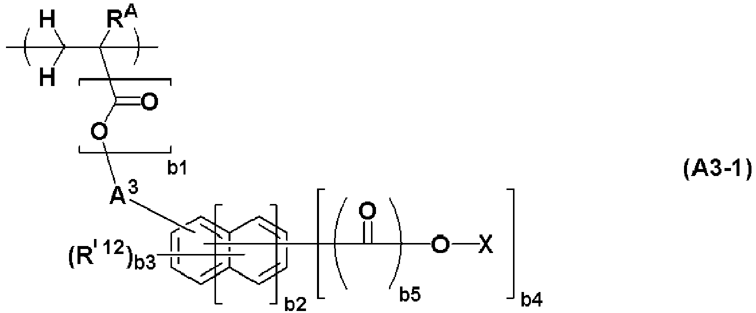

In the formula (A3-1), each R^{A} independently represents a hydrogen atom, a fluorine atom, a methyl group, or a trifluoromethyl group. b1 represents 0 or 1. b2 represents an integer of 0 to 2. b3 represents an integer that satisfies 0 ≤ b3 ≤ 5+2b2-b4. b4 represents an integer of 1 to 3. b5 represents 0 or 1. R'¹² represents a halogen atom, a saturated hydrocarbyl group having 1 to 6 carbon atoms optionally substituted with a halogen atom, a saturated hydrocarbyloxy group having 1 to 6 carbon atoms optionally substituted with a halogen atom, or a saturated hydrocarbylcarbonyloxy group having 2 to 8 carbon atoms optionally substituted with a halogen atom. A³ represents a single bond or a saturated hydrocarbylene group having 1 to 10 carbon atoms, a part of -CH₂- of the saturated hydrocarbylene group optionally being substituted with -O-. X represents an acid-labile group when b4 is 1 and represents a hydrogen atom or an acid-labile group when b4 is 2 or more, provided that at least one X is an acid-labile group.

In the formula (A3-1), R^{A} is as defined above. b1 represents 0 or 1. b2 represents an integer of 0 to 2, and when b2 is 0, a benzene skeleton is indicated, when b2 is 1, a naphthalene skeleton is indicated, and when b2 is 2, an anthracene skeleton is indicated respectively. b3 represents an integer that satisfies 0 ≤ b3 ≤ 5+2b2-b4. b4 represents an integer of 1 to 3. b5 represents 0 or 1. When b2 is 0, b3 is preferably an integer of 0 to 3 and b4 is preferably an integer of 1 to 3; and when b2 is 1 or 2, b3 is preferably an integer of 0 to 4 and b4 is preferably an integer of 1 to 3.

In the formula (A3-1), R'¹² represents a halogen atom, a saturated hydrocarbyl group having 1 to 6 carbon atoms optionally substituted with a halogen atom, a saturated hydrocarbyloxy group having 1 to 6 carbon atoms optionally substituted with a halogen atom, or a saturated hydrocarbylcarbonyloxy group having 2 to 8 carbon atoms optionally substituted with a halogen atom. The saturated hydrocarbyl moiety of the saturated hydrocarbyl group, the saturated hydrocarbyloxy group, and the saturated hydrocarbylcarbonyloxy group may be linear, branched, or cyclic, and specific examples thereof include: alkyl groups, such as a methyl group, an ethyl group, a propyl group, an isopropyl group, a butyl group, a pentyl group, and a hexyl group; cycloalkyl groups, such as a cyclopropyl group, a cyclobutyl group, a cyclopentyl group, and a cyclohexyl group; and groups obtained by combining these groups. When the number of carbon atoms is the upper limit or less, the solubility in an alkaline developer is favorable. When b3 is 2 or more, the R'¹²s may be identical to or different from one another.

In the formula (A3-1), A³ represents a single bond or a saturated hydrocarbylene group having 1 to 10 carbon atoms, and the -CH₂- of the saturated hydrocarbylene group may be substituted with -O-. The saturated hydrocarbylene group may be linear, branched, or cyclic, and specific examples thereof include: alkanediyl groups, such as a methylene group, an ethane-1,2-diyl group, a propane-1,3-diyl group, a butane-1,4-diyl group, a pentane-1,5-diyl group, a hexane-1,6-diyl group, and structural isomers thereof; cyclic saturated hydrocarbylene groups, such as a cyclopropanediyl group, a cyclobutanediyl group, a cyclopentanediyl group, and a cyclohexanediyl group; and groups obtained by combining these groups. When the saturated hydrocarbylene group contains an ether bond and b1 in the formula (A3-1) is 1, the ether bond may be contained in any position except between the α-carbon and the β-carbon relative to the ester oxygen. When b1 is 0, the atom bonded to the main chain may be an ether oxygen atom, and a second ether bond may be contained at any position except between the α-carbon and the β-carbon relative to the ether oxygen atom. Note that the saturated hydrocarbylene group preferably has 10 carbon atoms or fewer, since sufficient solubility to an alkaline developer can be achieved in such a case.

In the formula (A3-1), X represents an acid-labile group when b4 is 1 and represents a hydrogen atom or an acid-labile group when b4 is 2 or more, provided that at least one X is an acid-labile group. That is, in the repeating unit A3-1, at least one phenolic hydroxy group bonded to an aromatic ring is protected by an acid-labile group, or at least one carboxy group bonded to an aromatic ring is protected by an acid-labile group. Such an acid-labile group is not particularly limited, and any group can be used as long as the group is decomposed by an acid to form an acidic group that is already used for many known chemically amplified positive resist compositions.

When a tertiary saturated hydrocarbyl group is selected as the acid-labile group, a resist film is formed to have a thickness of, for example, 10 to 100 nm, so that a pattern having small LER can be formed even when a fine pattern having a line width of 45 nm or less is formed. Therefore, such a group is preferable. The tertiary saturated hydrocarbyl group preferably has 4 to 18 carbon atoms, so that the obtained monomer for polymerization can be obtained by distillation. Examples of the groups to be bonded to the tertiary carbon atom of the tertiary saturated hydrocarbyl group include saturated hydrocarbyl groups having 1 to 15 carbon atoms that optionally contain an oxygen-containing functional group such as an ether bond or a carbonyl group. The groups bonded to the tertiary carbon atom may be bonded to each other to form a ring.

Specific examples of the groups bonded to the tertiary carbon atom include a methyl group, an ethyl group, a propyl group, an adamantyl group, a norbornyl group, a tetrahydrofuran-2-yl group, 7-oxanorbornan-2-yl group, a cyclopentyl group, 2-tetrahydrofuril group, a tricyclo [5.2.1.0^{2,6}] decyl group, a tetracyclo [4 .4.0.1^{2,5}.1^{7,10}] dodecyl group, and a 3-oxo-1-cyclohexyl group.

Examples of the tertiary saturated hydrocarbyl group that has these substituents include a tert-butyl group, a tert-pentyl group, a 1-ethyl-1-methylpropyl group, a 1,1-diethylpropyl group, a 1,1,2-trimethylpropyl group, a 1-adamantyl-1-methylethyl group, a 1-methyl-1-(2-norbornyl)ethyl group, a 1-methyl-1-(tetrahydrofuran-2-yl)ethyl group, a 1-methyl-1-(7-oxanorbornan-2-yl)ethyl group, a 1-methylcyclopentyl group, a 1-ethylcyclopentyl group, a 1-propylcyclopentyl group, a 1-isopropylcyclopentyl group, a 1-cyclopentylcyclopentyl group, a 1-cyclohexylcyclopentyl group, a 1-(2-tetrahydrofuril)cyclopentyl group, a 1-(7-oxanorbornan-2-yl)cyclopentyl group, a 1-methylcyclohexyl group, a 1-ethylcyclohexyl group, a 1-cyclopentylcyclohexyl group, a 1-cyclohexylcyclohexyl group, a 2-methyl-2-norbornyl group, a 2-ethyl-2-norbornyl group, an 8-methyl-8-tricyclo[5.2.1.0^{2,6}]decyl group, an 8-ethyl-8-tricyclo[5.2.1.0^{2,6}]decyl group, a 3-methyl-3-tetracyclo [4 .4.0.1^{2,5}.1^{7,10}] dodecyl group, a 3-ethyl-3-tetracyclo [4 .4.0.1^{2,5}.1^{7,10}] dodecyl group, a 2-methyl-2-adamantyl group, a 2-ethyl-2-adamantyl group, a 1-methyl-3-oxo-1-cyclohexyl group, a 1-methyl-1-(tetrahydrofuran-2-yl)ethyl group, a 5-hydroxy-2-methyl-2-adamantyl group, and a 5-hydroxy-2-ethyl-2-adamantyl group. However, the tertiary saturated hydrocarbyl group is not limited thereto.

Examples of the acid-labile group include groups represented by the following formula (A3-1'). The group represented by the formula (A3-1') is commonly used as an acid-labile group, and is a useful choice as an acid-labile group that stably provides a pattern whose interface with a substrate is relatively rectangular. When X is a group represented by the formula (A3-1'), an acetal structure is formed.

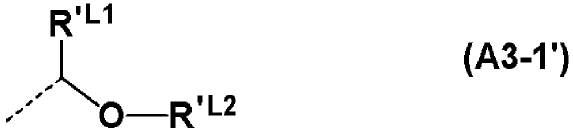

In the formula (A3-1'), R'^{L1} represents a hydrogen atom or a saturated hydrocarbyl group having 1 to 10 carbon atoms. R*'*^{L2} represents a saturated hydrocarbyl group having 1 to 30 carbon atoms. The saturated hydrocarbyl group may be linear, branched, or cyclic.

R*'*^{L1} is selected appropriately in accordance with design of the group decomposable by an acid. For example, a hydrogen atom is selected in design including decomposition by a strong acid while securing relatively high stability, and a linear alkyl group is selected in design using relatively high reactivity for higher sensitivity to pH. In case of designing larger change of solubility by decomposition with a relatively large alkyl group being selected as R*'*^{L2} in the terminal, R*'*^{L1} preferably contains a secondary carbon atom having a bond with an acetal carbon, although it also depends on the combination of an acid generator and a basic compound that are blended to the resist composition. Illustrative examples of R*'*^{L1} in which acetal carbon is bonded to a secondary carbon atom include an isopropyl group, a sec-butyl group, a cyclopentyl group, and a cyclohexyl group.

Among the above acetal groups, R*'*^{L2} preferably represents a polycyclic alkyl group having 7 to 30 carbon atoms for achieving higher resolution. Furthermore, when R*'*^{L2} is a polycyclic alkyl group, a bond is preferably formed between the acetal oxygen and the secondary carbon atom constituting the polycyclic structure. When the bond is on a secondary carbon atom of the ring structure, the polymer compound is more stable and the resist composition has better storage stability compared to the case in which the bond is on a tertiary carbon atom, thereby preventing the degradation of resolution. Meanwhile, when the bond is on a secondary carbon atom, the polymer is improved in glass transition temperature (Tg) compared with the case in which R*'*^{L2} is bonded on a primary carbon atom intervening in a linear alkyl group having one or more carbon atoms, so that profile defects due to baking do not occur in the developed resist pattern.

Preferable examples of the group represented by the formula (A3-1') include the groups shown below, but are not limited thereto. In the following formulae, R*'*^{L1} is as defined above.

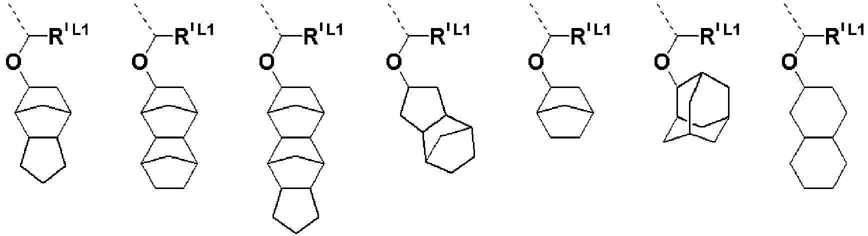

A repeating unit represented by the following formula (A3-2) (hereinafter, also referred to as a repeating unit A3-2) may also be contained as a repeating unit having an acidic functional group protected by the acid-labile group. The repeating unit represented by the formula (A3-2) has a high dissolution rate in an exposed portion, and is therefore a useful choice as an acid-labile group-containing unit that provides favorable performance regarding fluctuation in line width in development loading.

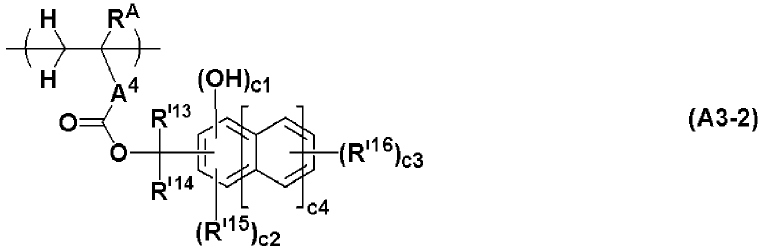

In the formula (A3-2), c1 represents an integer of 0 to 2. c2 represents an integer of 0 to 2. c3 represents an integer of 0 to 5. c4 represents an integer of 0 to 2. Each R^{A} independently represents a hydrogen atom, a fluorine atom, a methyl group, or a trifluoromethyl group. A⁴ represents a single bond, a phenylene group, a naphthylene group, or *-C(=O)-O-A⁴¹-. A⁴¹ represents an aliphatic hydrocarbylene group having 1 to 20 carbon atoms, a phenylene group, or a naphthylene group, the aliphatic hydrocarbylene group optionally having a hydroxy group, an ether bond, an ester bond, or a lactone ring. R*'*¹³ and R*'*¹⁴ each independently represent a hydrocarbyl group having 1 to 10 carbon atoms and optionally having a heteroatom, R*'*¹³ and R*'*¹⁴ optionally being bonded to each other to form a ring together with a carbon atom to which R*'*¹³ and R*'*¹⁴ are bonded. Each R*'*¹⁵ independently represents a fluorine atom, a fluorinated alkyl group having 1 to 5 carbon atoms, or a fluorinated alkoxy group having 1 to 5 carbon atoms. Each R*'*¹⁶ independently represents a hydrocarbyl group having 1 to 10 carbon atoms and optionally having a heteroatom.

In the formula (A3-2), c1 represents an integer of 0 to 2. c2 represents an integer of 0 to 2. c3 represents an integer of 0 to 5. c4 represents an integer of 0 to 2.

In the formula (A3-2), each R^{A} independently represents a hydrogen atom, a fluorine atom, a methyl group, or a trifluoromethyl group.

In the formula (A3-2), A⁴ represents a single bond, a phenylene group, a naphthylene group, or *-C(=0)-O-A⁴¹-. A⁴¹ represents an aliphatic hydrocarbylene group having 1 to 20 carbon atoms, a phenylene group, or a naphthylene group, the aliphatic hydrocarbylene group optionally having a hydroxy group, an ether bond, an ester bond, or a lactone ring.

In the formula (A3-2), R*'*¹³ and R*'*¹⁴ each independently represent a hydrocarbyl group having 1 to 10 carbon atoms and optionally having a heteroatom, R*'*¹³ and R*'*¹⁴ optionally being bonded to each other to form a ring together with a carbon atom to which R*'*¹³ and R*'*¹⁴ are bonded.

In the formula (A3-2), each R*'*¹⁵ independently represents a fluorine atom, a fluorinated alkyl group having 1 to 5 carbon atoms, or a fluorinated alkoxy group having 1 to 5 carbon atoms.

In the formula (A3-2), each R*'*¹⁶ independently represents a hydrocarbyl group having 1 to 10 carbon atoms and optionally having a heteroatom.

Preferable examples of the repeating unit A3-2 include the following, but are not limited thereto. In the following formulae, R^{A} is as defined above.

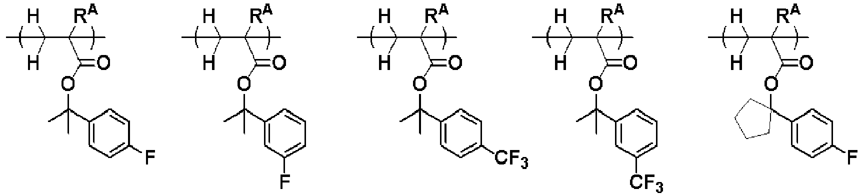

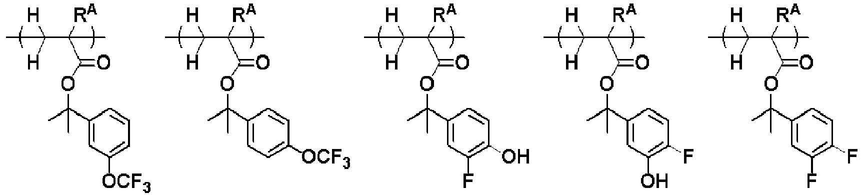

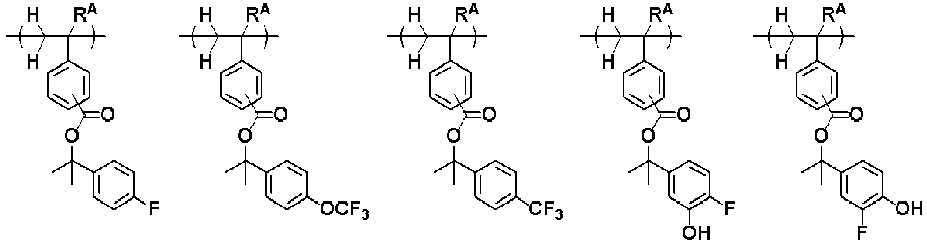

As another acid-labile group, it is also possible to use a phenolic hydroxy group in which a hydrogen atom is substituted with -CH₂COO- (a tertiary saturated hydrocarbyl group). In this event, it is possible to use, as the tertiary saturated hydrocarbyl group, the above-described tertiary saturated hydrocarbyl group used for protecting the phenolic hydroxy group.

The repeating unit A2 is preferably contained in an amount of 4 to 40 mol% of all the repeating units of the polymer. The repeating units A3-1 and A3-2 are preferably contained in an amount of 2 to 40 mol% of all the repeating units of the polymer. The total amount of the repeating units A2, A3-1, and A3-2 contained is preferably 8 to 60 mol% of all the repeating units of the polymer, more preferably 10 to 50 mol%, and further preferably 10 to 40 mol%.

The polymer may further contain at least one selected from repeating units C1 to C8 represented by any of the following formulae (C1) to (C8).

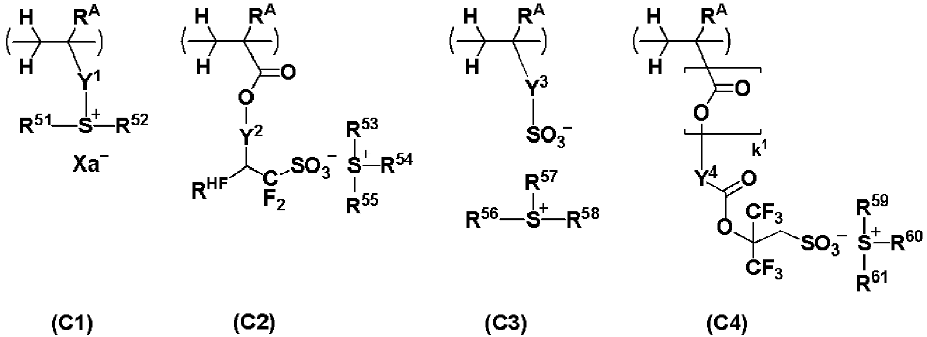

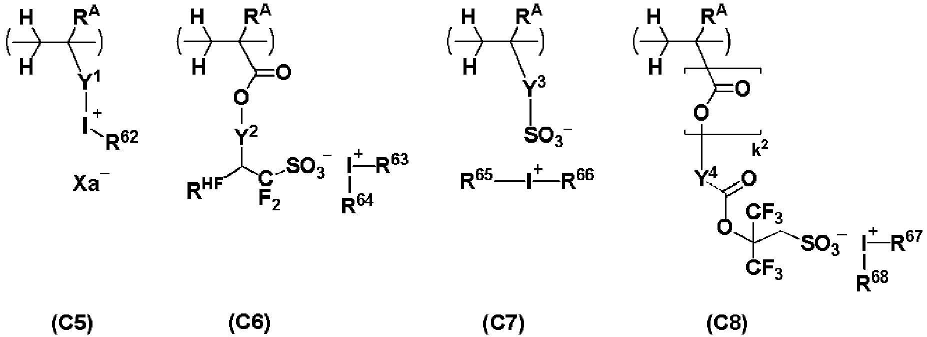

In the formulae, each R^{A} independently represents a hydrogen atom, a fluorine atom, a methyl group, or a trifluoromethyl group. Y¹ represents a single bond, an aliphatic hydrocarbylene group having 1 to 6 carbon atoms, a phenylene group, a naphthylene group, a group having 7 to 18 carbon atoms obtained by combining these groups, *-O-Y¹¹-, *-C (=O) -O-Y¹¹-, or *-C(=O)-NH-Y¹¹-. Y¹¹ represents an aliphatic hydrocarbylene group having 1 to 6 carbon atoms, a phenylene group, a naphthylene group, or a group having 7 to 18 carbon atoms obtained by combining these groups, Y¹¹ optionally having a carbonyl group, an ester bond, an ether bond, or a hydroxy group. Y² represents a single bond or **-Y²¹-C(=O)-O-. Y²¹ represents a hydrocarbylene group having 1 to 20 carbon atoms and optionally having a heteroatom. Y³ represents a single bond, a methylene group, an ethylene group, a phenylene group, a fluorinated phenylene group, a phenylene group substituted with a trifluoromethyl group, *-O-Y³¹-, *-C (=O)-O-Y³¹-, or *-C (=O)-NH-Y³¹-. Y³¹ represents an aliphatic hydrocarbylene group having 1 to 6 carbon atoms, a phenylene group, a fluorinated phenylene group, a phenylene group substituted with a trifluoromethyl group, or a group having 7 to 20 carbon atoms obtained by combining these groups, Y³¹ optionally having a carbonyl group, an ester bond, an ether bond, or a hydroxy group. "*" represents an attachment point to a carbon atom in the main chain. "**" represents an attachment point to an oxygen atom in the formula. Y⁴ represents a single bond or a hydrocarbylene group having 1 to 30 carbon atoms and optionally having a heteroatom. k¹ and k² each independently represent 0 or 1, and when Y⁴ is a single bond, k¹ and k² are 0. R⁵¹ to R⁶⁸ each independently represent a halogen atom or a hydrocarbyl group having 1 to 25 carbon atoms and optionally having a heteroatom. R⁵¹ and R⁵² are optionally bonded to each other to form a ring together with a sulfur atom to which R⁵¹ and R⁵² are bonded. R⁵³ and R⁵⁴, R⁵⁶ and R⁵⁷, and R⁵⁹ and R⁶⁰ are optionally bonded to each other to form a ring together with a sulfur atom to which R⁵³ and R⁵⁴, R⁵⁶ and R⁵⁷, and R⁵⁹ and R⁶⁰ are respectively bonded. R^{HF} represents a hydrogen atom or a trifluoromethyl group. Xa⁻ represents a non-nucleophilic counter ion.

In the formulae (C1) to (C8), R^{A} is as defined above. Y¹ represents a single bond, an aliphatic hydrocarbylene group having 1 to 6 carbon atoms, a phenylene group, a naphthylene group, a group having 7 to 18 carbon atoms obtained by combining these groups, *-O-Y¹¹-, *-C (=O)-O-Y¹¹-, or *-C (=O)-NH-Y¹¹-. Y¹¹ represents an aliphatic hydrocarbylene group having 1 to 6 carbon atoms, a phenylene group, a naphthylene group, or a group having 7 to 18 carbon atoms obtained by combining these groups, Y¹¹ optionally having a carbonyl group, an ester bond, an ether bond, or a hydroxy group. Y² represents a single bond or **-Y²¹-C(=O) -O-. Y²¹ represents a hydrocarbylene group having 1 to 20 carbon atoms and optionally having a heteroatom. Y³ represents a single bond, a methylene group, an ethylene group, a phenylene group, a fluorinated phenylene group, a phenylene group substituted with a trifluoromethyl group, *-O-Y³¹-, *-C (=O)-O-Y³¹-, or *-C(=O) -NH-Y³¹-. Y³¹ represents an aliphatic hydrocarbylene group having 1 to 6 carbon atoms, a phenylene group, a fluorinated phenylene group, a phenylene group substituted with a trifluoromethyl group, or a group having 7 to 20 carbon atoms obtained by combining these groups, Y³¹ optionally having a carbonyl group, an ester bond, an ether bond, or a hydroxy group. "*" represents an attachment point to a carbon atom in the main chain. "**" represents an attachment point to an oxygen atom in the formula. Y⁴ represents a single bond or a hydrocarbylene group having 1 to 30 carbon atoms and optionally having a heteroatom. k¹ and k² each independently represent 0 or 1, and when Y⁴ is a single bond, k¹ and k² are 0.

The repeating units represented by the formula (C4) or (C8) generate an acid in which the β-position of the sulfonyl group is difluoromethylated when irradiated with a high-energy beam such as ultraviolet ray, far ultraviolet ray, EB, EUV, X-ray, γ-ray, and synchrotron radiation beam. The acid has an appropriate acidity to deprotect a polymer containing the repeating unit A2. In addition, when the polymer containing the repeating unit represented by the formula (C4) or (C8) is used as a polymer of a chemically amplified positive resist composition, movement and diffusion of the generated acids can be controlled appropriately.

A photo-acid generator that generates an arenesulfonic acid by irradiation with a high-energy beam is also commonly used to deprotect the polymer containing units protected by an acetal group, a tertiary alkyl group, or a tert-butoxycarbonyl group. However, when the arenesulfonic acid-generating unit is introduced as a repeating unit of the base polymer to achieve the same effect as the present invention, the base polymer fails to dissolve in a solvent due to its low solvent-solubility in some cases. By contrast, the inventive polymer containing the repeating unit represented by the formula (C4) or (C8) has sufficient lipid-solubility and thus is easily produced, handled, and used to prepare a resist composition.

In the formulae (C2) and (C6), when Y² represents - Y²¹-C(=O)-O-, examples of the hydrocarbylene group represented by Y²¹ optionally containing a heteroatom include the following, but are not limited thereto.

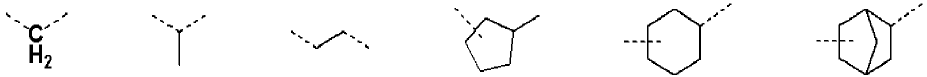

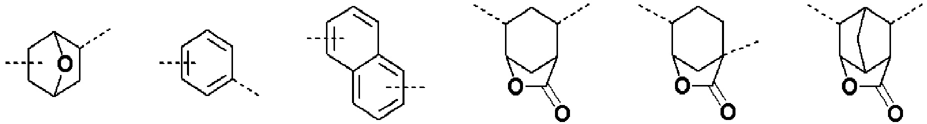

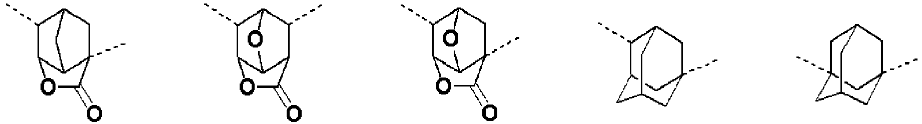

In the formulae, a broken line represents an attachment point.

In the formulae (C2) and (C6), R^{HF} represents a hydrogen atom or a trifluoromethyl group. In the repeating units C2 and C6, specific examples of cases where R^{HF} is a hydrogen atom include the repeating units disclosed in JP2010-116550A, and specific examples of cases where R^{HF} is a trifluoromethyl group include the repeating units disclosed in JP2010-077404A. Examples of the repeating units C3 and C7 include those disclosed in JP2012-246265A and JP2012-246426A.

In the formulae (C1) and (C5), Xa⁻ represents a non-nucleophilic counter ion. Examples of the non-nucleophilic counter ion represented by Xa⁻ include those disclosed in JP2010-113209A and JP2007-145797A.

The hydrocarbylene group represented by Y⁴ having 1 to 30 carbon atoms and optionally having a heteroatom may be saturated or unsaturated and may be linear, branched, or cyclic. Specific examples thereof include: alkanediyl groups, such as a methanediyl group, an ethane-1,2-diyl group, a propane-1,3-diyl group, a butane-1,4-diyl group, a pentane-1,5-diyl group, a hexane-1,6-diyl group, a heptane-1,7-diyl group, an octane-1,8-diyl group, a nonane-1,9-diyl group, a decane-1,10-diyl group, an undecane-1,11-diyl group, a dodecane-1,12-diyl group, a tridecane-1,13-diyl group, a tetradecane-1,14-diyl group, a pentadecane-1,15-diyl group, a hexadecane-1,16-diyl group, and a heptadecane-1,17-diyl group; cyclic saturated hydrocarbylene groups, such as a cyclopentanediyl group, a cyclohexanediyl group, a norbornanediyl group, and an adamantanediyl group; arylene groups, such as a phenylene group, a methylphenylene group, an ethylphenylene group, an n-propylphenylene group, an isopropylphenylene group, an n-butylphenylene group, an isobutylphenylene group, a sec-butylphenylene group, a tert-butylphenylene group, a naphthylene group, a methylnaphthylene group, an ethylnaphthylene group, an n-propylnaphthylene group, an isopropylnaphthylene group, an n-butylnaphthylene group, an isobutylnaphthylene group, a sec-butylnaphthylene group, and a tert-butylnaphthylene group; and groups obtained by combining these groups.

Some or all of the hydrogen atoms of the hydrocarbylene group may be substituted with a group containing a heteroatom, such as an oxygen atom, a sulfur atom, a nitrogen atom, or a halogen atom, while some -CH₂- contained in the hydrocarbylene group may be substituted with a group containing a heteroatom such as an oxygen atom, a sulfur atom, or a nitrogen atom. Thus, the resulting hydrocarbylene group may contain a hydroxy group, a cyano group, a fluorine atom, a chlorine atom, a bromine atom, an iodine atom, a carbonyl group, an ether bond, an ester bond, a sulfonic acid ester bond, a carbonate bond, a lactone ring, a sultone ring, a carboxylic anhydride (-C(=O)-O-C(=O)-), a haloalkyl group, etc.

Preferable examples of the anions of the monomers to give the repeating units C4 and C8 include the following anions, but are not limited thereto.

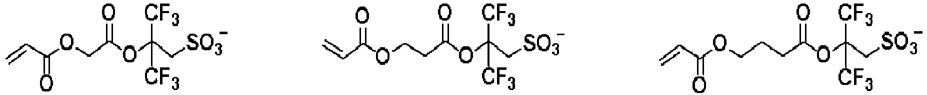

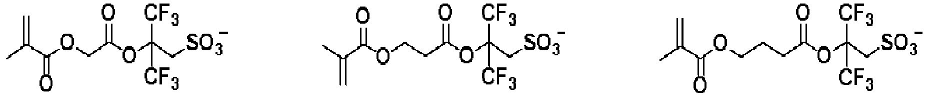

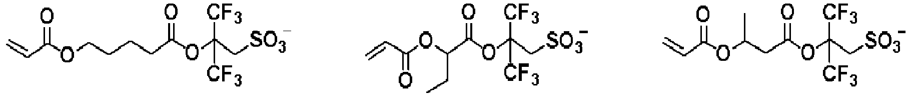

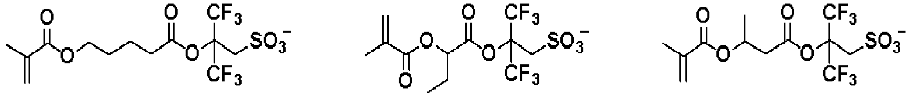

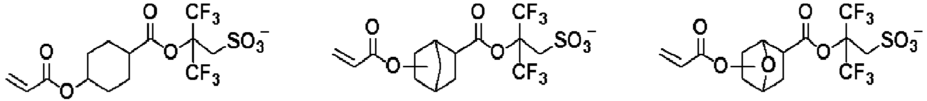

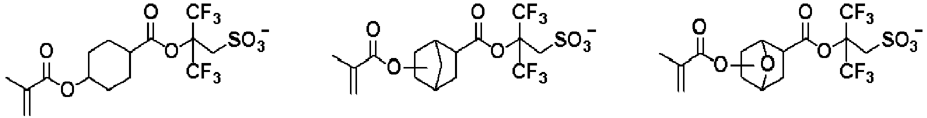

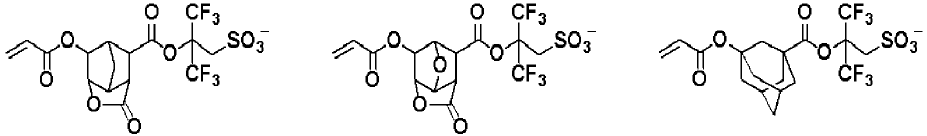

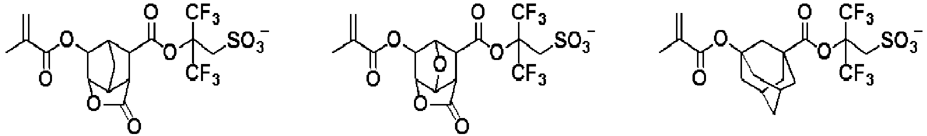

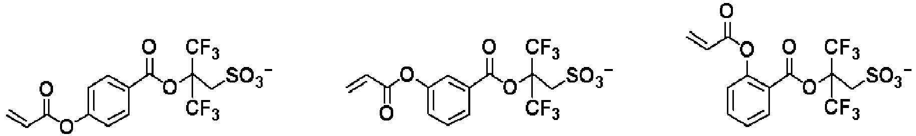

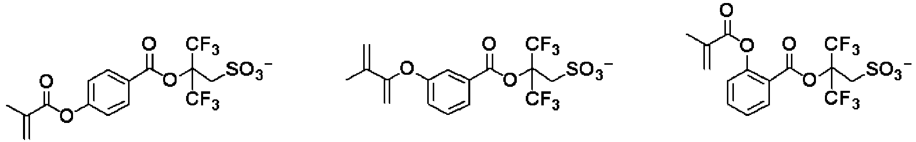

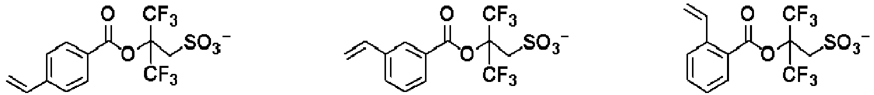

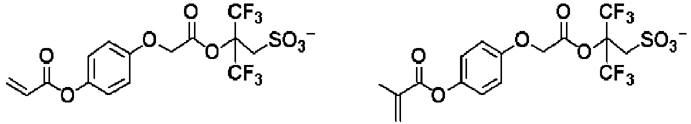

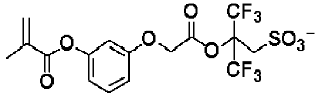

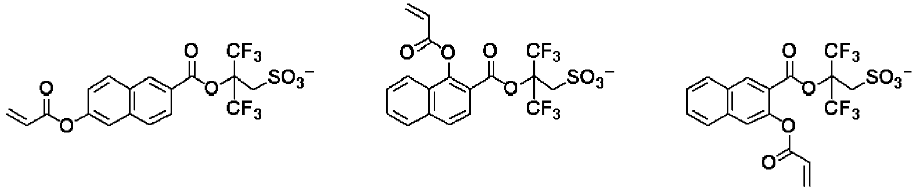

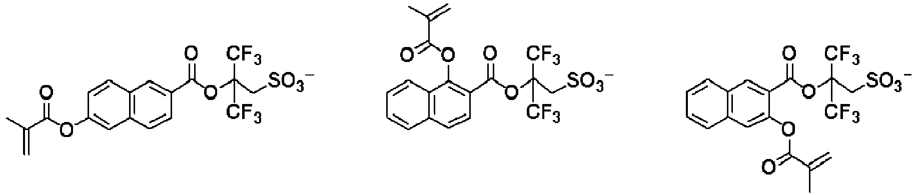

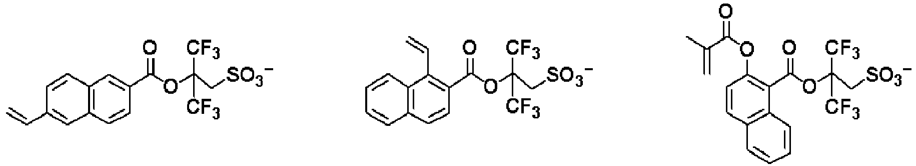

In the formulae (C1) to (C8), R⁵¹ to R⁶⁸ each independently represent a halogen atom or a hydrocarbyl group having 1 to 25 carbon atoms and optionally having a heteroatom.

Examples of the halogen atom include a fluorine atom, a chlorine atom, a bromine atom, an iodine atom, etc.

The hydrocarbyl group having 1 to 25 carbon atoms may be saturated or unsaturated and may be linear, branched, or cyclic. Specific examples thereof include: alkyl groups having 1 to 25 carbon atoms, such as a methyl group, an ethyl group, an n-propyl group, an isopropyl group, an n-butyl group, a sec-butyl group, a tert-butyl group, a tert-pentyl group, an n-pentyl group, an n-hexyl group, an n-octyl group, a 2-ethylhexyl group, an n-nonyl group, and an n-decyl group; cyclic saturated hydrocarbyl groups having 3 to 25 carbon atoms, such as a cyclopentyl group, a cyclohexyl group, a cyclopentylmethyl group, a cyclopentylethyl group, a cyclopentylbutyl group, a cyclohexylmethyl group, a cyclohexylethyl group, a cyclohexylbutyl group, a norbornyl group, a tricyclo[5.2.1.0^{2,6}]decanyl group, an adamantyl group, and an adamantylmethyl group; and aryl groups having 6 to 25 carbon atoms, such as a phenyl group, a naphthyl group, and an anthracenyl group. In addition, some or all of the hydrogen atoms of the hydrocarbyl group may be substituted with a group containing a heteroatom, such as an oxygen atom, a sulfur atom, a nitrogen atom, or a halogen atom, and the hydrocarbyl group may have an intervening group containing a heteroatom, such as an oxygen atom, a sulfur atom, or a nitrogen atom, in a carbon-carbon bond. Thus, the resulting hydrocarbyl group may contain a hydroxy group, a fluorine atom, a chlorine atom, a bromine atom, an iodine atom, a cyano group, a carbonyl group, an ether bond, an ester bond, a sulfonic acid ester bond, a carbonate bond, a lactone ring, a sultone ring, a carboxylic anhydride (-C(=O)-O-C(=O)-), a haloalkyl group, etc.

R⁵³ and R⁵⁴, R⁵⁶ and R⁵⁷, and R⁵⁹ and R⁶⁰ may be bonded to each other to form a ring together with a sulfur atom to which R⁵³ and R⁵⁴, R⁵⁶ and R⁵⁷, and R⁵⁹ and R⁶⁰ are respectively bonded. Examples of the ring formed in this event include the following.

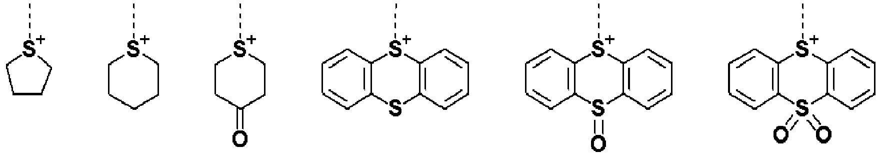

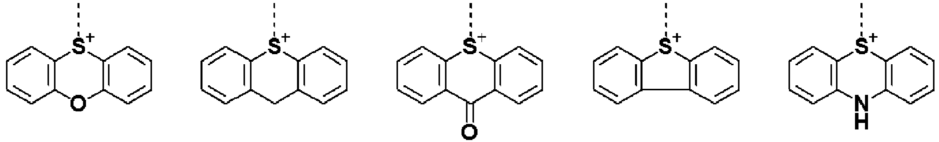

In the formulae, a broken line represents an attachment point.

Specific structures of the sulfonium cations in the formulae (C2) to (C4) include the following, but are not limited thereto.

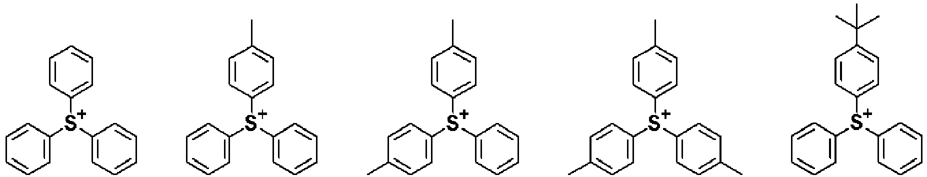

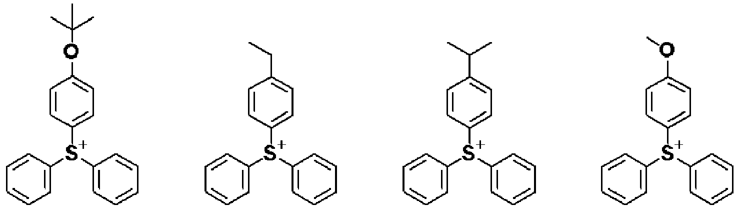

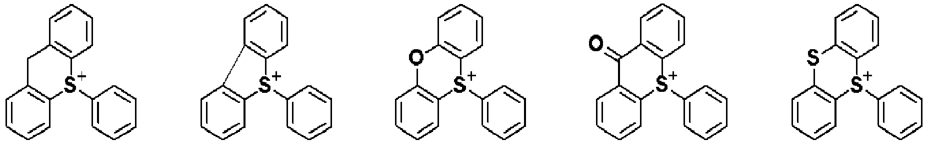

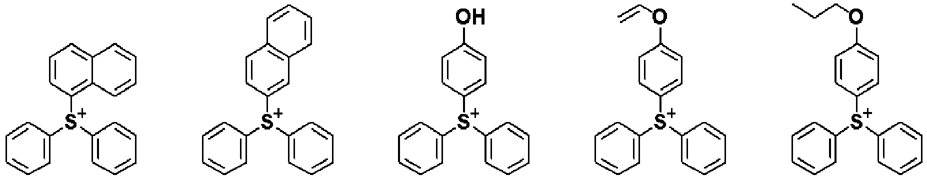

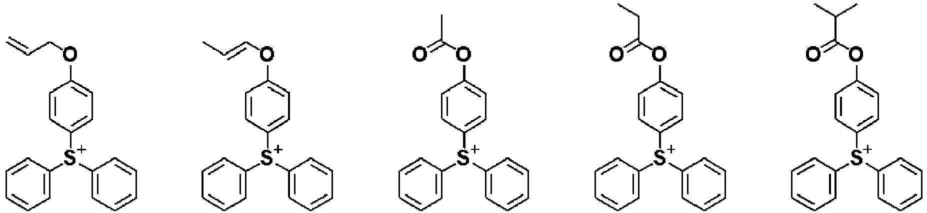

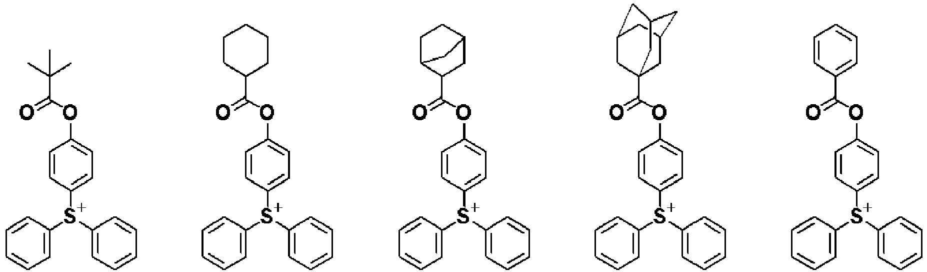

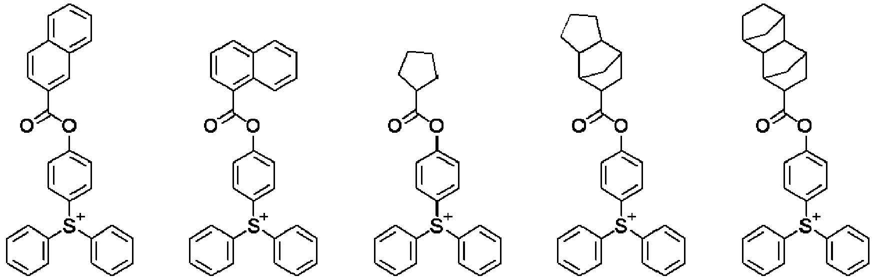

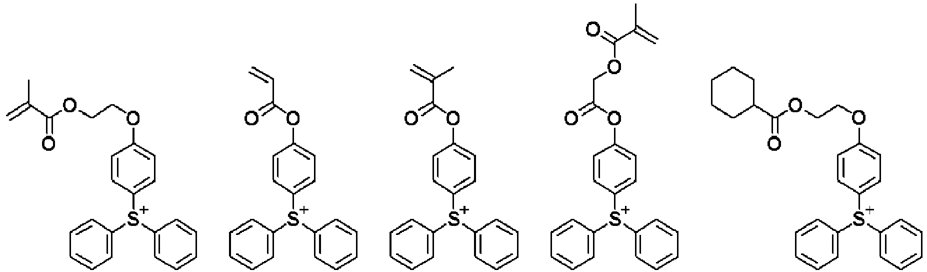

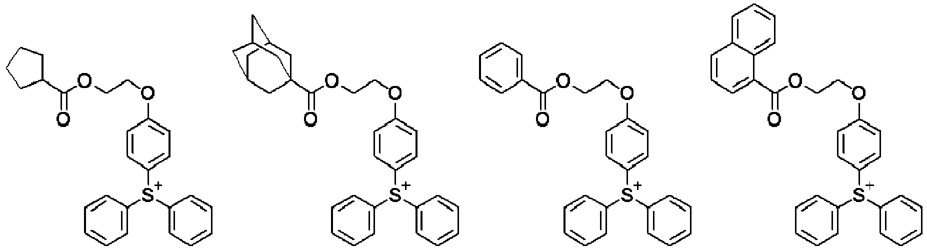

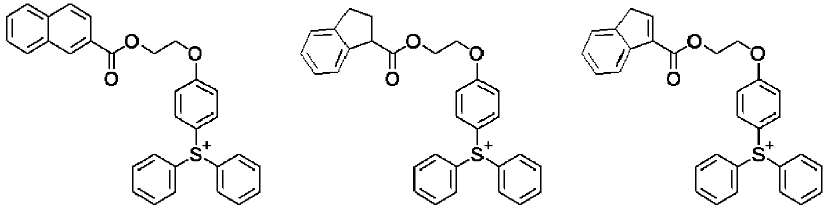

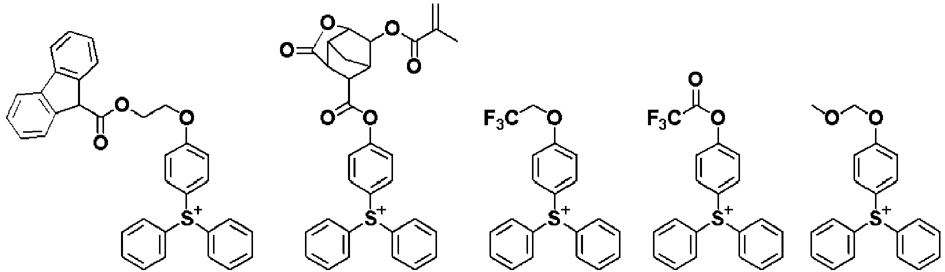

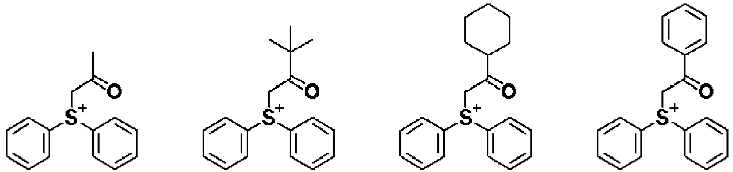

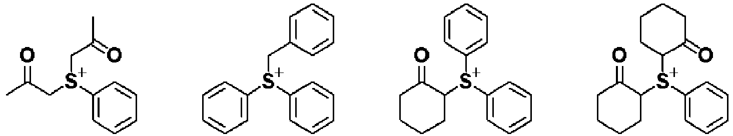

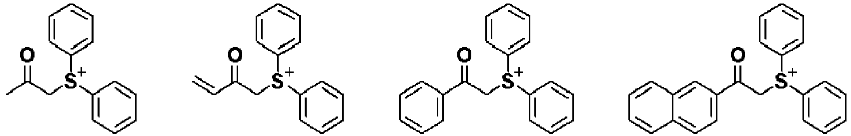

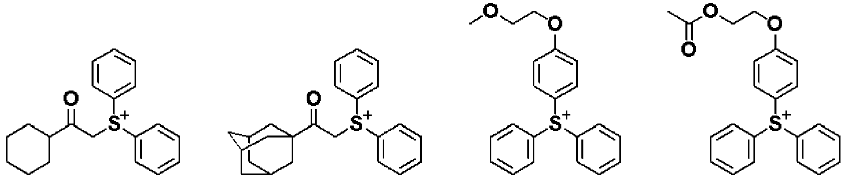

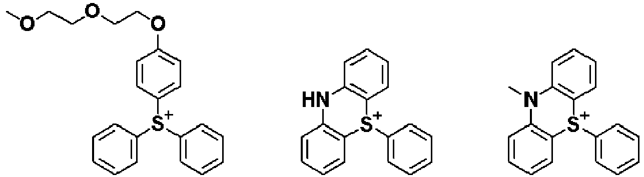

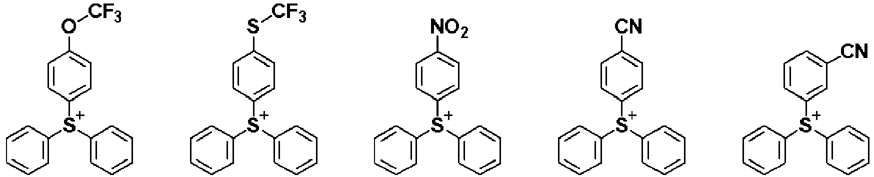

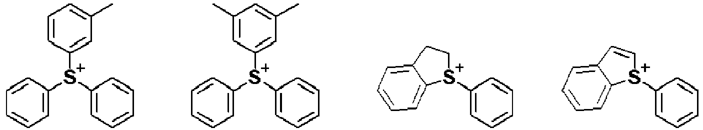

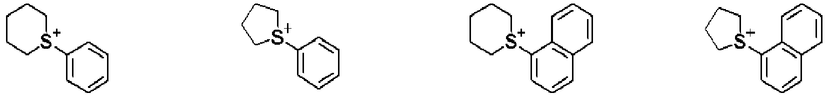

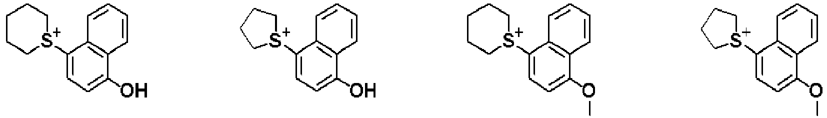

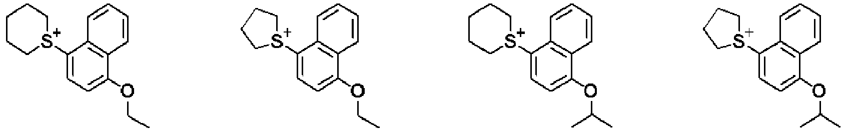

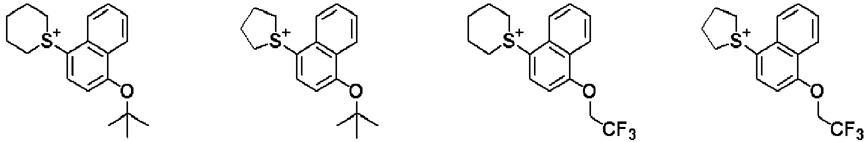

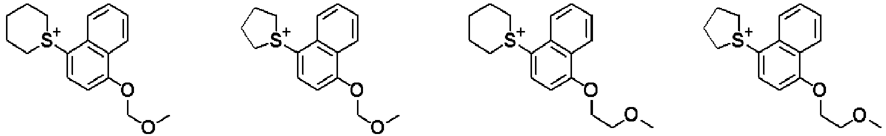

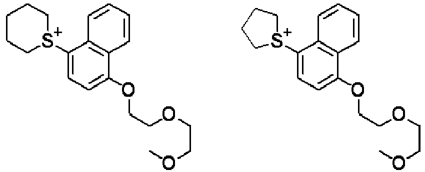

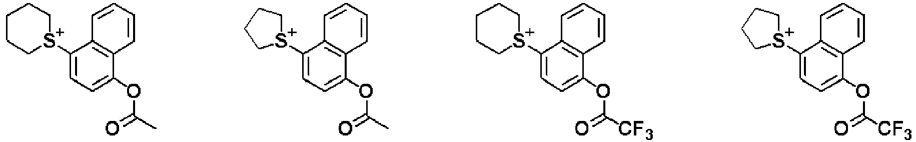

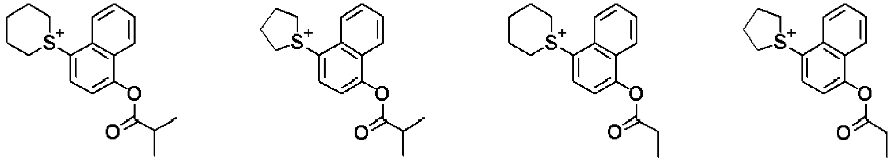

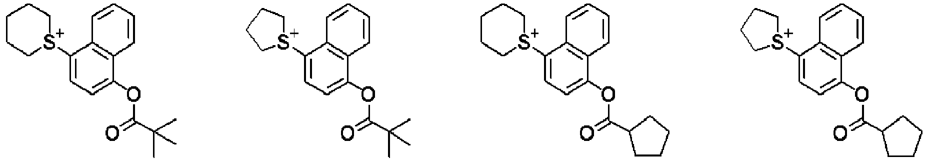

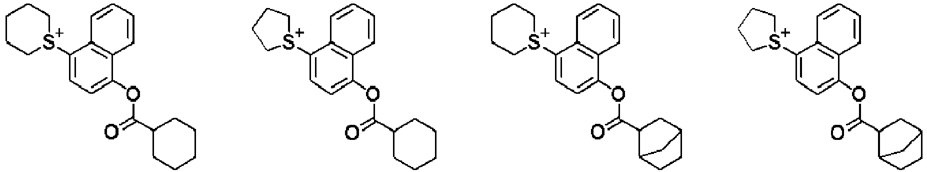

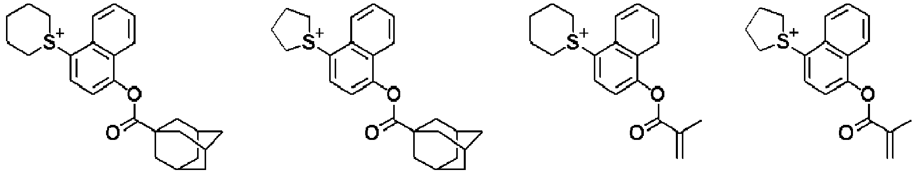

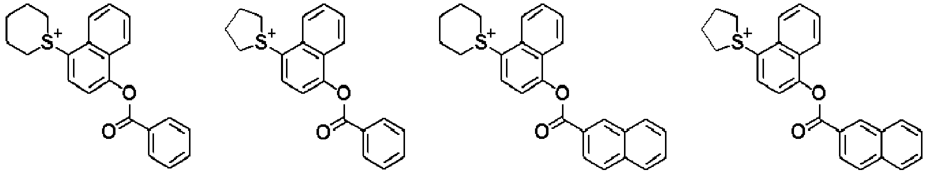

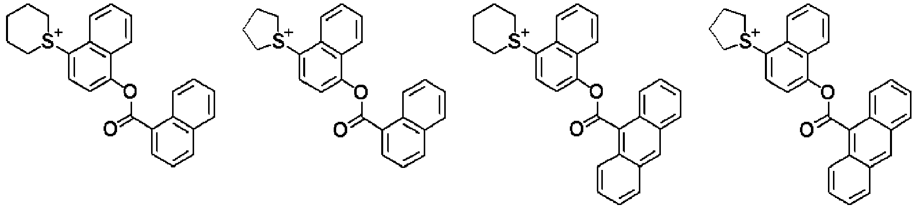

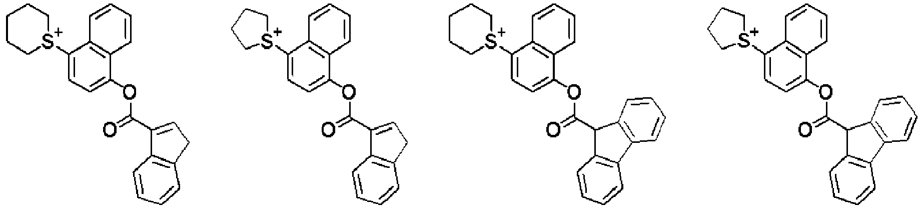

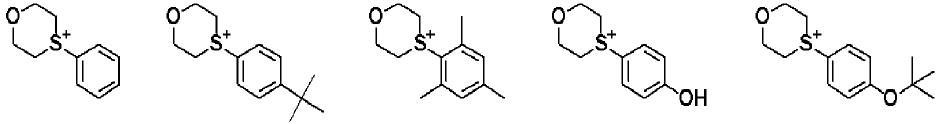

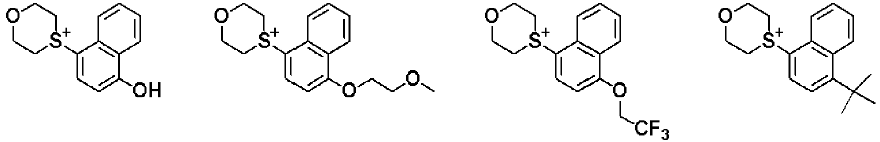

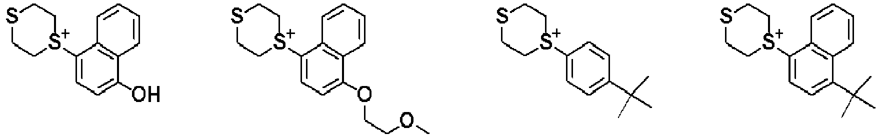

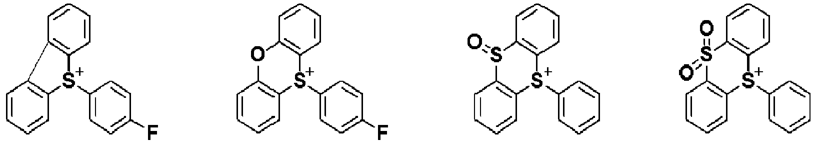

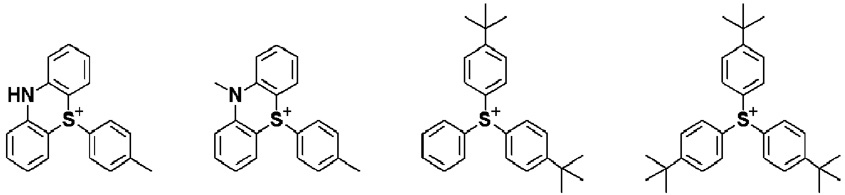

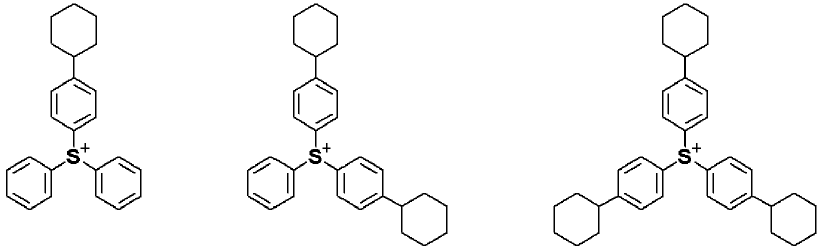

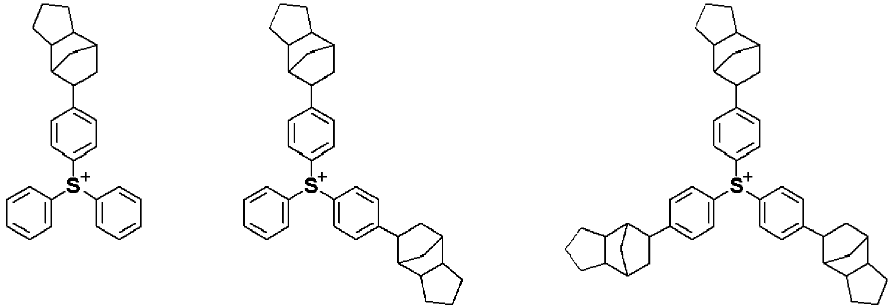

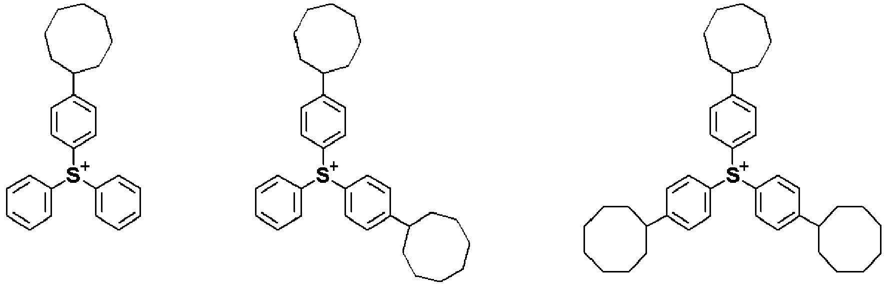

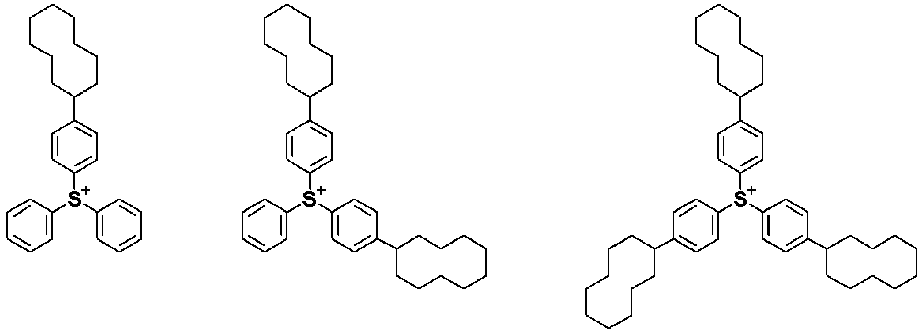

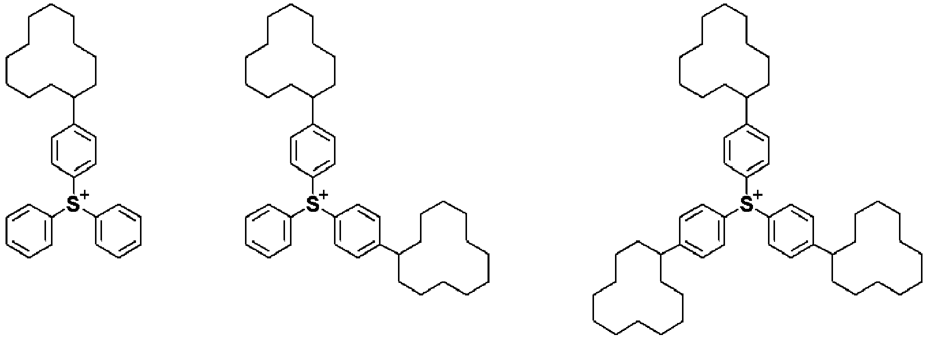

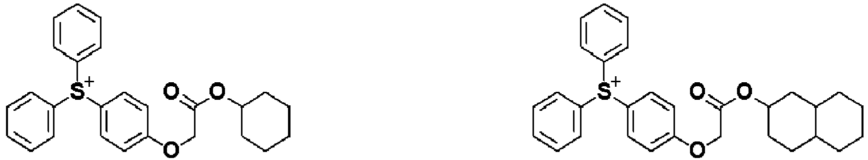

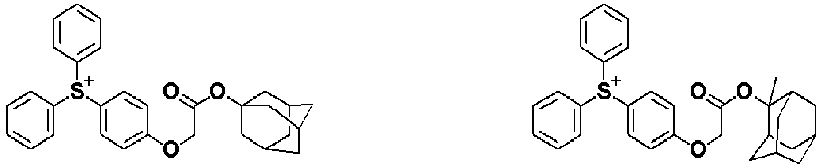

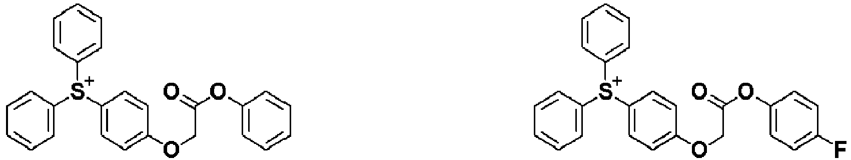

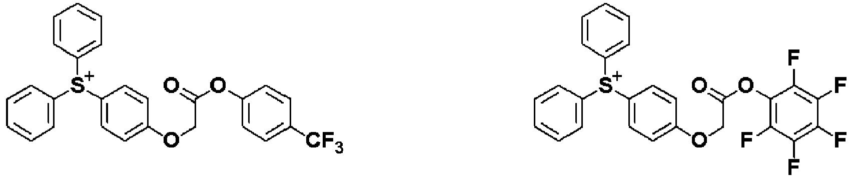

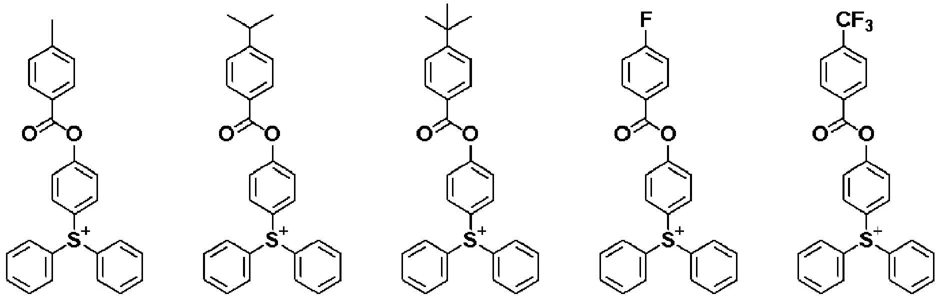

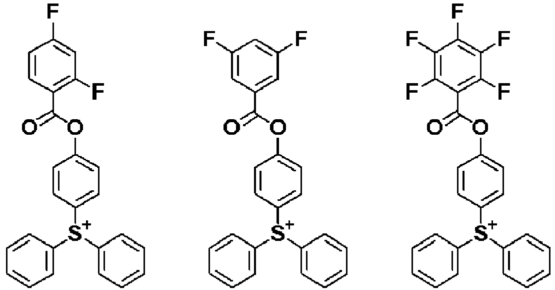

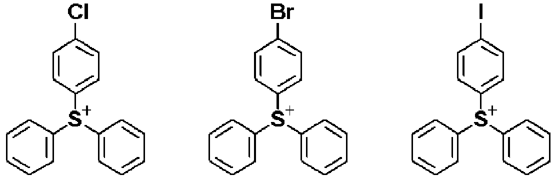

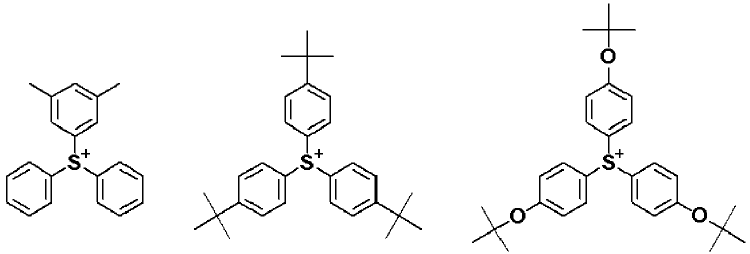

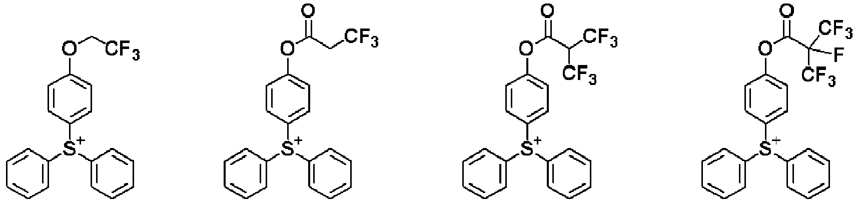

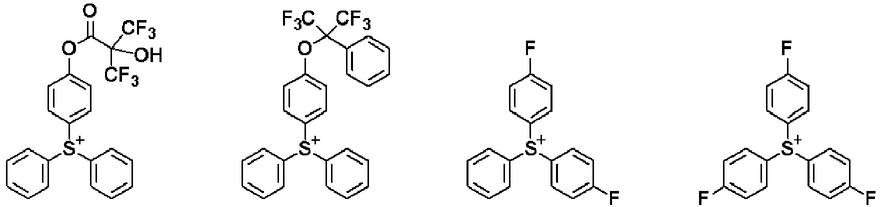

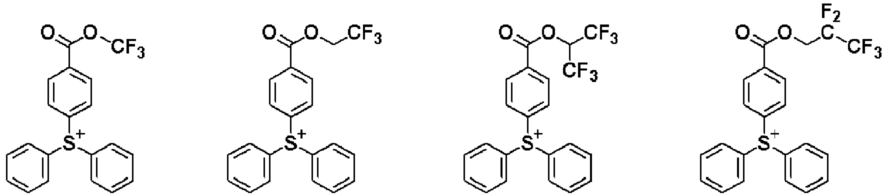

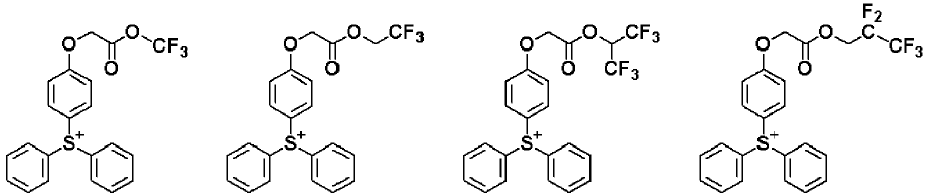

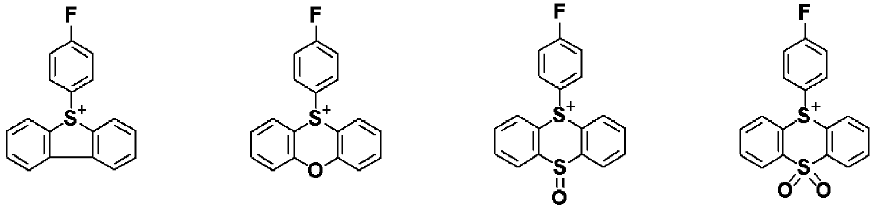

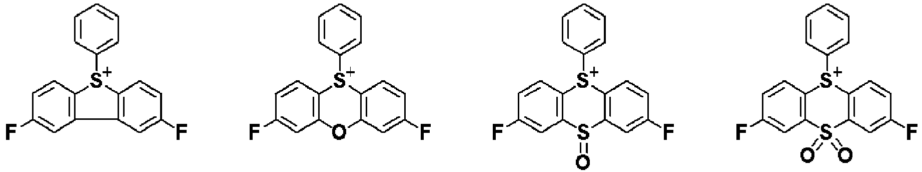

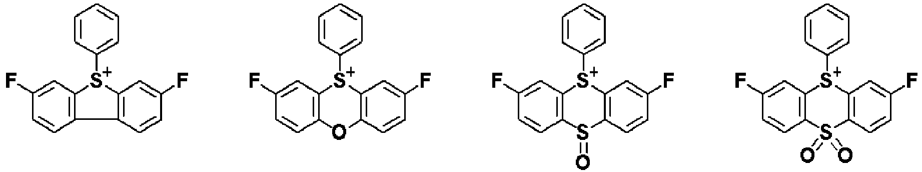

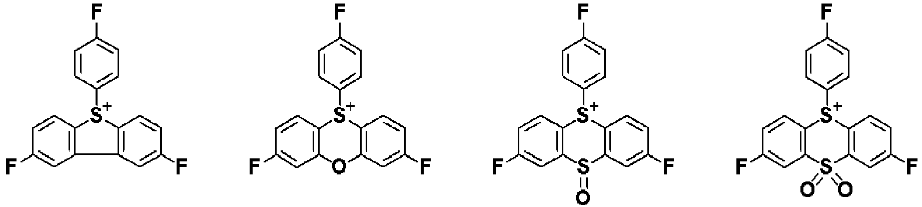

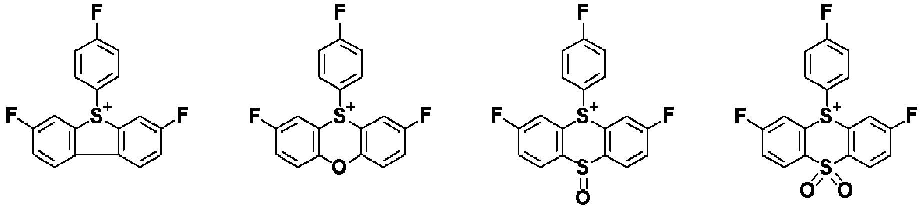

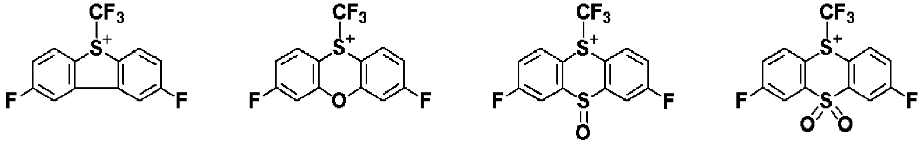

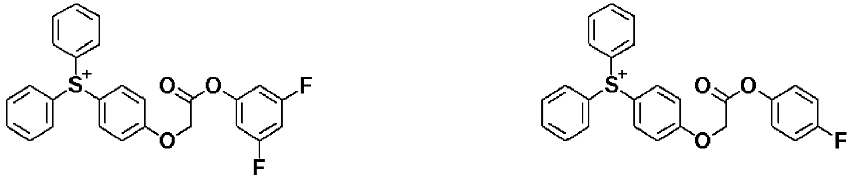

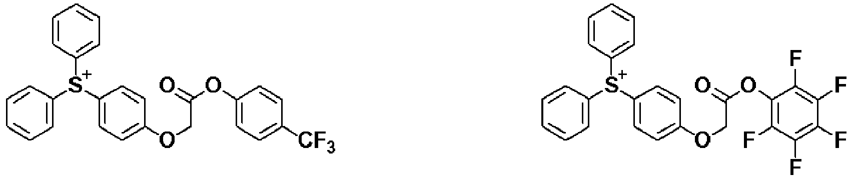

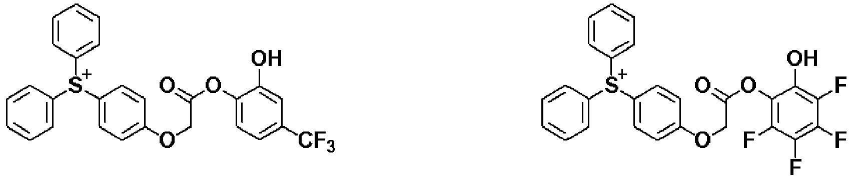

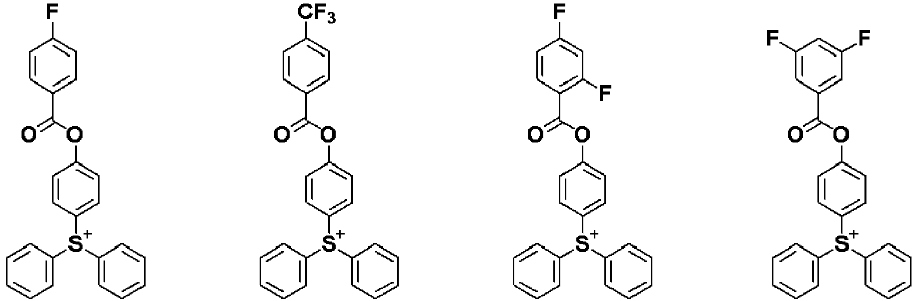

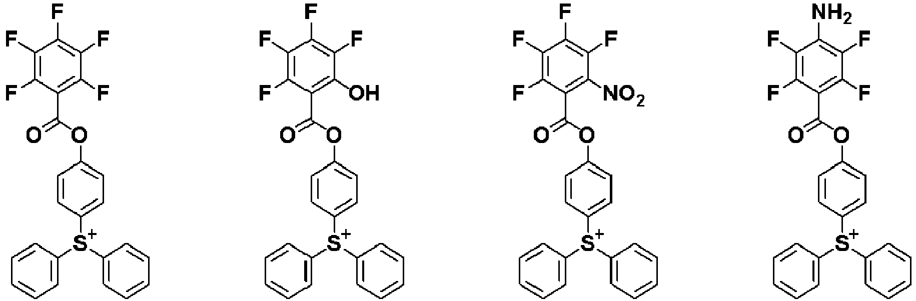

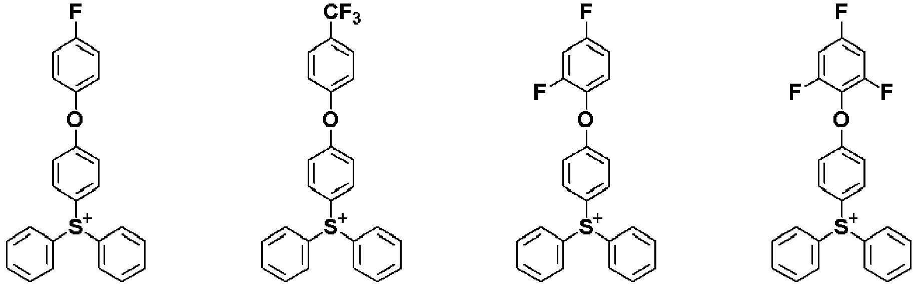

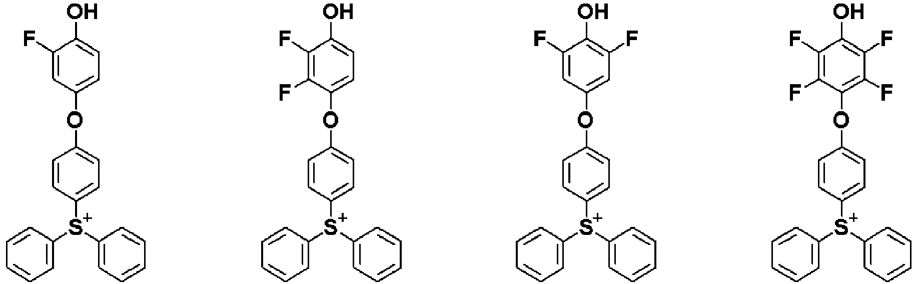

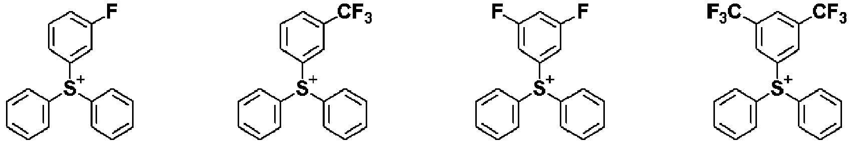

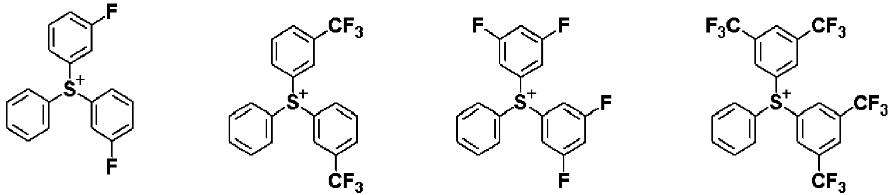

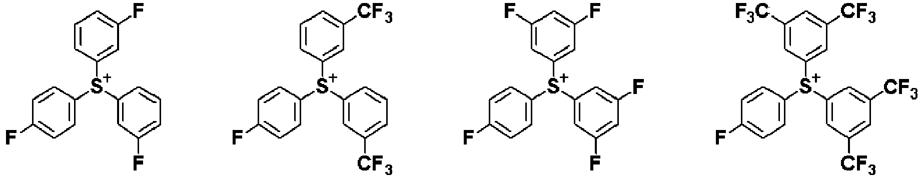

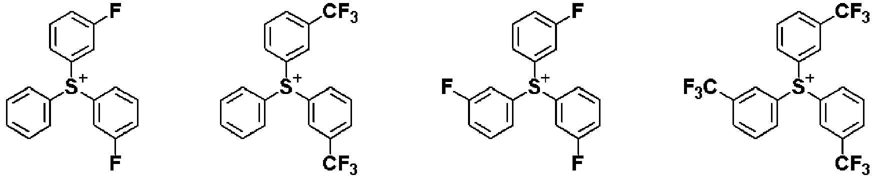

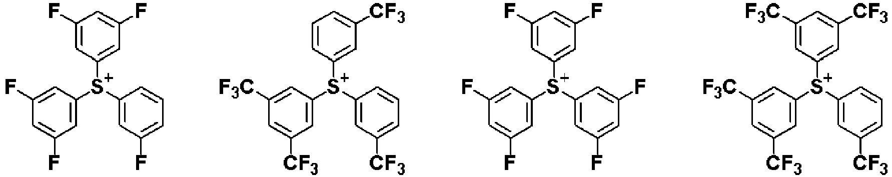

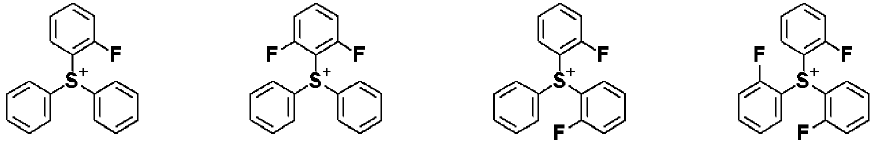

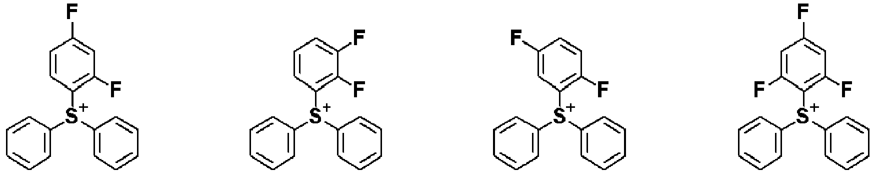

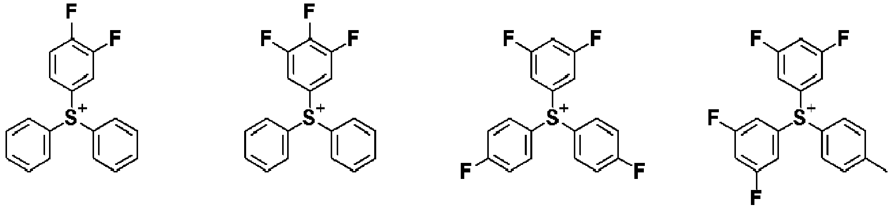

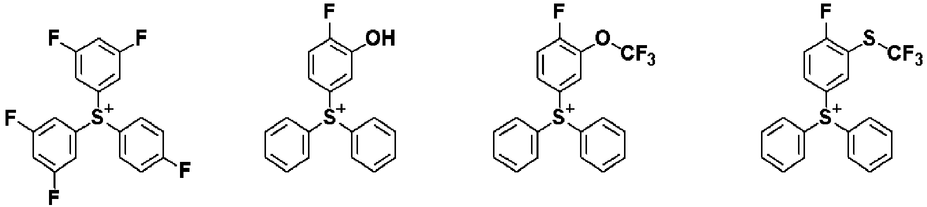

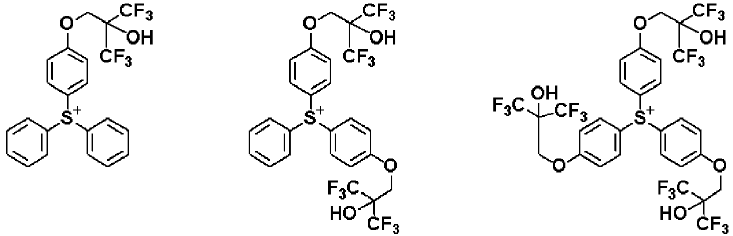

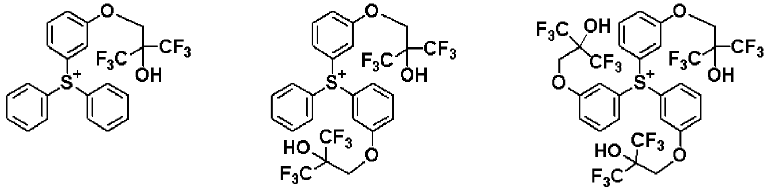

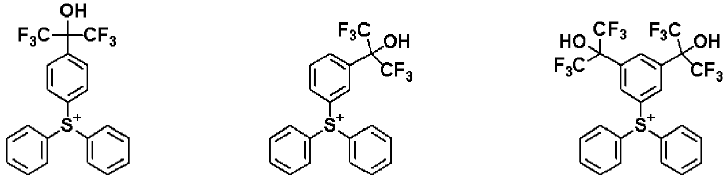

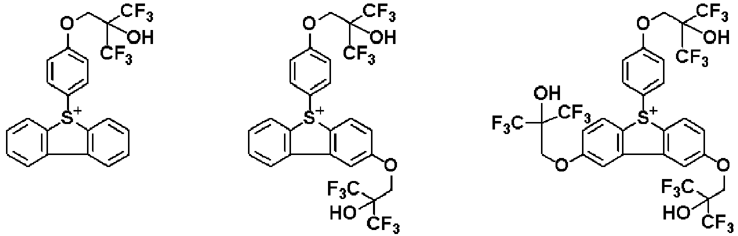

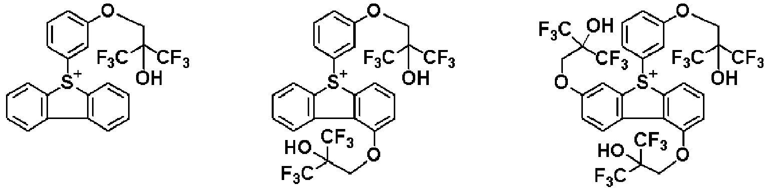

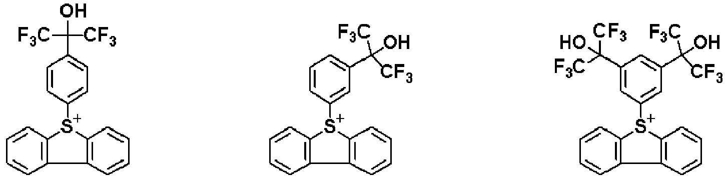

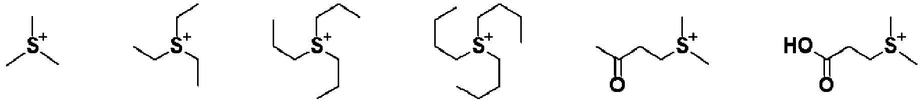

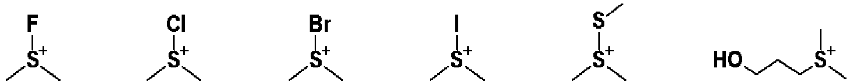

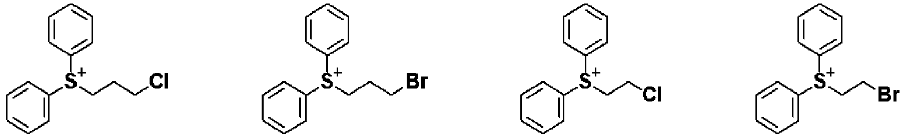

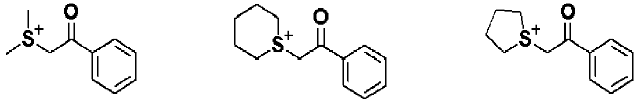

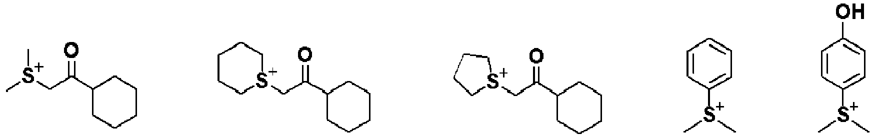

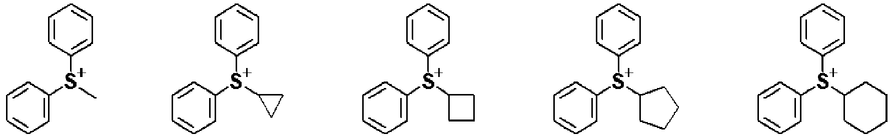

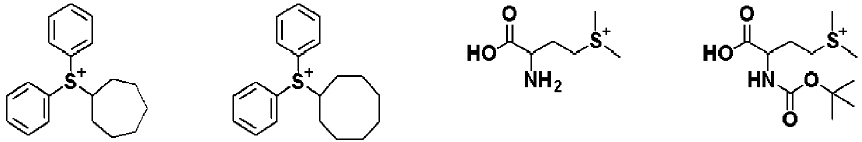

Specific structures of the iodonium cations in the formulae (C6) to (C8) include the following, but are not limited thereto.

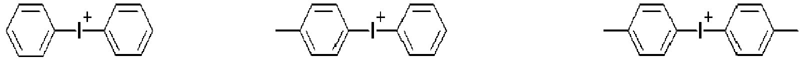

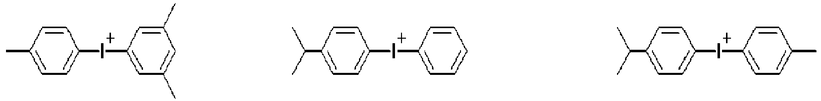

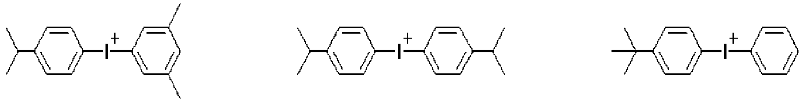

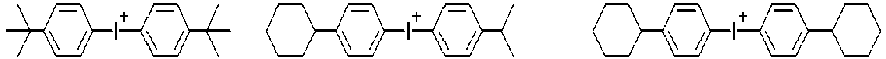

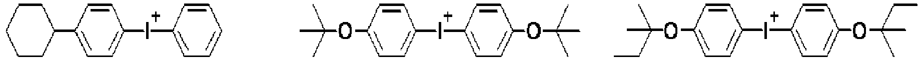

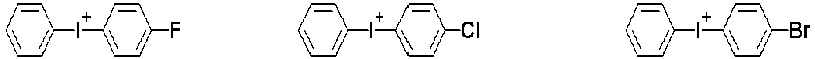

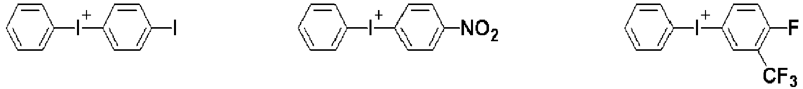

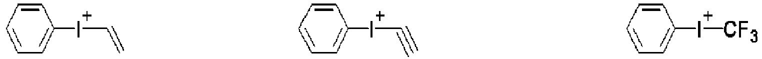

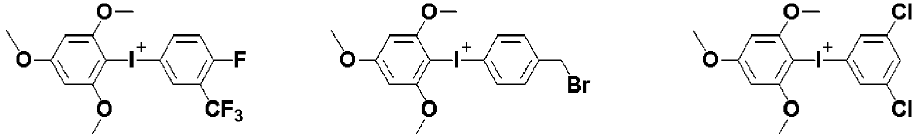

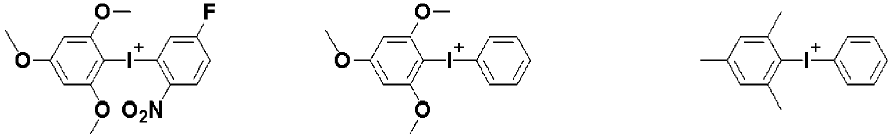

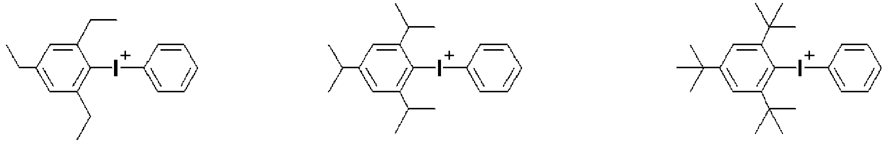

Out of the repeating units C1 to C8, the repeating unit C4 is preferable for the processing of a photomask blank, since the acidity is optimum for designing the acid-labile group of the polymer.

The repeating units C1 to C8 are units that generate an acid by irradiation with a high-energy beam. It is considered that acid diffusion is suppressed to a suitable extent when these units are contained in the polymer, so that a pattern having reduced LER can be obtained. It is also considered that when these units are contained in the polymer, a phenomenon that an acid volatilizes from an exposed portion when baking in a vacuum and becomes reattached to an unexposed portion is suppressed. Thus, the units are considered to be effective for reducing LER, reducing profile degradation due to undesired film loss in an unexposed portion, etc.

The repeating units C1 to C8 are preferably contained in an amount of 0.1 to 30 mol%, more preferably 0.5 to 20 mol% with respect to all the repeating units of the polymer. One kind of the repeating units C1 to C8 may be used, or two or more kinds may be used in combination.

Repeating units having an aromatic ring skeleton is preferably contained in an amount of 65 mol% or more, more preferably 75 mol% or more, and further preferably 85 mol% or more with respect to all the repeating units of the polymer. When the repeating units C1 to C8 are not contained, all units preferably have an aromatic ring skeleton.

The repeating unit A1, the repeating unit A2, the repeating unit A3-1, the repeating unit A3-2, and at least one selected from the repeating units B1 to B3 are preferably contained in an amount of 70 mol% or more, more preferably 80 mol% or more, and further preferably 90 mol% or more with respect to all the repeating units of the polymer.

The polymer may contain a (meth)acrylate ester unit protected by a conventional acid-liable group, a lactone structure, or a (meth)acrylate ester unit having an adhesive group such as a hydroxy group other than phenolic hydroxy groups. These repeating units make it possible to make fine adjustments to the properties of the resist film, but the units do not need to be contained.

Examples of the (meth)acrylate ester unit having an adhesive group include a repeating unit represented by the following formula (B4) (hereinafter, also referred to as a repeating unit B4), a repeating unit represented by the following formula (B5) (hereinafter, also referred to as a repeating unit B5), and a repeating unit represented by the following formula (B6) (hereinafter, also referred to as a repeating unit B6). These units are not acidic and can be used supplementarily as a unit to adjust the solubility or a unit to give adhesiveness to a substrate.

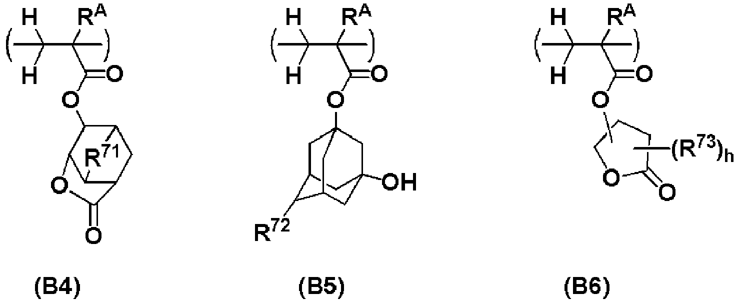

In the formulae (B4) to (B6), R^{A} is as defined above. R⁷¹ represents -O- or a methylene group. R⁷² represents a hydrogen atom or a hydroxy group. R⁷³ represents a saturated hydrocarbyl group having 1 to 4 carbon atoms. "h" represents an integer of 0 to 2.

When the repeating units B4 to B6 are contained, the contained amount thereof is preferably 0 to 20 mol%, more preferably 0 to 10 mol% with respect to all the repeating units of the polymer. One kind of the repeating units B4 to B6 may be used, or two or more kinds may be used in combination.

The polymer can be synthesized by known methods including copolymerization of each monomer that has been protected with a protective group in accordance with needs, followed by a deprotection reaction in accordance with needs. The copolymerization reaction is not particularly limited, but is preferably radical polymerization or anionic polymerization. Regarding these methods, JP2004-115630A may be consulted.

The polymer preferably has a weight-average molecular weight (Mw) of 1,000 to 50,000, further preferably 2,000 to 20,000. The Mw of 1,000 or more eliminates the risk that the head of a pattern becomes rounded to lower the resolution and the LER is degraded as has been known previously. Meanwhile, the Mw of 50,000 or less eliminates the risk of the LER being degraded, particularly when a pattern with the pattern width of 100 nm or less is formed. Note that in the present invention, Mw is a value measured in terms of polystyrene by gel permeation chromatography (GPC) using tetrahydrofuran (THF) or dimethylformamide (DMF) as an eluent.

The polymer preferably has a narrow molecular weight distribution (Mw/Mn) of 1.0 to 2.0, preferably 1.0 to 1.9, and further preferably 1.0 to 1.8. When the molecular weight distribution is thus narrow, there is no risk of foreign matters being formed on the pattern or the pattern profile being degraded after development.

The rate of dissolution of the polymer in an alkaline developer is preferably 10 nm/min or lower, more preferably 7 nm/min or lower, and further preferably 5 nm/min or lower. In advanced generations, pattern film loss in alkaline development has a great influence when the coating film of the substrate is in a thin film range (100 nm or less). Therefore, when the dissolution rate of the polymer in an alkali is 10 nm/min or lower, the pattern does not collapse, and a fine pattern can be formed. In particular, in the production of a photomask, where the absence of defects is required, the development process tends to be strong, so that the above-described advantageous effect is remarkable. Note that in the present invention, the dissolution rate of the polymer in an alkaline developer is a value obtained as follows: a 200-mm (8-inch) silicon wafer is spin-coated with a polymer solution (polymer concentration: 16.7 mass%, solvent: propylene glycol monomethyl ether acetate (PGMEA)); the resulting wafer is baked at 100°C for 90 seconds to form a film having a film thickness of 1,000 nm; subsequently, development is performed with a 2.38 mass% aqueous solution of tetramethylammonium hydroxide (TMAH) at 23°C for 100 seconds; and the dissolution rate is calculated from the amount of film loss in this event.

### [Chemically Amplified Positive Resist Composition]

The inventive chemically amplified positive resist composition contains the above-described polymer. Besides the polymer, the composition can also contain an organic solvent, a photo-acid generator, a quencher, a fluorine-containing polymer, etc. In the following, the inventive chemically amplified positive resist composition will be described in detail.

As the design of the chemically amplified positive resist composition, it is also possible to mix a known polymer having an acid-labile group protected by a tertiary alkyl group or a tert-butoxycarbonyl group besides the polymer having the formula (A2) shown in the present invention. However, for the advantageous effects of the present invention to be exhibited, the proportion of the polymer having the formula (A2) shown in the present invention is preferably 30% or more of all the polymers contained in the chemically amplified positive resist composition.

### [Fluorine-Containing Polymer]

The inventive chemically amplified positive resist composition can also contain a fluorine-containing polymer having at least one selected from a repeating unit represented by the following formula (D1), a repeating unit represented by the following formula (D2), a repeating unit represented by the following formula (D3), and a repeating unit represented by the following formula (D4) (hereinafter, also referred to as repeating units D1, D2, D3, and D4 respectively) for the purpose of achieving higher contrast, preventing chemical flare of acid upon irradiation with a high-energy beam, preventing mixing of acid from an antistatic film in the process of coating a resist film with an antistatic film material, and suppressing unexpected unnecessary pattern degradation. The fluorine-containing polymer also has the function of a surfactant, and can prevent the readhesion of an insoluble matter, which may be generated during a development process, to the substrate. Therefore, the fluorine-containing polymer is also effective against development defects.

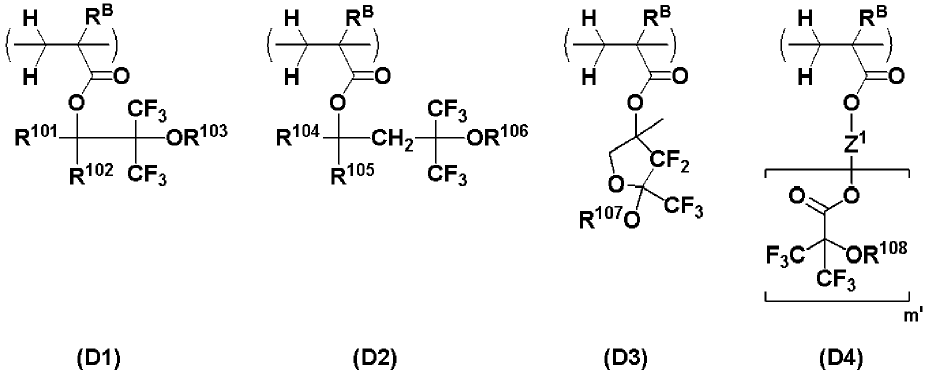

In the formulae, each R^{B} independently represents a hydrogen atom, a fluorine atom, a methyl group, or a trifluoromethyl group. R¹⁰¹, R¹⁰², R¹⁰⁴, and R¹⁰⁵ each independently represent a hydrogen atom or a saturated hydrocarbyl group having 1 to 10 carbon atoms. R¹⁰³, R¹⁰⁶, R¹⁰⁷, and R¹⁰⁸ each independently represent a hydrogen atom, a hydrocarbyl group having 1 to 15 carbon atoms, a fluorinated hydrocarbyl group having 1 to 15 carbon atoms, or an acid-labile group, R¹⁰³, R¹⁰⁶, R¹⁰⁷, and R¹⁰⁸ optionally having an intervening ether bond or carbonyl group in a carbon-carbon bond when each of R¹⁰³, R¹⁰⁶, R¹⁰⁷, and R¹⁰⁸ is a hydrocarbyl group or a fluorinated hydrocarbyl group. *"*m*'"* represents an integer of 1 to 3. Z¹ represents a hydrocarbon group having a valency of m*'*+1 and having 1 to 20 carbon atoms or a fluorinated hydrocarbon group having a valency of m*'*+1 and having 1 to 20 carbon atoms.

In the formulae (D1) to (D4), each R^{B} independently represents a hydrogen atom, a fluorine atom, a methyl group, or a trifluoromethyl group. R¹⁰¹, R¹⁰², R¹⁰⁴, and R¹⁰⁵ each independently represent a hydrogen atom or a saturated hydrocarbyl group having 1 to 10 carbon atoms. R¹⁰³, R¹⁰⁶, R¹⁰⁷, and R¹⁰⁸ each independently represent a hydrogen atom, a hydrocarbyl group having 1 to 15 carbon atoms, a fluorinated hydrocarbyl group having 1 to 15 carbon atoms, or an acid-labile group, R¹⁰³, R¹⁰⁶, R¹⁰⁷, and R¹⁰⁸ optionally having an intervening ether bond or carbonyl group in a carbon-carbon bond when each of R¹⁰³, R¹⁰⁶, R¹⁰⁷, and R¹⁰⁸ is a hydrocarbyl group or a fluorinated hydrocarbyl group. *"*m*'"* represents an integer of 1 to 3. Z¹ represents a hydrocarbon group having a valency of m*'*+1 and having 1 to 20 carbon atoms or a fluorinated hydrocarbon group having a valency of m*'*+1 and having 1 to 20 carbon atoms.

Examples of the saturated hydrocarbyl group having 1 to 10 carbon atoms represented by R¹⁰¹, R¹⁰², R¹⁰⁴, and R¹⁰⁵ in the formulae (D1) and (D2) include: alkyl groups having 1 to 10 carbon atoms, such as a methyl group, an ethyl group, an n-propyl group, an isopropyl group, an n-butyl group, an isobutyl group, a sec-butyl group, a tert-butyl group, an n-pentyl group, an n-hexyl group, an n-heptyl group, an n-octyl group, an n-nonyl group, and an n-decyl group; and cyclic saturated hydrocarbyl groups having 3 to 10 carbon atoms, such as a cyclopropyl group, a cyclobutyl group, a cyclopentyl group, a cyclohexyl group, an adamantyl group, and a norbornyl group. In particular, the saturated hydrocarbyl groups having 1 to 6 carbon atoms are preferable.

Examples of the hydrocarbyl group having 1 to 15 carbon atoms represented by R¹⁰³, R¹⁰⁶, R¹⁰⁷, and R¹⁰⁸ in the formulae (D1) to (D4) include alkyl groups having 1 to 15 carbon atoms, alkenyl groups having 2 to 15 carbon atoms, and alkynyl groups having 2 to 15 carbon atoms, and alkyl groups having 1 to 15 carbon atoms are preferable. Besides those given above, examples of the alkyl groups include a methyl group, an ethyl group, an n-propyl group, an isopropyl group, an n-butyl group, an isobutyl group, a sec-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, and an n-pentadecyl group. Examples of the fluorinated hydrocarbyl group include groups in which a part or all of the hydrogen atoms bonded to the carbon atoms of the hydrocarbyl groups above are substituted with a fluorine atom.

Examples of the hydrocarbon group in the formula (D4) represented by Z¹ having a valency of m*'*+1 and having 1 to 20 carbon atoms include groups that have *"*m*'"* fewer hydrogen atoms than alkyl groups having 1 to 20 carbon atoms or cyclic saturated hydrocarbyl groups having 3 to 20 carbon atoms. Examples of the fluorinated hydrocarbon group represented by Z¹ having a valency of m*'*+1 and having 1 to 20 carbon atoms include groups in which at least one hydrogen atom of the above-described hydrocarbon groups having a valency of m*'*+1 is substituted with a fluorine atom.

Specific examples of the repeating units D1 to D4 include the following, but are not limited thereto. In the following formulae, R^{B} is as defined above.

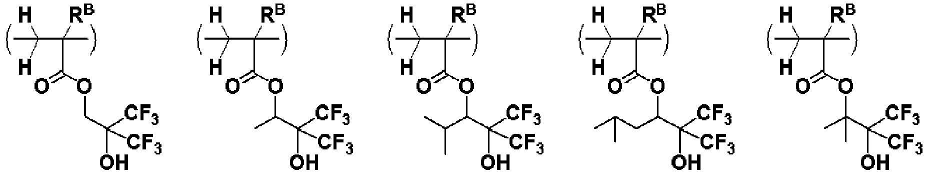

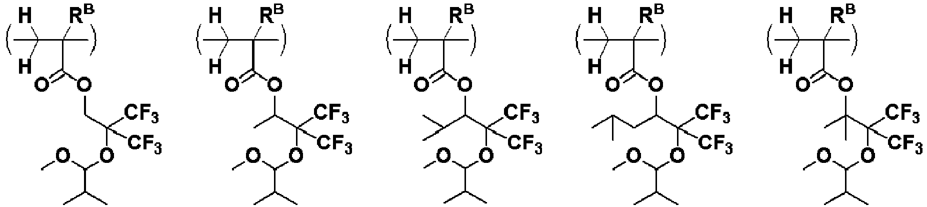

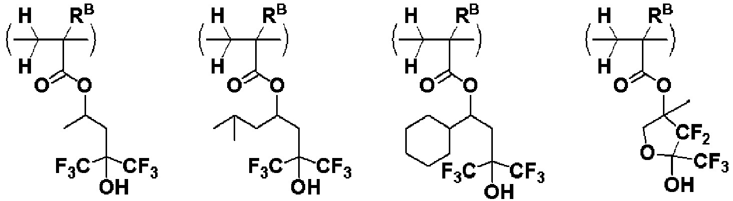

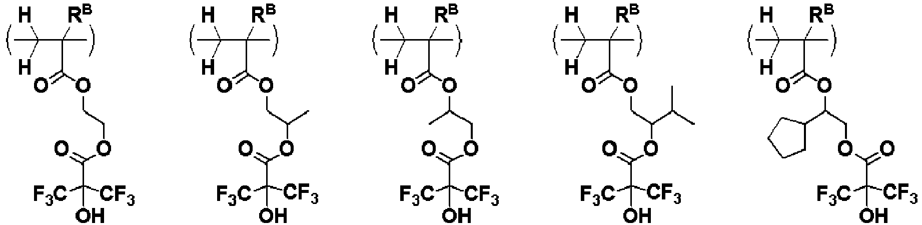

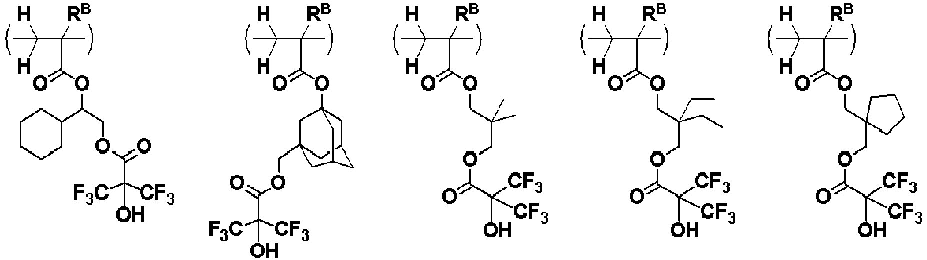

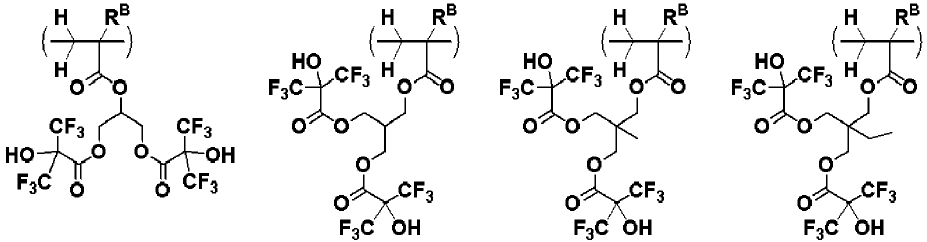

Furthermore, the fluorine-containing polymer preferably has at least one selected from a repeating unit represented by the following formula (D5) and a repeating unit represented by the following formula (D6) (hereinafter, also respectively referred to as repeating units D5 and D6).

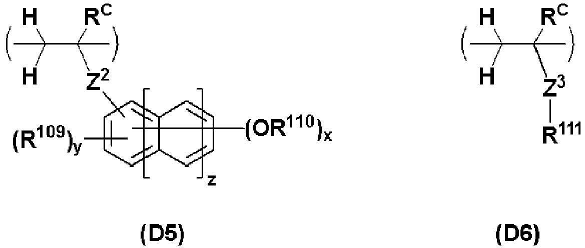

In the formulae, each R^{C} independently represents a hydrogen atom or a methyl group. R¹⁰⁹ represents a hydrogen atom or a linear or branched hydrocarbyl group having 1 to 5 carbon atoms and optionally having, in a carbon-carbon bond, an intervening group containing a heteroatom. R¹¹⁰ represents a linear or branched hydrocarbyl group having 1 to 5 carbon atoms and optionally having, in a carbon-carbon bond, an intervening group containing a heteroatom. R¹¹¹ represents a saturated hydrocarbyl group having 1 to 20 carbon atoms, at least one hydrogen atom being substituted with a fluorine atom and a part of -CH₂-constituting the saturated hydrocarbyl group optionally being substituted with an ester bond or an ether bond. "x" represents an integer of 1 to 3. "y" represents an integer that satisfies 0 ≤ y ≤ 5+2z-x. "z" represents 0 or 1. Z² represents a single bond, *-C(=O)-O-, or *-C(=O)-NH-. Z³ represents a single bond, -O-, *-C(=O)-O-Z³¹-Z³²-, or *-C (=O) -NH-Z³¹-Z³² - . Z³¹ represents a single bond or a saturated hydrocarbylene group having 1 to 10 carbon atoms. Z³² represents a single bond, an ester bond, an ether bond, or a sulfonamide bond. "*" represents an attachment point to a carbon atom in the main chain.

In the formulae (D5) and (D6), each R^{C} independently represents a hydrogen atom or a methyl group. R¹⁰⁹ represents a hydrogen atom or a linear or branched hydrocarbyl group having 1 to 5 carbon atoms and optionally having, in a carbon-carbon bond, an intervening group containing a heteroatom. R¹¹⁰ represents a linear or branched hydrocarbyl group having 1 to 5 carbon atoms and optionally having, in a carbon-carbon bond, an intervening group containing a heteroatom. R¹¹¹ represents a saturated hydrocarbyl group having 1 to 20 carbon atoms, at least one hydrogen atom being substituted with a fluorine atom and a part of -CH₂- constituting the saturated hydrocarbyl group optionally being substituted with an ester bond or an ether bond. "x" represents an integer of 1 to 3. "y" represents an integer that satisfies 0 ≤ y ≤ 5+2z-x. "z" represents 0 or 1. Z² represents a single bond, *-C(=O)-O-, or *-C(=O)-NH-. Z³ represents a single bond, - O-, *-C (=O)-O-Z³¹-Z³²-, or *-C (=O) -NH-Z³¹-Z³²-. Z³¹ represents a single bond or a saturated hydrocarbylene group having 1 to 10 carbon atoms. Z³² represents a single bond, an ester bond, an ether bond, or a sulfonamide bond. "*" represents an attachment point to a carbon atom in the main chain.

Examples of the hydrocarbyl groups in the formula (D5) represented by R¹⁰⁹ and R¹¹⁰ having 1 to 5 carbon atoms include alkyl groups, alkenyl groups, and alkynyl groups, and alkyl groups are preferable. Examples of the alkyl groups include a methyl group, an ethyl group, an n-propyl group, an isopropyl group, an n-butyl group, an isobutyl group, a sec-butyl group, and an n-pentyl group. A group having an intervening heteroatom, such as an oxygen atom, a sulfur atom, or a nitrogen atom, may also be contained in a carbon-carbon bond of these groups.

In the formula (D5), -OR¹¹⁰ is preferably a hydrophilic group. In this case, R¹¹⁰ is preferably a hydrogen atom, an alkyl group having 1 to 5 carbon atoms and having an intervening oxygen atom in a carbon-carbon bond, or the like.

In the formula (D5), Z² is preferably *-C(=O)-O- or *-C(=O)-NH-. Furthermore, R^{C} is preferably a methyl group. When Z² contains a carbonyl group, ability to trap acids derived from an antistatic film is improved. When R^{C} is a methyl group, a rigid polymer with a higher glass transition temperature (Tg) can be obtained, and thus the acid diffusion is suppressed. This allows the resist film to have temporal stability and prevents the resolution and the pattern profile from being degraded.

Examples of the repeating unit D5 include the following, but are not limited thereto. Note that in the following formulae, R^{C} is as defined above.

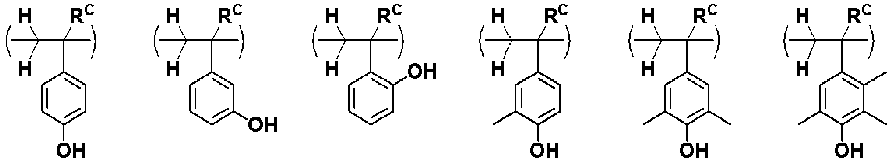

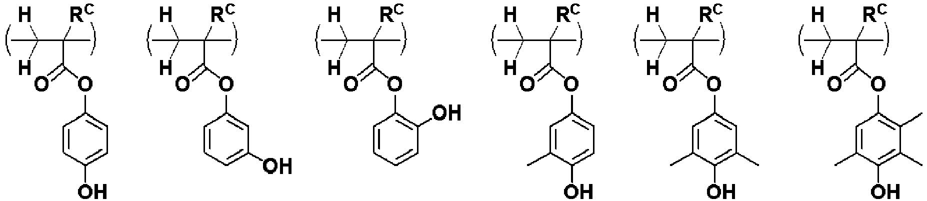

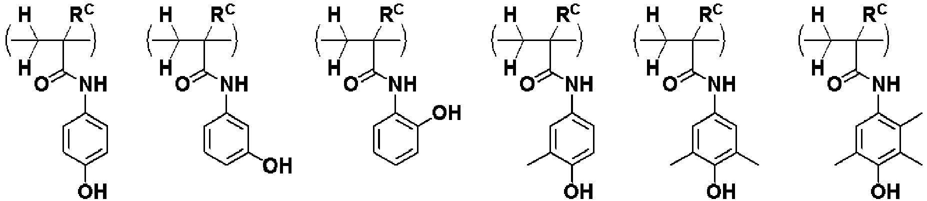

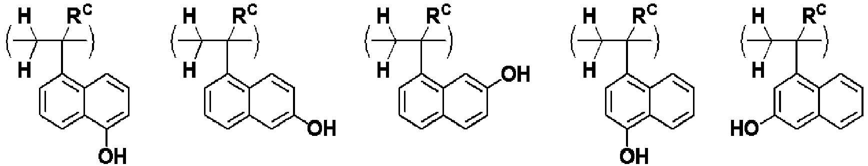

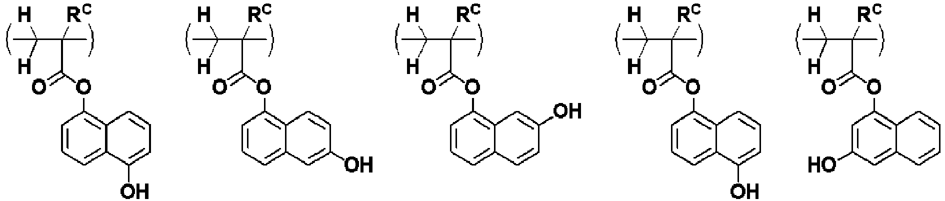

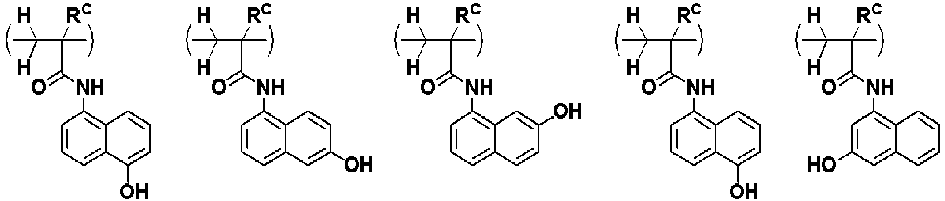

In the formula (D6), the saturated hydrocarbylene group represented by Z³ having 1 to 10 carbon atoms may be linear, branched or cyclic, and specific examples thereof include a methanediyl group, an ethane-1,1-diyl group, an ethane-1,2-diyl group, a propane-1,1-diyl group, a propane-1,2-diyl group, a propane-1,3-diyl group, a propane-2,2-diyl group, a butane-1,1-diyl group, a butane-1,2-diyl group, a butane-1,3-diyl group, a butane-2,3-diyl group, a butane-1,4-diyl group, and a 1,1-dimethylethane-1,2-diyl group.

In the formula (D6), the saturated hydrocarbyl group represented by R¹¹¹ having 1 to 20 carbon atoms, at least one hydrogen atom being substituted with a fluorine atom, may be linear, branched, or cyclic. Specific examples thereof include alkyl groups having 1 to 20 carbon atoms and cyclic saturated hydrocarbyl groups having 3 to 20 carbon atoms, at least one hydrogen atom of the groups being substituted with a fluorine atom.

Examples of the repeating unit D6 include the following, but are not limited thereto. In the following formulae, R^{C} is as defined above.

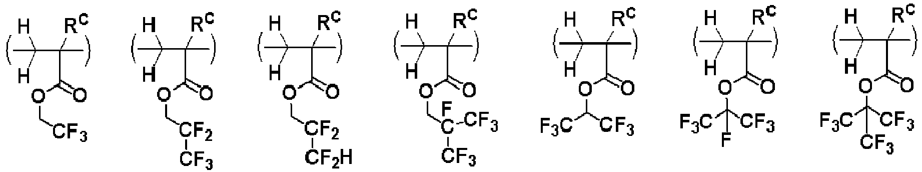

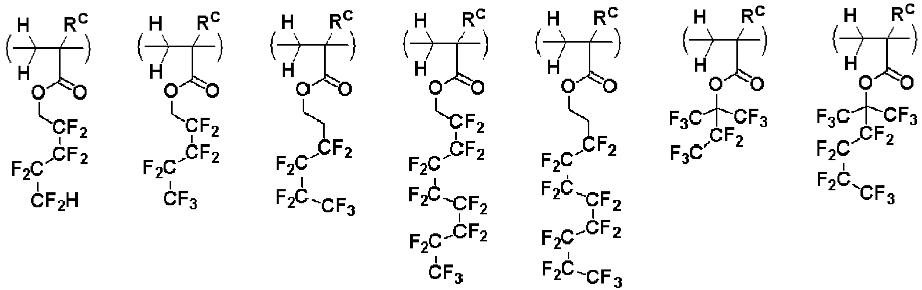

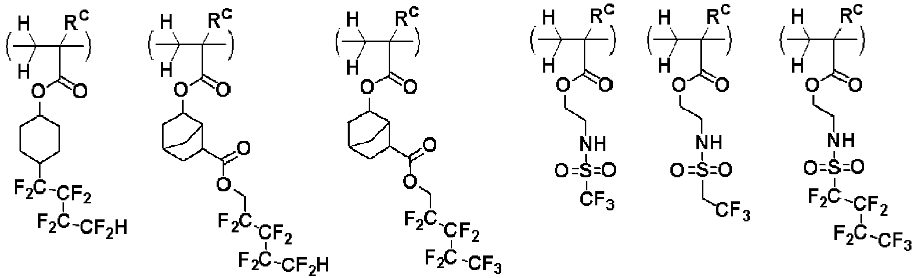

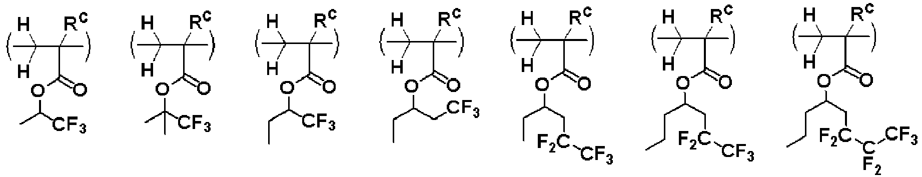

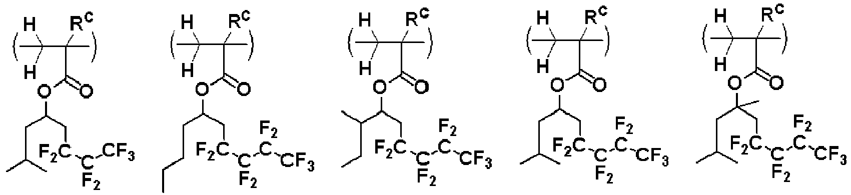

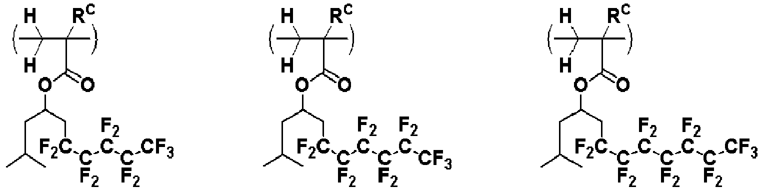

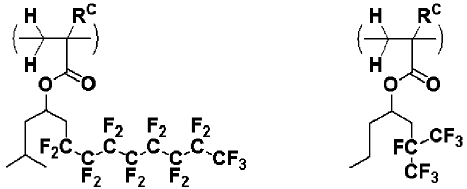

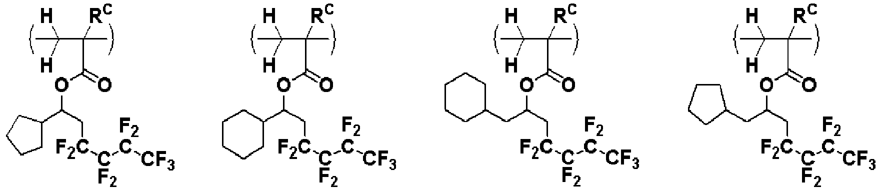

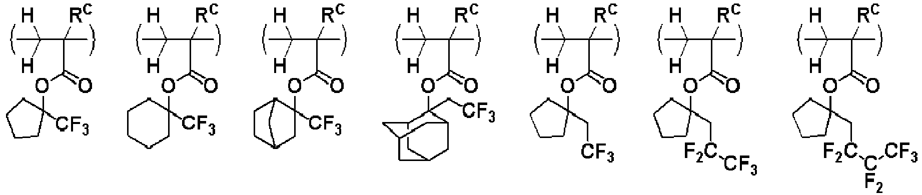

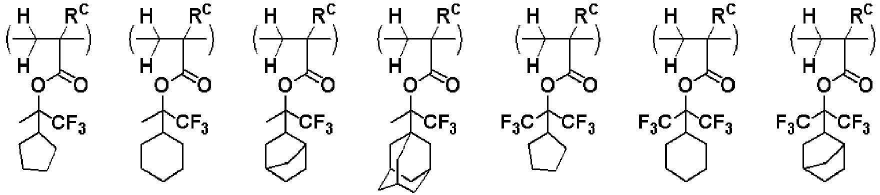

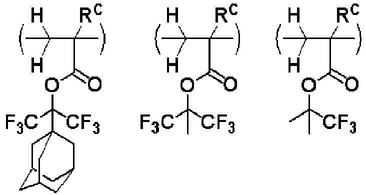

The repeating units D1 to D4 are preferably contained in an amount of 15 to 95 mol%, more preferably 20 to 85 mol% with respect to all the repeating units of the fluorine-containing polymer. The repeating units D5 and/or D6 are preferably contained in an amount of 5 to 85 mol%, more preferably 15 to 80 mol% with respect to all the repeating units of the fluorine-containing polymer. One kind of the repeating units D1 to D6 may be used, or two or more kinds may be used in combination.

The fluorine-containing polymer may also contain other repeating units besides the above-described repeating units. Such repeating units include those disclosed in paragraphs [0046] to [0078] of JP2014-177407A. When the fluorine-containing polymer contains the other repeating units, the contained amount is preferably 50 mol% or less of all the repeating units of the fluorine-containing polymer.

The fluorine-containing polymer can be synthesized by known methods including copolymerization of each monomer that has been protected with a protective group in accordance with needs, followed by a deprotection reaction in accordance with needs. The copolymerization reaction is not particularly limited, but is preferably radical polymerization or anionic polymerization. Regarding these methods, JP2004-115630A may be consulted.

The fluorine-containing polymer preferably has an Mw of 2,000 to 50,000, more preferably 3,000 to 20,000. When the Mw is 2,000 or more, acid does not diffuse, resolution does not become degraded, and stability over time does not become degraded. When Mw is 50,000 or less, solubility in a solvent is sufficient, and coating defects are not generated. In addition, the fluorine-containing polymer preferably has an Mw/Mn of 1.0 to 2.2, more preferably 1.0 to 1.7.

When the inventive chemically amplified positive resist composition contains the fluorine-containing polymer, the contained amount is preferably 0.01 to 30 parts by mass, more preferably 0.1 to 20 parts by mass, and further preferably 0.5 to 10 parts by mass relative to 80 parts by mass of the polymer.

### [Photo-Acid Generator]

The inventive chemically amplified positive resist composition may contain a photo-acid generator. The photo-acid generator is not particularly limited as long as the photo-acid generator is a compound that generates an acid upon irradiation with a high-energy beam. Suitable examples of the photo-acid generator include sulfonium salts, iodonium salts, sulfonyldiazo methane, N-sulfonyl oxyimide, and oxime-o-sulfonate type acid generators.

Specific examples of the photo-acid generator include nonafluorobutanesulfonate, partially fluorinated sulfonates described in paragraphs [0247]-[0251] of JP2012-189977A, partially fluorinated sulfonates described in paragraphs [0261]-[0265] of JP2013-101271A, the ones described in paragraphs [0122]-[0142] of JP2008-111103A, and paragraphs [0080]-[0081] of JP2010-215608A. Among the above specific examples, aryl sulfonate type and alkane sulfonate type photo-acid generators generate an acid having an appropriate acidity for the deprotection of the acid-labile group of the repeating unit represented by the formula (A1), and are preferable.

As such photo-acid generators, compounds having an anion having a structure shown below are preferable.

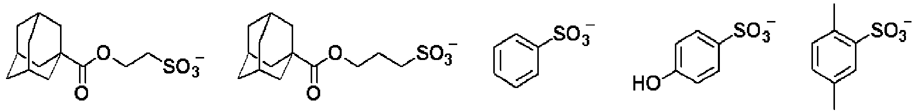

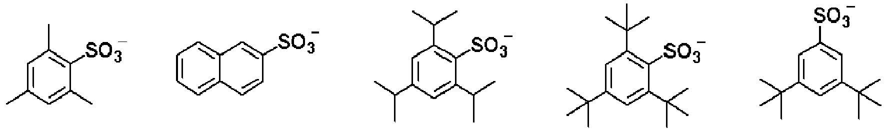

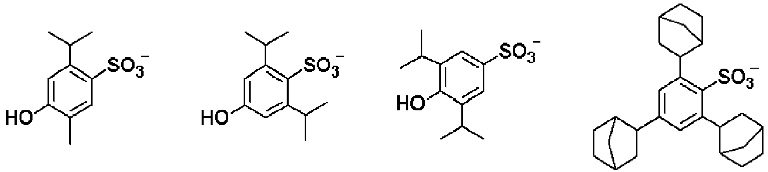

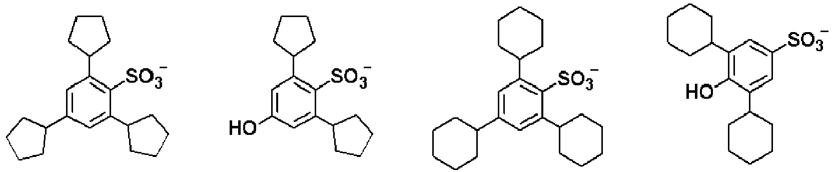

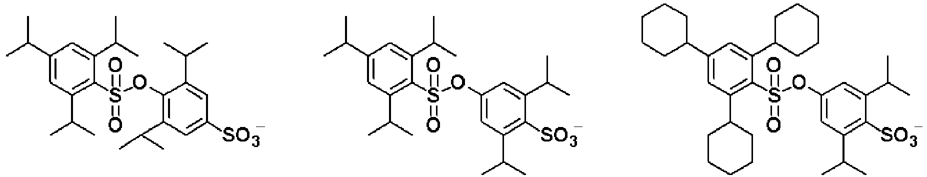

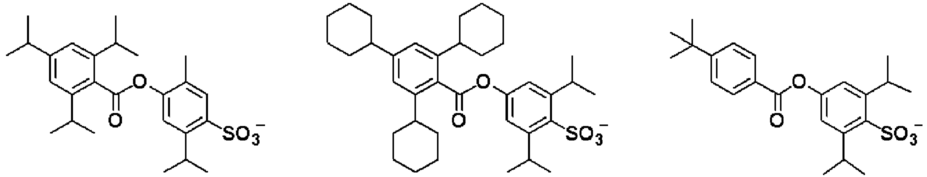

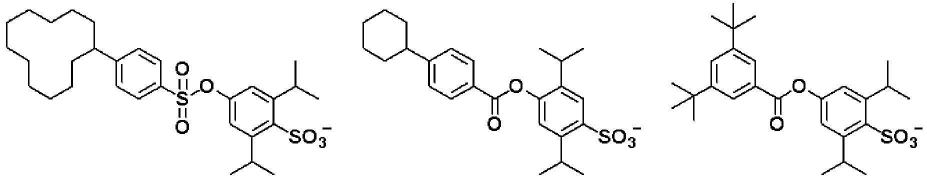

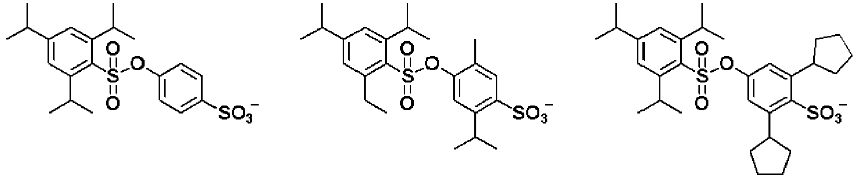

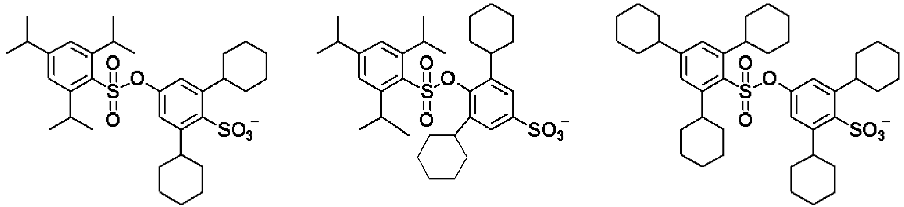

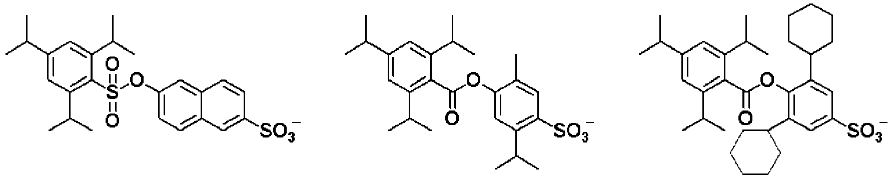

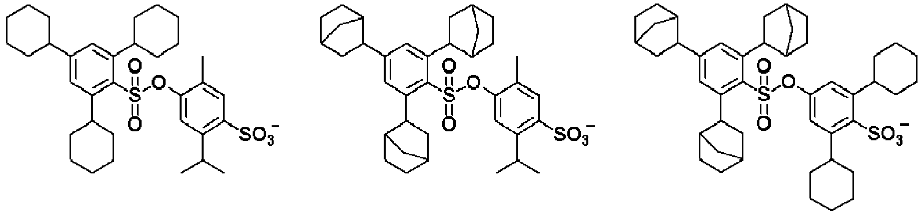

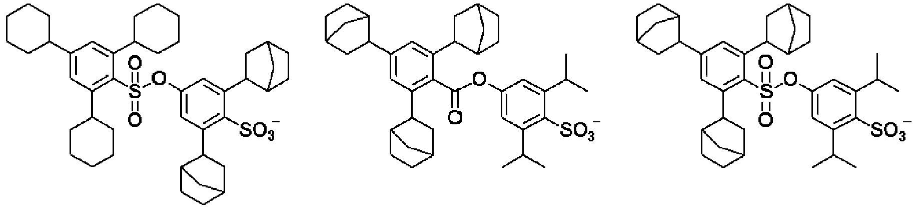

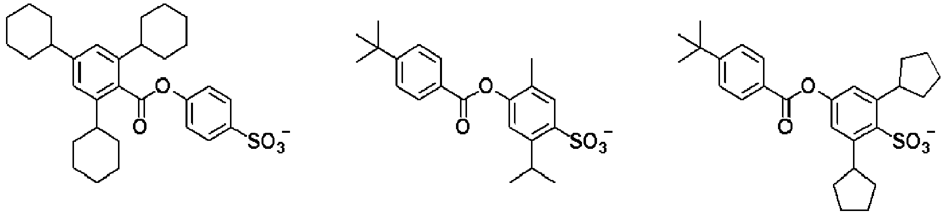

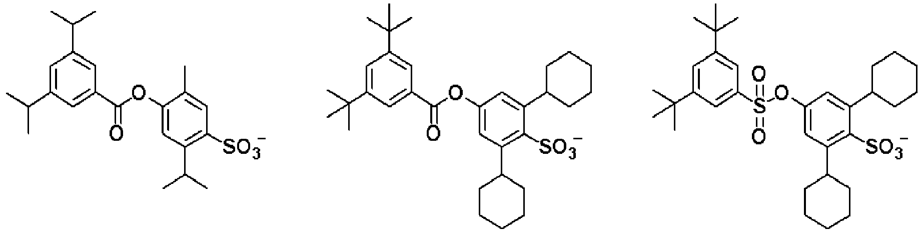

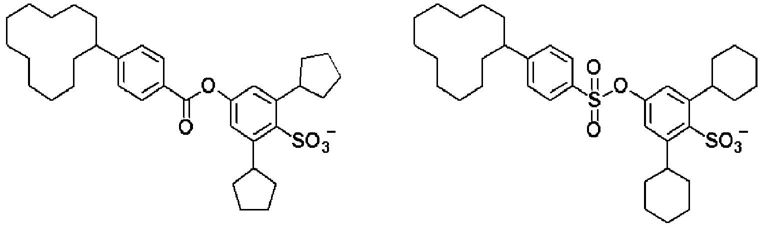

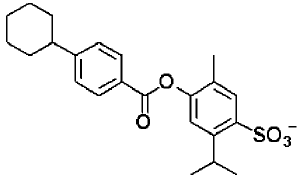

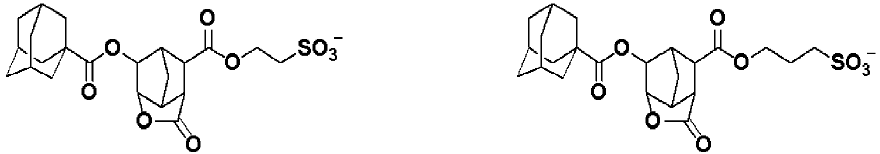

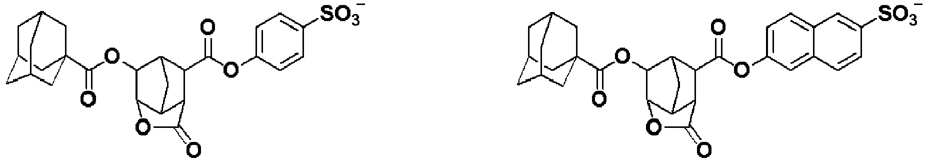

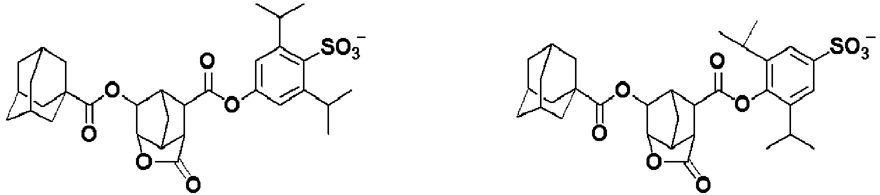

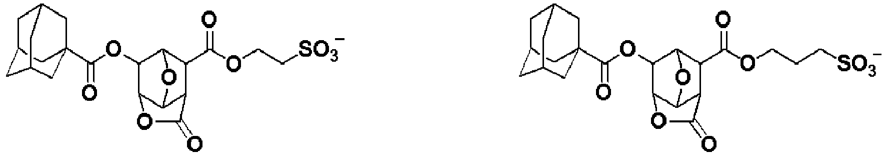

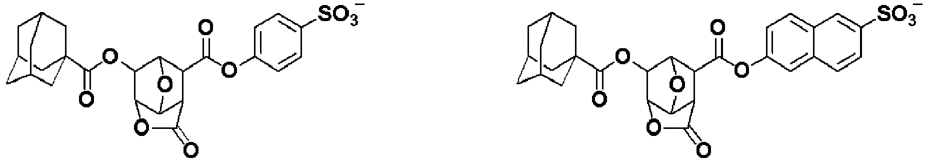

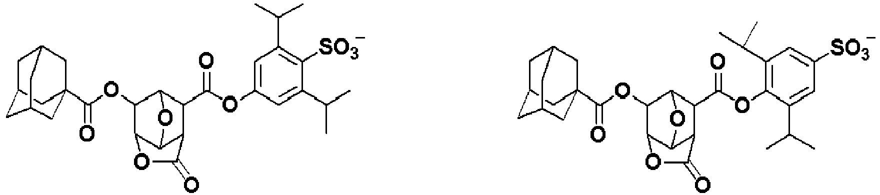

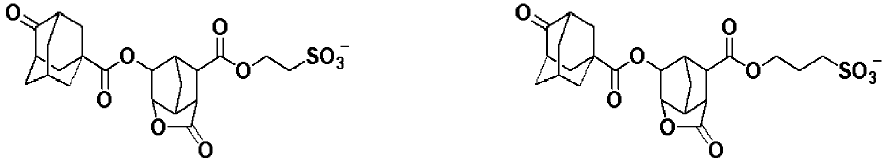

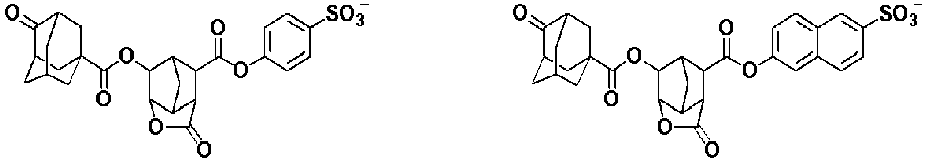

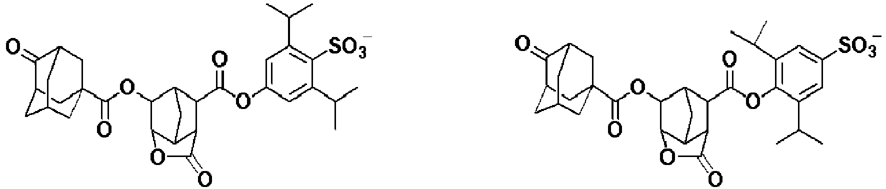

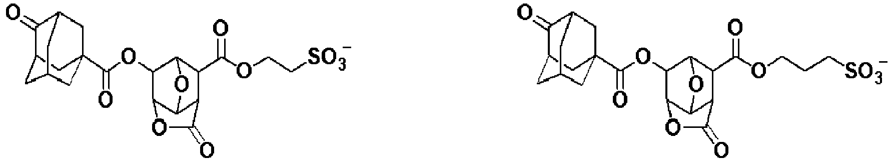

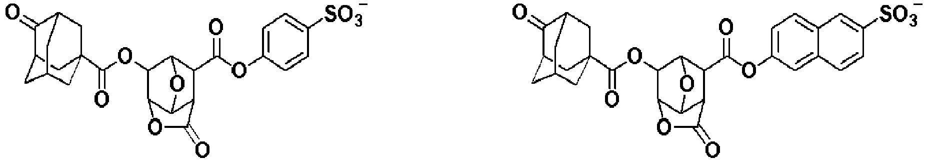

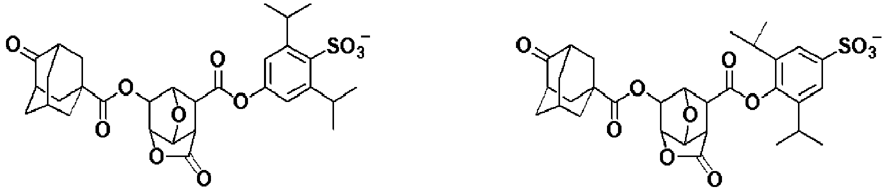

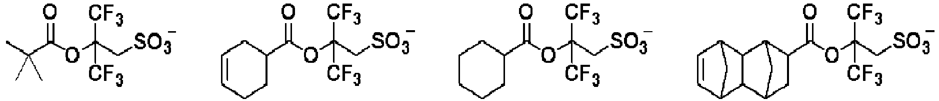

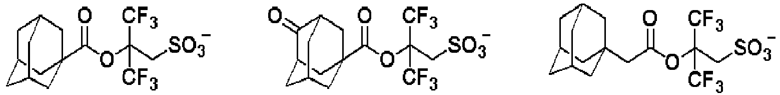

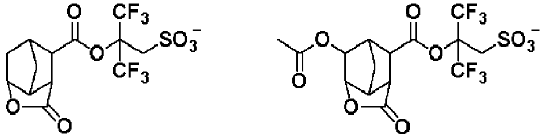

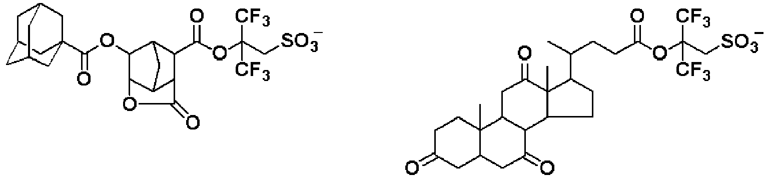

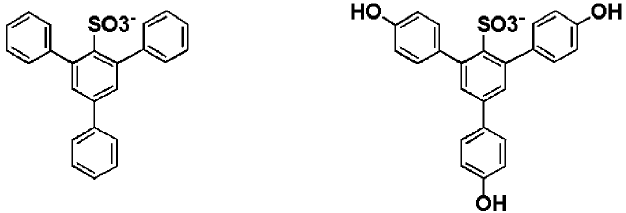

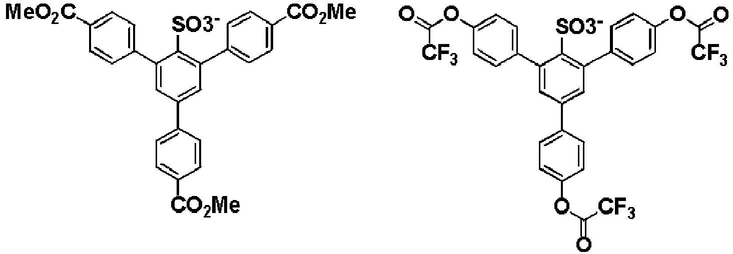

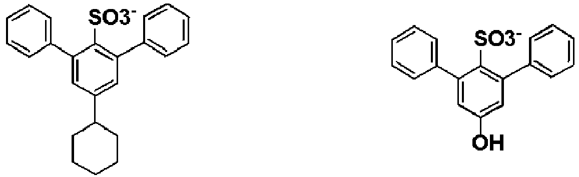

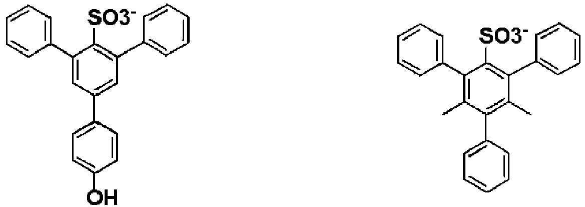

The photo-acid generator preferably contains an anion structure of a photo-acid generator represented by the following formula (M-1).

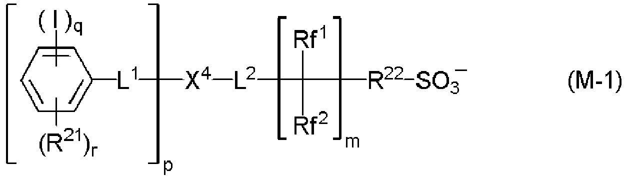

In the formula (M-1), "m" represents 0 or 1. "p" represents an integer of 1 to 3. "q" represents an integer of 1 to 5. "r" represents an integer of 0 to 3. L¹ represents a single bond, an ether bond, an ester bond, a sulfonic acid ester bond, a carbonate bond, or a carbamate bond. L² represents an ether bond, an ester bond, a sulfonic acid ester bond, a carbonate bond, or a carbamate bond. X⁴ represents a single bond or a hydrocarbylene group having 1 to 20 carbon atoms when "p" is 1, and represents a hydrocarbon group having a valency of p+1 and having 1 to 20 carbon atoms when "p" is 2 or 3, the hydrocarbylene group and the hydrocarbon group having a valency of p+1 optionally having at least one selected from an ether bond, a carbonyl group, an ester bond, an amide bond, a sultone ring, a lactam ring, a carbonate bond, a halogen atom, a hydroxy group, and a carboxy group. Rf¹ and Rf² each independently represent a hydrogen atom, a fluorine atom, or a trifluoromethyl group, provided that at least one is a fluorine atom or a trifluoromethyl group. R²¹ represents a hydroxy group, a carboxy group, a saturated hydrocarbyl group having 1 to 6 carbon atoms, a saturated hydrocarbyloxy group having 1 to 6 carbon atoms, a saturated hydrocarbylcarbonyloxy group having 2 to 6 carbon atoms, a fluorine atom, a chlorine atom, a bromine atom, an amino group, -N(R^{1A})-C(=O)-R^{1B}, or -N(R^{1A})-C(=O)-O-R^{1B}. R^{1A} represents a hydrogen atom or a saturated hydrocarbyl group having 1 to 6 carbon atoms. R^{1B} represents a saturated hydrocarbyl group having 1 to 6 carbon atoms or an unsaturated aliphatic hydrocarbyl group having 2 to 8 carbon atoms. R²² represents a saturated hydrocarbylene group having 1 to 20 carbon atoms or an arylene group having 6 to 14 carbon atoms, a part or all of hydrogen atoms in the saturated hydrocarbylene group optionally being substituted with a halogen atom other than a fluorine atom, and a part or all of hydrogen atoms in the arylene group optionally being substituted with a substituent selected from a saturated hydrocarbyl group having 1 to 20 carbon atoms, a saturated hydrocarbyloxy group having 1 to 20 carbon atoms, an aryl group having 6 to 14 carbon atoms, a halogen atom, and a hydroxy group.

In the formula (M-1), "m" represents 0 or 1. "p" represents an integer of 1 to 3. "q" represents an integer of 1 to 5. "r" represents an integer of 0 to 3.

In the formula (M-1), L¹ represents a single bond, an ether bond, an ester bond, a sulfonic acid ester bond, a carbonate bond, or a carbamate bond.

In the formula (M-1), L² represents an ether bond, an ester bond, a sulfonic acid ester bond, a carbonate bond, or a carbamate bond.

In the formula (M-1), X⁴ represents a single bond or a hydrocarbylene group having 1 to 20 carbon atoms when "p" is 1, and represents a hydrocarbon group having a valency of p+1 and having 1 to 20 carbon atoms when "p" is 2 or 3, the hydrocarbylene group and the hydrocarbon group having a valency of p+1 optionally having at least one selected from an ether bond, a carbonyl group, an ester bond, an amide bond, a sultone ring, a lactam ring, a carbonate bond, a halogen atom, a hydroxy group, and a carboxy group.

The hydrocarbylene group represented by X⁴ having 1 to 20 carbon atoms may be saturated or unsaturated, and may be linear, branched, or cyclic. Specific examples thereof include: alkanediyl groups having 1 to 20 carbon atoms, such as a methanediyl group, an ethane-1,1-diyl group, an ethane-1,2-diyl group, a propane-1,3-diyl group, a butane-1,4-diyl group, a pentane-1,5-diyl group, a hexane-1,6-diyl group, a heptane-1,7-diyl group, an octane-1,8-diyl group, a nonane-1,9-diyl group, a decane-1,10-diyl group, an undecane-1,11-diyl group, and a dodecane-1,12-diyl group; cyclic saturated hydrocarbylene groups having 3 to 20 carbon atoms, such as a cyclopentanediyl group, a cyclohexanediyl group, a norbornanediyl group, and an adamantanediyl group; unsaturated aliphatic hydrocarbylene groups having 2 to 20 carbon atoms, such as a vinylene group and a propene-1,3-diyl group; arylene groups having 6 to 20 carbon atoms, such as a phenylene group and a naphthylene group; and groups obtained by combining these groups. Furthermore, the hydrocarbon group represented by X⁴ having a valency of p+1 and having 1 to 20 carbon atoms may be saturated or unsaturated, and may by linear, branched, or cyclic. Specific examples thereof include the above-mentioned specific examples of the hydrocarbylene groups having 1 to 20 carbon atoms, the groups having one or two fewer hydrogen atoms.

In the formula (M-1), Rf¹ and Rf² each independently represent a hydrogen atom, a fluorine atom, or a trifluoromethyl group, provided that at least one is a fluorine atom or a trifluoromethyl group.

In the formula (M-1), R²¹ represents a hydroxy group, a carboxy group, a saturated hydrocarbyl group having 1 to 6 carbon atoms, a saturated hydrocarbyloxy group having 1 to 6 carbon atoms, a saturated hydrocarbylcarbonyloxy group having 2 to 6 carbon atoms, a fluorine atom, a chlorine atom, a bromine atom, an amino group, -N(R^{1A})-C(=O)-R^{1B}, or -N(R^{1A})-C(=O)-O-R^{1B}. R^{1A} represents a hydrogen atom or a saturated hydrocarbyl group having 1 to 6 carbon atoms. R^{1B} represents a saturated hydrocarbyl group having 1 to 6 carbon atoms or an unsaturated aliphatic hydrocarbyl group having 2 to 8 carbon atoms.

The saturated hydrocarbyl groups represented by R²¹, R^{1A}, and R^{1B} having 1 to 6 carbon atoms may be linear, branched, or cyclic, and specific examples thereof include: alkyl groups having 1 to 6 carbon atoms, such as a methyl group, an ethyl group, an n-propyl group, an isopropyl group, an n-butyl group, an isobutyl group, a sec-butyl group, a tert-butyl group, an n-pentyl group, and an n-hexyl group; and cyclic saturated hydrocarbyl groups having 3 to 6 carbon atoms, such as a cyclopropyl group, a cyclobutyl group, a cyclopentyl group, and a cyclohexyl group. Examples of the saturated hydrocarbyl moiety of the saturated hydrocarbyloxy group represented by R²¹ having 1 to 6 carbon atoms include the specific examples of the saturated hydrocarbyl group given above, and examples of the saturated hydrocarbyl moiety of the saturated hydrocarbylcarbonyloxy group represented by R²¹ having 2 to 6 carbon atoms include, out of the specific examples of the saturated hydrocarbyl group having 1 to 6 carbon atoms given above, the groups having 1 to 5 carbon atoms.

The unsaturated aliphatic hydrocarbyl group represented by R^{1B} having 2 to 8 carbon atoms may be linear, branched, or cyclic, and specific examples thereof include: alkenyl groups having 2 to 8 carbon atoms, such as a vinyl group, a propenyl group, a butenyl group, and a hexenyl group; alkynyl groups having 2 to 8 carbon atoms, such as an ethynyl group, a propynyl group, and a butynyl group; and cyclic unsaturated aliphatic hydrocarbyl groups having 3 to 8 carbon atoms, such as a cyclohexenyl group and a norbornenyl group.

In the formula (M-1), R²² represents a saturated hydrocarbylene group having 1 to 20 carbon atoms or an arylene group having 6 to 14 carbon atoms, a part or all of hydrogen atoms in the saturated hydrocarbylene group optionally being substituted with a halogen atom other than a fluorine atom, and a part or all of hydrogen atoms in the arylene group optionally being substituted with a substituent selected from a saturated hydrocarbyl group having 1 to 20 carbon atoms, a saturated hydrocarbyloxy group having 1 to 20 carbon atoms, an aryl group having 6 to 14 carbon atoms, a halogen atom, and a hydroxy group.

The hydrocarbylene group represented by R²² having 1 to 20 carbon atoms may be saturated or unsaturated, and may be linear, branched, or cyclic. Specific examples thereof include the groups given as the examples of the hydrocarbylene group represented by X⁴ having 1 to 20 carbon atoms.

Specific examples of the arylene group represented by R²² having 6 to 14 carbon atoms include a phenylene group, a naphthylene group, a phenanthrenediyl group, and an anthracenediyl group. The saturated hydrocarbyl group having 1 to 20 carbon atoms and the hydrocarbyl moiety of the hydrocarbyloxy group having 1 to 20 carbon atoms, the groups being substituents of the arylene group, may be linear, branched, or cyclic. Specific examples thereof include: alkyl groups having 1 to 20 carbon atoms, such as a methyl group, an ethyl group, an n-propyl group, an isopropyl group, an n-butyl group, an isobutyl group, a sec-butyl group, a tert-butyl group, an n-pentyl group, an n-hexyl group, an n-octyl group, an n-nonyl group, an n-decyl group, an undecyl group, a dodecyl group, a tridecyl group, a tetradecyl group, a pentadecyl group, a heptadecyl group, an octadecyl group, a nonadecyl group, and an icosyl group; cyclic saturated hydrocarbyl groups having 3 to 20 carbon atoms, such as a cyclopropyl group, a cyclopentyl group, a cyclohexyl group, a cyclopropylmethyl group, a 4-methylcyclohexyl group, a cyclohexylmethyl group, a norbornyl group, and an adamantyl group. Specific examples of the arylene group, which is a substituent of the arylene group, having 6 to 14 carbon atoms include a phenylene group, a naphthylene group, a phenanthrenediyl group, and an anthracenediyl group.

The photo-acid generator further preferably contains an anion structure of a photo-acid generator represented by the following formula (M-2).

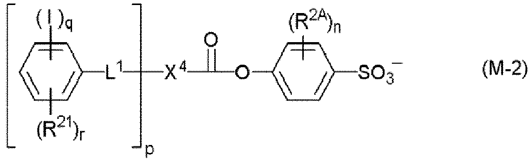

In the formula (M-2), "p", "q", "r", L¹, X⁴, and R²¹ are as defined above. "n" represents an integer of 1 to 4. R^{2A} represents a saturated hydrocarbyl group having 1 to 20 carbon atoms, a saturated hydrocarbyloxy group having 1 to 20 carbon atoms, an aryl group having 6 to 14 carbon atoms, a halogen atom, or a hydroxy group. When "n" is 2 to 4, the R^{2A}s may be identical to or different from one another.

Examples of the anion of the sulfonic acid represented by the formula (M-1) include the following, but are not limited thereto.

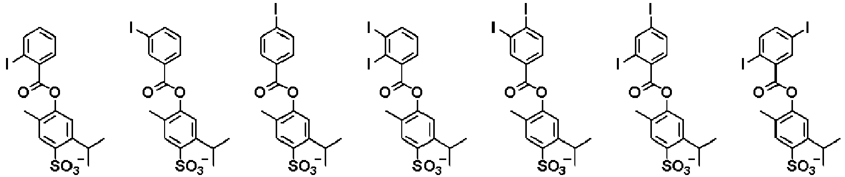

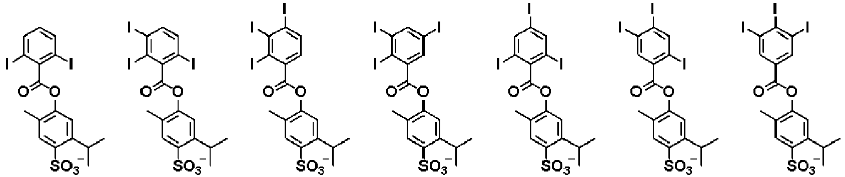

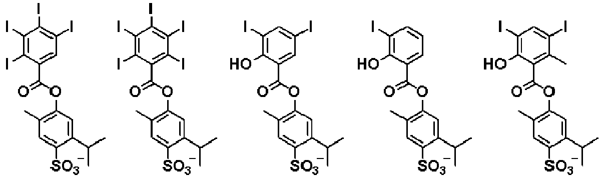

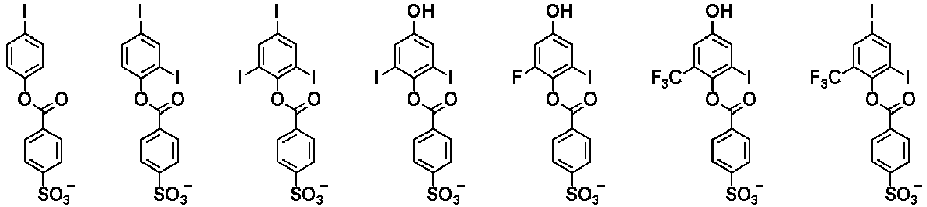

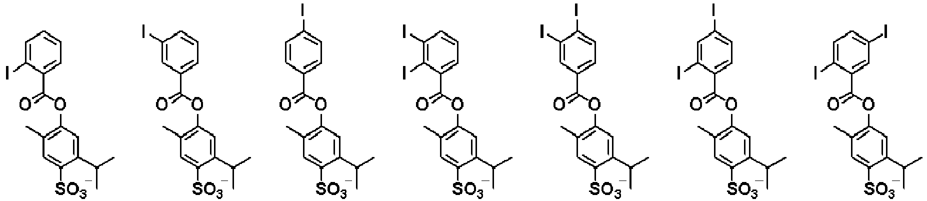

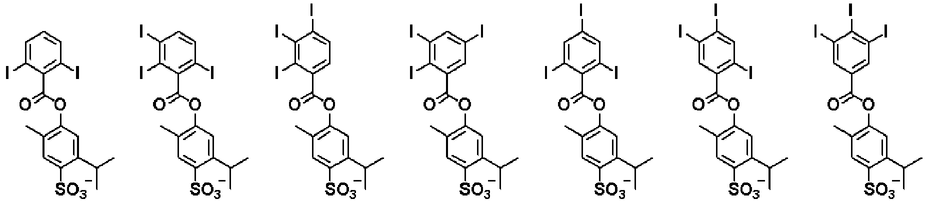

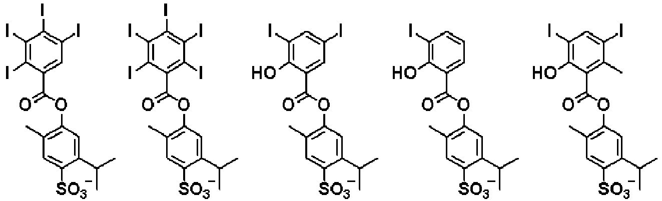

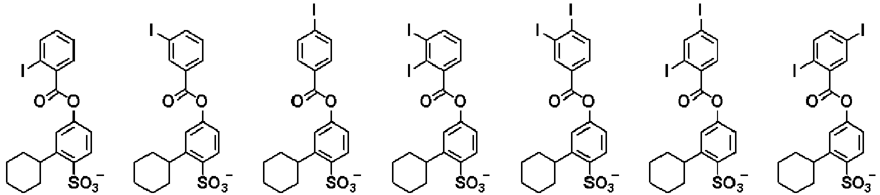

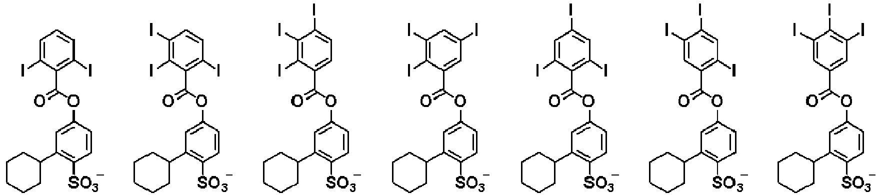

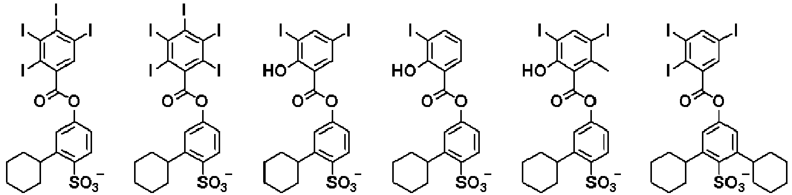

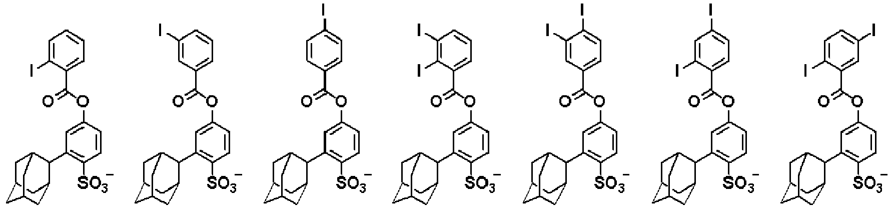

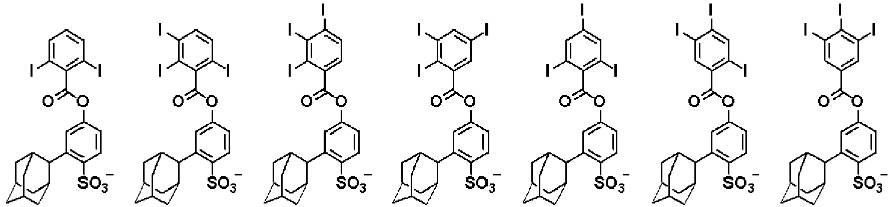

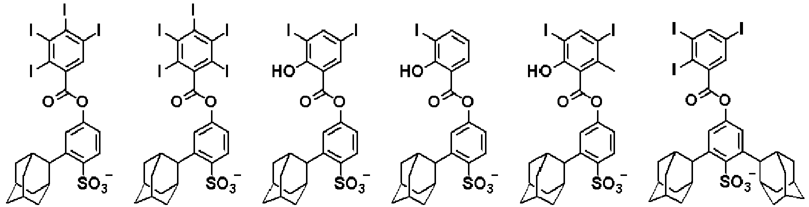

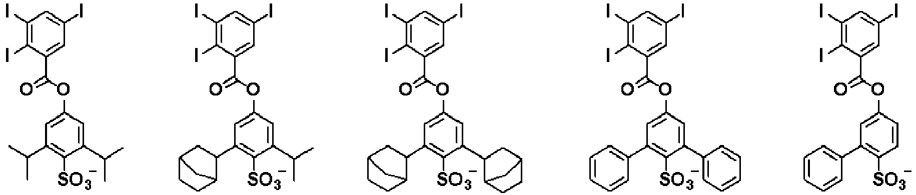

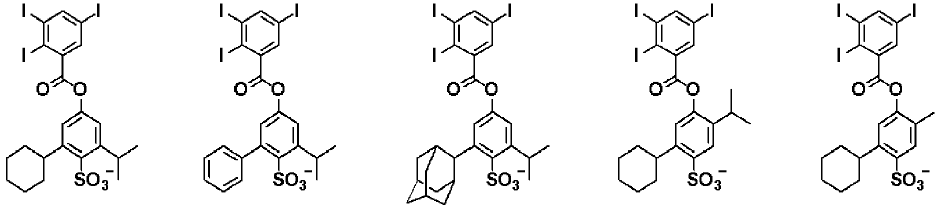

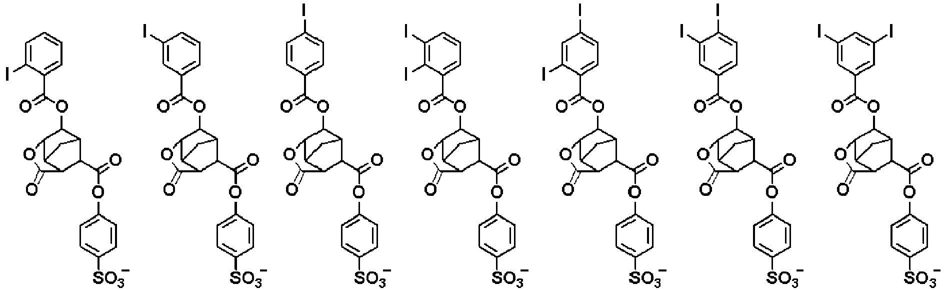

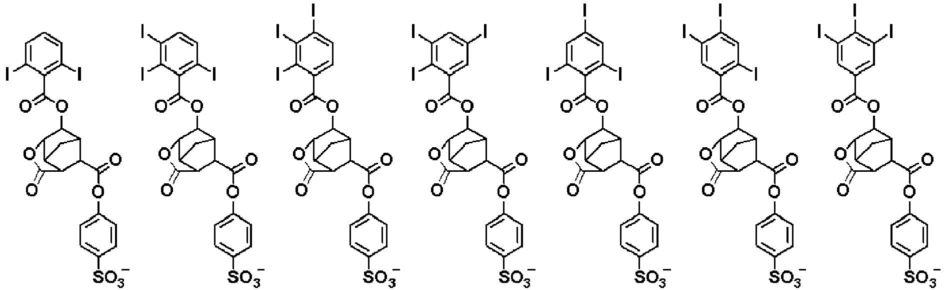

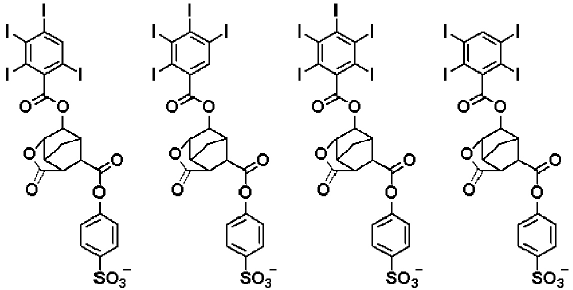

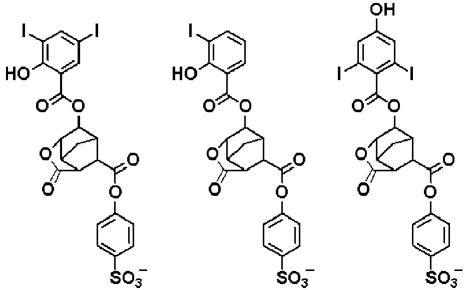

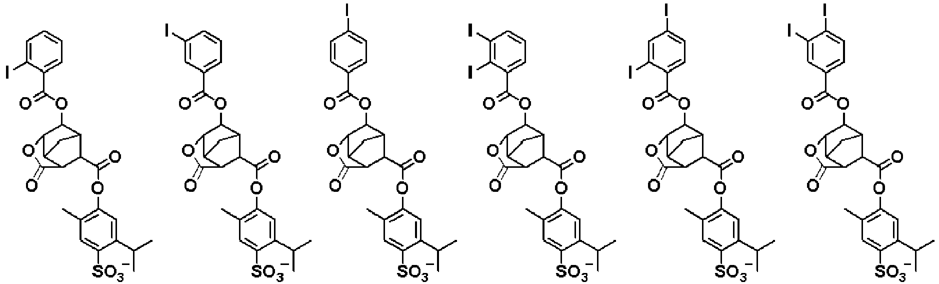

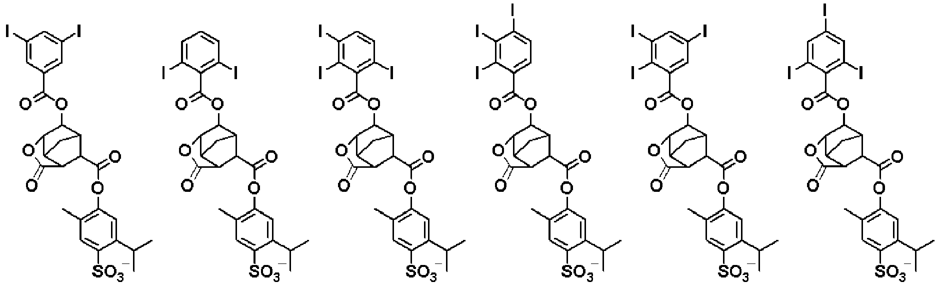

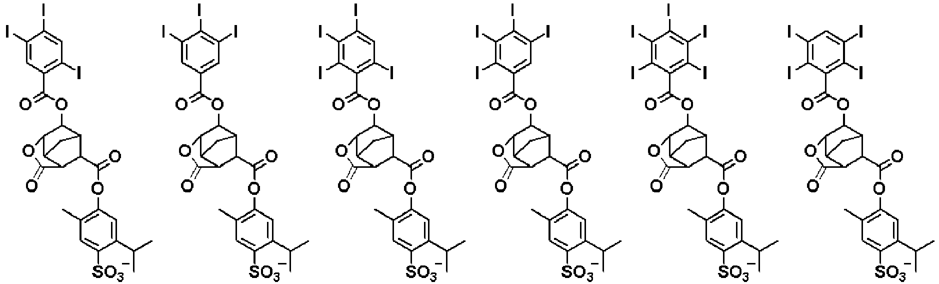

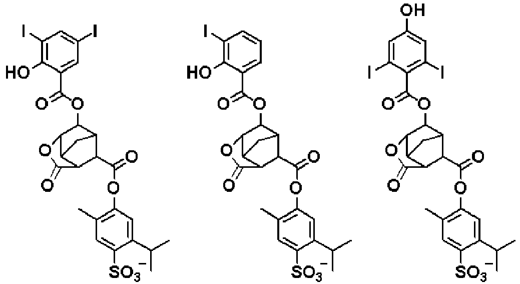

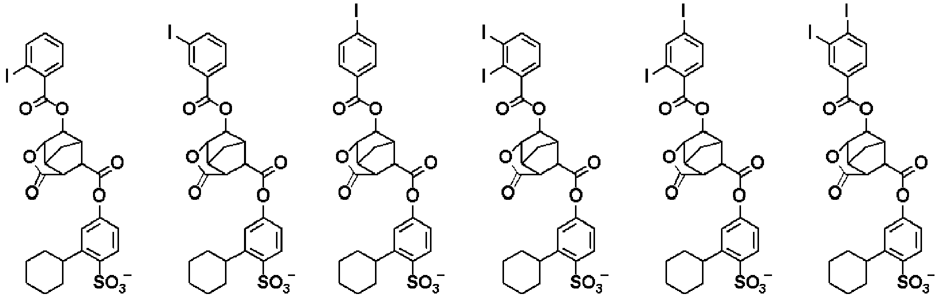

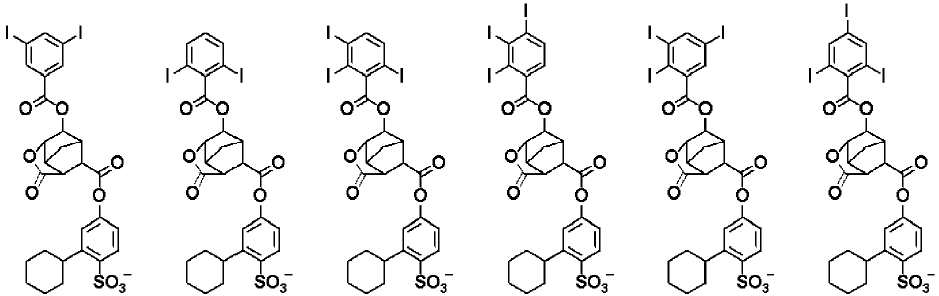

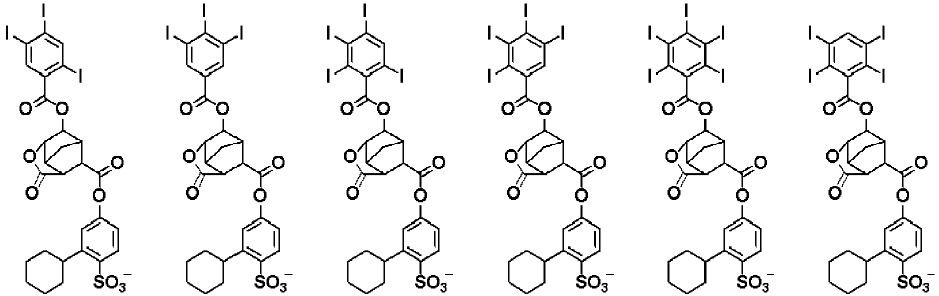

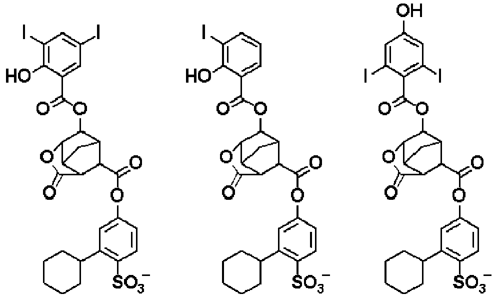

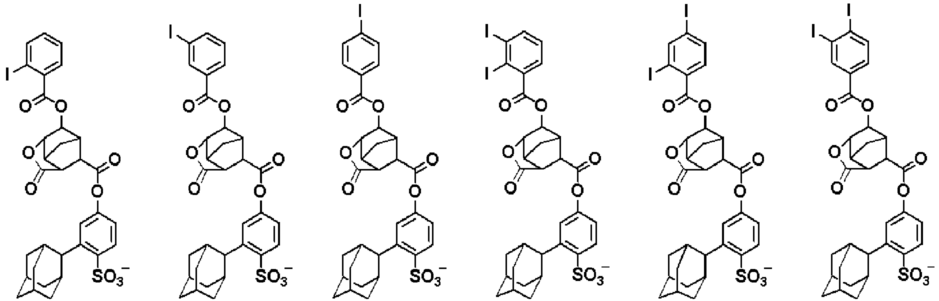

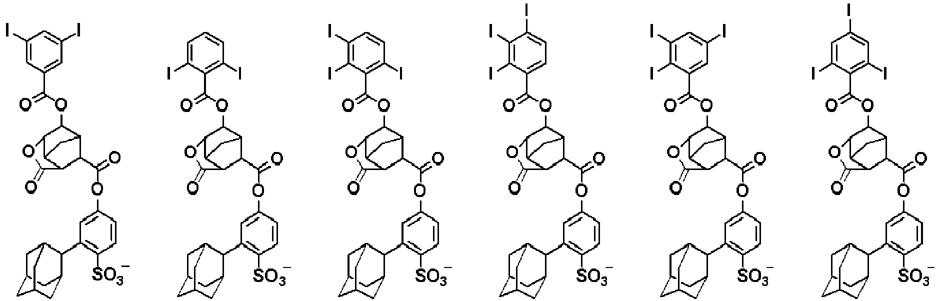

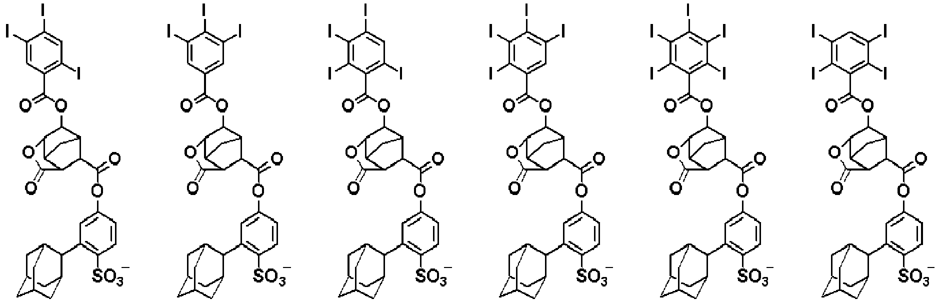

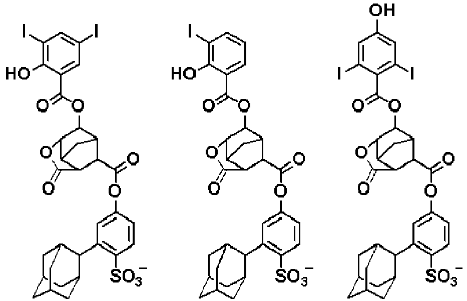

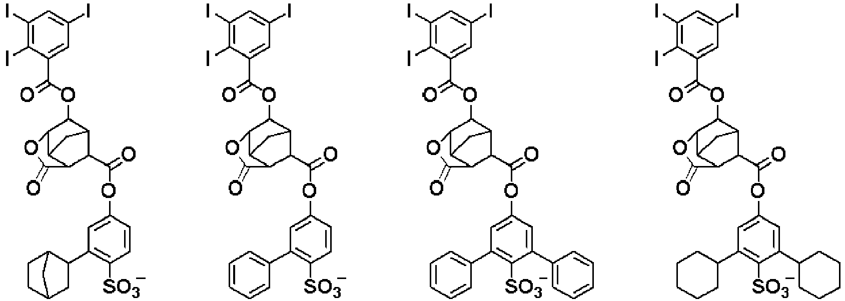

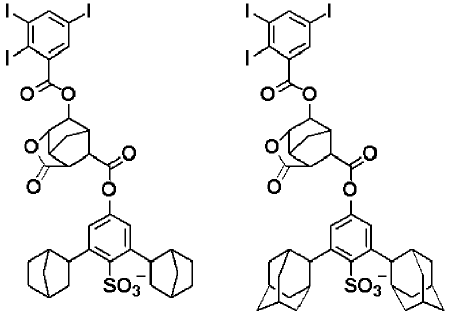

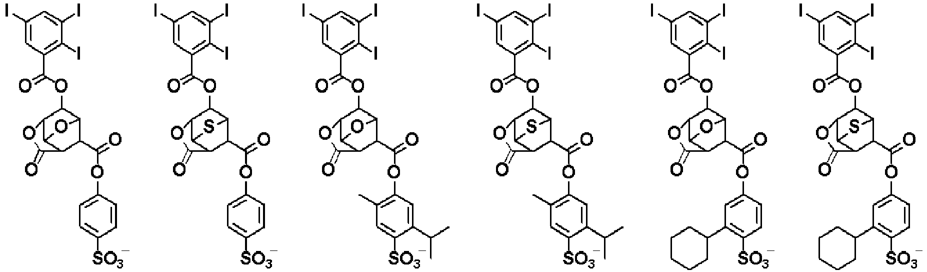

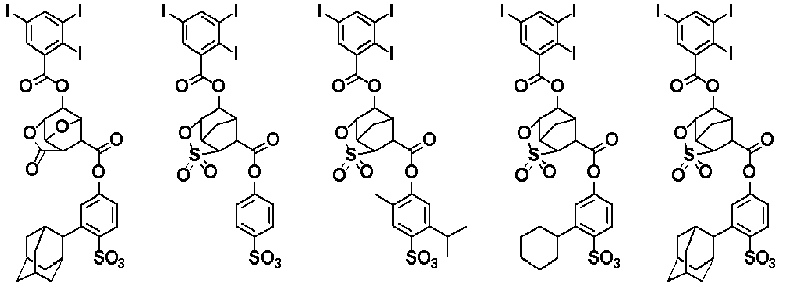

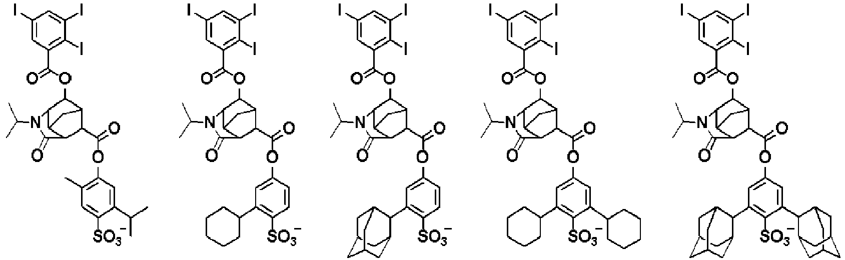

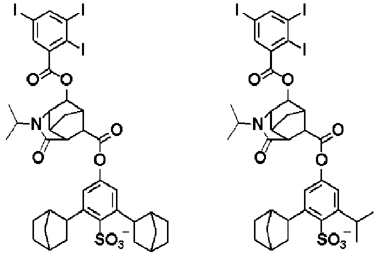

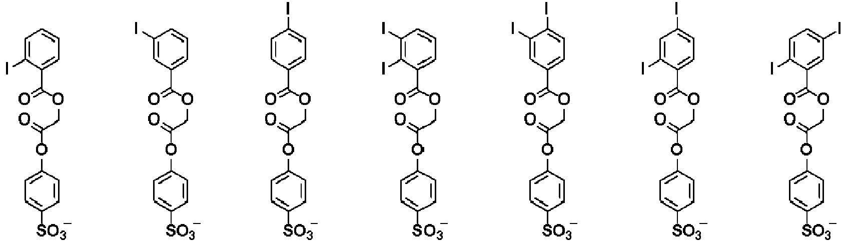

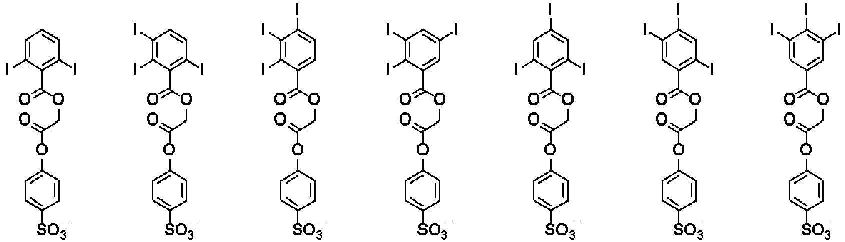

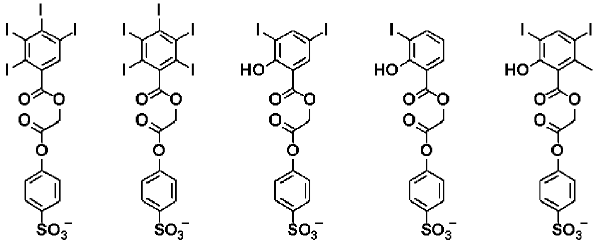

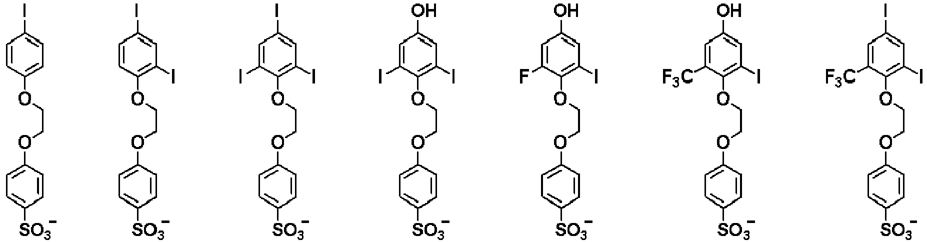

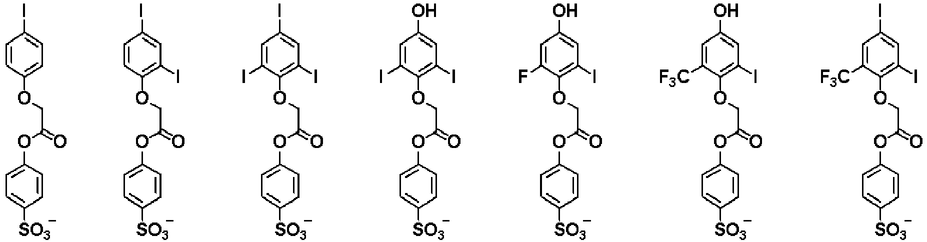

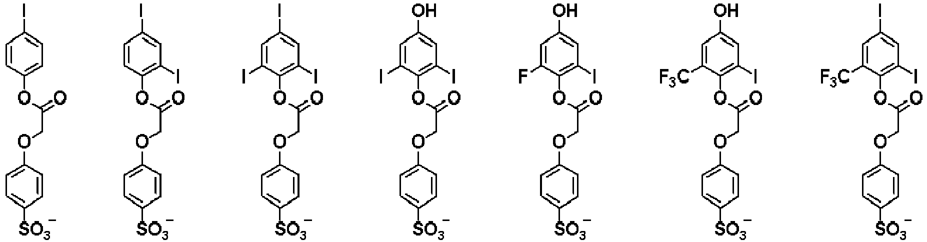

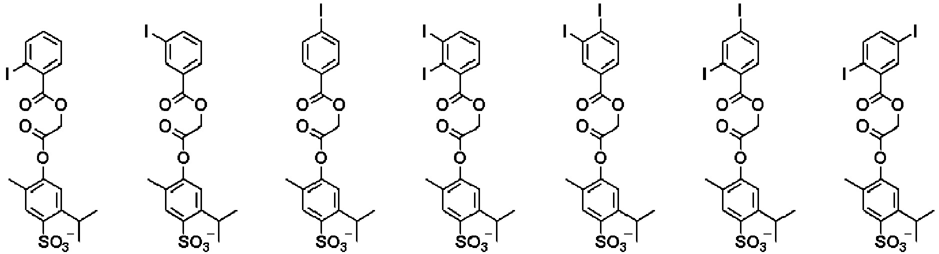

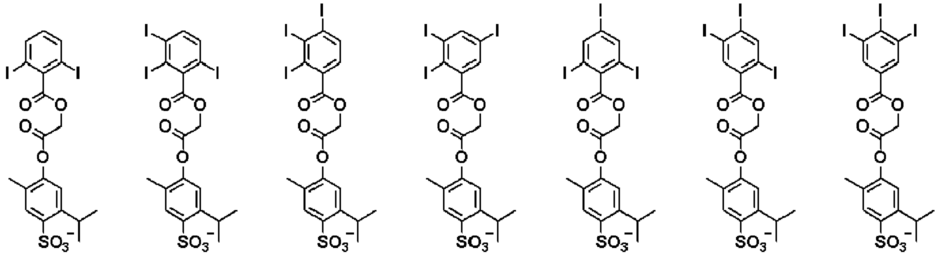

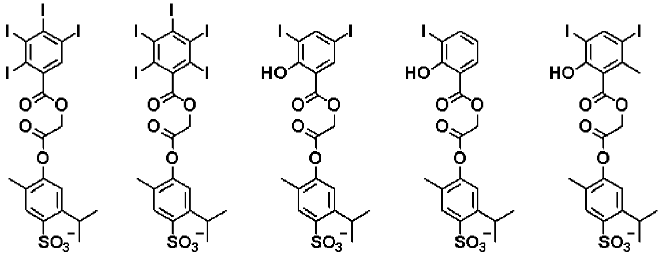

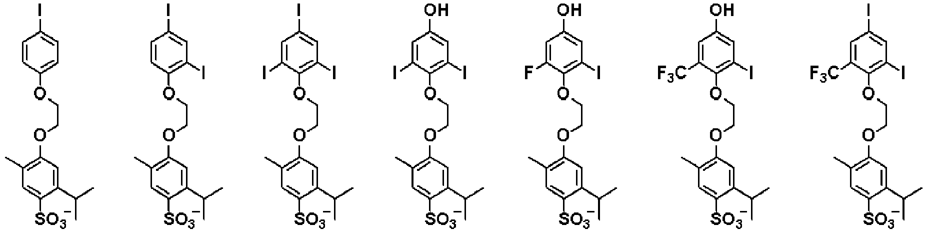

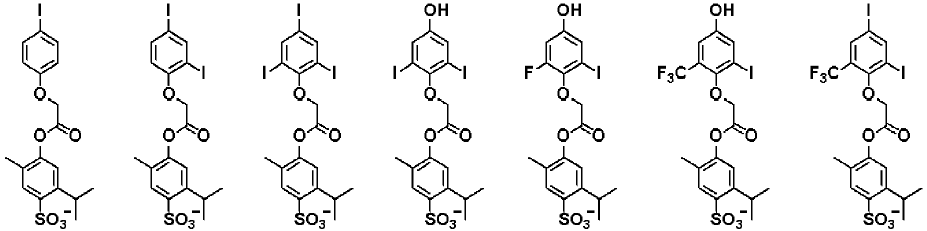

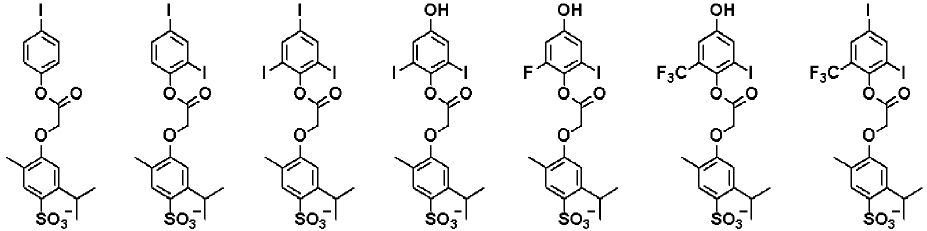

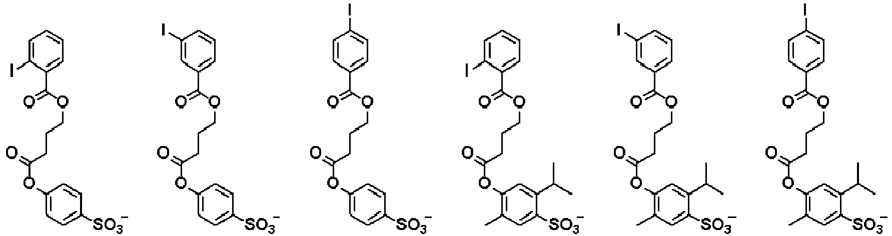

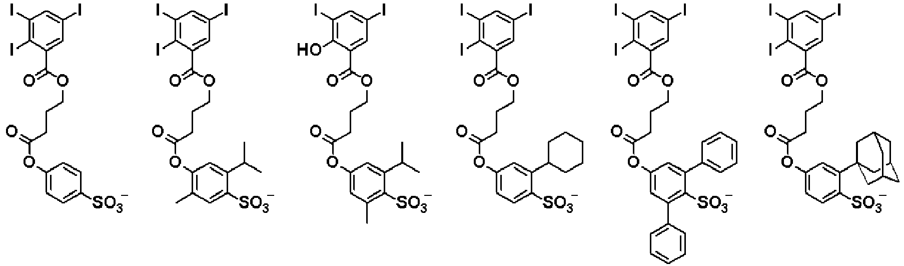

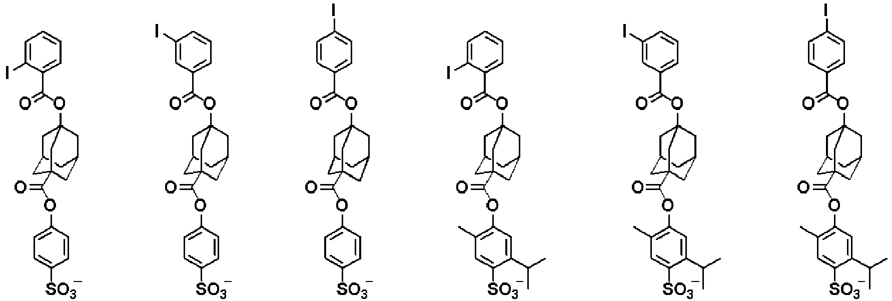

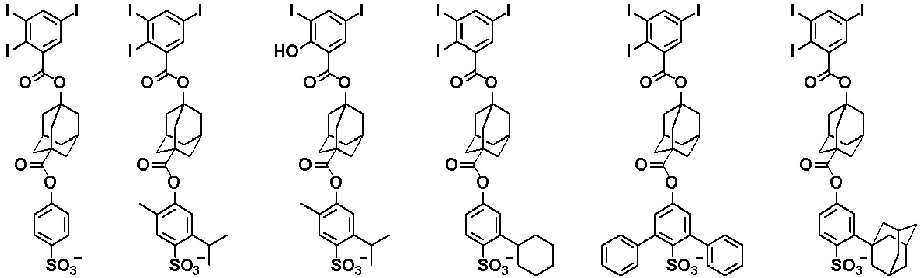

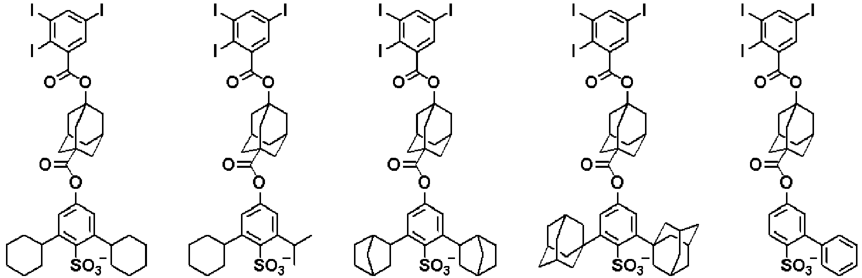

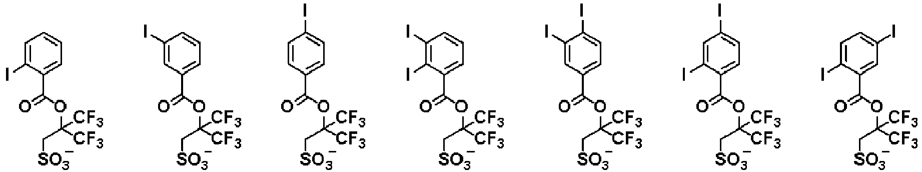

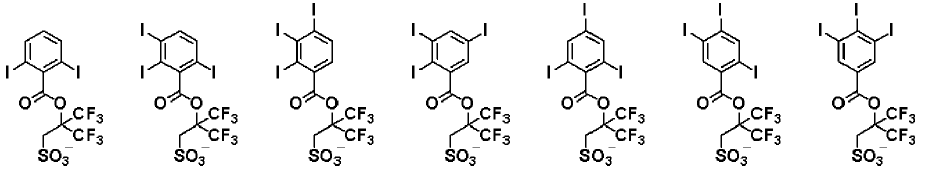

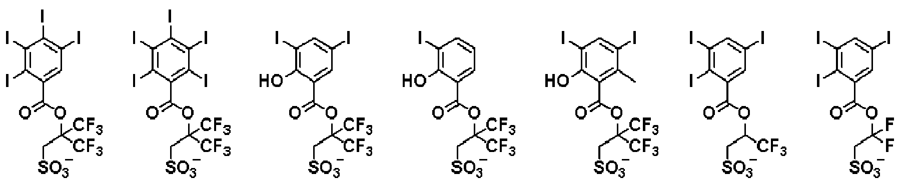

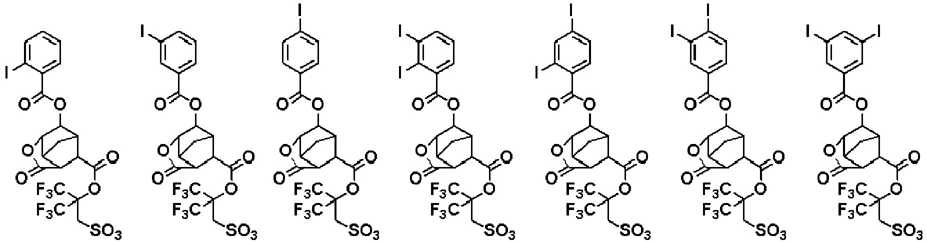

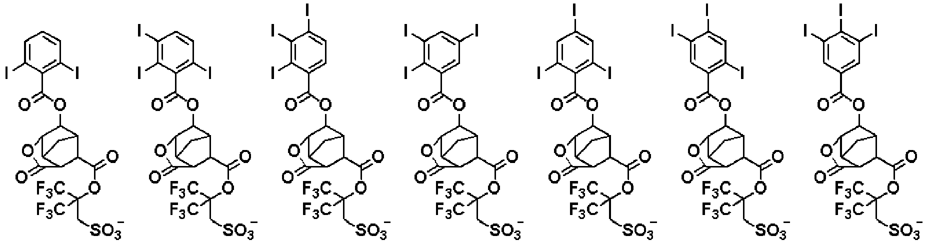

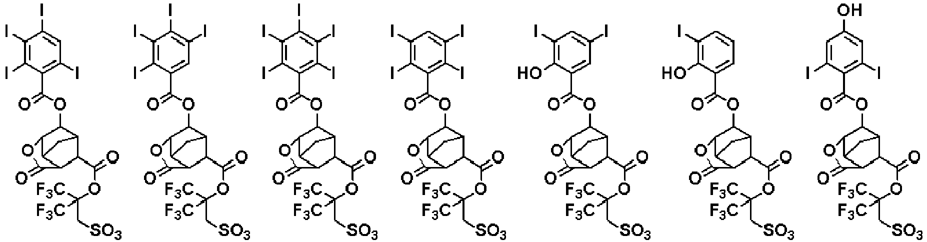

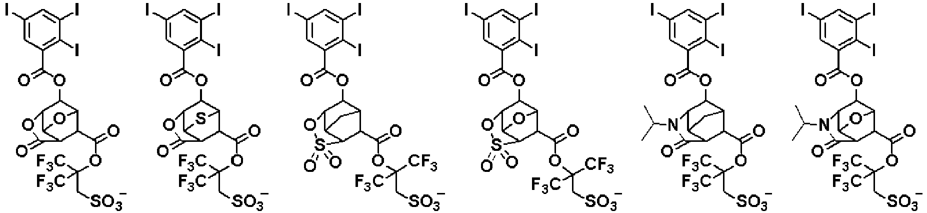

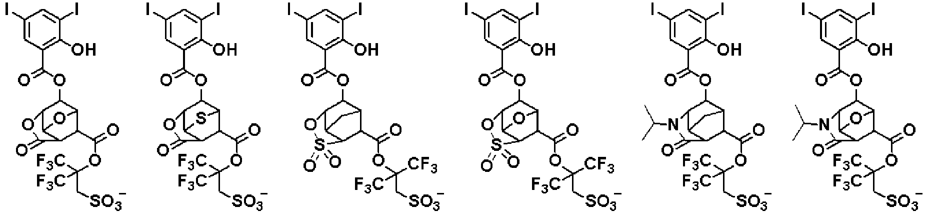

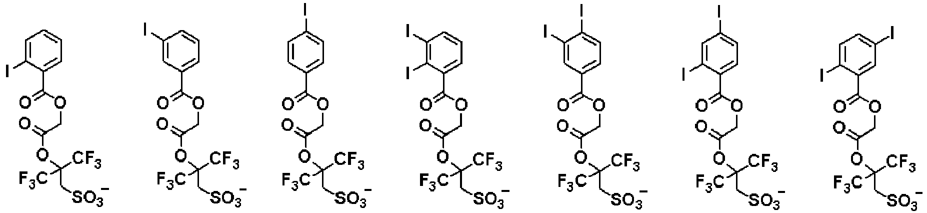

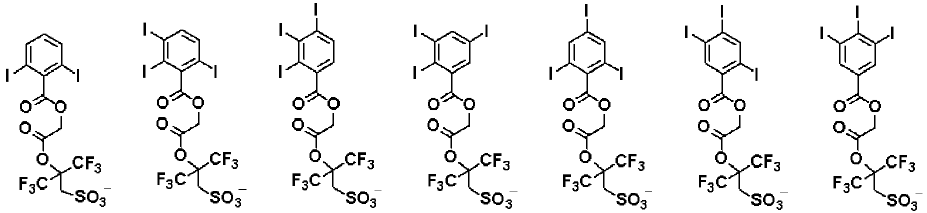

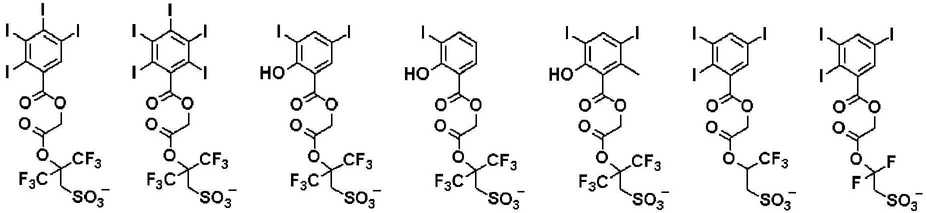

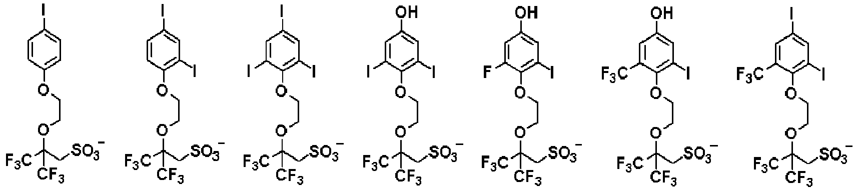

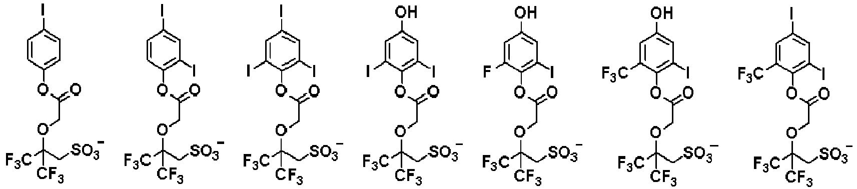

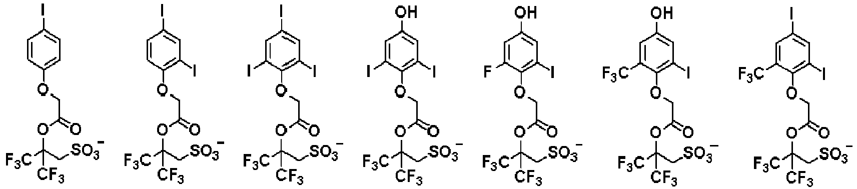

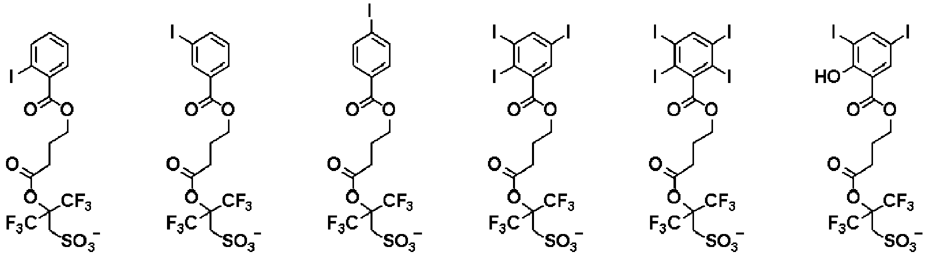

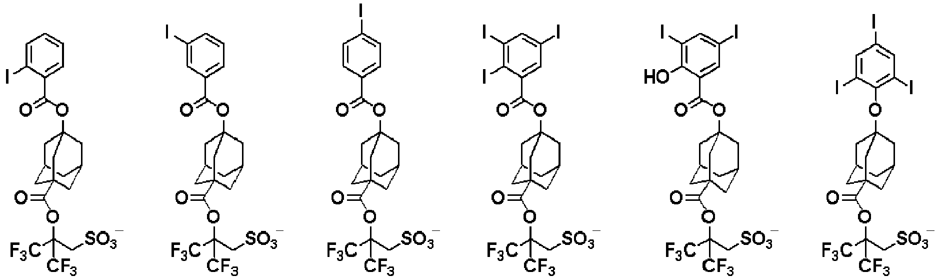

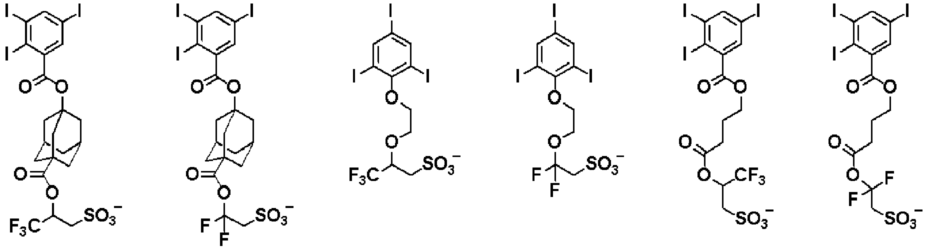

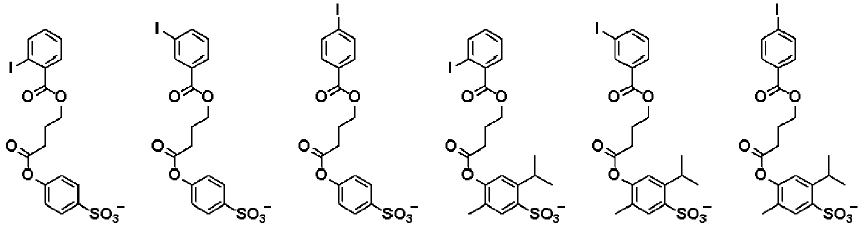

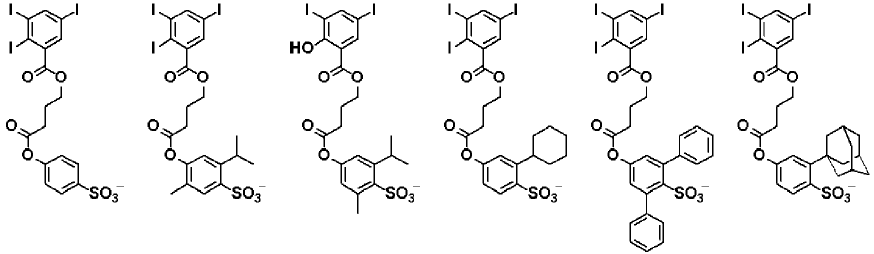

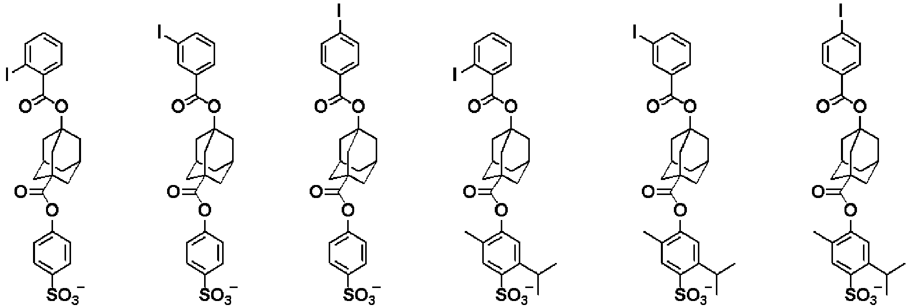

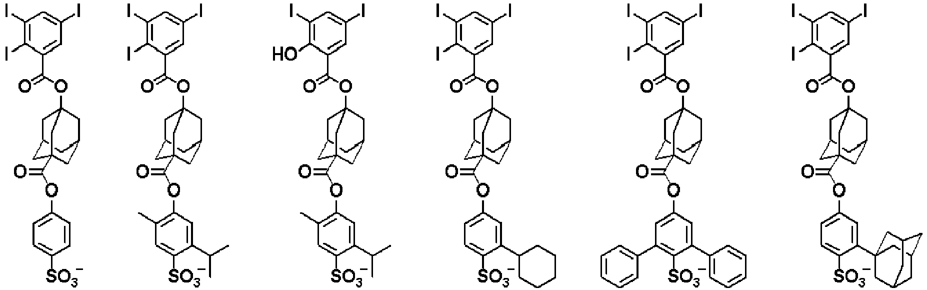

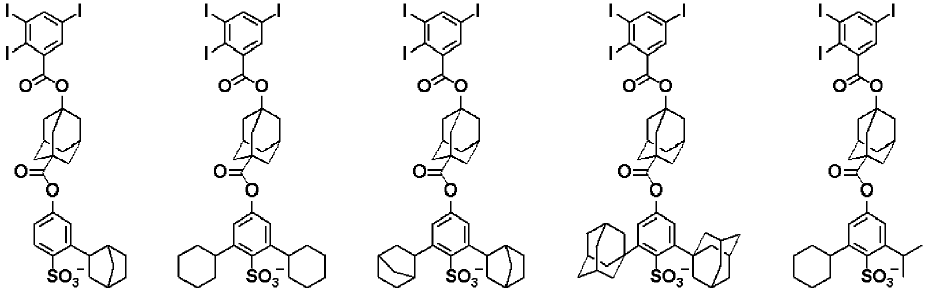

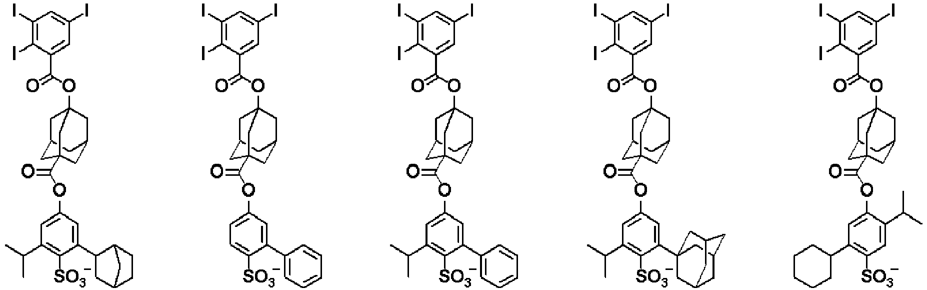

As a cation to form a pair with the anion, a sulfonium cation represented by the following formula (E) or an iodonium cation represented by the following formula (F) is preferable.

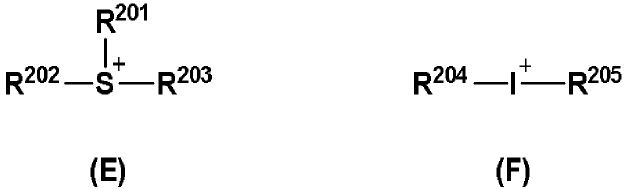

In the formulae (E) and (F), R²⁰¹ to R²⁰⁵ each independently represent a halogen atom or a hydrocarbyl group having 1 to 20 carbon atoms and optionally having a heteroatom.

Examples of the halogen atom include a fluorine atom, a chlorine atom, a bromine atom, and an iodine atom.

The hydrocarbyl group having 1 to 20 carbon atoms may be saturated or unsaturated, and may be linear, branched, or cyclic. Specific examples thereof include: alkyl groups having 1 to 20 carbon atoms, such as a methyl group, an ethyl group, an n-propyl group, an isopropyl group, an n-butyl group, a sec-butyl group, a tert-butyl group, a tert-pentyl group, an n-pentyl group, an n-hexyl group, an n-octyl group, a 2-ethylhexyl group, an n-nonyl group, and an n-decyl group; cyclic saturated hydrocarbyl groups having 3 to 20 carbon atoms, such as a cyclopentyl group, a cyclohexyl group, a cyclopentylmethyl group, a cyclopentylethyl group, a cyclopentylbutyl group, a cyclohexylmethyl group, a cyclohexylethyl group, a cyclohexylbutyl group, a norbornyl group, a tricyclo[5.2.1.0^{2,6}]decanyl group, an adamantyl group, and an adamantylmethyl group; and aryl groups having 6 to 20 carbon atoms, such as a phenyl group, a naphthyl group, and an anthracenyl group. In addition, some or all of the hydrogen atoms of the hydrocarbyl group may be substituted with a group containing a heteroatom, such as an oxygen atom, a sulfur atom, a nitrogen atom, or a halogen atom, and the hydrocarbyl group may have an intervening group containing a heteroatom, such as an oxygen atom, a sulfur atom, or a nitrogen atom, in a carbon-carbon bond. Thus, the resulting hydrocarbyl group may contain a hydroxy group, a fluorine atom, a chlorine atom, a bromine atom, an iodine atom, a cyano group, a carbonyl group, an ether bond, an ester bond, a sulfonic acid ester bond, a carbonate bond, a lactone ring, a sultone ring, a carboxylic anhydride (-C(=O)-O-C(=O)-), a haloalkyl group, etc.

R²⁰¹ and R²⁰² may also be bonded to each other to form a ring together with a sulfur atom to which R²⁰¹ and R²⁰² are bonded. Examples of the ring formed in this event include the following.

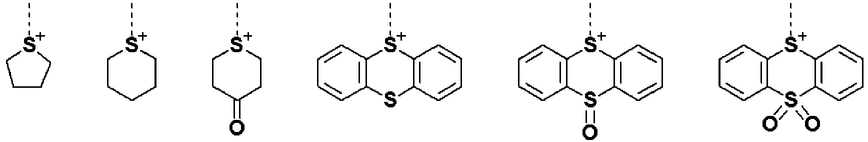

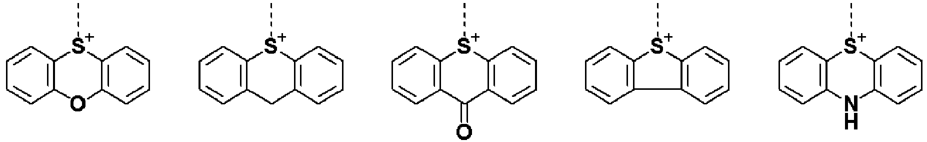

In the formulae, a broken line represents an attachment point.

Specific structures of the sulfonium cation include the structures of the sulfonium cations in the formulae (C2) to (C4), but are not limited thereto.

Specific structures of the iodonium cation include the structures of the iodonium cations in the formulae (C6) to (C8), but are not limited thereto.

The acid generated by the photo-acid generator, that is, the conjugate acid of the anion, preferably has acidity (pKa) of -2.0 or higher, more preferably -1.0 or higher. Furthermore, the upper limit of the pKa is preferably 2.0. Note that the pKa value is calculated by using a pKa DB using a software ACD/Chemsketch ver: 9.04 available from Advanced Chemistry Development, Inc. A chemically amplified positive resist composition containing such a photo-acid generator catalyzes the deprotection reaction of the acid-labile groups of the polymer, so that favorable resolution can be achieved.

When the inventive chemically amplified positive resist composition contains a photo-acid generator, the contained amount is preferably 1 to 30 parts by mass, more preferably 2 to 20 parts by mass relative to 80 parts by mass of the polymer. One kind of the photo-acid generator may be used, or two or more kinds may be used in combination.

### [Quencher]

The inventive chemically amplified positive resist composition preferably contains a quencher (acid diffusion regulator). Examples of the quencher include conventional basic compounds. Examples of the conventional basic compounds include primary, secondary, and tertiary aliphatic amines, mixed amines, aromatic amines, heterocyclic amines, nitrogen-containing compounds having a carboxy group(s), nitrogen-containing compounds having a sulfonyl group(s), nitrogen-containing compounds having a hydroxy group(s), nitrogen-containing compounds having a hydroxyphenyl group(s), alcoholic nitrogen-containing compounds, amides, imides, and carbamates. Particularly preferable quenchers include primary, secondary, and tertiary amine compounds disclosed in paragraphs [0146] to [0164] of JP2008-111103A, in particular, amine compounds having a hydroxy group, an ether bond, an ester bond, a lactone ring, a cyano group, or a sulfonic acid ester bond, and compounds having a carbamate group disclosed in JP3790649B2. Preferable examples include tris[2-(methoxymethoxy)ethyl]amine, tris[2-(methoxymethoxy)ethyl]amine-N-oxide, dibutylaminobenzoic acid, morpholine derivatives, and imidazole derivatives. When such a basic compound is contained, it is possible to suppress the diffusion rate of an acid in the resist film further and to correct the profile, for example.

Examples of the quencher also include onium salts disclosed in JP2008-158339A, such as sulfonium salts, iodonium salts, and ammonium salts of carboxylic acids where the α position is not fluorinated. A sulfonic acid, an imidic acid, or a methide acid, fluorinated in the α position, is necessary for deprotecting an acid-labile group, and a carboxylic acid that is not fluorinated in the α position is released by salt exchange with an onium salt that is not fluorinated in the α position. A carboxylic acid that is not fluorinated in the α position hardly causes a deprotection reaction, and therefore, functions as a quencher.

Examples of the onium salt of the carboxylic acid that is not fluorinated in the α position include onium salts represented by the following formula (C'1).

**R⁶⁹-CO₂⁻ Mq**⁺ **(C'1)**

In the formula (C'1), R⁶⁹ represents a hydrogen atom or a hydrocarbyl group having 1 to 40 carbon atoms and optionally having a heteroatom, except for groups in which the hydrogen atom bonded to the carbon atom in the α position of a carboxy group is substituted with a fluorine atom or a fluoroalkyl group.

The hydrocarbyl group may be saturated or unsaturated, and may be linear, branched, or cyclic. Specific examples thereof include: alkyl groups having 1 to 40 carbon atoms, such as a methyl group, an ethyl group, an n-propyl group, an isopropyl group, an n-butyl group, a sec-butyl group, a tert-butyl group, an n-pentyl group, a tert-pentyl group, an n-hexyl group, an n-octyl group, a 2-ethylhexyl group, an n-nonyl group, and an n-decyl group; cyclic saturated hydrocarbyl groups having 3 to 40 carbon atoms, such as a cyclopentyl group, a cyclohexyl group, a cyclopentylmethyl group, a cyclopentylethyl group, a cyclopentylbutyl group, a cyclohexylmethyl group, a cyclohexylethyl group, a cyclohexylbutyl group, a norbornyl group, a tricyclo[5.2.1.0^{2,6}]decanyl group, an adamantyl group, and an adamantylmethyl group; alkenyl groups having 2 to 40 carbon atoms, such as a vinyl group, an allyl group, a propenyl group, a butenyl group, and a hexenyl group; cyclic unsaturated aliphatic hydrocarbyl groups having 3 to 40 carbon atoms, such as a cyclohexenyl group; aryl groups having 6 to 40 carbon atoms, such as a phenyl group, a naphthyl group, alkylphenyl groups (such as a 2-methylphenyl group, a 3-methylphenyl group, a 4-methylphenyl group, a 4-ethylphenyl group, a 4-tert-butylphenyl group, and a 4-n-butylphenyl group), dialkylphenyl groups (such as a 2,4-dimethylphenyl group and a 2,4,6-triisopropylphenyl group), alkylnaphthyl groups (such as a methylnaphthyl group and an ethylnaphthyl group), and dialkylnaphthyl groups (such as a dimethylnaphthyl group and a diethylnaphthyl group); and aralkyl groups having 7 to 40 carbon atoms, such as a benzyl group, a 1-phenylethyl group and a 2-phenylethyl group.

Some or all of the hydrogen atoms of the hydrocarbyl group may be substituted with a group containing a heteroatom, such as an oxygen atom, a sulfur atom, a nitrogen atom, or a halogen atom, while some -CH₂- of the hydrocarbyl group may be substituted with a group containing a heteroatom such as an oxygen atom, a sulfur atom, or a nitrogen atom. Thus, the resulting hydrocarbyl group may contain a hydroxy group, a cyano group, a carbonyl group, an ether bond, a thioether bond, an ester bond, a sulfonic acid ester bond, a carbonate bond, a lactone ring, a sultone ring, a carboxylic anhydride (-C(=O)-O-C(=O)-), a haloalkyl group, etc. Examples of the hydrocarbyl group containing a heteroatom include: heteroaryl groups, such as a thienyl group; alkoxyphenyl groups, such as a 4-hydroxyphenyl group, a 4-methoxyphenyl group, a 3-methoxyphenyl group, a 2-methoxyphenyl group, a 4-ethoxyphenyl group, a 4-tert-butoxyphenyl group, and a 3-tert-butoxyphenyl group; alkoxynaphthyl groups, such as a methoxynaphthyl group, an ethoxynaphthyl group, an n-propoxynaphthyl group, and an n-butoxynaphthyl group; dialkoxynaphthyl groups, such as a dimethoxynaphthyl group and a diethoxynaphthyl group; and aryloxoalkyl groups, such as 2-aryl-2-oxoethyl groups such as a 2-phenyl-2-oxoethyl group, a 2-(1-naphthyl)-2-oxoethyl group, and a 2-(2-naphthyl)-2-oxoethyl group.

In the formula (C'1), Mq⁺ represents an onium cation. As the onium cation, a sulfonium cation, an iodonium cation, or an ammonium cation is preferable, and a sulfonium cation or an iodonium cation is more preferable. Specific examples of the sulfonium cation include the cations given as examples of the cations of the sulfonium salts represented by the formulae (C2) to (C4). Specific examples of the iodonium cation include the cations given as examples of the cations of the iodonium salts represented by the formulae (C6) to (C8).

Examples of the anion of the onium salt represented by the formula (C'1) include the following, but are not limited thereto.

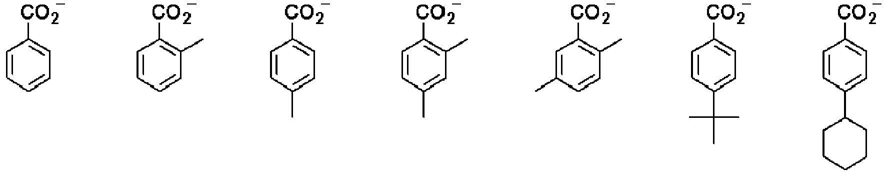

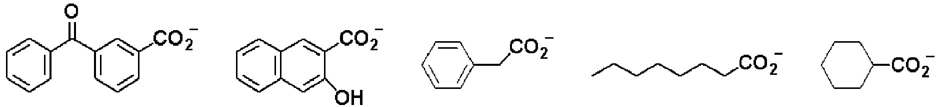

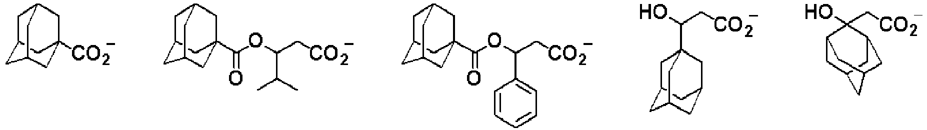

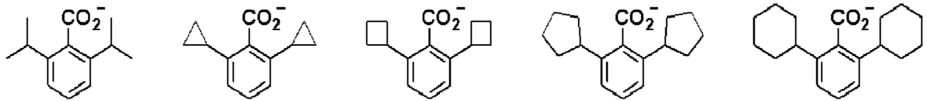

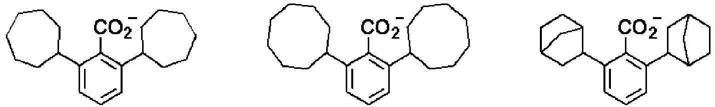

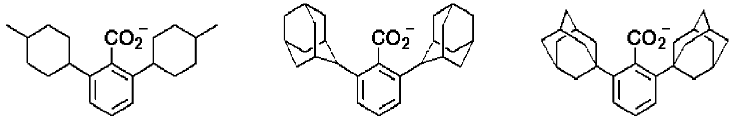

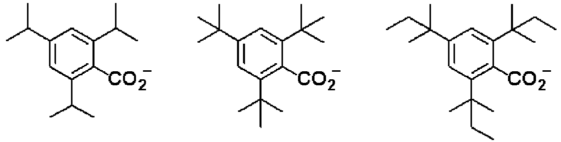

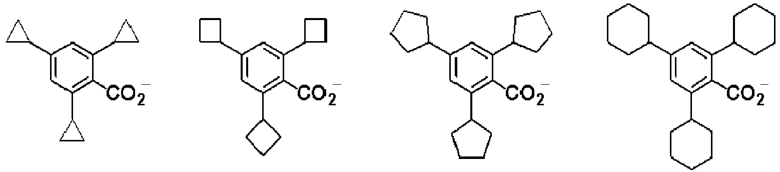

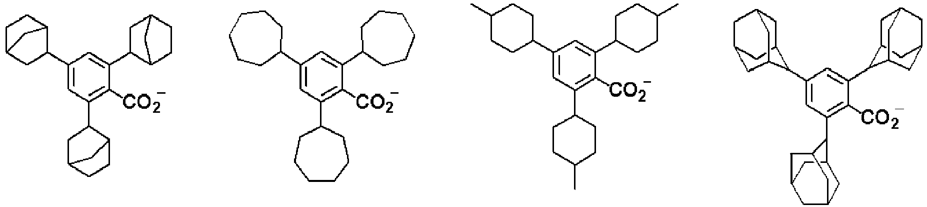

A sulfonium salt of a carboxylic acid containing an iodized benzene ring shown by the following formula (C'2) can also be used suitably as the quencher.

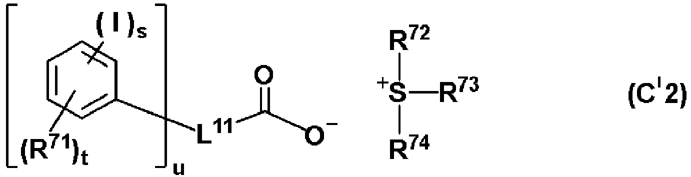

In the formula (C'2), "s" represents an integer of 1 to 5. "t" represents an integer of 0 to 3. "u" represents an integer of 1 to 3. s+t is an integer of 1 to 5.

In the formula (C'2), R⁷¹ represents: a hydroxy group, a fluorine atom, a chlorine atom, a bromine atom, an amino group, a nitro group, or a cyano group; a saturated hydrocarbyl group having 1 to 6 carbon atoms, a saturated hydrocarbyloxy group having 1 to 6 carbon atoms, a saturated hydrocarbylcarbonyloxy group having 2 to 6 carbon atoms, or a saturated hydrocarbylsulfonyloxy group having 1 to 4 carbon atoms, in each of which some or all of hydrogen atoms being substituted with a halogen atom; or -N(R^{71A})-C(=O)-R^{71B} or -N(R^{71A})-C(=O)-OR^{71B}. R^{71A} represents a hydrogen atom or a saturated hydrocarbyl group having 1 to 6 carbon atoms. R^{71B} represents a saturated hydrocarbyl group having 1 to 6 carbon atoms or an unsaturated aliphatic hydrocarbyl group having 2 to 8 carbon atoms. When "t" and/or "u" are 2 or more, the R⁷¹s may be identical to or different from one another.

In the formula (C'2), L¹¹ represents a single bond or a linking group having a valency of u+1 and having 1 to 20 carbon atoms, and may contain at least one selected from an ether bond, a carbonyl group, an ester bond, an amide bond, a sultone ring, a lactam ring, a carbonate bond, a halogen atom, a hydroxy group, and a carboxy group. The saturated hydrocarbyl group, the saturated hydrocarbyloxy group, the saturated hydrocarbylcarbonyloxy group, and the saturated hydrocarbylsulfonyloxy group may be linear, branched, or cyclic.

In the formula (C'2), R⁷², R⁷³, and R⁷⁴ each independently represent a halogen atom or a hydrocarbyl group having 1 to 20 carbon atoms and optionally having a heteroatom. The hydrocarbyl group may be saturated or unsaturated, and may be linear, branched, or cyclic. Specific examples of the hydrocarbyl group include alkyl groups having 1 to 20 carbon atoms, alkenyl groups having 2 to 20 carbon atoms, aryl groups having 6 to 20 carbon atoms, and aralkyl groups having 7 to 20 carbon atoms. In addition, some or all of the hydrogen atoms of the hydrocarbyl group may be substituted with a hydroxy group, a carboxy group, a halogen atom, an oxo group, a cyano group, a nitro group, a sultone ring, a sulfo group, or a sulfonium salt-containing group, while some -CH₂- of the hydrocarbyl group may be substituted with an ether bond, an ester bond, a carbonyl group, an amide bond, a carbonate bond, or a sulfonic acid ester bond. R⁷² and R⁷³ may also be bonded to each other to form a ring together with the sulfur atom bonded to R⁷² and R⁷³.

Specific examples of the compound represented by the formula (C'2) include the compounds disclosed in JP2017-219836A. The compound represented by the formula (C'2) has high absorption, a high sensitizing effect, and a high acid diffusion regulation effect.

As the quencher, it is also possible to use a nitrogen atom-containing carboxylate compound represented by the following formula (C'3).

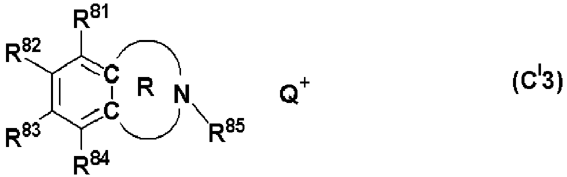

In the formula (C'3), R⁸¹ to R⁸⁴ each independently represent a hydrogen atom, -L¹²-CO₂⁻, or a hydrocarbyl group having 1 to 20 carbon atoms and optionally having a heteroatom. R⁸¹ and R⁸², R⁸² and R⁸³, and R⁸³ and R⁸⁴ may be bonded to each other to form a ring together with the carbon atoms to which R⁸¹ and R⁸², R⁸² and R⁸³, and R⁸³ and R⁸⁴ are respectively bonded. L¹² represents a single bond or a hydrocarbylene group having 1 to 20 carbon atoms and optionally having a heteroatom. R⁸⁵ represents a hydrogen atom or a hydrocarbyl group having 1 to 20 carbon atoms and optionally having a heteroatom.

In the formula (C'3), the ring R has 2 to 6 carbon atoms and includes carbon atoms and a nitrogen atom in the formula. A part or all of the hydrogen atoms bonded to the carbon atoms of the ring may be substituted with a hydrocarbyl group having 1 to 20 carbon atoms or -L¹²-CO₂⁻, and a part of the carbon atoms of the ring may be substituted with a sulfur atom, an oxygen atom, or a nitrogen atom. The ring may be alicyclic or aromatic, and is preferably a five-membered ring or a six-membered ring. Specific examples of the ring include a pyridine ring, a pyrrole ring, a pyrrolidine ring, a piperidine ring, a pyrazole ring, an imidazoline ring, a pyridazine ring, a pyrimidine ring, a pyrazine ring, an oxazole ring, a thiazole ring, a morpholine ring, a thiazine ring, and a triazole ring.

The carboxylic acid onium salt represented by the formula (C'3) has at least one -L¹²-CO₂⁻ group. That is, at least one of R⁸¹ to R⁸⁴ is -L¹²-CO₂⁻ and/or at least one of the hydrogen atoms bonded to the carbon atoms of the ring R is substituted with -L¹²-CO₂⁻.

In the formula (C'3), Q⁺ represents a sulfonium cation, an iodonium cation, or an ammonium cation, and a sulfonium cation is preferable. Specific examples of the sulfonium cation include the cations given as examples of the sulfonium cations in the formulae (C2) to (C4).

Examples of the anion of the compound represented by the formula (C'3) include the following, but are not limited thereto.

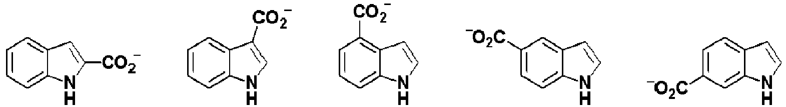

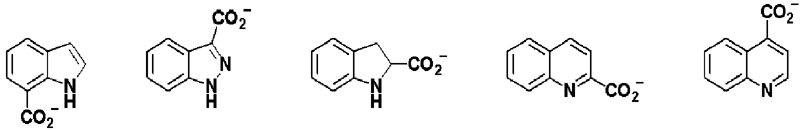

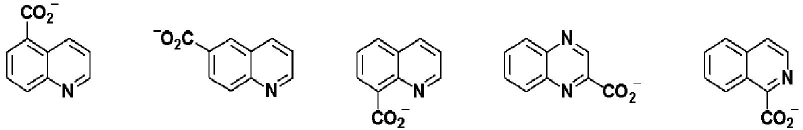

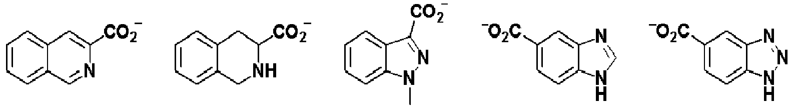

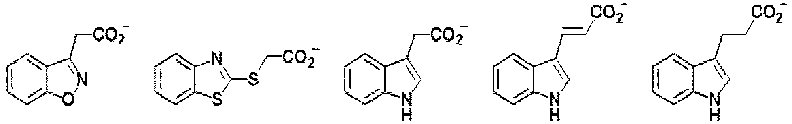

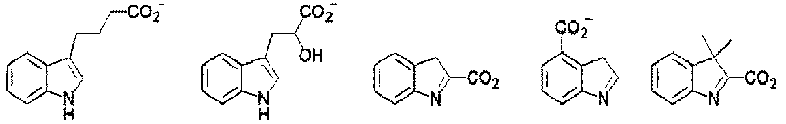

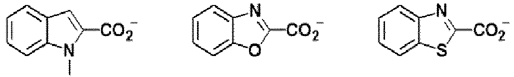

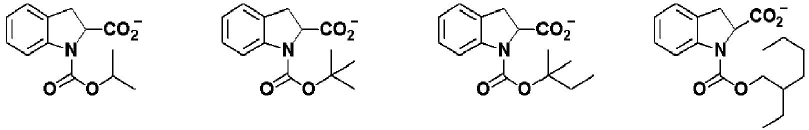

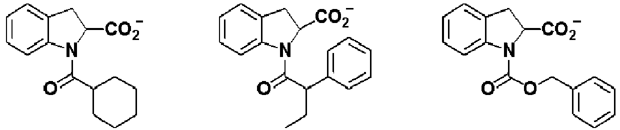

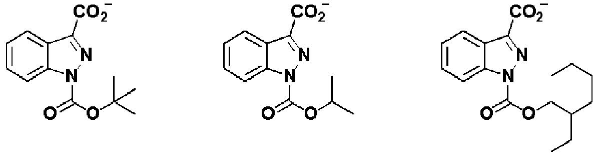

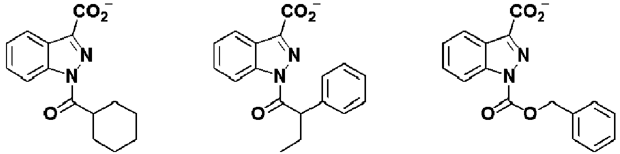

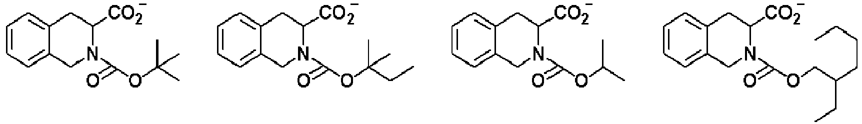

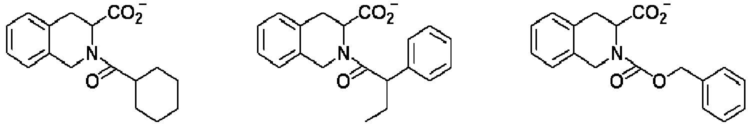

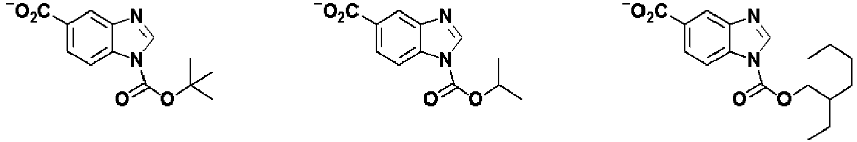

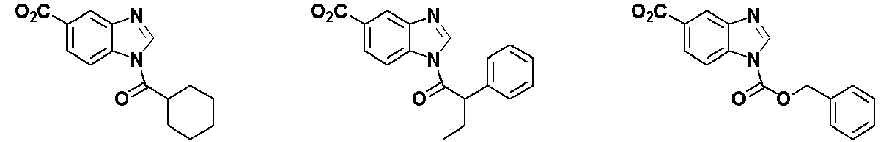

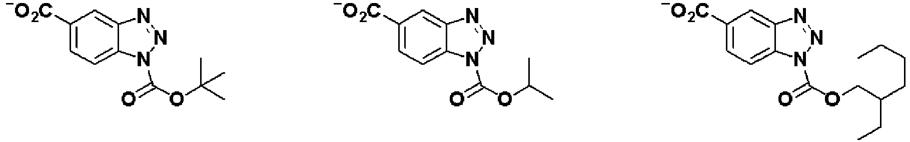

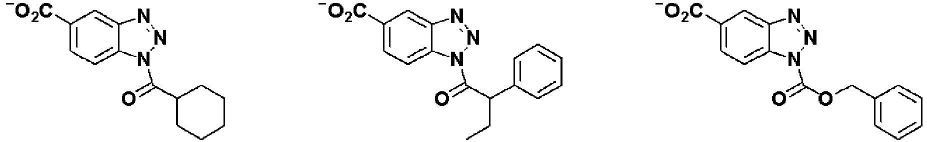

As the quencher, a betaine type compound of weak acid can also be used. Specific examples thereof include the following, but are not limited thereto.

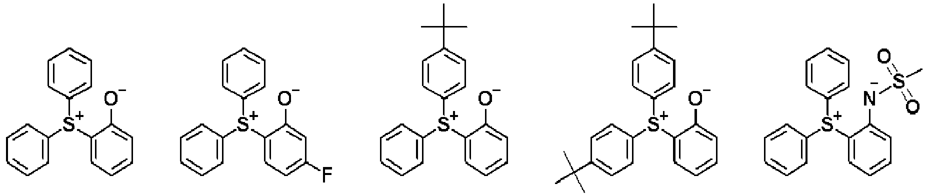

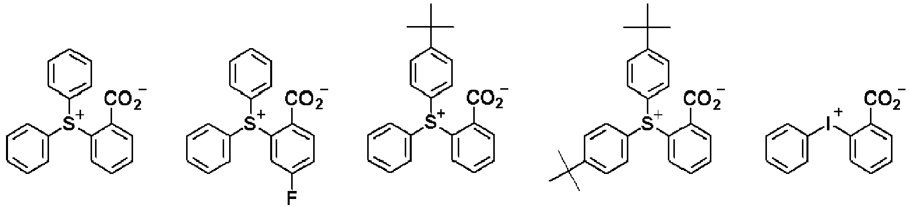

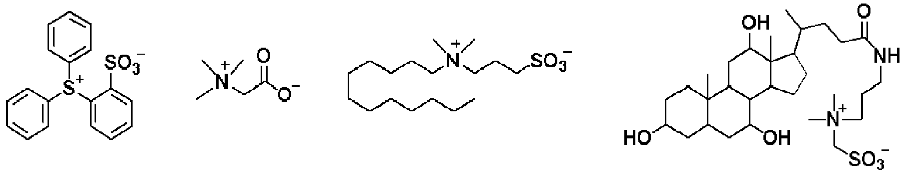

Examples of the quencher further include a polymeric quencher disclosed in JP2008-239918A. Such a quencher is oriented on the surface of the resist film, and enhances the rectangularity of the resist pattern. The polymeric quencher also has effects of preventing rounding of pattern top and film thickness loss of pattern when a top coat for immersion lithography is applied.

When the inventive chemically amplified positive resist composition contains a quencher, the quencher is preferably contained in an amount of 0 to 50 parts by mass, more preferably 0.1 to 40 parts by mass relative to 80 parts by mass of the polymer. One kind of the quencher may be used, or two or more kinds thereof may be used in combination.

When the inventive chemically amplified positive resist composition contains both a photo-acid generator and a quencher, the ratio of the contained photo-acid generator to the contained quencher (photo-acid generator/quencher) is preferably less than 3, more preferably less than 2.5, and further preferably less than 2 in terms of mass. When the ratio of the photo-acid generator contained to the quencher contained in the chemically amplified positive resist composition is within the above ranges, acid diffusion can be suppressed sufficiently, and excellent resolution and excellent critical dimension uniformity can be achieved.

### [Organic Solvent]

The inventive chemically amplified positive resist composition may also contain an organic solvent. The organic solvent is not particularly limited, as long as it is capable of dissolving the above-described components. Examples of such an organic solvent include those disclosed in paragraphs [0144] to [0145] of JP2008-111103A: ketones, such as cyclohexanone and methyl-2-n-pentyl ketone; alcohols, such as 3-methoxybutanol, 3-methyl-3-methoxybutanol, 1-methoxy-2-propanol, 1-ethoxy-2-propanol, and diacetone alcohol; ethers, such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters, such as propylene glycol monoethyl ether acetate (PGMEA), ethyl lactate (EL), ethyl pyruvate, butyl acetate, methyl 3-methoxypropionate, ethyl 3-ethoxypropionate, tert-butyl acetate, tert-butyl propionate, and propylene glycol mono-t-butyl ether acetate; lactones, such as γ-butyrolactone; and mixed solvents thereof. When an acetal-based acid-labile group is used, a high-boiling-point alcohol-based solvent, specifically, diethylene glycol, propylene glycol, glycerin, 1,4-butanediol, 1,3-butanediol, etc., may be contained in order to accelerate deprotection reaction of the acetal.

Among these organic solvents, 1-ethoxy-2-propanol, PGMEA, PGME, cyclohexanone, EL, γ-butyrolactone, and mixed solvents thereof are preferable.

When the inventive chemically amplified positive resist composition contains the organic solvent, the organic solvent is preferably contained in an amount of 200 to 10,000 parts by mass, more preferably 400 to 5,000 parts by mass relative to 80 parts by mass of the polymer. One kind of the organic solvent may be used, or two or more kinds thereof may be used in mixture.

### [Surfactant]

A surfactant conventionally used to improve the coating property onto a substrate may be contained in the inventive chemically amplified positive resist composition. In a case where a surfactant is used, there are many known surfactants as described in JP2004-115630A, and these surfactants can be referred to as options. The surfactant is preferably contained in an amount of 0 to 5 parts by mass based on 80 parts by mass of the polymer. Note that when the above-described fluorine-containing polymer is contained in the inventive chemically amplified positive resist composition, the surfactant does not need to be contained, since the fluorine-containing polymer also acts as a surfactant.

The inventive chemically amplified positive resist composition is preferably filtered. As the type of filter, a nylon or polyethylene (PE) filter can be used to remove effectively the gel components and particles contained in the resist. Furthermore, regarding pore size, a filter having a pore size of 20 nm or less is preferably used, since high quality can be maintained in advanced-generation products.

Meanwhile, an unexposed portion of a resist film obtained from the inventive chemically amplified positive resist composition preferably has a dissolution rate of 10 nm/min or lower, more preferably 9 nm/min or lower, and further preferably 8 nm/min or lower in an alkaline developer. Pattern film loss in an alkaline developer has a great influence when the resist film is in a thin film range (100 nm or less), so that when the dissolution rate of an unexposed portion is 10 nm/min or lower, the pattern does not collapse, and a fine pattern can be formed. In particular, in the production of a photomask, where the absence of defects is required, the development process tends to be strong, so that the above-described advantageous effect is remarkable. Note that the dissolution rate of an unexposed portion is a value obtained as follows: a 150-mm (6-inch) silicon wafer is spin-coated with the inventive chemically amplified positive resist composition; the resulting wafer is baked at 110°C for 240 seconds to form a resist film having a film thickness of 80 nm; subsequently, development is performed with a 2.38 mass% aqueous solution of TMAH at 23°C for 80 seconds; and the dissolution rate is calculated from the amount of film loss in this event.

An exposed portion of a resist film obtained from the inventive chemically amplified positive resist composition preferably has a dissolution rate of 50 nm/sec or higher, more preferably 80 nm/sec or higher in an alkaline developer in view of improving development loading. When the dissolution rate is 50 nm/sec or higher, the resist film can be dissolved in an alkaline developer uniformly even when there is variation in the pattern layout in a pattern of low and high densities, so that the fluctuation of line width can be reduced. Note that the dissolution rate of an exposed portion in the present invention is a value obtained as follows: a 200-mm (8-inch) silicon wafer is spin-coated with the inventive chemically amplified positive resist composition; the resulting wafer is baked at 110°C for 60 seconds to form a resist film having a film thickness of 90 nm; exposure is performed with a KrF excimer laser beam at the amount of energy at which the deprotection reaction of the polymer is completed; baking is performed at 110°C for 60 seconds; subsequently, development is performed with a 2.38 mass% aqueous solution of TMAH at 23°C; and the dissolution rate is calculated from the amount of film loss in this event by using a resist development analyzer.

### [Resist Patterning Process]

The inventive resist patterning process includes the steps of:
forming a resist film on a substrate by using the above-described chemically amplified positive resist composition;
irradiating the resist film with a high-energy beam to form a pattern (that is, exposing the resist film to a high-energy beam); and
developing, by using an alkaline developer, the resist film irradiated to form the pattern.

As the substrate, it is possible to use, for example, a substrate for manufacturing an integrated circuit (such as Si, SiO, SiO₂, SiN, SiON, TiN, WSi, BPSG, SOG, and an organic antireflective film) or a substrate for manufacturing a transmission type or reflective mask circuit (such as Cr, CrO, CrON, MoSi₂, Si, SiO, SiO₂, SiON, SiONC, CoTa, NiTa, TaBN, and SnO₂). The chemically amplified positive resist composition is applied onto these substrates by a technique such as spin coating to have a film thickness of 0.03 to 2 um. The resulting film is prebaked on a hot plate, preferably at 60 to 150°C for 1 to 20 minutes, more preferably at 80 to 140°C for 1 to 10 minutes. Thus, a resist film is formed.

Subsequently, the resist film is exposed and irradiated with a high-energy beam to form a pattern. Examples of the high-energy beam include a KrF excimer laser beam, an ArF excimer laser beam, an electron beam, or an extreme ultraviolet ray having a wavelength of 3 to 15 nm. In the present invention, the exposure is preferably performed by using an electron beam.

Regarding the energy of the electron beam, the irradiation is preferably performed so that the exposure is 50 to 400 µC/cm², in order to form the target pattern.

As the exposure, it is also possible to perform, besides usual exposure methods, an immersion method, where the space between the mask and the resist film is immersed, in some cases. In such a case, a top coat that is insoluble in water can also be used.

Next, PEB (post exposure baking) is performed on a hot plate, preferably at 60 to 150°C for 1 to 20 minutes, more preferably at 80 to 140°C for 1 to 10 minutes.

After that, development is carried out by using a developer of a 0.1 to 5 mass%, preferably 2 to 3 mass%, aqueous alkaline solution of TMAH or the like, preferably for 0.1 to 3 minutes, more preferably 0.5 to 2 minutes by a conventional technique such as a dip method, a puddle method, or a spray method. In this manner, a target pattern is formed on the substrate.

The inventive chemically amplified positive resist composition is useful, since it is possible to form a pattern having, in particular, excellent isolated space resolution and reduced LER. In addition, the inventive chemically amplified positive resist composition is particularly useful for forming a pattern in a substrate having, on a surface, a material that easily causes pattern delamination and pattern collapse because of difficulty in achieving adhesiveness of a resist pattern. As such a substrate, preferable substrates have an uppermost surface composed of a material containing at least one selected from chromium, silicon, tantalum, molybdenum, cobalt, nickel, tungsten, and tin. That is, examples include substrates having metal chromium or a chromium compound containing one or more light elements selected from oxygen, nitrogen, and carbon formed on the uppermost surface by sputtering, and substrates that contain SiO, SiOₓ, a tantalum compound, a molybdenum compound, a cobalt compound, a nickel compound, a tungsten compound, or a tin compound on the uppermost layer. The inventive chemically amplified positive resist composition is particularly useful for forming a pattern by using a photomask blank as a substrate. In this event, the photomask blank may be a transmission type or reflective. That is, a transmission type or reflective mask blank that has the above-described chemically amplified positive resist composition applied thereto is preferable.

As a transmission type mask blank, a photomask blank having a light-shielding film containing a chromium-based material may be a photomask blank for a binary mask, or may be a photomask blank for a phase shift mask. In the case of a photomask blank for a binary mask, the photomask blank may have, as a light-shielding film, an antireflective layer containing a chromium-based material and a light-shielding layer; or the entire antireflective film on the outer layer side or only the outer layer side of the antireflective film on the outer layer side may be made from a chromium-based material and the rest of the antireflective film may be, for example, made from a silicon-based compound material that may contain a transition metal. Meanwhile, in the case of a photomask blank for a phase shift mask, a photomask blank for a phase shift mask, the photomask blank having a chromium-based light-shielding film on a phase shift film, can be used.

The photomask blank having a chromium-based material on the uppermost layer is described in JP2008-026500A and JP2007-302873A and given as examples of conventional technology in these documents, and is extremely well known. Therefore, a detailed description will be omitted, but for example, when a chromium-based material constitutes a light-shielding film having an antireflective layer and a light-shielding layer, the following film constitution may be adopted.

When a light-shielding film having an antireflective layer and a light-shielding layer is formed from a chromium-based material, the layers may be configured as follows: an antireflective layer and a light-shielding layer may be laminated in this order from the upper layer side; or an antireflective layer, a light-shielding layer, and an antireflective layer may be laminated in this order. Furthermore, each of the antireflective layer and the light-shielding layer may be multilayered, and the compositions between the layers having different compositions may change discontinuously, or the compositions may change continuously. As the chromium-based material to be used, metal chromium and materials including a light element such as oxygen, nitrogen, and carbon contained in metal chromium are used. Specifically, it is possible to use metal chromium, chromium oxide, chromium nitride, chromium carbide, chromium oxynitride, chromium oxycarbide, chromium carbonitride, chromium oxycarbonitride, etc.

Meanwhile, a reflective mask blank includes: a substrate; a multilayer reflective film formed on a first main surface (front surface) of the substrate, specifically, a multilayer reflective film that reflects exposure light such as EUV light; and an absorber film formed on the multilayer reflective film, specifically, an absorber film that absorbs exposure light such as EUV light and reduces reflectance. From a reflective mask blank (reflective mask blank for EUV), a reflective mask (reflective mask for EUV) is produced, the reflective mask having an absorber pattern (pattern of the absorber film) formed by patterning the absorber film. The EUV light used in EUV lithography has a wavelength of 13 to 14 nm, and normally, has a wavelength of about 13.5 nm.

Normally, the multilayer reflective film is preferably provided so as to contact the first main surface of the substrate. However, an underlying film can be provided between the substrate and the multilayer reflective film as long as the advantageous effects of the present invention are not degraded. The absorber film may be formed adjacent to the multilayer reflective film, but a protective film (film for protecting the multilayer reflective film) may be provided between the multilayer reflective film and the absorber film, preferably in contact with the multilayer reflective film, more preferably in contact with the multilayer reflective film and the absorber film. The protective film is used for protecting the multilayer reflective film and so forth in cleaning, processing such as correction, etc. In addition, the protective film preferably has functions of protecting the multilayer reflective film while patterning the absorber film by etching and preventing the oxidation of the multilayer reflective film. Meanwhile, a conductive film may be provided on a second main surface (back surface), which is a surface on the opposite side of the first main surface of the substrate, preferably in contact with the second main surface, for holding a reflective mask on an exposure apparatus by an electrostatic chuck. In the above description, a first main surface of the substrate is defined as the front side or the upper side, and a second main surface is defined as the back side or the lower side. However, the front and back sides or the upper and lower sides in both surfaces are defined for the sake of convenience. The first main surface and the second main surface are two main surfaces (film forming surfaces) of the substrate respectively, and the front and back sides or the upper and lower sides may be substituted. More specifically, the conductive film can be formed according to JP2021-139970A or by the method shown as an example of a conventional technique in the document.

According to the inventive resist patterning process, it is possible to obtain a pattern having high resolution, suppressed effects of development loading and residue defects, and little difference in dimensions regardless of the density of the pattern even when using a substrate (e.g. a transmission type or reflective mask blank) whose uppermost surface is made of a material that affects resist pattern profile easily, such as a material containing chromium, silicon, or tantalum.

### EXAMPLE

Hereinafter, the present invention will be described specifically with reference to Synthesis Examples, Examples, and Comparative Examples. However, the present invention is not limited to the following Examples. Copolymerization composition ratio means mole ratio, and Mw is a weight-average molecular weight measured by GPC in terms of polystyrene.

### [1] Synthesis of Acetal Modifier

### [Synthesis Example 1-1] Synthesis of Acetal Modifier AC-1

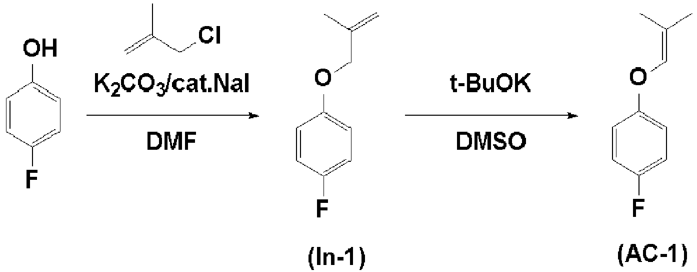

### (1) Synthesis of Intermediate In-1

Under a nitrogen atmosphere, 4-fluorophenol (250 g), potassium carbonate (370 g), and sodium iodide (33 g) were dispersed in DMF (1,000 g). Subsequently, the internal temperature was raised to 50°C, and methallyl chloride (242 g) was added dropwise. After the dropwise addition, the internal temperature was raised to 65°C, and the mixture was aged for 5 hours. After the aging, the reaction liquid was cooled, and water (1,500 g) was added to terminate the reaction. The target product was extracted twice with toluene (1,000 g), a common aqueous work-up was performed, the solvent was distilled off, and then purification was performed with distillation to obtain 344 g of an intermediate In-1 (91% yield).

### (2) Synthesis of Acetal Modifier AC-1

Under a nitrogen atmosphere, the intermediate In-1 (344 g) and potassium t-butoxide (23 g) were dissolved in DMSO (350 g). The internal temperature of the reaction liquid was raised to 80°C, and the reaction liquid was aged for 12 hours. After the aging, the reaction liquid was cooled, and water (500 g) was added to terminate the reaction. The target product was extracted twice with toluene (500 g), a common aqueous work-up was performed, the solvent was distilled off, and then purification was performed with distillation to obtain the target product, 321 g of acetal modifier AC-1 as a colorless oil (94% yield).

IR spectrum data and results of a nuclear magnetic resonance spectrum (¹H-NMR in DMSO-d₆) of acetal modifier AC-1 are shown below.
IR (D-ATR): ν = 3053, 2966, 2918, 2884, 2859, 1691, 1614, 1503, 1451, 1379, 1288, 1250, 1208, 1149, 1122, 1092, 1035, 1009, 830, 764, 547, 505, 445 cm⁻¹.
¹H-NMR (600 MHz in DMSO-d₆): δ = 7.13 (2H, m), 6.99 (2H, m), 6.34 (1H, m), 1.63 (6H, s) ppm.

### [Synthesis Examples 1-2 to 1-8] Synthesis of Acetal Modifiers AC-2 to AC-8

Using the corresponding raw material and known organic synthesis method, each of acetal modifiers AC-2 to AC-8 was synthesized.

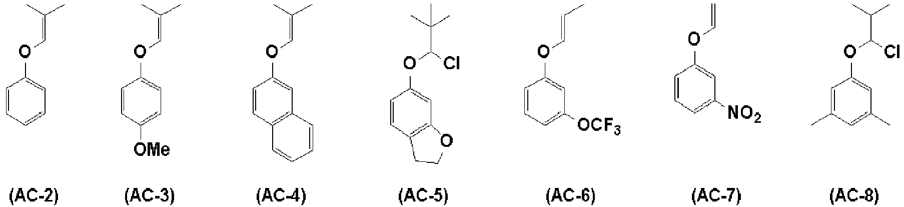

### [2] Synthesis of Polymer

### [Synthesis Example 2-1] Synthesis of Polymer P-1

Into a 100-ml flask, 20 g of a polyhydroxystyrene-acenaphthylene copolymer and, as a solvent, 46.7 g of tetrahydrofuran were introduced. Into this reaction vessel, under a nitrogen atmosphere at around 25°C, 0.5 g of methanesulfonic acid was added, then 4.4 g of the acetal modifier AC-1 was added dropwise, and reaction was allowed to proceed at room temperature for 4.5 hours. After the reaction was completed, 1.0 g of triethylamine was added, the obtained reaction liquid was added dropwise to 500 g of hexane, and the precipitated copolymer was filtered. The filtered copolymer was washed twice with 120 g of hexane. The obtained copolymer was dissolved in a mixed solvent of 60 g of ethyl acetate and 20 g of water, the obtained solution was transferred to a separatory funnel, 0.7 g of acetic acid was added thereto, and a liquid separation operation was performed. The under layer was distilled off, 20 g of water and 0.9 g of pyridine were added to the obtained organic layer, and a liquid separation operation was performed. The under layer was distilled off, and 20 g of water was added to the organic layer further obtained to perform washing with water and liquid separation (the washing with water and liquid separation were performed five times in total). The separated organic layer was concentrated, and then dissolved in 40 g of PGME. The obtained solution was added dropwise to 600 g of water. The precipitated crystal obtained was filtered, washed with water, and dried to give 20.3 g of a white polymer, the target polymer P-1. The polymer P-1 was subjected to ¹³C-NMR, ¹H-NMR, and GPC measurements to reveal the following analysis results.

### P-1 (a = 0.62, b = 0.11, c = 0.27, Mw = 5,700)

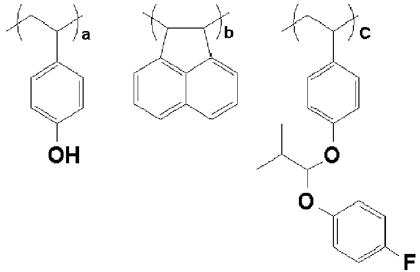

The following polymers P-2 to P-15 and AP-1 to AP-6 and comparative polymers cP-1 to cP-6 were synthesized in the same manner as in Synthesis Example 2-1 and known methods, except that the kind and blending ratio of the monomer was changed.

| | |
|---|---|
| **P-2** | **P-3** |
| **(a = 0.61, 6 = 0.11, c = 0.28, Mw = 6,500)** | **(a = 0.63, 6 = 0.12, c = 0.25, Mw = 5,900)** |
| 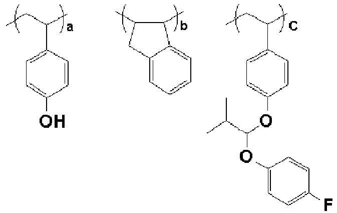 | 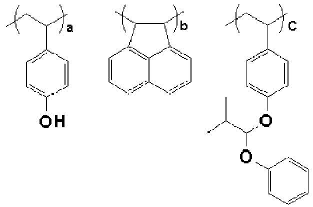 |
| **P-4** | **P-5** |
| **(a = 0.61, b = 0.13, c = 0.26, Mw = 6,000)** | **(a = 0.63, 6 = 0.10, c = 0.27, Mw = 5,500)** |
| 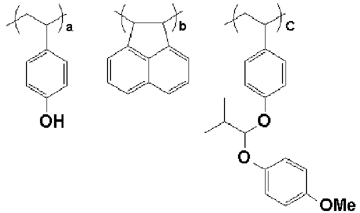 | 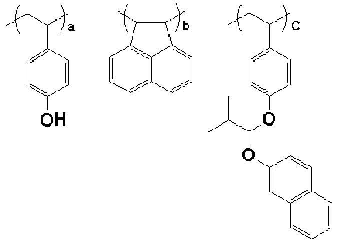 |
| **P-6** | **P-7** |
| **(a = 0.64, 6 = 0.13, c = 0.23, Mw = 6,400)** | **(a = 0.63, b = 0.13, c = 0.24, Mw = 6,600)** |
| 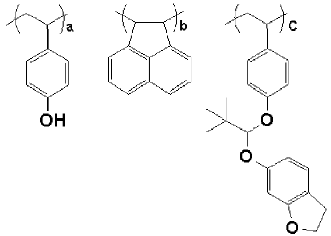 | 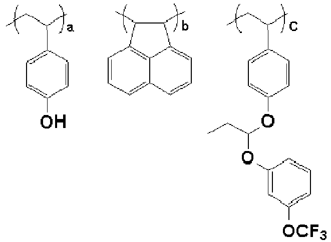 |
| **P-8** | **P-9** |
| **(a = 0.61, 6 = 0.13, c = 0.26, Mw = 6,100)** | **(a = 0.66, 6 = 0.11, c = 0.23, Mw = 5,800)** |
| 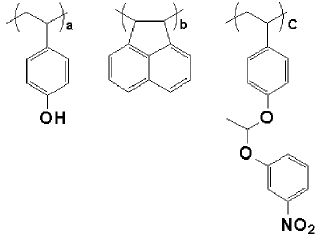 | 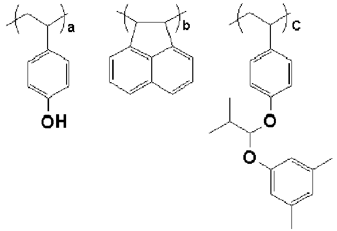 |

| | |
|---|---|
| **P-10** | **P-11** |
| **(a = 0.66, b = 0.10, c = 0.24, Mw = 5,500)** | **(a = 0.59, b = 0.18, c = 0.23, Mw = 6,100)** |
| 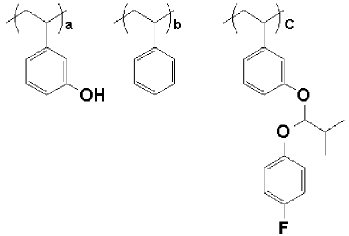 | 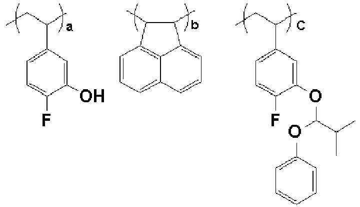 |
| **P-12** | **P-13** |
| **(a = 0.54, 6 = 0.20, c = 0.26, Mw = 6,300)** | **(a = 0.75, b = 0.25, Mw = 5,400)** |
| 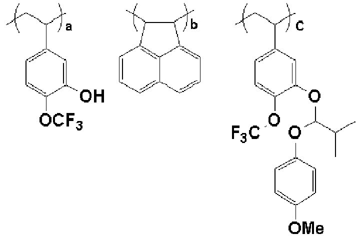 | 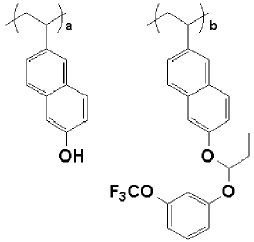 |
| **P-14** | **P-15** |
| **(a = 0.63, 6 = 0.15, c = 0.22, Mw = 5,900)** | **(a = 0.55, b = 0.18, c = 0.27, Mw = 7,400)** |
| 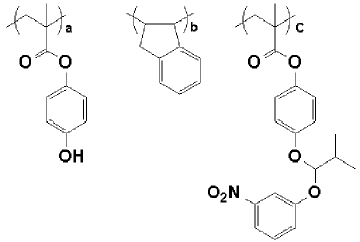 | 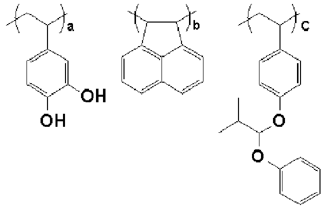 |

| | |
|---|---|
| **cP-1** | **cP-2** |
| **(a = 0.78, 6 = 0.13, c = 0.09, Mw = 7,100)** | **(a = 0.73, b = 0.13, c = 0.14, Mw = 5,300)** |
| 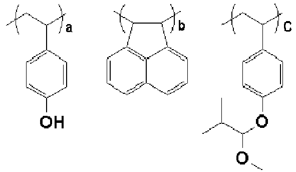 | 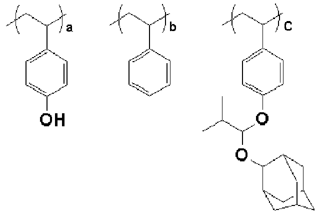 |
| **cP-3** | **cP-4** |
| **(a = 0.75, b = 0.11, c = 0.14, Mw = 5,400)** | **(a = 0.68, 6 = 0.10, c = 0.22, Mw = 6,700)** |
| 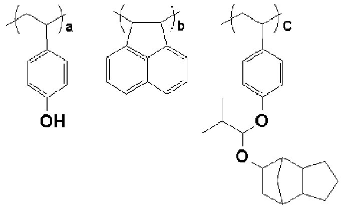 | 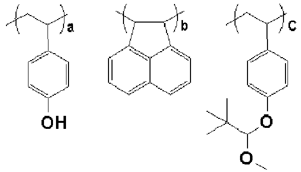 |
| **cP-5** | **cP-6** |
| **(a = 0.63, b = 0.16, c = 0.21, Mw = 6,800)** | **(a = 0.67, b = 0.15, c = 0.18, Mw = 6,300)** |
| 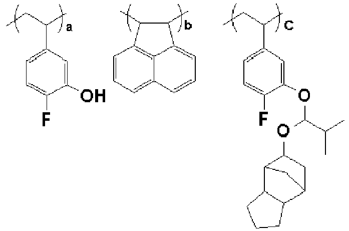 | 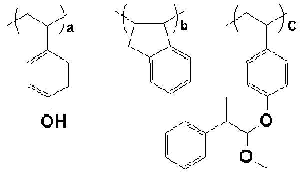 |

| | |
|---|---|
| **AP-1** | **AP-2** |
| **(a=0.67, b=0.10, c=0.23, Mw=5,500)** | **(a=0.60, b=0.10, c=0.30, Mw=5,200)** |
| 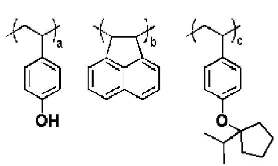 | 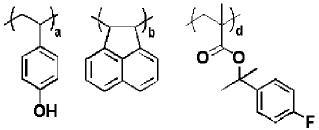 |
| **AP-3** | **AP4** |
| **(a=0.65, b=0.10, c=0.10, d=0.15, Mw=5,200)** | **(a=0.55, b=0.10, c=0.25, d=0.10, Mw=17,200)** |
| 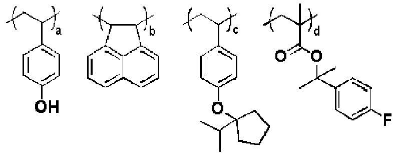 | 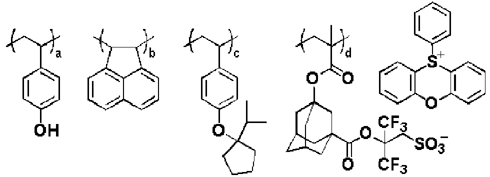 |
| **AP-5** | **AP-6** |
| **(a=0.70, b=0.15, c=0.15, Mw=4,700)** | **(a=0.70, b=0.30, Mw=4,500)** |
| 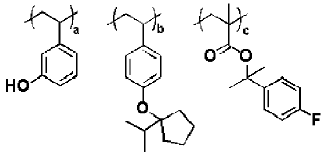 | 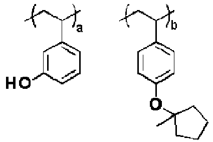 |

The dissolution rate of each polymer in an alkaline developer was determined as follows: an 8-inch silicon wafer was spin-coated with a polymer solution (polymer concentration: 16.7 mass%, solvent: PGMEA); the resulting wafer was baked at 100°C for 90 seconds to form a 1,000-nm thick film; development was then performed with a 2.38 mass% aqueous solution of TMAH at 23°C for 100 seconds; the film loss amount was measured; and the dissolution rate was calculated therefrom. As a result, the polymers P-1 to P-15, AP-1 to AP-6, and cP-2 to cP-6 had a dissolution rate of 5 nm/min or lower, and the comparative polymer cP-1 had a dissolution rate of 14 nm/min.

### [3] Preparation of Chemically Amplified Positive Resist Composition

### [Examples 1-1 to 1-41 and Comparative Examples 1-1 to 1-10]

Each chemically amplified positive resist composition was prepared by dissolving each component in an organic solvent according to the composition shown in the following Tables 1 to 3 and filtering the obtained solution with a 5-nm nylon filter and a 1-nm UPE filter. Incidentally, the organic solvent was a mixed solvent of 940 parts by mass of PGMEA, 1,870 parts by mass of EL, and 1,870 parts by mass of PGME.

**[Table 1]**

| | Resist composition | Polymer 1 (parts by mass) | Polymer 2 (parts by mass) | Photo-acid generator (parts by mass) | Quencher (parts by mass) | Additive (parts by mass) |
|---|---|---|---|---|---|---|
| Example 1-1 | R-1 | P-1 (80) | - | PAG-1 (12) | Q-1 (8.0) | - |
| Example 1-2 | R-2 | P-1 (80) | - | PAG-1 (8) | Q-1 (7.0) | - |
| | | | | PAG-4 (4) | | |
| Example 1-3 | R-3 | P-1 (80) | - | PAG-1 (8) | Q-1 (7.0) | P-1 (1.5) |
| | | | | PAG-4 (4) | | |
| Example 1-4 | R-4 | P-1 (80) | - | PAG-1(8) | Q-1 (7.0) | D-2 (3.0) |
| | | | | PAG-4 (4) | | |
| Example 1-5 | R-5 | P-1 (80) | - | PAG-1 (8) | Q-1 (7.0) | D-3 (5.0) |
| | | | | PAG-4 (4) | | |
| Example 1-6 | R-6 | P-1 (80) | - | PAG-1 (8) | Q-1 (7.0) | D-4 (1.5) |
| | | | | PAG-4 (4) | | |
| Example 1-7 | R-7 | P-1 (80) | - | PAG-1 (8) | Q-1 (7.0) | D-5 (1.5) |
| | | | | PAG-4 (4) | | |
| Example 1-8 | R-8 | P-1 (80) | - | PAG-2 (8) | Q-1 (7.0) | P-1 (1.5) |
| | | | | PAG-4 (4) | | |
| Example 1-9 | R-9 | P-1 (80) | - | PAG-3 (8) | Q-1 (7.0) | P-1 (1.5) |
| | | | | PAG-4 (4) | | |
| Example 1-10 | R-10 | P-1 (80) | - | PAG-5 (8) | Q-1 (7.0) | P-1 (1.5) |
| | | | | PAG-4(4) | | |
| Example 1-11 | R-11 | P-1 (80) | - | PAG-2 (8) | Q-2 (7.0) | P-1 (1.5) |
| | | | | PAG-4 (4) | | |
| Example 1-12 | R-12 | P-1 (80) | - | PAG-2 (8) | Q-3 (7.0) | P-1 (1.5) |
| | | | | PAG-4 (4) | | |
| Example 1-13 | R-13 | P-1 (80) | - | PAG-2 (8) | Q-4 (7.0) | P-1 (1.5) |
| | | | | PAG-4 (4) | | |
| Example 1-14 | R-14 | P-2 (80) | - | PAG-2 (8) | Q-1 (7.0) | P-1 (1.5) |
| | | | | PAG-4 (4) | | |
| Example 1-15 | R-15 | P-3 (80) | - | PAG-2 (8) | Q-1 (7.0) | P-1 (1.5) |
| | | | | PAG-4 (4) | | |
| Example 1-16 | R-16 | P-4 (80) | - | PAG-2 (8) | Q-1 (7.0) | P-1 (1.5) |
| | | | | PAG-4 (4) | | |
| Example 1-17 | R-17 | P-5 (80) | - | PAG-2 (8) | Q-1 (7.0) | P-1 (1.5) |
| | | | | PAG-4 (4) | | |
| Example 1-18 | R-18 | P-6 (80) | - | PAG-2 (8) | Q-1 (7.0) | P-1 (1.5) |
| | | | | PAG-4 (4) | | |
| Example 1-19 | R-19 | P-7 (80) | - | PAG-2 (8) | Q-1 (7.0) | P-1 (1.5) |
| | | | | PAG-4 (4) | | |
| Example 1-20 | R-20 | P-8 (80) | - | PAG-2 (8) | Q-1 (7.0) | P-1(1.5) |
| | | | | PAG-4 (4) | | |
| Example 1-21 | R-21 | P-9 (80) | - | PAG-2 (8) | Q-1 (7.0) | P-1 (1.5) |
| | | | | PAG-4 (4) | | |
| Example 1-22 | R-22 | P-10 (80) | - | PAG-2 (8) | Q-1 (7.0) | P-1 (1.5) |
| | | | | PAG-4 (4) | | |
| Example 1-23 | R-23 | P-11 (80) | - | PAG-2 (8) | Q-1 (7.0) | P-1 (1.5) |
| | | | | PAG-4 (4) | | |
| Example 1-24 | R-24 | P-12 (80) | - | PAG-2 (8) | Q-1 (7.0) | P-1 (1.5) |
| | | | | PAG-4 (4) | | |
| Example 1-25 | R-25 | P-13 (80) | - | PAG-2 (8) | Q-1 (7.0) | P-1 (1.5) |
| | | | | PAG-4 (4) | | |

**[Table 2]**

| | Resist composition | Polymer 1 (parts by mass) | Polymer 2 (parts by mass) | Photo-acid generator (parts by mass) | Quencher (parts by mass) | Additive (parts by mass) |
|---|---|---|---|---|---|---|
| Example 1-26 | R-2 6 | P-14 (80) | - | PAG-2 (8) | Q-1 (7.0) | D-1 (1.5) |
| | | | | PAG-4 (4) | | |
| Example 1-27 | R-27 | P-15 (80) | < | PAG-2 (8) | Q-1 (7.0) | D-1 (1.5) |
| | | | | PAG-4 (4) | | |
| Example 1-28 | R-2 8 | P-1 (40) | AP-1 (40) | PAG-2 (8) | Q-1 (7.0) | D-1 (1.5) |
| | | | | PAG-4 (4) | | |
| Example 1-29 | R-2 9 | P-1 (40) | AP-2 (40) | PAG-2 (8) | Q-1 (7.0) | D-1 (1.5) |
| | | | | PAG-4 (4) | | |
| Example 1-30 | R-30 | P-1 (40) | AP-3 (40) | PAG-2 (8) | Q-1 (7.0) | D-1 (1.5) |
| | | | | PAG-4 (4) | | |
| Example 1-31 | R-31 | P-1 (40) | AP-4 (40) | PAG-1 (12) | Q-1 (9.0) | D-1 (1.5) |
| Example 1-32 | R-32 | P-1 (40) | AP-5 (40) | PAG-2 (8) | Q-1 (7.0) | D-1 (1.5) |
| | | | | PAG-4 (4) | | |
| Example 1-33 | R-33 | P-1 (40) | AP-6 (40) | PAG-2 (8) | Q-1 (7.0) | D-1 (1.5) |
| | | | | PAG-4 (4) | | |
| Example 1-34 | R-34 | P-2 (40) | AP-1 (40) | PAG-2 (8) | Q-3 (8.5) | D-2 (3.0) |
| | | | | PAG-4 (4) | | |
| Example 1-35 | R-35 | P-5 (40) | AP-3 (40) | PAG-1 (12) | Q-4 (8.5) | D-1 (1.5) |
| Example 1-36 | R-36 | P-6 (80) | AP-5 (40) | PAG-3 (8) | Q-2 (8.5) | D-1 (1.5) |
| | | | | PAG-4 (4) | | |
| Example 1-37 | R-37 | P-8 (80) | AP-6 (40) | PAG-1 (8) | Q-2 (7.5) | D-1 (1.5) |
| | | | | PAG-4 (4) | | |
| Example 1-38 | R-38 | P-10 (80) | AP-4 (40) | PAG-3 (6) | Q-1 (7.0) | D-1 (1.5) |
| | | | | PAG-4 (6) | | |
| Example 1-39 | R-39 | P-11 (80) | AP-3 (40) | PAG-4 (10) | Q-3 (7.5) | D-1 (1.5) |
| | | | | PAG-4 (2) | | |
| Example 1-40 | R-40 | P-13 (80) | AP-5 (40) | PAG-5 (8) | Q-4 (8.5) | D-1 (1.5) |
| | | | | PAG-4 (4) | | |
| Example 1-41 | R-41 | P-15 (80) | AP-2 (40) | PAG-2 (8) | Q-2 (8.5) | D-1 (1.5) |
| | | | | PAG-4 (4) | | |

**[Table 3]**

| | Resist composition | Polymer 1 (parts by mass) | Polymer 2 (parts by mass) | Photo-acid generator (parts by mass) | Quencher (parts by mass) | Additive (parts by mass) |
|---|---|---|---|---|---|---|
| Comparative Example 1-1 | CR-1 | cP-1 (80) | | PAG-2 (8) | Q-1 (7.0) | D-1 (1.5) |
| | | | - | PAG-4 (4) | | |
| Comparative Example 1-2 | CR-2 | cP-2 (80) | - | PAG-2 (8) | Q-1 (7.0) | D-1 (1.5) |
| | | | | PAG-4 (4) | | |
| Comparative Example 1-3 | CR-3 | cP-3 (80) | - | PAG-2 (8) | Q-1 (7.0) | D-1 (1.5) |
| | | | | PAG-4 (4) | | |
| Comparative Example 1-4 | CR-4 | cP-4 (80) | | PAG-2 (8) | Q-1 (7.0) | D-1 (1.5) |
| | | | - | PAG-4 (4) | | |
| Comparative Example 1-5 | CR-5 | cP-5 (80) | | PAG-2 (8) | Q-1 (7.0) | D-1 (1.5) |
| | | | - | PAG-4 (4) | | |
| Comparative Example 1-6 | CR-6 | cP-6 (80) | - | PAG-2 (8) | Q-1 (7.0) | D-1 (1.5) |
| | | | | PAG-4 (4) | | |
| Comparative Example 1-7 | CR-7 | cP-1 (40) | AP-1 (40) | PAG-2 (8) | Q-2 (7.0) | D-1 (1.5) |
| | | | | PAG-4 (4) | | |
| Comparative Example 1-8 | CR-8 | cP-3 (40) | AP-3 (40) | PAG-1 (12) | Q-4 (8.5) | D-1 (1.5) |
| Comparative Example 1-9 | CR-9 | cP-4 (40) | AP-5 (40) | PAG-3 (8) | Q-2 (8.5) | D-1 (1.5) |
| | | | | PAG-4 (4) | | |
| Comparative Example 1-10 | CR-10 | cP-6 (40) | AP-6 (40) | PAG-1 (8) | Q-2 (7.5) | D-1 (1.5) |
| | | | | PAG-4 (4) | | |

In Tables 1 to 3, the structures of the photo-acid generators PAG-1 to PAG-5, the quenchers Q-1 to Q-4, and the fluorine-containing polymers D-1 to D-5 are as follows.

| | |
|---|---|
| 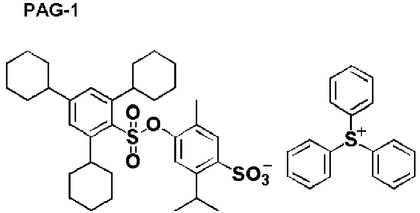 | 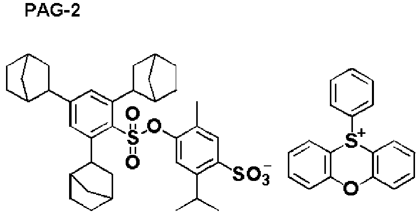 |
| 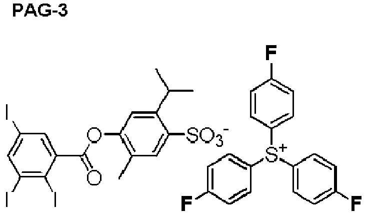 | 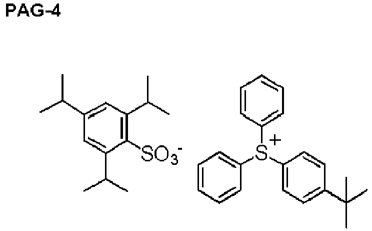 |
| 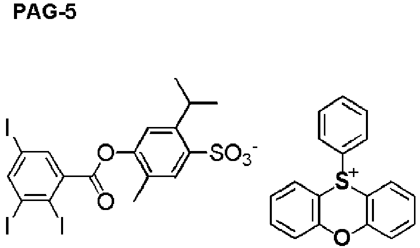 | |

| | |
|---|---|
| 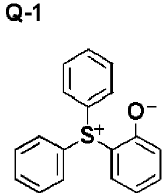 | 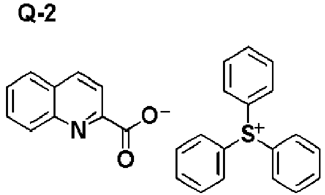 |
| 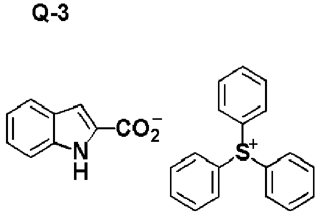 | 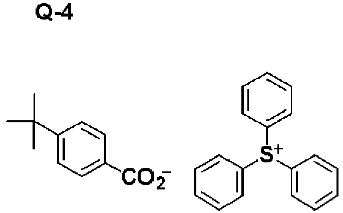 |

| | | |
|---|---|---|
| **D-1 (a=0.80, b=0.20, Mw=6000)** | **D-2 (a=0.80, b=0.20, Mw=6400)** | **D-3 (a=0.80, b=0.20, Mw=6500)** |
| 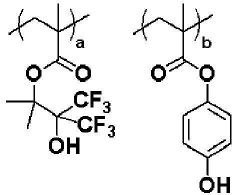 | 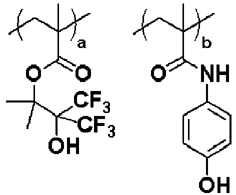 | 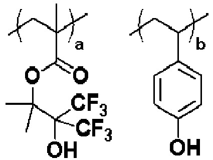 |
| **D-4 (a=0.80, b=0.20, Mw=8200)** | **D-5 (a=1.0, Mw=8600)** | |
| 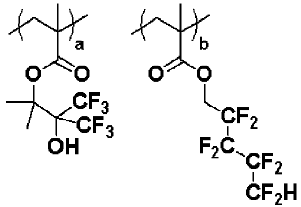 | 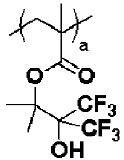 | |

### [4] EB Lithography Evaluation

### [Examples 2-1 to 2-41 and Comparative Examples 2-1 to 2-10]

By using ACT-M (manufactured by Tokyo Electron Ltd.), a 284-nm thick multilayer reflective film of an Mo/Si 40 layer was formed on a 150-mm (6-inch) square low-thermal-expansion glass substrate; a 3.5-nm Ru film was formed thereon as a protective film; a 70-nm TaN film was formed thereon as an absorption layer; a 6-nm CrN film was formed thereon as a hard mask; and each chemically amplified positive resist composition (R-1 to R-41 and CR-1 to CR-10) was respectively applied on the resulting mask blank as a reflective mask blank for an EUV exposure mask by spin-coating. This was prebaked on a hot plate at 110°C for 600 seconds to produce a resist film having a film thickness of 80 nm. The thickness of the obtained resist film was measured by using an optical measuring apparatus Nanospec (manufactured by Nanometrics Inc.). The film thickness was measured on 81 points of the blank substrate plane except for the peripheral portion ranging to the inside from the periphery of the blank by 10 mm, and the average film thickness and the range of the film thicknesses were calculated.

Additionally, exposure was performed by using an electron beam exposure apparatus (EBM-5000plus, manufactured by NuFlare Technology, Inc., accelerating voltage: 50 kV), followed by PEB at 110°C for 600 seconds and development with a 2.38 mass% aqueous TMAH solution to give a positive type pattern.

The obtained resist pattern was evaluated as follows. The produced patterned mask blank was observed under a top SEM (scanning electron microscope), defining the exposure dose in which a 200-nm line-and-space (LS) of 1:1 is resolved as 1:1 as the optimum exposure dose (µC/cm²) and the minimum size at the exposure dose to resolve a 200-nm isolated space as 9:1 as resolution (limiting IS resolution), to measure the LER of the 200-nm LS by SEM. Regarding the evaluation of development loading, a 200-nm LS pattern was formed on the substrate plane at an exposure dose (µC/cm²) to resolve a 200-nm design 1:1 LS at a ratio of 1:1, a 200-nm LS pattern was formed near the pattern so that dummy patterns with a density of 15%, 25%, 33%, 45%, 50%, 55%, 66%, 75%, 85%, and 95% were each arranged. The dimensions of the space portions of the 200-nm LS patterns were measured by SEM, and the difference between the dimensions of the patterns with different densities was compared. Regarding pattern profile, it was visually observed and judged whether or not the pattern profile was rectangular.

The dissolution rate in an exposed portion was determined as follows: a 200-mm (8-inch) silicon wafer was spin-coated with a resist solution; the resulting wafer was baked at 110°C for 60 seconds to form a 90-nm thick resist film; exposure was then performed with a KrF excimer laser beam at an exposure dose (mJ/cm²) to resolve a 200-nm 1:1 line-and-space (LS) at 1:1; the resultant was baked at 110°C for 60 seconds; then, development was performed by using a resist development analyzer (RDA-800 manufactured by Litho Tech Japan Corporation) and using a 2.38 mass% aqueous TMAH solution at 23°C; and the dissolution rate was calculated therefrom. Tables 4 to 6 show the results.

**[Table 4]**

| | Resist composition | Optimum exposure dose (µC/cm²) | Limiting IS resolution (nm) | LER (nm) | Development loading variation (Δnm) | Pattern profile | Dissolution rate (nm/s) of exposed portion |
|---|---|---|---|---|---|---|---|
| Example 2-1 | R-1 | 220 | 23 | 4.7 | 1.9 | Rectangular | 120 |
| Example 2-2 | R-2 | 215 | 23 | 4.5 | 1.8 | Rectangular | 120 |
| Example 2-3 | R-3 | 210 | 18 | 4.2 | 1.7 | Rectangular | 130 |
| Example 2-4 | R-4 | 215 | 20 | 4.5 | 1.8 | Rectangular | 110 |
| Example 2-5 | R-5 | 215 | 20 | 4.4 | 1.7 | Rectangular | 120 |
| Example 2-6 | R-6 | 215 | 20 | 4.3 | 1.8 | Rectangular | 130 |
| Example 2-7 | R-7 | 220 | 20 | 4.5 | 1.7 | Rectangular | 120 |
| Example 2-8 | R-8 | 210 | 18 | 4.4 | 1.7 | Rectangular | 120 |
| Example 2-9 | R-9 | 215 | 20 | 4.3 | 1.8 | Rectangular | 120 |
| Example 2-10 | R-10 | 210 | 20 | 4.2 | 1.8 | Rectangular | 130 |
| Example 2-11 | R-11 | 215 | 20 | 4.5 | 1.7 | Rectangular | 110 |
| Example 2-12 | R-12 | 210 | 18 | 4.3 | 1.8 | Rectangular | 130 |
| Example 2-13 | R-13 | 215 | 20 | 4.4 | 1.8 | Rectangular | 120 |
| Example 2-14 | R-14 | 210 | 20 | 4.5 | 1.8 | Rectangular | 120 |
| Example 2-15 | R-15 | 215 | 20 | 4.6 | 1.7 | Rectangular | 110 |
| Example 2-16 | R-16 | 215 | 18 | 4.4 | 1.8 | Rectangular | 130 |
| Example 2-17 | R-17 | 215 | 20 | 4.3 | 1.8 | Rectangular | 120 |
| Example 2-18 | R-18 | 215 | 20 | 4.5 | 1.8 | Rectangular | 120 |
| Example 2-19 | R-19 | 215 | 20 | 4.6 | 1.8 | Rectangular | 120 |
| Example 2-20 | R-20 | 215 | 18 | 4. 7 | 1.8 | Rectangular | 120 |
| Example 2-21 | R-21 | 210 | 20 | 4.4 | 1.7 | Rectangular | 110 |
| Example 2-22 | R-22 | 215 | 18 | 4.4 | 1.8 | Rectangular | 120 |
| Example 2-23 | R-23 | 210 | 20 | 4. 3 | 1.7 | Rectangular | 120 |
| Example 2-24 | R-24 | 215 | 20 | 4. 5 | 1.7 | Rectangular | 110 |
| Example 2-25 | R-25 | 210 | 20 | 4.2 | 1.8 | Rectangular | 110 |
| Example 2-26 | R-26 | 215 | 18 | 4. 5 | 1.7 | Rectangular | 130 |
| Example 2-27 | R-27 | 215 | 20 | 5.5 | 1.8 | Rectangular | 120 |
| Example 2-28 | R-28 | 210 | 20 | 4. 3 | 1.8 | Rectangular | 120 |
| Example 2-29 | R-29 | 210 | 20 | 4.4 | 1.7 | Rectangular | 130 |
| Example 2-30 | R-30 | 215 | 18 | 4.5 | 1.8 | Rectangular | 110 |

**[Table 5]**

| | Resist composition | Optimum exposure dose (µC/cm²) | Limiting IS resolution (nm) | LER (nm) | Development loading variation (Δnm) | Pattern profile | Dissolution rate (nm/s) of exposed portion |
|---|---|---|---|---|---|---|---|
| Example 2-31 | R-31 | 210 | 20 | 4.6 | 1.7 | Rectangular | 100 |
| Example 2-32 | R-32 | 215 | 20 | 4.5 | 1.8 | Rectangular | 110 |
| Example 2-33 | R-33 | 215 | 20 | 4.4 | 1.7 | Rectangular | 120 |
| Example 2-34 | R-34 | 210 | 20 | 4.3 | 1.8 | Rectangular | 110 |
| Example 2-35 | R-35 | 215 | 18 | 4.5 | 1.8 | Rectangular | 120 |
| Example 2-36 | R-36 | 210 | 20 | 4.4 | 1.7 | Rectangular | 110 |
| Example 2-37 | R-37 | 215 | 20 | 4.4 | 1.8 | Rectangular | 100 |
| Example 2-38 | R-38 | 215 | 20 | 4.5 | 1.7 | Rectangular | 120 |
| Example 2-39 | R-39 | 215 | 18 | 4.4 | 1.8 | Rectangular | 130 |
| Example 2-40 | R-40 | 210 | 20 | 4.3 | 1.7 | Rectangular | 120 |
| Example 2-41 | R-41 | 210 | 20 | 4.5 | 1.8 | Rectangular | 120 |

**[Table 6]**

| | Resist composition | Optimum exposure dose (µC/cm²) | Limiting IS resolution (nm) | LER (nm) | Development loading variation (Δnm) | Pattern profile | Dissolution rate (nm/s) of exposed portion |
|---|---|---|---|---|---|---|---|
| Comparative Example 2-1 | CR-1 | 190 | 26 | 5.5 | 2.4 | Trailing | 100 |
| Comparative Example 2-2 | CR-2 | 200 | 35 | 5.3 | 2.3 | Trailing | 70 |
| Comparative Example 2-3 | CR-3 | 205 | 35 | 5.4 | 2.1 | Trailing | 60 |
| Comparative Example 2-4 | CR-4 | 195 | 40 | 5.3 | 2.4 | Trailing | 80 |
| Comparative Example 2-5 | CR-5 | 200 | 35 | 5.1 | 2.3 | Trailing | 70 |
| Comparative Example 2-6 | CR-6 | 210 | 40 | 5.3 | 2.2 | Trailing | 80 |
| Comparative Example 2-7 | CR-7 | 215 | 35 | 5.2 | 2.4 | Trailing | 70 |
| Comparative Example 2-8 | CR-8 | 200 | 30 | 5.6 | 2.4 | Trailing | 80 |
| Comparative Example 2-9 | CR-9 | 210 | 35 | 5.3 | 2.3 | Trailing | 90 |
| Comparative Example 2-10 | CR-10 | 210 | 30 | 5.4 | 2.1 | Trailing | 80 |

### [5] Evaluation of Residue Defects

### [Examples 3-1 to 3-41 and Comparative Examples 3-1 to 3-10]

On a substrate obtained by applying each of the resist compositions (R-1 to R-41 and CR-1 to CR-10) respectively on a reflective mask blank for an EUV exposure mask in the same manner as above, a pattern was drawn on the entire surface by using an electron beam exposure apparatus (EBM-5000plus, manufactured by NuFlare Technology, Inc., accelerating voltage: 50 keV) at the optimum exposure dose of each resist composition, followed by PEB at 110°C for 600 seconds and development with a 2.38 mass% aqueous TMAH solution, and development residue was evaluated by using a mask defect inspection apparatus (M9650, manufactured by Lasertec Corporation). The total count of defects after development is shown in Table 7.

**[Table 7]**

| | Resist composition | Total count of defects after development | | Resist composition | Total count of defects after development |
|---|---|---|---|---|---|
| Example 3-1 | R-1 | 340 | Example 3-27 | R-27 | 325 |
| Example 3-2 | R-2 | 360 | Example 3-28 | R-2 8 | 335 |
| Example 3-3 | R-3 | 290 | Example 3-29 | R-2 9 | 325 |
| Example 3-4 | R-4 | 310 | Example 3-30 | R-30 | 310 |
| Example 3-5 | R-5 | 310 | Example 3-31 | R-31 | 320 |
| Example 3-6 | R-6 | 330 | Example 3-32 | R-32 | 355 |
| Example 3-7 | R-7 | 310 | Example 3-33 | R-33 | 330 |
| Example 3-8 | R-8 | 320 | Example 3-34 | R-34 | 310 |
| Example 3-9 | R-9 | 330 | Example 3-35 | R-35 | 305 |
| Example 3-10 | R-10 | 335 | Example 3-36 | R-36 | 310 |
| Example 3-11 | R-11 | 295 | Example 3-37 | R-37 | 295 |
| Example 3-12 | R-12 | 345 | Example 3-38 | R-38 | 300 |
| Example 3-13 | R-13 | 325 | Example 3-39 | R-39 | 330 |
| Example 3-14 | R-14 | 310 | Example 3-40 | R-40 | 315 |
| Example 3-15 | R-15 | 340 | Example 3-41 | R-41 | 325 |
| Example 3-16 | R-16 | 320 | Comparative Example 3-1 | CR-1 | 660 |
| Example 3-17 | R-17 | 350 | Comparative Example 3-2 | CR-2 | 1260 |
| Example 3-18 | R-18 | 210 | Comparative Example 3-3 | CR-3 | 1300 |
| Example 3-19 | R-19 | 325 | Comparative Example 3-4 | CR-4 | 1340 |
| Example 3-20 | R-20 | 314 | Comparative Example 3-5 | CR-5 | 1420 |
| Example 3-21 | R-21 | 320 | Comparative Example 3-6 | CR-6 | 1420 |
| Example 3-22 | R-22 | 315 | Comparative Example 3-7 | CR-7 | 1200 |
| Example 3-23 | R-23 | 295 | Comparative Example 3-8 | CR-8 | 940 |
| Example 3-24 | R-24 | 290 | Comparative Example 3-9 | CR-9 | 950 |
| Example 3-25 | R-25 | 305 | Comparative Example 3-10 | CR-10 | 1100 |
| Example 3-26 | R-26 | 310 | | | |

As shown in Tables 4 to 7, the inventive chemically amplified positive resist compositions (R-1 to R-41) had better isolated space (IS) resolution, better LER, and better pattern rectangularity, and showed suppressed values of development loading and total count of defects after development compared with the resist compositions (CR-1 to CR-10) of the Comparative Examples.

### [6] Evaluation of Dry Etching Resistance

### [Examples 4-1 to 4-41 and Comparative Examples 4-1 to 4-10]

Each of the components in the composition shown in Tables 1 to 3 was respectively dissolved in 10 g of cyclohexanone in an amount of 2 g. Each of the resist compositions (R-1 to R-41 and CR-1 to CR-10) was filtered with a 0.2-µm filter and applied to a 152-mm square mask blank whose uppermost surface is a Cr film by spin-coating to form a film. The film was formed to have a thickness of 300 nm, and evaluation was carried out under the following conditions.

### Etching test with chlorine-based gas:

The difference between the film thicknesses of the polymer film before and after etching was determined using a mask dry etching apparatus Gen-4 manufactured by Plasma-Therm LLC.

The etching conditions are as shown below.

| | |
|---|---|
| Chamber pressure | 6.0 mTorr |
| RF power | 700 V |
| Cl₂ gas flow rate | 185 sccm |
| O₂ flow rate | 55 sccm |
| He flow rate | 9 sccm |
| Time | 75 sec |

In this evaluation, a smaller difference in film thickness, that is, a smaller amount reduced, indicates that the film has etching resistance.

Table 8 shows the results of the dry etching resistance evaluation.

**[Table 8]**

| | Resist composition | Cl₂/O₂-based gas etching rate (nm/min) | | Resist composition | Cl₂/O₂-based gas etching rate (nm/min) |
|---|---|---|---|---|---|
| Example 4-1 | R-1 | 89 | Example 4-27 | R-27 | 90 |
| Example 4-2 | R-2 | 90 | Example 4-28 | R-28 | 92 |
| Example 4-3 | R-3 | 87 | Example 4-29 | R-29 | 87 |
| Example 4-4 | R-4 | 90 | Example 4-30 | R-30 | 91 |
| Example 4-5 | R-5 | 91 | Example 4-31 | R-31 | 88 |
| Example 4-6 | R-6 | 93 | Example 4-32 | R-32 | 90 |
| Example 4-7 | R-7 | 89 | Example 4-33 | R-33 | 89 |
| Example 4-8 | R-8 | 87 | Example 4-34 | R-34 | 92 |
| Example 4-9 | R-9 | 89 | Example 4-35 | R-35 | 91 |
| Example 4-10 | R-10 | 87 | Example 4-36 | R-36 | 88 |
| Example 4-11 | R-11 | 91 | Example 4-37 | R-37 | 89 |
| Example 4-12 | R-12 | 93 | Example 4-38 | R-38 | 93 |
| Example 4-13 | R-13 | 87 | Example 4-39 | R-39 | 91 |
| Example 4-14 | R-14 | 89 | Example 4-40 | R-40 | 89 |
| Example 4-15 | R-15 | 90 | Example 4-41 | R-41 | 88 |
| Example 4-16 | R-16 | 91 | Comparative Example 4-1 | CR-1 | 132 |
| Example 4-17 | R-17 | 87 | Comparative Example 4-2 | CR-2 | 112 |
| Example 4-18 | R-18 | 89 | Comparative Example 4-3 | CR-3 | 117 |
| Example 4-19 | R-19 | 91 | Comparative Example 4-4 | CR-4 | 126 |
| Example 4-20 | R-20 | 93 | Comparative Example 4-5 | CR-5 | 109 |
| Example 4-21 | R-21 | 89 | Comparative Example 4-6 | CR-6 | 107 |
| Example 4-22 | R-22 | 89 | Comparative Example 4-7 | CR-7 | 123 |
| Example 4-23 | R-23 | 88 | Comparative Example 4-8 | CR-8 | 106 |
| Example 4-24 | R-24 | 94 | Comparative Example 4-9 | CR-9 | 104 |
| Example 4-25 | R-25 | 87 | Comparative Example 4-10 | CR-10 | 117 |
| Example 4-26 | R-26 | 89 | | | |

From the results shown in Table 8, it was confirmed that the chemically amplified positive resist compositions (R-1 to R-41) containing the inventive polymer had excellent dry etching resistance to Cl₂/O₂-based gas.

It follows from the above results that the inventive polymer, chemically amplified positive resist composition containing the polymer, resist patterning process, and mask blank that uses the inventive chemically amplified positive resist composition are useful for the production of semiconductor devices, particularly in photolithography for processing a transmission type or reflective photomask blank.

The present description includes the following embodiments.
[1]: A polymer comprising a structural unit comprising an aromatic hydroxy group bonded to a main chain, wherein the aromatic hydroxy group is protected by an acid-labile group represented by the following formula (ALU-1) and is deprotected by action of an acid to become alkali-soluble, 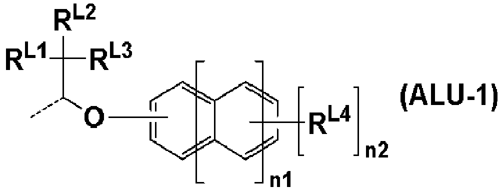 wherein R^{L1} to R^{L3} each independently represent a hydrogen atom or a hydrocarbyl group having 1 to 6 carbon atoms and do not have an aromatic ring structure, any two of R^{L1} to R^{L3} optionally being bonded to each other to form a cyclic structure together with a carbon atom to which R^{L1} to R^{L3} are bonded; R^{L4} represents a hydrogen atom, a halogen atom, a nitro group, or a hydrocarbyl group having 1 to 6 carbon atoms and optionally having a heteroatom; n1 represents an integer of 0 or 1; when n1 is 0, n2 represents an integer of 0 to 5 and when n1 is 1, n2 represents an integer of 0 to 7; and a broken line represents a bond with an oxygen atom of the aromatic hydroxy group of the unit comprising the aromatic hydroxy group bonded to the main chain of the polymer.
[2]: The polymer of the above [1], wherein the unit comprising the aromatic hydroxy group bonded to the main chain of the polymer is a repeating unit represented by the following formula (A1), 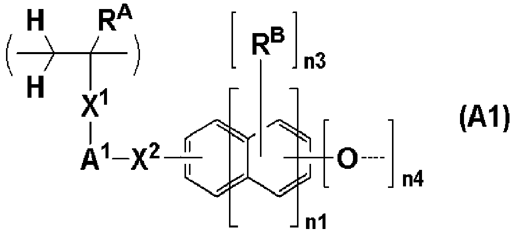 wherein each R^{A} independently represents a hydrogen atom, a fluorine atom, a methyl group, or a trifluoromethyl group; X¹ represents a single bond, *-C(=O)-O-, or *-C(=O)-NH-; "*" represents an attachment point to a carbon atom in the main chain; A¹ represents a single bond or a saturated hydrocarbylene group having 1 to 10 carbon atoms, a part of -CH₂- constituting the saturated hydrocarbylene group optionally being substituted with - O-; X² represents a single bond, an ether bond, an ester bond, a carbonyl group, a sulfonic acid ester bond, a carbonate bond, or a carbamate bond; R^{B} represents a halogen atom or a linear, branched, or cyclic hydrocarbyl group having 1 to 20 carbon atoms and optionally having a heteroatom; n1 is as defined above; n3 represents an integer of 0 to 4 when n1 is 0 and represents an integer of 0 to 6 when n1 is 1; n4 represents an integer of 1 to 3, provided that when n1 is 0, n3+n4 ≤ 5 and when n1 is 1, n3+n4 ≤ 7; and a broken line represents a bond with the formula (ALU-1).
[3]: The polymer of the above [1] or [2], further comprising a phenolic hydroxy group-containing repeating unit represented by the following formula (A2), 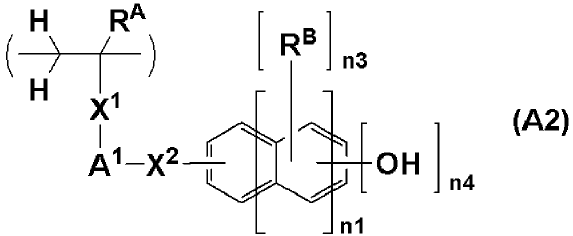 wherein each R^{A} independently represents a hydrogen atom, a fluorine atom, a methyl group, or a trifluoromethyl group; X¹ represents a single bond, *-C(=O)-O-, or *-C(=O)-NH-; "*" represents an attachment point to a carbon atom in the main chain; A¹ represents a single bond or a saturated hydrocarbylene group having 1 to 10 carbon atoms, a part of -CH₂- constituting the saturated hydrocarbylene group optionally being substituted with - O-; X² represents a single bond, an ether bond, an ester bond, a carbonyl group, a sulfonic acid ester bond, a carbonate bond, or a carbamate bond; R^{B} represents a halogen atom or a linear, branched, or cyclic hydrocarbyl group having 1 to 20 carbon atoms and optionally having a heteroatom; n1 is as defined above; n3 represents an integer of 0 to 4 when n1 is 0 and represents an integer of 0 to 6 when n1 is 1; n4 represents an integer of 1 to 3, provided that when n1 is 0, n3+n4 ≤ 5 and when n1 is 1, n3+n4 ≤ 7.
[4]: The polymer of the above [3], wherein the phenolic hydroxy group-containing repeating unit is a repeating unit represented by the following formula (A2-1), 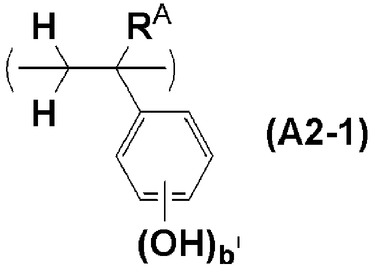 wherein R^{A} is as defined above; and "b‴ represents an integer of 1 to 3.
[5]: The polymer of any one of the above [1] to [4], further comprising one or more repeating units represented by any of the following formulae (B1) to (B3), 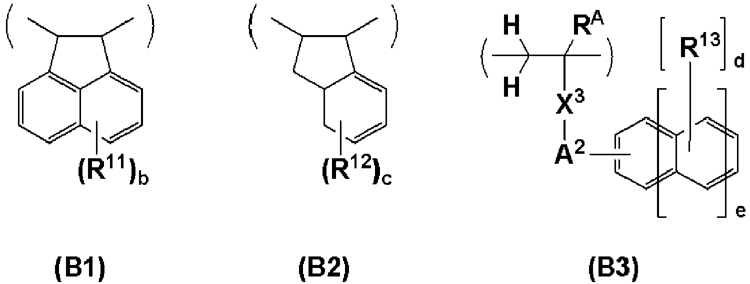 wherein each R^{A} independently represents a hydrogen atom, a fluorine atom, a methyl group, or a trifluoromethyl group; "b" and "c" each independently represent an integer of 0 to 4; "d" represents an integer of 0 to 5; "e" represents an integer of 0 to 2; X³ represents a single bond, *-C(=O)-O-, or *-C(=O)-NH-; "*" represents an attachment point to a carbon atom in the main chain; A² represents a single bond or a saturated hydrocarbylene group having 1 to 10 carbon atoms, a part of -CH₂-constituting the saturated hydrocarbylene group optionally being substituted with -O-; R¹¹ and R¹² each independently represent a hydroxy group, a halogen atom, a saturated hydrocarbylcarbonyloxy group having 2 to 8 carbon atoms optionally substituted with a halogen atom, a saturated hydrocarbyl group having 1 to 8 carbon atoms optionally substituted with a halogen atom, or a saturated hydrocarbyloxy group having 1 to 8 carbon atoms optionally substituted with a halogen atom; and R¹³ represents an acetyl group, a saturated hydrocarbyl group having 1 to 20 carbon atoms, a saturated hydrocarbyloxy group having 1 to 20 carbon atoms, a saturated hydrocarbylcarbonyloxy group having 2 to 20 carbon atoms, a saturated hydrocarbyloxyhydrocarbyl group having 2 to 20 carbon atoms, a saturated hydrocarbylthiohydrocarbyl group having 2 to 20 carbon atoms, a halogen atom, a nitro group, or a cyano group, and when "e" is 1 or 2, R¹³ optionally represents a hydroxy group.
[6]: The polymer of any one of the above [1] to [5], further comprising a repeating unit represented by the following formula (A3-1) and/or the following formula (A3-2), 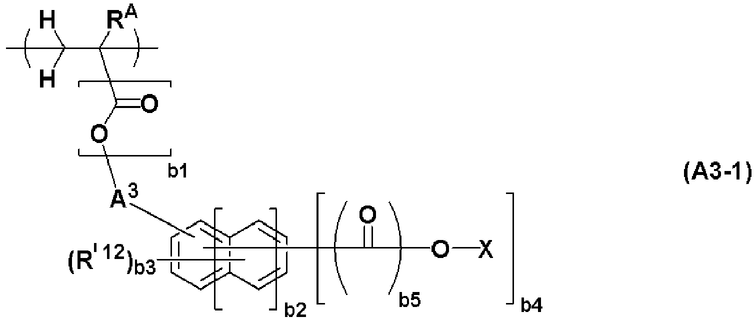 wherein each R^{A} independently represents a hydrogen atom, a fluorine atom, a methyl group, or a trifluoromethyl group; b1 represents 0 or 1; b2 represents an integer of 0 to 2; b3 represents an integer that satisfies 0 ≤ b3 ≤ 5+2b2-b4; b4 represents an integer of 1 to 3; b5 represents 0 or 1; R'¹² represents a halogen atom, a saturated hydrocarbyl group having 1 to 6 carbon atoms optionally substituted with a halogen atom, a saturated hydrocarbyloxy group having 1 to 6 carbon atoms optionally substituted with a halogen atom, or a saturated hydrocarbylcarbonyloxy group having 2 to 8 carbon atoms optionally substituted with a halogen atom; A³ represents a single bond or a saturated hydrocarbylene group having 1 to 10 carbon atoms, a part of -CH₂- of the saturated hydrocarbylene group optionally being substituted with -O-; and X represents an acid-labile group when b4 is 1 and represents a hydrogen atom or an acid-labile group when b4 is 2 or more, provided that at least one X is an acid-labile group, 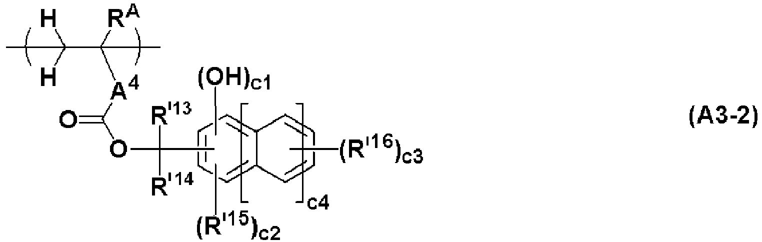 wherein c1 represents an integer of 0 to 2; c2 represents an integer of 0 to 2; c3 represents an integer of 0 to 5; c4 represents an integer of 0 to 2; each R^{A} independently represents a hydrogen atom, a fluorine atom, a methyl group, or a trifluoromethyl group; A⁴ represents a single bond, a phenylene group, a naphthylene group, or *-C(=O)-O-A⁴¹-; A⁴¹ represents an aliphatic hydrocarbylene group having 1 to 20 carbon atoms, a phenylene group, or a naphthylene group, the aliphatic hydrocarbylene group optionally having a hydroxy group, an ether bond, an ester bond, or a lactone ring; R'¹³ and R'¹⁴ each independently represent a hydrocarbyl group having 1 to 10 carbon atoms and optionally having a heteroatom, R'¹³ and R'¹⁴ optionally being bonded to each other to form a ring together with a carbon atom to which R'¹³ and R'¹⁴ are bonded; each R'¹⁵ independently represents a fluorine atom, a fluorinated alkyl group having 1 to 5 carbon atoms, or a fluorinated alkoxy group having 1 to 5 carbon atoms; and each R'¹⁶ independently represents a hydrocarbyl group having 1 to 10 carbon atoms and optionally having a heteroatom.
[7]: The polymer of any one of the above [1] to [6], further comprising one or more repeating units represented by any of the following formulae (C1) to (C8), 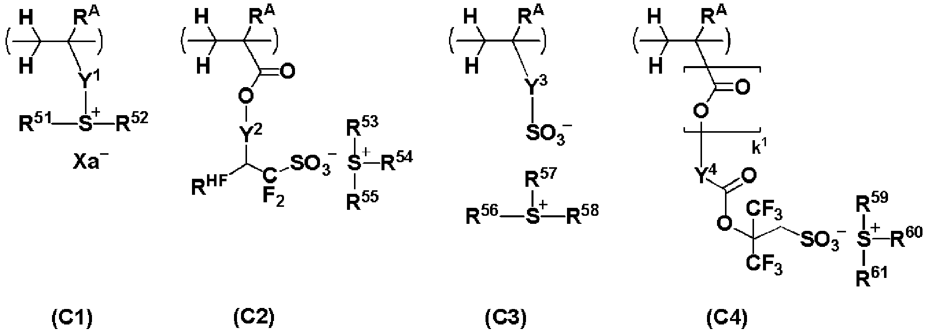 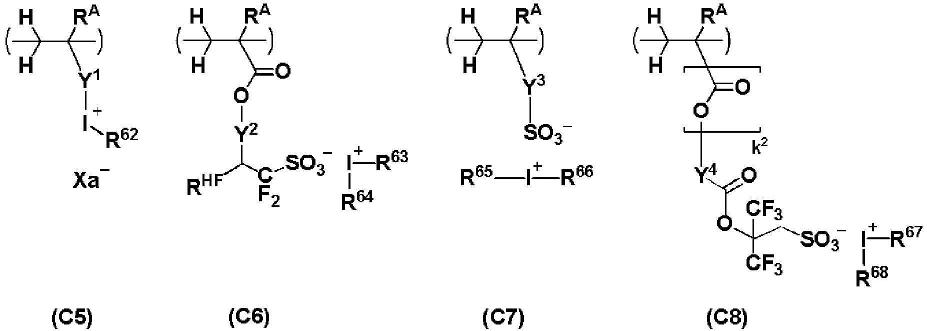 wherein each R^{A} independently represents a hydrogen atom, a fluorine atom, a methyl group, or a trifluoromethyl group; Y¹ represents a single bond, an aliphatic hydrocarbylene group having 1 to 6 carbon atoms, a phenylene group, a naphthylene group, a group having 7 to 18 carbon atoms obtained by combining these groups, *-O-Y¹¹-, *-C(=O)-O-Y¹¹-, or *-C(=O)-NH-Y¹¹-; Y¹¹ represents an aliphatic hydrocarbylene group having 1 to 6 carbon atoms, a phenylene group, a naphthylene group, or a group having 7 to 18 carbon atoms obtained by combining these groups, Y¹¹ optionally having a carbonyl group, an ester bond, an ether bond, or a hydroxy group; Y² represents a single bond or * *-Y²¹-C(=O)-O-; Y²¹ represents a hydrocarbylene group having 1 to 20 carbon atoms and optionally having a heteroatom; Y³ represents a single bond, a methylene group, an ethylene group, a phenylene group, a fluorinated phenylene group, a phenylene group substituted with a trifluoromethyl group, *-O-Y³¹-, *-C(=O)-O-Y³¹-, or *-C(=O)-NH-Y³¹-; Y³¹ represents an aliphatic hydrocarbylene group having 1 to 6 carbon atoms, a phenylene group, a fluorinated phenylene group, a phenylene group substituted with a trifluoromethyl group, or a group having 7 to 20 carbon atoms obtained by combining these groups, Y³¹ optionally having a carbonyl group, an ester bond, an ether bond, or a hydroxy group; "*" represents an attachment point to a carbon atom in the main chain; "**" represents an attachment point to an oxygen atom in the formula; Y⁴ represents a single bond or a hydrocarbylene group having 1 to 30 carbon atoms and optionally having a heteroatom; k¹ and k² each independently represent 0 or 1, and when Y⁴ is a single bond, k¹ and k² are 0; R⁵¹ to R⁶⁸ each independently represent a halogen atom or a hydrocarbyl group having 1 to 25 carbon atoms and optionally having a heteroatom; R⁵¹ and R⁵² are optionally bonded to each other to form a ring together with a sulfur atom to which R⁵¹ and R⁵² are bonded; R⁵³ and R⁵⁴, R⁵⁶ and R⁵⁷, and R⁵⁹ and R⁶⁰ are optionally bonded to each other to form a ring together with a sulfur atom to which R⁵³ and R⁵⁴, R⁵⁶ and R⁵⁷, and R⁵⁹ and R⁶⁰ are respectively bonded; R^{HF} represents a hydrogen atom or a trifluoromethyl group; and Xa⁻ represents a non-nucleophilic counter ion.
[8]: A chemically amplified positive resist composition comprising the polymer of any one of the above [1] to [7].
[9]: The chemically amplified positive resist composition of the above [8], further comprising an organic solvent.
[10]: The chemically amplified positive resist composition of the above [8] or [9], further comprising a photo-acid generator whose anion has a conjugate acid having acidity pKa of -2.0 or higher.
[11]: The chemically amplified positive resist composition of the above [10], wherein the photo-acid generator contains an anion structure of a photo-acid generator represented by the following formula (M-1), 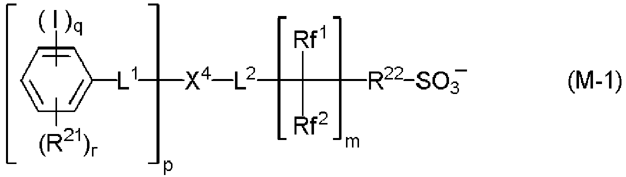 wherein "m" represents 0 or 1; "p" represents an integer of 1 to 3; "q" represents an integer of 1 to 5; "r" represents an integer of 0 to 3; L¹ represents a single bond, an ether bond, an ester bond, a sulfonic acid ester bond, a carbonate bond, or a carbamate bond; L² represents an ether bond, an ester bond, a sulfonic acid ester bond, a carbonate bond, or a carbamate bond; X⁴ represents a single bond or a hydrocarbylene group having 1 to 20 carbon atoms when "p" is 1, and represents a hydrocarbon group having a valency of p+1 and having 1 to 20 carbon atoms when "p" is 2 or 3, the hydrocarbylene group and the hydrocarbon group having a valency of p+1 optionally having at least one selected from an ether bond, a carbonyl group, an ester bond, an amide bond, a sultone ring, a lactam ring, a carbonate bond, a halogen atom, a hydroxy group, and a carboxy group; Rf¹ and Rf² each independently represent a hydrogen atom, a fluorine atom, or a trifluoromethyl group, provided that at least one is a fluorine atom or a trifluoromethyl group; R²¹ represents a hydroxy group, a carboxy group, a saturated hydrocarbyl group having 1 to 6 carbon atoms, a saturated hydrocarbyloxy group having 1 to 6 carbon atoms, a saturated hydrocarbylcarbonyloxy group having 2 to 6 carbon atoms, a fluorine atom, a chlorine atom, a bromine atom, an amino group, -N(R^{1A})-C(=O)-R^{1B}, or -N(R^{1A})-C(=O)-O-R^{1B}; R^{1A} represents a hydrogen atom or a saturated hydrocarbyl group having 1 to 6 carbon atoms; R^{1B} represents a saturated hydrocarbyl group having 1 to 6 carbon atoms or an unsaturated aliphatic hydrocarbyl group having 2 to 8 carbon atoms; and R²² represents a saturated hydrocarbylene group having 1 to 20 carbon atoms or an arylene group having 6 to 14 carbon atoms, a part or all of hydrogen atoms in the saturated hydrocarbylene group optionally being substituted with a halogen atom other than a fluorine atom, and a part or all of hydrogen atoms in the arylene group optionally being substituted with a substituent selected from a saturated hydrocarbyl group having 1 to 20 carbon atoms, a saturated hydrocarbyloxy group having 1 to 20 carbon atoms, an aryl group having 6 to 14 carbon atoms, a halogen atom, and a hydroxy group.
[12]: The chemically amplified positive resist composition of any one of the above [8] to [11], further comprising a quencher.
[13]: The chemically amplified positive resist composition of any one of the above [8] to [12], further comprising a fluorine-containing polymer having at least one selected from a repeating unit represented by the following formula (D1), a repeating unit represented by the following formula (D2), a repeating unit represented by the following formula (D3), and a repeating unit represented by the following formula (D4), 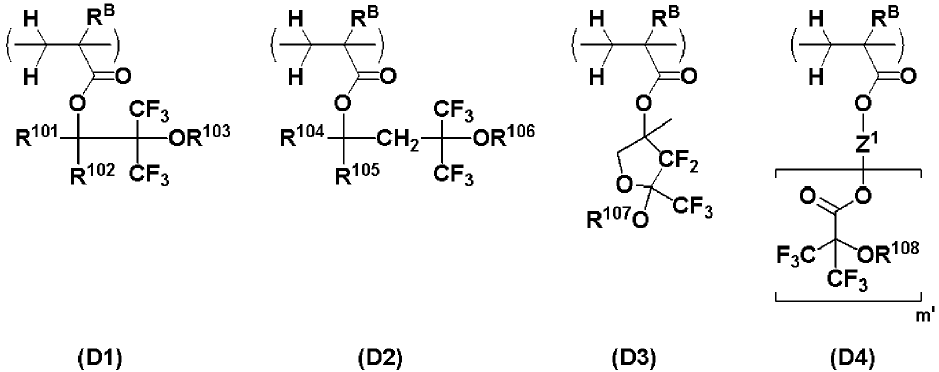 wherein each R^{B} independently represents a hydrogen atom, a fluorine atom, a methyl group, or a trifluoromethyl group; R¹⁰¹, R¹⁰², R¹⁰⁴, and R¹⁰⁵ each independently represents a hydrogen atom or a saturated hydrocarbyl group having 1 to 10 carbon atoms; R¹⁰³, R¹⁰⁶, R¹⁰⁷, and R¹⁰⁸ each independently represent a hydrogen atom, a hydrocarbyl group having 1 to 15 carbon atoms, a fluorinated hydrocarbyl group having 1 to 15 carbon atoms, or an acid-labile group, wherein R¹⁰³, R¹⁰⁶, R¹⁰⁷, and R¹⁰⁸ optionally have an intervening ether bond or carbonyl group in a carbon-carbon bond when each of R¹⁰³, R¹⁰⁶, R¹⁰⁷, and R¹⁰⁸ is a hydrocarbyl group or a fluorinated hydrocarbyl group; "m‴ represents an integer of 1 to 3; and Z¹ represents a hydrocarbon group having a valency of m'+1 and having 1 to 20 carbon atoms or a fluorinated hydrocarbon group having a valency of m'+1 and having 1 to 20 carbon atoms.
[14]: The chemically amplified positive resist composition of the above [13], wherein the fluorine-containing polymer further has at least one selected from a repeating unit represented by the following formula (D5) and a repeating unit represented by the following formula (D6), 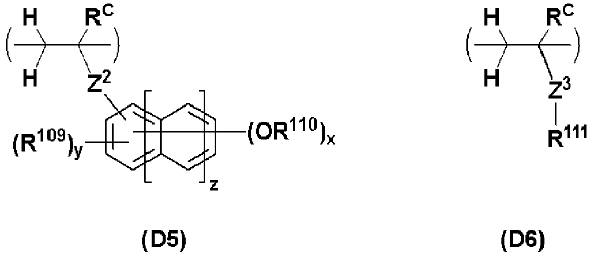 wherein each R^{C} independently represents a hydrogen atom or a methyl group; R¹⁰⁹ represents a hydrogen atom or a linear or branched hydrocarbyl group having 1 to 5 carbon atoms and optionally having, in a carbon-carbon bond, an intervening group containing a heteroatom; R¹¹⁰ represents a linear or branched hydrocarbyl group having 1 to 5 carbon atoms and optionally having, in a carbon-carbon bond, an intervening group containing a heteroatom; R¹¹¹ represents a saturated hydrocarbyl group having 1 to 20 carbon atoms, at least one hydrogen atom being substituted with a fluorine atom and a part of - CH₂- constituting the saturated hydrocarbyl group optionally being substituted with an ester bond or an ether bond; "x" represents an integer of 1 to 3; "y" represents an integer that satisfies 0 ≤ y ≤ 5+2z-x; "z" represents 0 or 1; Z² represents a single bond, *-C(=O)-O-, or *-C(=O)-NH-; Z³ represents a single bond, -O-, *-C(=O)-O-Z³¹-Z³²-, or *-C(=O)-NH-Z³¹-Z³²-; Z³¹ represents a single bond or a saturated hydrocarbylene group having 1 to 10 carbon atoms; Z³² represents a single bond, an ester bond, an ether bond, or a sulfonamide bond; and "*" represents an attachment point to a carbon atom in the main chain.
[15]: The chemically amplified positive resist composition of any one of the above [8] to [14], wherein the polymer has a dissolution rate of 10 nm/min or lower to an alkaline developer.
[16]: The chemically amplified positive resist composition of any one of the above [8] to [14], wherein an unexposed portion of a resist film obtained from the chemically amplified positive resist composition has a dissolution rate of 10 nm/min or lower to an alkaline developer.
[17]: The chemically amplified positive resist composition of any one of the above [8] to [14], wherein an exposed portion of a resist film obtained from the chemically amplified positive resist composition has a dissolution rate of 50 nm/sec or higher to an alkaline developer.
[18]: A resist patterning process comprising the steps of:
   forming a resist film on a substrate by using the chemically amplified positive resist composition of any one of the above [8] to [17];
   irradiating the resist film with a high-energy beam to form a pattern; and
   developing, by using an alkaline developer, the resist film irradiated to form the pattern.
[19]: The resist patterning process of the above [18], wherein the high-energy beam is a KrF excimer laser beam, an ArF excimer laser beam, an electron beam, or an extreme ultraviolet ray having a wavelength of 3 to 15 nm.
[20]: The resist patterning process of the above [18] or [19], wherein an uppermost surface of the substrate is composed of a material containing at least one selected from chromium, silicon, tantalum, molybdenum, cobalt, nickel, tungsten, and tin.
[21]: The resist patterning process of the above [20], wherein a transmission type or reflective mask blank is used as the substrate.
[22]: A transmission type or reflective mask blank, coated with the chemically amplified positive resist composition of any one of the above [8] to [17].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention. The present invention also refers to the following numbered embodiments, wherein the term "claim" means "embodiment":
1. A polymer comprising a structural unit comprising an aromatic hydroxy group bonded to a main chain, wherein the aromatic hydroxy group is protected by an acid-labile group represented by the following formula (ALU-1) and is deprotected by action of an acid to become alkali-soluble, 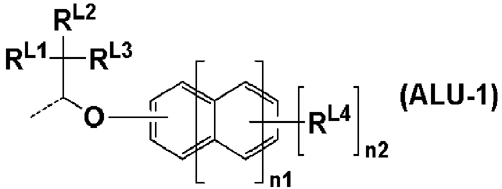 wherein R^{L1} to R^{L3} each independently represent a hydrogen atom or a hydrocarbyl group having 1 to 6 carbon atoms and do not have an aromatic ring structure, any two of R^{L1} to R^{L3} optionally being bonded to each other to form a cyclic structure together with a carbon atom to which R^{L1} to R^{L3} are bonded; R^{L4} represents a hydrogen atom, a halogen atom, a nitro group, or a hydrocarbyl group having 1 to 6 carbon atoms and optionally having a heteroatom; n1 represents an integer of 0 or 1; when n1 is 0, n2 represents an integer of 0 to 5 and when n1 is 1, n2 represents an integer of 0 to 7; and a broken line represents a bond with an oxygen atom of the aromatic hydroxy group of the unit comprising the aromatic hydroxy group bonded to the main chain of the polymer.
2. The polymer according to claim 1, wherein the unit comprising the aromatic hydroxy group bonded to the main chain of the polymer is a repeating unit represented by the following formula (A1), 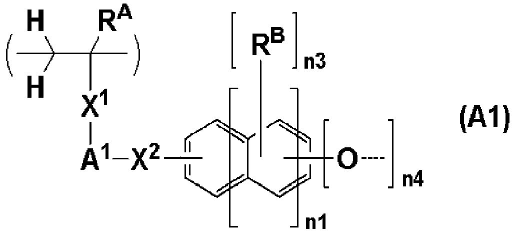 wherein each R^{A} independently represents a hydrogen atom, a fluorine atom, a methyl group, or a trifluoromethyl group; X¹ represents a single bond, *-C(=O)-O-, or *-C(=O)-NH-; "*" represents an attachment point to a carbon atom in the main chain; A¹ represents a single bond or a saturated hydrocarbylene group having 1 to 10 carbon atoms, a part of -CH₂- constituting the saturated hydrocarbylene group optionally being substituted with - O-; X² represents a single bond, an ether bond, an ester bond, a carbonyl group, a sulfonic acid ester bond, a carbonate bond, or a carbamate bond; R^{B} represents a halogen atom or a linear, branched, or cyclic hydrocarbyl group having 1 to 20 carbon atoms and optionally having a heteroatom; n1 is as defined above; n3 represents an integer of 0 to 4 when n1 is 0 and represents an integer of 0 to 6 when n1 is 1; n4 represents an integer of 1 to 3, provided that when n1 is 0, n3+n4 ≤ 5 and when n1 is 1, n3+n4 ≤ 7; and a broken line represents a bond with the formula (ALU-1).
3. The polymer according to claim 1 or 2, further comprising a phenolic hydroxy group-containing repeating unit represented by the following formula (A2), 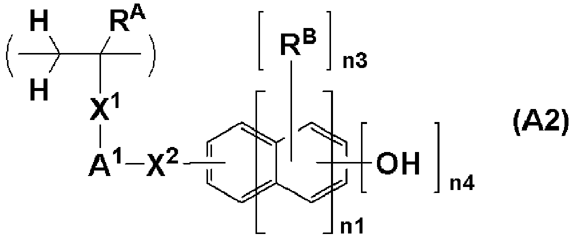 wherein each R^{A} independently represents a hydrogen atom, a fluorine atom, a methyl group, or a trifluoromethyl group; X¹ represents a single bond, *-C(=O)-O-, or *-C(=O)-NH-; "*" represents an attachment point to a carbon atom in the main chain; A¹ represents a single bond or a saturated hydrocarbylene group having 1 to 10 carbon atoms, a part of -CH₂- constituting the saturated hydrocarbylene group optionally being substituted with - O-; X² represents a single bond, an ether bond, an ester bond, a carbonyl group, a sulfonic acid ester bond, a carbonate bond, or a carbamate bond; R^{B} represents a halogen atom or a linear, branched, or cyclic hydrocarbyl group having 1 to 20 carbon atoms and optionally having a heteroatom; n1 is as defined above; n3 represents an integer of 0 to 4 when n1 is 0 and represents an integer of 0 to 6 when n1 is 1; n4 represents an integer of 1 to 3, provided that when n1 is 0, n3+n4 ≤ 5 and when n1 is 1, n3+n4 ≤ 7.
4. The polymer according to claim 3, wherein the phenolic hydroxy group-containing repeating unit is a repeating unit represented by the following formula (A2-1), 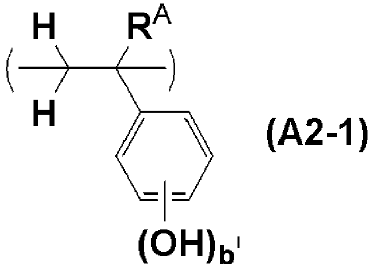 wherein R^{A} is as defined above; and "b‴ represents an integer of 1 to 3.
5. The polymer according to any one of claims 1 to 4, further comprising one or more repeating units represented by any of the following formulae (B1) to (B3), 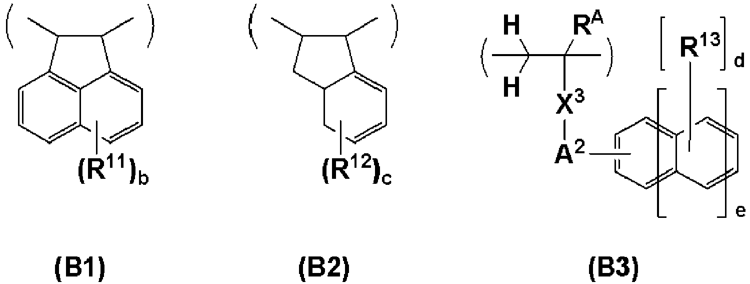 wherein each R^{A} independently represents a hydrogen atom, a fluorine atom, a methyl group, or a trifluoromethyl group; "b" and "c" each independently represent an integer of 0 to 4; "d" represents an integer of 0 to 5; "e" represents an integer of 0 to 2; X³ represents a single bond, *-C(=O)-O-, or *-C(=O)-NH-; "*" represents an attachment point to a carbon atom in the main chain; A² represents a single bond or a saturated hydrocarbylene group having 1 to 10 carbon atoms, a part of -CH₂-constituting the saturated hydrocarbylene group optionally being substituted with -O-; R¹¹ and R¹² each independently represent a hydroxy group, a halogen atom, a saturated hydrocarbylcarbonyloxy group having 2 to 8 carbon atoms optionally substituted with a halogen atom, a saturated hydrocarbyl group having 1 to 8 carbon atoms optionally substituted with a halogen atom, or a saturated hydrocarbyloxy group having 1 to 8 carbon atoms optionally substituted with a halogen atom; and R¹³ represents an acetyl group, a saturated hydrocarbyl group having 1 to 20 carbon atoms, a saturated hydrocarbyloxy group having 1 to 20 carbon atoms, a saturated hydrocarbylcarbonyloxy group having 2 to 20 carbon atoms, a saturated hydrocarbyloxyhydrocarbyl group having 2 to 20 carbon atoms, a saturated hydrocarbylthiohydrocarbyl group having 2 to 20 carbon atoms, a halogen atom, a nitro group, or a cyano group, and when "e" is 1 or 2, R¹³ optionally represents a hydroxy group.
6. The polymer according to any one of claims 1 to 5, further comprising a repeating unit represented by the following formula (A3-1) and/or the following formula (A3-2), 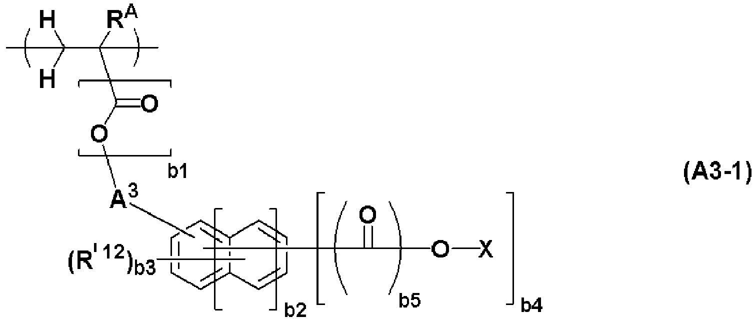 wherein each R^{A} independently represents a hydrogen atom, a fluorine atom, a methyl group, or a trifluoromethyl group; b1 represents 0 or 1; b2 represents an integer of 0 to 2; b3 represents an integer that satisfies 0 ≤ b3 ≤ 5+2b2-b4; b4 represents an integer of 1 to 3; b5 represents 0 or 1; R'¹² represents a halogen atom, a saturated hydrocarbyl group having 1 to 6 carbon atoms optionally substituted with a halogen atom, a saturated hydrocarbyloxy group having 1 to 6 carbon atoms optionally substituted with a halogen atom, or a saturated hydrocarbylcarbonyloxy group having 2 to 8 carbon atoms optionally substituted with a halogen atom; A³ represents a single bond or a saturated hydrocarbylene group having 1 to 10 carbon atoms, a part of -CH₂- of the saturated hydrocarbylene group optionally being substituted with -O-; and X represents an acid-labile group when b4 is 1 and represents a hydrogen atom or an acid-labile group when b4 is 2 or more, provided that at least one X is an acid-labile group, 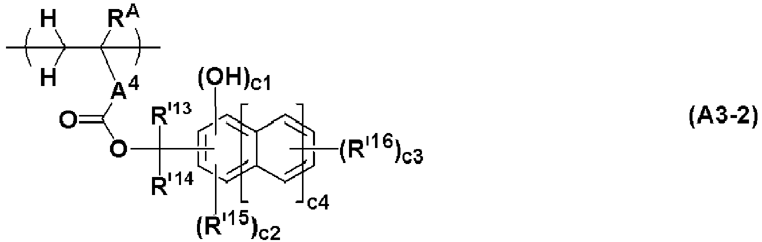 wherein c1 represents an integer of 0 to 2; c2 represents an integer of 0 to 2; c3 represents an integer of 0 to 5; c4 represents an integer of 0 to 2; each R^{A} independently represents a hydrogen atom, a fluorine atom, a methyl group, or a trifluoromethyl group; A⁴ represents a single bond, a phenylene group, a naphthylene group, or *-C(=O)-O-A⁴¹-; A⁴¹ represents an aliphatic hydrocarbylene group having 1 to 20 carbon atoms, a phenylene group, or a naphthylene group, the aliphatic hydrocarbylene group optionally having a hydroxy group, an ether bond, an ester bond, or a lactone ring; R'¹³ and R'¹⁴ each independently represent a hydrocarbyl group having 1 to 10 carbon atoms and optionally having a heteroatom, R'¹³ and R'¹⁴ optionally being bonded to each other to form a ring together with a carbon atom to which R'¹³ and R'¹⁴ are bonded; each R'¹⁵ independently represents a fluorine atom, a fluorinated alkyl group having 1 to 5 carbon atoms, or a fluorinated alkoxy group having 1 to 5 carbon atoms; and each R'¹⁶ independently represents a hydrocarbyl group having 1 to 10 carbon atoms and optionally having a heteroatom.
7. The polymer according to any one of claims 1 to 6, further comprising one or more repeating units represented by any of the following formulae (C1) to (C8), 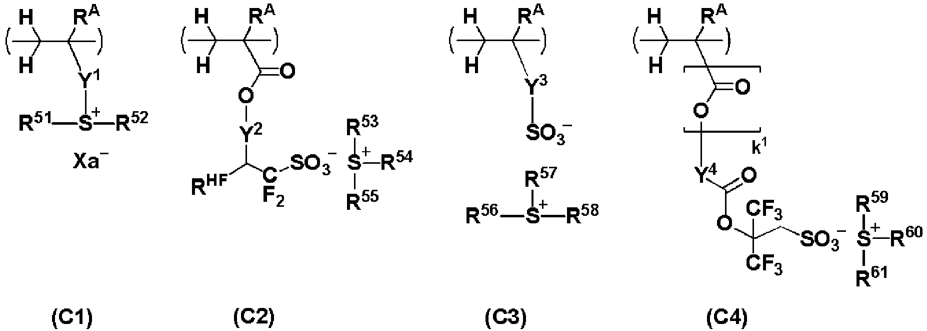 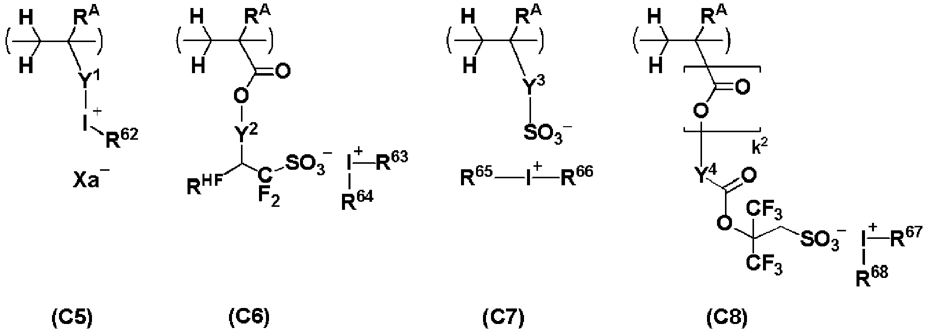 wherein each R^{A} independently represents a hydrogen atom, a fluorine atom, a methyl group, or a trifluoromethyl group; Y¹ represents a single bond, an aliphatic hydrocarbylene group having 1 to 6 carbon atoms, a phenylene group, a naphthylene group, a group having 7 to 18 carbon atoms obtained by combining these groups, *-O-Y¹¹-, *-C(=O)-O-Y¹¹-, or *-C(=O)-NH-Y¹¹-; Y¹¹ represents an aliphatic hydrocarbylene group having 1 to 6 carbon atoms, a phenylene group, a naphthylene group, or a group having 7 to 18 carbon atoms obtained by combining these groups, Y¹¹ optionally having a carbonyl group, an ester bond, an ether bond, or a hydroxy group; Y² represents a single bond or **-Y²¹-C(=O)-O-; Y²¹ represents a hydrocarbylene group having 1 to 20 carbon atoms and optionally having a heteroatom; Y³ represents a single bond, a methylene group, an ethylene group, a phenylene group, a fluorinated phenylene group, a phenylene group substituted with a trifluoromethyl group, *-O-Y³¹-, *-C(=O)-O-Y³¹, or *-C(=O)-NH-Y³¹-; Y³¹ represents an aliphatic hydrocarbylene group having 1 to 6 carbon atoms, a phenylene group, a fluorinated phenylene group, a phenylene group substituted with a trifluoromethyl group, or a group having 7 to 20 carbon atoms obtained by combining these groups, Y³¹ optionally having a carbonyl group, an ester bond, an ether bond, or a hydroxy group; "*" represents an attachment point to a carbon atom in the main chain; "**" represents an attachment point to an oxygen atom in the formula; Y⁴ represents a single bond or a hydrocarbylene group having 1 to 30 carbon atoms and optionally having a heteroatom; k¹ and k² each independently represent 0 or 1, and when Y⁴ is a single bond, k¹ and k² are 0; R⁵¹ to R⁶⁸ each independently represent a halogen atom or a hydrocarbyl group having 1 to 25 carbon atoms and optionally having a heteroatom; R⁵¹ and R⁵² are optionally bonded to each other to form a ring together with a sulfur atom to which R⁵¹ and R⁵² are bonded; R⁵³ and R⁵⁴, R⁵⁶ and R⁵⁷, and R⁵⁹ and R⁶⁰ are optionally bonded to each other to form a ring together with a sulfur atom to which R⁵³ and R⁵⁴, R⁵⁶ and R⁵⁷, and R⁵⁹ and R⁶⁰ are respectively bonded; R^{HF} represents a hydrogen atom or a trifluoromethyl group; and Xa" represents a non-nucleophilic counter ion.
8. A chemically amplified positive resist composition comprising the polymer according to any one of claims 1 to 7.
9. The chemically amplified positive resist composition according to claim 8, further comprising an organic solvent.
10. The chemically amplified positive resist composition according to claim 8 or 9, further comprising a photo-acid generator whose anion has a conjugate acid having acidity pKa of -2.0 or higher.
11. The chemically amplified positive resist composition according to claim 10, wherein the photo-acid generator contains an anion structure of a photo-acid generator represented by the following formula (M-1), 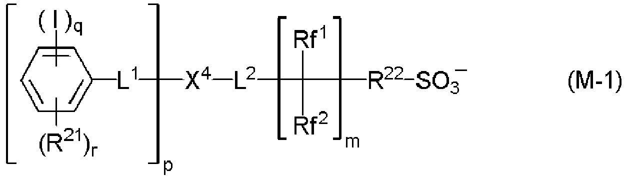 wherein "m" represents 0 or 1; "p" represents an integer of 1 to 3; "q" represents an integer of 1 to 5; "r" represents an integer of 0 to 3; L¹ represents a single bond, an ether bond, an ester bond, a sulfonic acid ester bond, a carbonate bond, or a carbamate bond; L² represents an ether bond, an ester bond, a sulfonic acid ester bond, a carbonate bond, or a carbamate bond; X⁴ represents a single bond or a hydrocarbylene group having 1 to 20 carbon atoms when "p" is 1, and represents a hydrocarbon group having a valency of p+1 and having 1 to 20 carbon atoms when "p" is 2 or 3, the hydrocarbylene group and the hydrocarbon group having a valency of p+1 optionally having at least one selected from an ether bond, a carbonyl group, an ester bond, an amide bond, a sultone ring, a lactam ring, a carbonate bond, a halogen atom, a hydroxy group, and a carboxy group; Rf¹ and Rf² each independently represent a hydrogen atom, a fluorine atom, or a trifluoromethyl group, provided that at least one is a fluorine atom or a trifluoromethyl group; R²¹ represents a hydroxy group, a carboxy group, a saturated hydrocarbyl group having 1 to 6 carbon atoms, a saturated hydrocarbyloxy group having 1 to 6 carbon atoms, a saturated hydrocarbylcarbonyloxy group having 2 to 6 carbon atoms, a fluorine atom, a chlorine atom, a bromine atom, an amino group, -N(R^{1A})-C(=O)-R^{1B}, or -N(R^{1A})-C(=O)-O-R^{1B}; R^{1A} represents a hydrogen atom or a saturated hydrocarbyl group having 1 to 6 carbon atoms; R^{1B} represents a saturated hydrocarbyl group having 1 to 6 carbon atoms or an unsaturated aliphatic hydrocarbyl group having 2 to 8 carbon atoms; and R²² represents a saturated hydrocarbylene group having 1 to 20 carbon atoms or an arylene group having 6 to 14 carbon atoms, a part or all of hydrogen atoms in the saturated hydrocarbylene group optionally being substituted with a halogen atom other than a fluorine atom, and a part or all of hydrogen atoms in the arylene group optionally being substituted with a substituent selected from a saturated hydrocarbyl group having 1 to 20 carbon atoms, a saturated hydrocarbyloxy group having 1 to 20 carbon atoms, an aryl group having 6 to 14 carbon atoms, a halogen atom, and a hydroxy group.
12. The chemically amplified positive resist composition according to any one of claims 8 to 11, further comprising a quencher.
13. The chemically amplified positive resist composition according to any one of claims 8 to 12, further comprising a fluorine-containing polymer having at least one selected from a repeating unit represented by the following formula (D1), a repeating unit represented by the following formula (D2), a repeating unit represented by the following formula (D3), and a repeating unit represented by the following formula (D4), 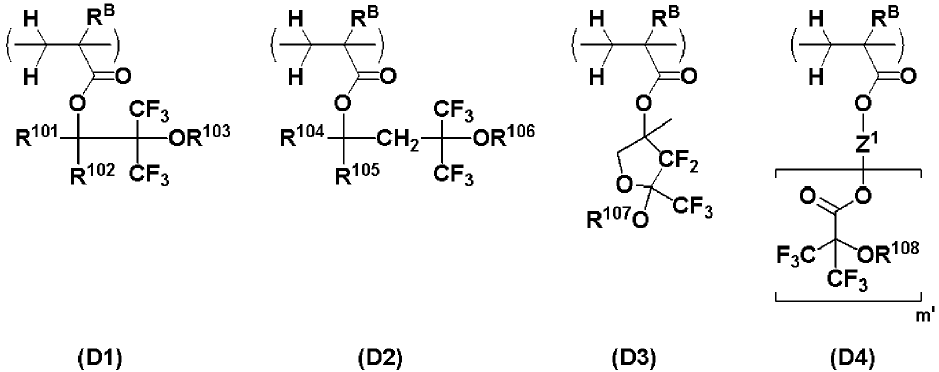 wherein each R^{B} independently represents a hydrogen atom, a fluorine atom, a methyl group, or a trifluoromethyl group; R¹⁰¹, R¹⁰², R¹⁰⁴, and R¹⁰⁵ each independently represents a hydrogen atom or a saturated hydrocarbyl group having 1 to 10 carbon atoms; R¹⁰³, R¹⁰⁶, R¹⁰⁷, and R¹⁰⁸ each independently represent a hydrogen atom, a hydrocarbyl group having 1 to 15 carbon atoms, a fluorinated hydrocarbyl group having 1 to 15 carbon atoms, or an acid-labile group, wherein R¹⁰³, R¹⁰⁶, R¹⁰⁷, and R¹⁰⁸ optionally have an intervening ether bond or carbonyl group in a carbon-carbon bond when each of R¹⁰³, R¹⁰⁶, R¹⁰⁷, and R¹⁰⁸ is a hydrocarbyl group or a fluorinated hydrocarbyl group; "m'" represents an integer of 1 to 3; and Z¹ represents a hydrocarbon group having a valency of m'+1 and having 1 to 20 carbon atoms or a fluorinated hydrocarbon group having a valency of m'+1 and having 1 to 20 carbon atoms.
14. The chemically amplified positive resist composition according to claim 13, wherein the fluorine-containing polymer further has at least one selected from a repeating unit represented by the following formula (D5) and a repeating unit represented by the following formula (D6), 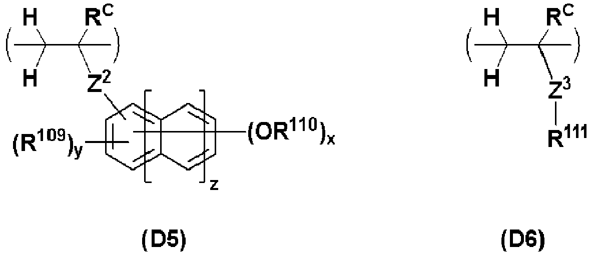 wherein each R^{C} independently represents a hydrogen atom or a methyl group; R¹⁰⁹ represents a hydrogen atom or a linear or branched hydrocarbyl group having 1 to 5 carbon atoms and optionally having, in a carbon-carbon bond, an intervening group containing a heteroatom; R¹¹⁰ represents a linear or branched hydrocarbyl group having 1 to 5 carbon atoms and optionally having, in a carbon-carbon bond, an intervening group containing a heteroatom; R¹¹¹ represents a saturated hydrocarbyl group having 1 to 20 carbon atoms, at least one hydrogen atom being substituted with a fluorine atom and a part of - CH₂- constituting the saturated hydrocarbyl group optionally being substituted with an ester bond or an ether bond; "x" represents an integer of 1 to 3; "y" represents an integer that satisfies 0 ≤ y ≤ 5+2z-x; "z" represents 0 or 1; Z² represents a single bond, *-C(=O)-O-, or *-C(=O)-NH-; Z³ represents a single bond, -O-, *-C(=O)-O-Z³¹-Z³²-, or *-C(=O)-NH-Z³¹-Z³²-; Z³¹ represents a single bond or a saturated hydrocarbylene group having 1 to 10 carbon atoms; Z³² represents a single bond, an ester bond, an ether bond, or a sulfonamide bond; and "*" represents an attachment point to a carbon atom in the main chain.
15. The chemically amplified positive resist composition according to any one of claims 8 to 14, wherein the polymer has a dissolution rate of 10 nm/min or lower to an alkaline developer.
16. The chemically amplified positive resist composition according to any one of claims 8 to 14, wherein an unexposed portion of a resist film obtained from the chemically amplified positive resist composition has a dissolution rate of 10 nm/min or lower to an alkaline developer.
17. The chemically amplified positive resist composition according to any one of claims 8 to 14, wherein an exposed portion of a resist film obtained from the chemically amplified positive resist composition has a dissolution rate of 50 nm/sec or higher to an alkaline developer.
18. A resist patterning process comprising the steps of:
   forming a resist film on a substrate by using the chemically amplified positive resist composition according to any one of claims 8 to 17;
   irradiating the resist film with a high-energy beam to form a pattern; and
   developing, by using an alkaline developer, the resist film irradiated to form the pattern.
19. The resist patterning process according to claim 18, wherein the high-energy beam is a KrF excimer laser beam, an ArF excimer laser beam, an electron beam, or an extreme ultraviolet ray having a wavelength of 3 to 15 nm.
20. The resist patterning process according to claim 18 or 19, wherein an uppermost surface of the substrate is composed of a material containing at least one selected from chromium, silicon, tantalum, molybdenum, cobalt, nickel, tungsten, and tin.
21. The resist patterning process according to claim 20, wherein a transmission type or reflective mask blank is used as the substrate.
22. A transmission type or reflective mask blank, coated with the chemically amplified positive resist composition according to any one of claims 8 to 17.

## Claims

1. A polymer comprising a structural unit comprising an aromatic hydroxy group bonded to a main chain, wherein the aromatic hydroxy group is protected by an acid-labile group represented by the following formula (ALU-1) and is deprotected by action of an acid to become alkali-soluble, 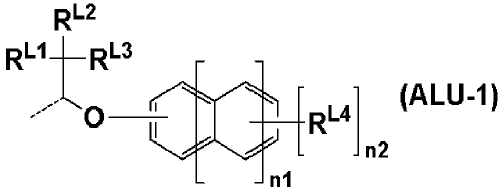 wherein R^{L1} to R^{L3} each independently represent a hydrogen atom or a hydrocarbyl group having 1 to 6 carbon atoms and do not have an aromatic ring structure, any two of R^{L1} to R^{L3} optionally being bonded to each other to form a cyclic structure together with a carbon atom to which R^{L1} to R^{L3} are bonded; R^{L4} represents a hydrogen atom, a halogen atom, a nitro group, or a hydrocarbyl group having 1 to 6 carbon atoms and optionally having a heteroatom; n1 represents an integer of 0 or 1; when n1 is 0, n2 represents an integer of 0 to 5 and when n1 is 1, n2 represents an integer of 0 to 7; and a broken line represents a bond with an oxygen atom of the aromatic hydroxy group of the unit comprising the aromatic hydroxy group bonded to the main chain of the polymer.

2. The polymer according to claim 1, wherein the unit comprising the aromatic hydroxy group bonded to the main chain of the polymer is a repeating unit represented by the following formula (A1), 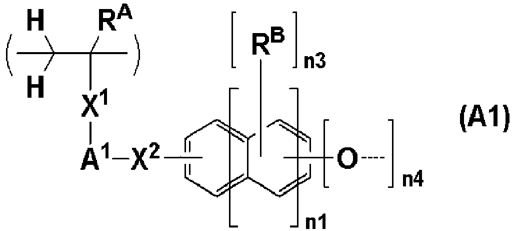 wherein each R^{A} independently represents a hydrogen atom, a fluorine atom, a methyl group, or a trifluoromethyl group; X¹ represents a single bond, *-C(=O)-O-, or *-C(=O)-NH-; "*" represents an attachment point to a carbon atom in the main chain; A¹ represents a single bond or a saturated hydrocarbylene group having 1 to 10 carbon atoms, a part of -CH₂- constituting the saturated hydrocarbylene group optionally being substituted with - O-; X² represents a single bond, an ether bond, an ester bond, a carbonyl group, a sulfonic acid ester bond, a carbonate bond, or a carbamate bond; R^{B} represents a halogen atom or a linear, branched, or cyclic hydrocarbyl group having 1 to 20 carbon atoms and optionally having a heteroatom; n1 is as defined above; n3 represents an integer of 0 to 4 when n1 is 0 and represents an integer of 0 to 6 when n1 is 1; n4 represents an integer of 1 to 3, provided that when n1 is 0, n3+n4 ≤ 5 and when n1 is 1, n3+n4 ≤ 7; and a broken line represents a bond with the formula (ALU-1).

3. The polymer according to claim 1 or 2, further comprising a phenolic hydroxy group-containing repeating unit represented by the following formula (A2), 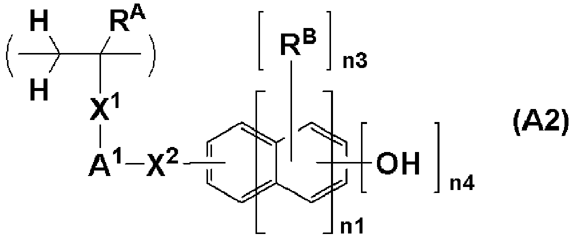 wherein each R^{A} independently represents a hydrogen atom, a fluorine atom, a methyl group, or a trifluoromethyl group; X¹ represents a single bond, *-C(=O)-O-, or *-C(=O)-NH-; "*" represents an attachment point to a carbon atom in the main chain; A¹ represents a single bond or a saturated hydrocarbylene group having 1 to 10 carbon atoms, a part of -CH₂- constituting the saturated hydrocarbylene group optionally being substituted with - O-; X² represents a single bond, an ether bond, an ester bond, a carbonyl group, a sulfonic acid ester bond, a carbonate bond, or a carbamate bond; R^{B} represents a halogen atom or a linear, branched, or cyclic hydrocarbyl group having 1 to 20 carbon atoms and optionally having a heteroatom; n1 is as defined above; n3 represents an integer of 0 to 4 when n1 is 0 and represents an integer of 0 to 6 when n1 is 1; n4 represents an integer of 1 to 3, provided that when n1 is 0, n3+n4 ≤ 5 and when n1 is 1, n3+n4 ≤ 7; preferably wherein the phenolic hydroxy group-containing repeating unit is a repeating unit represented by the following formula (A2-1), 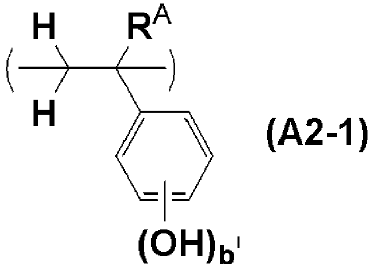 wherein R^{A} is as defined above; and "b'" represents an integer of 1 to 3.

4. The polymer according to any one of claims 1 to 3, further comprising one or more repeating units represented by any of the following formulae (B1) to (B3), 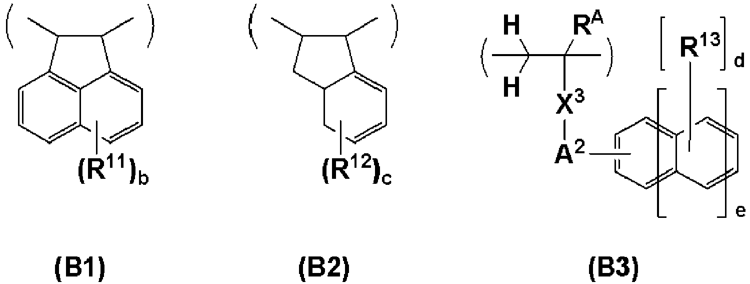 wherein each R^{A} independently represents a hydrogen atom, a fluorine atom, a methyl group, or a trifluoromethyl group; "b" and "c" each independently represent an integer of 0 to 4; "d" represents an integer of 0 to 5; "e" represents an integer of 0 to 2; X³ represents a single bond, *-C(=O)-O-, or *-C(=O)-NH-; "*" represents an attachment point to a carbon atom in the main chain; A² represents a single bond or a saturated hydrocarbylene group having 1 to 10 carbon atoms, a part of -CH₂-constituting the saturated hydrocarbylene group optionally being substituted with -O-; R¹¹ and R¹² each independently represent a hydroxy group, a halogen atom, a saturated hydrocarbylcarbonyloxy group having 2 to 8 carbon atoms optionally substituted with a halogen atom, a saturated hydrocarbyl group having 1 to 8 carbon atoms optionally substituted with a halogen atom, or a saturated hydrocarbyloxy group having 1 to 8 carbon atoms optionally substituted with a halogen atom; and R¹³ represents an acetyl group, a saturated hydrocarbyl group having 1 to 20 carbon atoms, a saturated hydrocarbyloxy group having 1 to 20 carbon atoms, a saturated hydrocarbylcarbonyloxy group having 2 to 20 carbon atoms, a saturated hydrocarbyloxyhydrocarbyl group having 2 to 20 carbon atoms, a saturated hydrocarbylthiohydrocarbyl group having 2 to 20 carbon atoms, a halogen atom, a nitro group, or a cyano group, and when "e" is 1 or 2, R¹³ optionally represents a hydroxy group; and/or further comprising a repeating unit represented by the following formula (A3-1) and/or the following formula (A3-2), 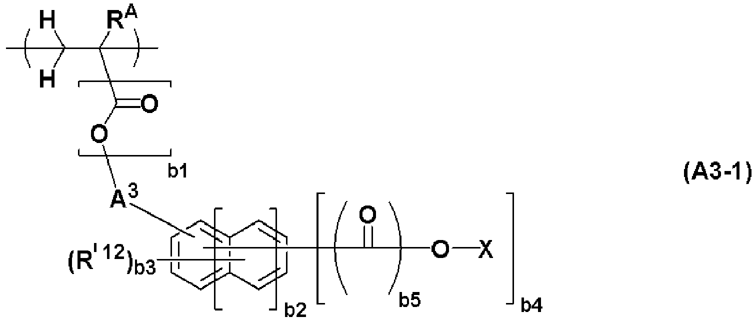 wherein each R^{A} independently represents a hydrogen atom, a fluorine atom, a methyl group, or a trifluoromethyl group; b1 represents 0 or 1; b2 represents an integer of 0 to 2; b3 represents an integer that satisfies 0 ≤ b3 ≤ 5+2b2-b4; b4 represents an integer of 1 to 3; b5 represents 0 or 1; R'¹² represents a halogen atom, a saturated hydrocarbyl group having 1 to 6 carbon atoms optionally substituted with a halogen atom, a saturated hydrocarbyloxy group having 1 to 6 carbon atoms optionally substituted with a halogen atom, or a saturated hydrocarbylcarbonyloxy group having 2 to 8 carbon atoms optionally substituted with a halogen atom; A³ represents a single bond or a saturated hydrocarbylene group having 1 to 10 carbon atoms, a part of -CH₂- of the saturated hydrocarbylene group optionally being substituted with -O-; and X represents an acid-labile group when b4 is 1 and represents a hydrogen atom or an acid-labile group when b4 is 2 or more, provided that at least one X is an acid-labile group, 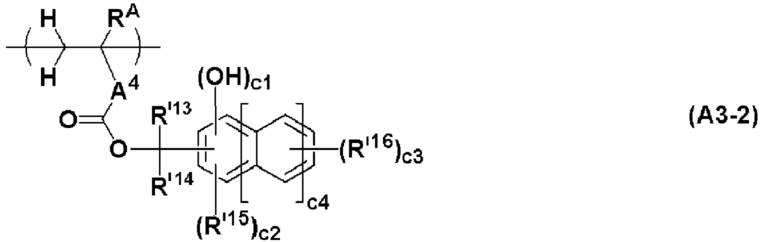 wherein c1 represents an integer of 0 to 2; c2 represents an integer of 0 to 2; c3 represents an integer of 0 to 5; c4 represents an integer of 0 to 2; each R^{A} independently represents a hydrogen atom, a fluorine atom, a methyl group, or a trifluoromethyl group; A⁴ represents a single bond, a phenylene group, a naphthylene group, or *-C(=O)-O-A⁴¹-; A⁴¹ represents an aliphatic hydrocarbylene group having 1 to 20 carbon atoms, a phenylene group, or a naphthylene group, the aliphatic hydrocarbylene group optionally having a hydroxy group, an ether bond, an ester bond, or a lactone ring; R'¹³ and R'¹⁴ each independently represent a hydrocarbyl group having 1 to 10 carbon atoms and optionally having a heteroatom, R'¹³ and R'¹⁴ optionally being bonded to each other to form a ring together with a carbon atom to which R'¹³ and R'¹⁴ are bonded; each R'¹⁵ independently represents a fluorine atom, a fluorinated alkyl group having 1 to 5 carbon atoms, or a fluorinated alkoxy group having 1 to 5 carbon atoms; and each R'¹⁶ independently represents a hydrocarbyl group having 1 to 10 carbon atoms and optionally having a heteroatom.

5. The polymer according to any one of claims 1 to 4, further comprising one or more repeating units represented by any of the following formulae (C1) to (C8), 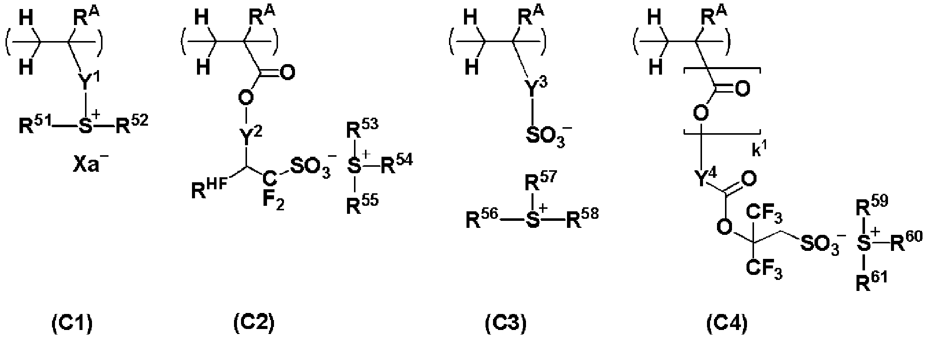 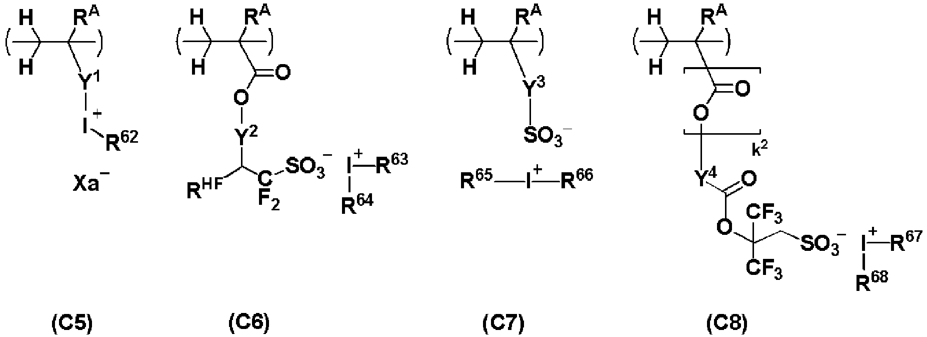 wherein each R^{A} independently represents a hydrogen atom, a fluorine atom, a methyl group, or a trifluoromethyl group; Y¹ represents a single bond, an aliphatic hydrocarbylene group having 1 to 6 carbon atoms, a phenylene group, a naphthylene group, a group having 7 to 18 carbon atoms obtained by combining these groups, *-O-Y¹¹-, *-C(=O)-O-Y¹¹-, or *-C(=O)-NH-Y¹¹-; Y¹¹ represents an aliphatic hydrocarbylene group having 1 to 6 carbon atoms, a phenylene group, a naphthylene group, or a group having 7 to 18 carbon atoms obtained by combining these groups, Y¹¹ optionally having a carbonyl group, an ester bond, an ether bond, or a hydroxy group; Y² represents a single bond or **-Y²¹-C(=O)-O-; Y²¹ represents a hydrocarbylene group having 1 to 20 carbon atoms and optionally having a heteroatom; Y³ represents a single bond, a methylene group, an ethylene group, a phenylene group, a fluorinated phenylene group, a phenylene group substituted with a trifluoromethyl group, *-O-Y³¹-, *-C(=O)-O-Y³¹-, or *-C(=O)-NH-Y³¹-; Y³¹ represents an aliphatic hydrocarbylene group having 1 to 6 carbon atoms, a phenylene group, a fluorinated phenylene group, a phenylene group substituted with a trifluoromethyl group, or a group having 7 to 20 carbon atoms obtained by combining these groups, Y³¹ optionally having a carbonyl group, an ester bond, an ether bond, or a hydroxy group; "*" represents an attachment point to a carbon atom in the main chain; "**" represents an attachment point to an oxygen atom in the formula; Y⁴ represents a single bond or a hydrocarbylene group having 1 to 30 carbon atoms and optionally having a heteroatom; k¹ and k² each independently represent 0 or 1, and when Y⁴ is a single bond, k¹ and k² are 0; R⁵¹ to R⁶⁸ each independently represent a halogen atom or a hydrocarbyl group having 1 to 25 carbon atoms and optionally having a heteroatom; R⁵¹ and R⁵² are optionally bonded to each other to form a ring together with a sulfur atom to which R⁵¹ and R⁵² are bonded; R⁵³ and R⁵⁴, R⁵⁶ and R⁵⁷, and R⁵⁹ and R⁶⁰ are optionally bonded to each other to form a ring together with a sulfur atom to which R⁵³ and R⁵⁴, R⁵⁶ and R⁵⁷, and R⁵⁹ and R⁶⁰ are respectively bonded; R^{HF} represents a hydrogen atom or a trifluoromethyl group; and Xa⁻ represents a non-nucleophilic counter ion.

6. A chemically amplified positive resist composition comprising the polymer according to any one of claims 1 to 5.

7. The chemically amplified positive resist composition according to claim 6, further comprising an organic solvent.

8. The chemically amplified positive resist composition according to claim 6 or 7, further comprising a photo-acid generator whose anion has a conjugate acid having acidity pKa of -2.0 or higher; preferably wherein the photo-acid generator contains an anion structure of a photo-acid generator represented by the following formula (M-1), 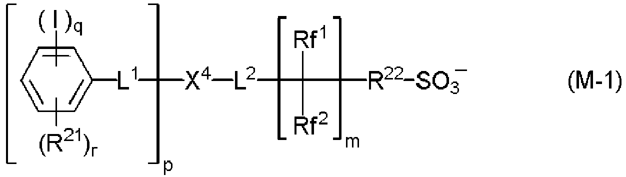 wherein "m" represents 0 or 1; "p" represents an integer of 1 to 3; "q" represents an integer of 1 to 5; "r" represents an integer of 0 to 3; L¹ represents a single bond, an ether bond, an ester bond, a sulfonic acid ester bond, a carbonate bond, or a carbamate bond; L² represents an ether bond, an ester bond, a sulfonic acid ester bond, a carbonate bond, or a carbamate bond; X⁴ represents a single bond or a hydrocarbylene group having 1 to 20 carbon atoms when "p" is 1, and represents a hydrocarbon group having a valency of p+1 and having 1 to 20 carbon atoms when "p" is 2 or 3, the hydrocarbylene group and the hydrocarbon group having a valency of p+1 optionally having at least one selected from an ether bond, a carbonyl group, an ester bond, an amide bond, a sultone ring, a lactam ring, a carbonate bond, a halogen atom, a hydroxy group, and a carboxy group; Rf¹ and Rf² each independently represent a hydrogen atom, a fluorine atom, or a trifluoromethyl group, provided that at least one is a fluorine atom or a trifluoromethyl group; R²¹ represents a hydroxy group, a carboxy group, a saturated hydrocarbyl group having 1 to 6 carbon atoms, a saturated hydrocarbyloxy group having 1 to 6 carbon atoms, a saturated hydrocarbylcarbonyloxy group having 2 to 6 carbon atoms, a fluorine atom, a chlorine atom, a bromine atom, an amino group, -N(R^{1A})-C(=O)-R^{1B}, or -N(R^{1A})-C(=O)-O-R^{1B}; R^{1A} represents a hydrogen atom or a saturated hydrocarbyl group having 1 to 6 carbon atoms; R^{1B} represents a saturated hydrocarbyl group having 1 to 6 carbon atoms or an unsaturated aliphatic hydrocarbyl group having 2 to 8 carbon atoms; and R²² represents a saturated hydrocarbylene group having 1 to 20 carbon atoms or an arylene group having 6 to 14 carbon atoms, a part or all of hydrogen atoms in the saturated hydrocarbylene group optionally being substituted with a halogen atom other than a fluorine atom, and a part or all of hydrogen atoms in the arylene group optionally being substituted with a substituent selected from a saturated hydrocarbyl group having 1 to 20 carbon atoms, a saturated hydrocarbyloxy group having 1 to 20 carbon atoms, an aryl group having 6 to 14 carbon atoms, a halogen atom, and a hydroxy group.

9. The chemically amplified positive resist composition according to any one of claims 6 to 8, further comprising a quencher; and/or further comprising a fluorine-containing polymer having at least one selected from a repeating unit represented by the following formula (D1), a repeating unit represented by the following formula (D2), a repeating unit represented by the following formula (D3), and a repeating unit represented by the following formula (D4), 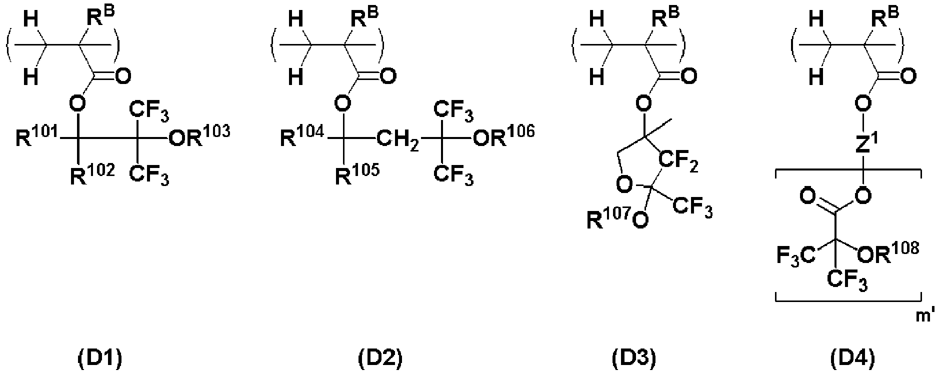 wherein each R^{B} independently represents a hydrogen atom, a fluorine atom, a methyl group, or a trifluoromethyl group; R¹⁰¹, R¹⁰², R¹⁰⁴, and R¹⁰⁵ each independently represents a hydrogen atom or a saturated hydrocarbyl group having 1 to 10 carbon atoms; R¹⁰³, R¹⁰⁶, R¹⁰⁷, and R¹⁰⁸ each independently represent a hydrogen atom, a hydrocarbyl group having 1 to 15 carbon atoms, a fluorinated hydrocarbyl group having 1 to 15 carbon atoms, or an acid-labile group, wherein R¹⁰³, R¹⁰⁶, R¹⁰⁷, and R¹⁰⁸ optionally have an intervening ether bond or carbonyl group in a carbon-carbon bond when each of R¹⁰³, R¹⁰⁶, R¹⁰⁷, and R¹⁰⁸ is a hydrocarbyl group or a fluorinated hydrocarbyl group; "m'" represents an integer of 1 to 3; and Z¹ represents a hydrocarbon group having a valency of m'+1 and having 1 to 20 carbon atoms or a fluorinated hydrocarbon group having a valency of m'+1 and having 1 to 20 carbon atoms; preferably wherein the fluorine-containing polymer further has at least one selected from a repeating unit represented by the following formula (D5) and a repeating unit represented by the following formula (D6), 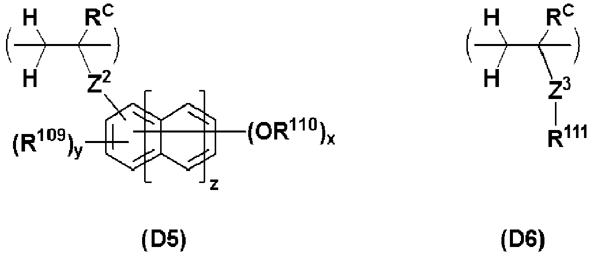 wherein each R^{C} independently represents a hydrogen atom or a methyl group; R¹⁰⁹ represents a hydrogen atom or a linear or branched hydrocarbyl group having 1 to 5 carbon atoms and optionally having, in a carbon-carbon bond, an intervening group containing a heteroatom; R¹¹⁰ represents a linear or branched hydrocarbyl group having 1 to 5 carbon atoms and optionally having, in a carbon-carbon bond, an intervening group containing a heteroatom; R¹¹¹ represents a saturated hydrocarbyl group having 1 to 20 carbon atoms, at least one hydrogen atom being substituted with a fluorine atom and a part of - CH₂- constituting the saturated hydrocarbyl group optionally being substituted with an ester bond or an ether bond; "x" represents an integer of 1 to 3; "y" represents an integer that satisfies 0 ≤ y ≤ 5+2z-x; "z" represents 0 or 1; Z² represents a single bond, *-C(=O)-O-, or *-C(=O)-NH-; Z³ represents a single bond, -O-, *-C(=O)-O-Z³¹-Z³²-, or *-C(=O)-NH-Z³¹-Z³²-; Z³¹ represents a single bond or a saturated hydrocarbylene group having 1 to 10 carbon atoms; Z³² represents a single bond, an ester bond, an ether bond, or a sulfonamide bond; and "*" represents an attachment point to a carbon atom in the main chain.

10. The chemically amplified positive resist composition according to any one of claims 6 to 9, wherein
(A) the polymer has a dissolution rate of 10 nm/min or lower to an alkaline developer; or
(B) an unexposed portion of a resist film obtained from the chemically amplified positive resist composition has a dissolution rate of 10 nm/min or lower to an alkaline developer.

11. The chemically amplified positive resist composition according to any one of claims 6 to 10, wherein an exposed portion of a resist film obtained from the chemically amplified positive resist composition has a dissolution rate of 50 nm/sec or higher to an alkaline developer.

12. A resist patterning process comprising the steps of:
forming a resist film on a substrate by using the chemically amplified positive resist composition according to any one of claims 6 to 11;
irradiating the resist film with a high-energy beam to form a pattern; and
developing, by using an alkaline developer, the resist film irradiated to form the pattern.

13. The resist patterning process according to claim 12, wherein the high-energy beam is a KrF excimer laser beam, an ArF excimer laser beam, an electron beam, or an extreme ultraviolet ray having a wavelength of 3 to 15 nm.

14. The resist patterning process according to claim 12 or 13, wherein an uppermost surface of the substrate is composed of a material containing at least one selected from chromium, silicon, tantalum, molybdenum, cobalt, nickel, tungsten, and tin; preferably wherein a transmission type or reflective mask blank is used as the substrate.

15. A transmission type or reflective mask blank, coated with the chemically amplified positive resist composition according to any one of claims 6 to 11.
